(19) Europäisches Patentamt
European Patent Office
Office européen des brevets

(11) EP 1 247 333 B1

(12) EUROPEAN PATENT SPECIFICATION

(45) Date of publication and mention of the grant of the patent:
**07.12.2005 Bulletin 2005/49**

(21) Application number: **00967288.2**

(22) Date of filing: **04.10.2000**

(51) Int Cl.$^7$: **H03D 7/16**

(86) International application number:
**PCT/US2000/027281**

(87) International publication number:
**WO 2001/026214 (12.04.2001 Gazette 2001/15)**

# (54) FREQUENCY CONVERTER AND METHOD

FREQUENZUMSETZER , UND VERFAHREN DAZU

PROCEDE, SYSTEME, ET APPAREIL DESTINES A LA CONVERSION D'ELEVATION EN FREQUENCE EQUILIBREE D'UN SIGNAL DE BANDE DE BASE

(84) Designated Contracting States:
**AT BE CH CY DE DK ES FI FR GB GR IE IT LI LU MC NL PT SE**

(30) Priority:
**07.10.1999 US 158047 P**
**21.12.1999 US 171349 P**
**22.12.1999 US 171502 P**
**24.01.2000 US 177705 P**
**24.01.2000 US 177381 P**
**24.01.2000 US 177702 P**
**07.02.2000 US 180667 P**
**14.03.2000 US 525615**
**14.03.2000 US 526041**
**15.03.2000 US 189453 P**
**24.04.2000 US 199141 P**
**16.05.2000 US 204796 P**
**21.06.2000 US 213363 P**

(43) Date of publication of application:
**09.10.2002 Bulletin 2002/41**

(73) Proprietor: **Parkervision, Inc.**
**Jacksonville, FL 32256 (US)**

(72) Inventors:
- **SORRELLS, David, F.**
  **Middleburg, FL 32058 (US)**
- **BULTMAN, Michael, J.**
  **Jacksonville, FL 32246 (US)**
- **COOK, Robert, W.**
  **Switzerland, FL 32259 (US)**
- **LOOKE, Richard, C.**
  **Jacksonville, FL 32223 (US)**
- **MOSES, Charley, D., Jr.**
  **Jacksonville, FL 32217 (US)**
- **RAWLINS, Gregory, S.**
  **Lake Mary, FL 32746 (US)**
- **RAWLINS, Michael, W.**
  **Lake Mary, FL 32746 (US)**

(74) Representative:
**Cross, James Peter Archibald et al**
**R.G.C. Jenkins & Co.,**
**26 Caxton Street**
**London SW1H 0RJ (GB)**

(56) References cited:
**EP-A- 0 817 369**
**WO-A-91/18445**
**WO-A-99/23755**
**US-A- 4 855 894**
**US-A- 5 801 654**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European Patent Convention).

EP 1 247 333 B1

## Description

### *Background of the Invention*

### *Field of the Invention*

The present invention is generally related to frequency up-conversion of a baseband signal, and applications of same.

### *Related Art*

Various communication components and systems exist for performing frequency up-conversion of electromagnetic signals.

The document WO 99/23755 discloses an upconverting mixer which uses optically activated switches with non-overlapping duty cycles to mix an amplified baseband signal with a local oscillator signal.

The document US 5801654 discloses a frequency translation device including a plurality of multiplying digital to analog converters that multiply an input signal by phase shifted digital sinewave approximation signals to perform frequency translation.

### *Summary of the Invention*

According to one aspect of the present invention, there is provided a method according to claim 1. According to another aspect of the present invention, there is provided apparatus according to claim 12.

Applications of the invention include, but are not limited to, up-converting a spread spectrum signal directly from baseband to radio frequency (RF) without utilizing any intermediate frequency (IF) processing.

In embodiments, a baseband signal is differentially sampled according to first and second control signals, resulting in a harmonically rich signal. The harmonically rich signal contains multiple harmonic images that each contain the necessary amplitude, frequency, and/or phase information to reconstruct the baseband signal. The harmonic images in the harmonically rich signal repeat at the harmonics of the sampling frequency ($1/T_s$) that are associated with the first and second control signals. In other words, the sampling is performed sub-harmonically according to the control signals. Additionally, the control signals include pulses that have an associated pulse width $T_A$ that is established to improve energy transfer to a desired harmonic image in the harmonically rich signal. The desired harmonic image can optionally be selected using a bandpass filter for transmission over a communications medium.

In operation, the input baseband signal is converted from a (single-ended) input into a differential baseband signal having first and second components. The first differential component is substantially similar to the input baseband signal, and the second differential component is an inverted version of the input baseband signal. The first differential component is sampled according to the first control signal, resulting in a first harmonically rich signal. Likewise, the second differential component is sampled according to the second control signal, resulting in a second harmonically rich signal. The first and second harmonically rich signals are combined to generate the output harmonically rich signal.

The sampling modules that perform the differentially sampling can be configured in a series or shunt configuration. In the series configuration, the baseband input is received at one port of the sampling module, and is gated to a second port of the sampling module; to generate the harmonically rich signal at the second port of the sampling module. In the shunt configuration, the baseband input is received at one port of the sampling module and is periodically shunted to ground at the second port of the sampling module, according to the control signal. Therefore, in the shunt configuration, the harmonically rich signal is generated at the first port of the sampling module and coexists with the baseband input signal at the first port.

The first control signal and second control signals that control the sampling process are phase shifted relative to one another. In embodiments of the invention, the phase-shift is 180 degrees in reference to a master clock signal, although the invention includes other phase shift values. Therefore, the sampling modules alternately sample the differential components of the baseband signal. Additionally as mentioned above, the first and second control signals include pulses having a pulse width $T_A$ that is established to improve energy transfer to a desired harmonic in the harmonically rich signal during the sampling process. More specifically, the pulse width $T_A$ is a non-negligible fraction of a period associated with a desired harmonic of interest. In an embodiment, the pulse width $T_A$ is one-half of a period of the harmonic of interest. Additionally, in an embodiment, the frequency of the pulses in both the first and second control signal are a sub-harmonic frequency of the output signal.

In further embodiments, DC offset voltages are minimized between the sampling modules during the differential sampling. In the serial configuration, this is accomplished by distributing a reference voltage to the input and output of the sampling modules. The result of minimizing (or preventing) DC offset voltages is that carrier insertion is minimized in the harmonics of the harmonically rich signal. In many transmit applications, carrier insertion is undesirable because the information to be transmitted is carried in the sidebands, and any energy at the carrier frequency is wasted. Alternatively, some transmit applications require sufficient carrier insertion for coherent demodulation of the transmitted signal at the receiver. In these applications, offset voltages can be generated between sampling modules, thereby causing carrier insertion in the harmonics of the harmonically rich signal.

An advantage is that embodiments of the invention up-convert a baseband signal directly from baseband-to-RF without any IF processing, while still meeting the spectral growth requirements of the most demanding communications standards. (Other embodiments may employ IF processing.) For example, in an I Q configuration, a CDMA spread spectrum signal can be up-converted directly from baseband-to-RF, and still meet the CDMA IS-95 figure-of-merit and spectral growth requirements. In other words, the up-conversion process is sufficiently linear and efficient that no IF filtering or amplification is required to meet the IS-95 figure-of-merit and spectral growth requirements. As a result, the entire IF chain in a conventional CDMA transmitter configuration can be eliminated, including the expensive and hard to integrate SAW filter. Since the SAW filter is eliminated, substantial portions of a CDMA transmitter in an embodiment of the invention can be integrated onto a single CMOS chip that uses a standard CMOS process, although the invention is not limited to this example application.

Further features and advantages of the invention, as well as the structure and operation of various embodiments of the invention, are described in detail below with reference to the accompanying drawings.

### *Brief Description of the Figures*

Embodiments of the present invention will be described with reference to the accompanying drawings, wherein:

FIG. 1A is a block diagram of a universal frequency translation (UFT) module according to an embodiment of the invention;
FIG. 1B is a more detailed diagram of a universal frequency translation (UFT) module according to an embodiment of the invention;
FIG. 1C illustrates a UFT module used in a universal frequency down-conversion (UFD) module according to an embodiment of the invention;
FIG. 1 D illustrates a UFT module used in a universal frequency up-conversion (UFU) module according to an embodiment of the invention;
FIG. 2A is a block diagram of a universal frequency translation (UFT) module according to embodiments of the invention;
FIG. 2B is a block diagram of a universal frequency translation (UFT) module according to embodiments of the invention;
FIG. 3 is a block diagram of a universal frequency up-conversion (UFU) module according to an embodiment of the invention;
FIG. 4 is a more detailed diagram of a universal frequency up-conversion (UFU) module according to an embodiment of the invention;
FIG. 5 is a block diagram of a universal frequency up-conversion (UFU) module according to an alternative embodiment of the invention;
FIGS. 6A-6I illustrate example waveforms used to describe the operation of the UFU module;
FIG. 7 illustrates a UFT module used in a receiver,
FIG. 8 illustrates a UFT module used in a transmitter according to an embodiment of the invention;
FIG. 9 illustrates an environment comprising a transmitter and a receiver, each of which may be implemented using a UFT module;
FIG. 10 illustrates a transceiver according to an embodiment of the invention;
FIG. 11 illustrates a transceiver according to an alternative embodiment of the invention;
FIG. 12 illustrates an environment comprising a transmitter and a receiver, each of which may be implemented using enhanced signal reception (ESR) components of the invention;
FIG. 13 illustrates a transceiver 7100 according to embodiments of the present invention;
FIG. 14 illustrates a transceiver 7200 according to embodiments of the present invention;
FIG. 15 illustrates an environment comprising a transmitter and a receiver, each of which may be implemented using enhanced signal reception (ESR) components of the invention, wherein the receiver may be further implemented using one or more UFD modules of the invention;
FIG.16 illustrates various pulse generators according to embodiments ofthe invention;
FIGs. 17 and 18 illustrate various example signal diagrams associated with the pulse generator in FIG. 16, according to embodiments of the invention;

FIGs. 19 and 20 illustrate various additional pulse generators according to embodiments of the invention;
FIG. 21 illustrates an enhanced signal reception system according to an embodiment of the invention;
FIGS. 22A-22F are example waveforms used to describe the system of FIG. 21;
FIG. 23A illustrates an example transmitter in an enhanced signal reception system according to an embodiment of the invention;
FIGS. 23B and 23C are example waveforms used to further describe the enhanced signal reception system according to an embodiment of the invention;
FIG. 23D illustrates another example transmitter in an enhanced signal reception system according to an embodiment of the invention;
FIGS. 23E and 23F are example waveforms used to further describe the enhanced signal reception system according to an embodiment of the invention;
FIG. 24A illustrates an example receiver in an enhanced signal reception system according to an embodiment of the invention;
FIGS. 24B-24J are example waveforms used to further describe the enhanced signal reception system according to an embodiment of the invention;
FIGs. 25A-B illustrate carrier insertion;
FIGs. 26A-C illustrate a balanced transmitter 2602 according to an embodiment of the present invention;
FIG. 26B-C illustrate example waveforms that are associated with the balanced transmitter 2602 according to an embodiment of the present invention;
FIG. 26D illustrates example FET configurations of the balanced transmitter 2602;
FIGs.27A-I illustrate various example timing diagrams associated with the transmitter 2602;
FIG. 27J illustrates an example frequency spectrum associated with the modulator 2604;
FIG. 28A illustrate a balanced modulator 2802 configured for carrier insertion according to embodiments of the present invention;
FIG. 28B illustrates example signal diagrams associated with the balanced transmitter 2802 according to embodiments of the invention;
FIG. 29 illustrates an I Q balanced transmitter 2920 according to embodiments of the present invention;
FIGs. 30A-C illustrate various example signal diagrams associated with the balanced transmitter 2920 in FIG. 29;
FIG. 31A illustrates an IQ balanced transmitter 3108 according to embodiments of the invention;
FIG. 31B illustrates an I Q balanced modulator 3118 according to embodiments of the invention;
FIG. 32 illustrates an IQ balanced modulator 3202 configured for carrier insertion according to embodiments of the invention;
FIG. 33 illustrates an I Q balanced modulator 3302 configured for carrier insertion according to embodiments of the invention;
FIGs. 34A-B illustrate various input configurations for the balanced transmitter 2920 according to embodiments of the present invention;
FIGs. 35A-B illustrate sidelobe requirements according to the IS-95 CDMA specification;
FIG. 36 illustrates a conventional CDMA transmitter 3600;
FIG. 37A illustrates a CDMA transmitter 3700 according to embodiments of the present invention;
FIGs. 37B-E illustrate various example signal diagrams according to embodiments of the present invention;
FIG. 37F illustrates a CDMA transmitter 3720 according to embodiments of the present invention;
FIG. 38 illustrates a CDMA transmitter utilizing a CMOS chip according to embodiments of the present invention;
FIG. 39 illustrates an example test set 3900;
FIGs. 40-52Z illustrate various example test results from testing the modulator 2910 in the test set 3900;
FIGs. 53A-C illustrate a transmitter 5300 and associated signal diagrams according to embodiments of the present invention;
FIGs. 54A-B illustrate a transmitter 5400 and associated signal diagrams according to embodiments of the present invention;
FIG. 54C illustrates a transmitter 5430 according to embodiments of the invention;
FIGs. 55A-D illustrates various implementation circuits for the modulator 2910 according to embodiments of the present invention;
FIG. 56A illustrate a transmitter 5600 according to embodiments of the present invention;
FIGs. 56B-C illustrate various frequency spectrums that are associated with the transmitter 5600;
FIG. 56D illustrates a FET configuration for the modulator 5600;
FIG 57 illustrates a IQ transmitter 5700 according to embodiments of the present invention;
FIGs. 58A-C illustrate various frequency spectrums that are associated with the IQ transmitter 5700;
FIG. 59 illustrates an IQ transmitter 5900 according to embodiments of the present invention;
FIG. 60 illustrates an IQ transmitter 6000 according to embodiments of the present invention;

FIG. 61 illustrates an IQ transmitter 6100 according to embodiments of the invention;

FIG. 62 illustrates a flowchart 6200 that is associated with the transmitter 2602 in the FIG. 26A according to an embodiment of the invention;

FIG. 63 illustrates a flowchart 6300 that further defines the flowchart 6200 in the FIG. 62, and is associated with the transmitter 2602 according to an embodiment of the invention;

FIG. 64 illustrates a flowchart 6400 that further defines the flowchart 6200 in the FIG. 63 and is associated with the transmitter 6400 according to an embodiment of the invention;

FIG. 65 illustrates the flowchart 6500 that is associated with the transmitter 2920 in the FIG. 29 according to an embodiment of the invention;

FIG. 66 illustrates a flowchart 6600 that is associated with the transmitter 5700 according to an embodiment of the invention;

FIG. 67 illustrates a flowchart 6700 that is associated with the spread spectrum transmitter 5300 in FIG. 53A according to an embodiment of the invention;

FIGs. 68A and FIG. 68B illustrate a flowchart 6800 that is associated with an IQ spread spectrum modulator 6100 in FIG. 61 according to an embodiment of the invention;

FIGs. 69A and FIG. 69B illustrate a flowchart 6900 that is associated with an IQ spread spectrum transmitter 5300 in FIG. 54A according to an embodiment of the invention;

FIG. 70 illustrates a flowchart 7300 that is associated with the CDMA transmitter 3720 in FIG. 30 according to an embodiment of the invention.

***Detailed Description of the Preferred Embodiments***

***Table of Contents***

1. Universal Frequency Translation
2. Frequency Up-conversion
3. Enhanced Signal Reception
4. Other Example Application Embodiments of the Invention
5. Universal Transmitter

    5.1 Universal Transmitter Having 2 UFT Modules

        5.1.1 Balanced Modulator Detailed Description
        5.1.2 Balanced Modulator Example Signal Diagrams and Mathematical Description
        5.1.3 Balanced Modulator Having Shunt Configuration
        5.1.4 Balanced Modulator FET Configuration
        5.1.5 Universal Transmitter Configured for Carrier Insertion

    5.2 Universal Transmitter in an IQ Configuration

        5.2.1 IQ Transmitter Using Series-Type Balanced Modulator
        5.2.2 IQ Transmitter Using Shunt-Type Balanced Modulator
        5.2.3 IQ Transmitters Configured for Carrier Insertion

    5.3 Universal Transmitter and CDMA

        5.3.1 IS-95 CDMA Specifications
        5.3.2 Conventional CDMA Transmitter
        5.3.3. CDMA Transmitter Using the Present Invention
        5.3.4 CDMA Transmitter Measured Test Results

6. Integrated Up-conversion and Spreading of a Baseband Signal

    6.1 Integrated Up-Conversion and Spreading Using an Amplitude Shaper
    6.2 Integrated Up-Conversion and Spreading Using a Smoothing Varying Clock Signal

7. Shunt Transceiver Embodiments Utilizing UFT Modules
8. Conclusion

### *1. Universal Frequency Translation*

FIG. 1A illustrates a universal frequency translation (UFT) module 102 according to embodiments of the invention. (The UFT module is also sometimes called a universal frequency translator, or a universal translator.)
As indicated by the example of FIG. 1A, some embodiments of the UFT module 102 include three ports (nodes), designated in FIG. 1A as Port 1, Port 2, and Port 3. Other UFT embodiments include other than three ports.
Generally, the UFT module 102 (perhaps in combination with other components) operates to generate an output signal from an input signal, where the frequency of the output signal differ from the frequency of the input signal. In other words, the UFT module 102 (and perhaps other components) operates to generate the output signal from the input signal by translating the frequency (and perhaps other characteristics) of the input signal to the frequency (and perhaps other characteristics) of the output signal.
An example embodiment of the UFT module 103 is generally illustrated in FIG. 1B. Generally, the UFT module 103 includes a switch 106 controlled by a control signal 108. The switch 106 is said to be a controlled switch.
As noted above, some UFT embodiments include other than three ports. For example, and without limitation, FIG. 2 illustrates an example UFT module 202. The example UFT module 202 includes a diode 204 having two ports, designated as Port 1 and Port 2/3. This embodiment does not include a third port, as indicated by the dotted line around the "Port 3" label. FIG. 2B illustrates a second example UFT module 208 having a FET 210 whose gate is controlled by the control signal.
The UFT module is a very powerful and flexible device. Its flexibility is illustrated, in part, by the wide range of applications in which it can be used. Its power is illustrated, in part, by the usefulness and performance of such applications.
For example, as shown in FIG. 1C, a UFT module 117 can be used in a universal frequency up-conversion (UFU) module 116. In this capacity, the UFT module 117. frequency up-converts an input signal to an output signal.
These and other applications of the UFT module are described below. Additional applications of the UFT module will be apparent to persons skilled in the relevant art(s) based on the teachings contained herein. In some applications, the UFT module is a required component. In other applications, the UFT module is an optional component.

### *2. Frequency Up-conversion Using Universal Frequency Translation*

The present invention is directed to systems and methods of frequency up-conversion, and applications of same. An example frequency up-conversion system 300 is illustrated in FIG. 3. The frequency up-conversion system 300 is now described.
An input signal 302 (designated as "Control Signal" in FIG. 3) is accepted by a switch module 304. For purposes of example only, assume that the input signal 302 is a FM input signal 606, an example of which is shown in FIG. 6C. FM input signal 606 may have been generated by modulating information signal 602 onto oscillating signal 604 (FIGS. 6A and 6B). It should be understood that the invention is not limited to this embodiment. The information signal 602 can be analog, digital, or any combination thereof, and any modulation scheme can be used.
The output of switch module 304 is a harmonically rich signal 306, shown for example in FIG. 6D as a harmonically rich signal 608. The harmonically rich signal 608 has a continuous and periodic waveform.
FIG. 6E is an expanded view of two sections of harmonically rich signal 608, section 610 and section 612. The harmonically rich signal 608 may be a rectangular wave, such as a square wave or a pulse (although, the invention is not limited to this embodiment). For ease of discussion, the term "rectangular waveform" is used to refer to waveforms that are substantially rectangular. In a similar manner, the term "square wave" refers to those waveforms that are substantially square and it is not the intent of the present invention that a perfect square wave be generated or needed.
Harmonically rich signal 608 is comprised of a plurality of sinusoidal waves whose frequencies are integer multiples of the fundamental frequency of the waveform of the harmonically rich signal 608. These sinusoidal waves are referred to as the harmonics of the underlying waveform, and the fundamental frequency is referred to as the first harmonic. FIG. 6F and FIG. 6G show separately the sinusoidal components making up the first, third, and fifth harmonics of section 610 and section 612. (Note that in theory there may be an infinite number of harmonics; in this example, because harmonically rich signal 608 is shown as a square wave, there are only odd harmonics). Three harmonics are shown simultaneously (but not summed) in FIG. 6H.
The relative amplitudes of the harmonics are generally a function of the relative widths of the pulses of harmonically rich signal 306 and the period of the fundamental frequency, and can be determined by doing a Fourier analysis of harmonically rich signal 306. According to an embodiment of the invention, the input signal 606 may be shaped to ensure that the amplitude of the desired harmonic is sufficient for its intended use (e.g., transmission).

A filter 308 filters out any undesired frequencies (harmonics), and outputs an electromagnetic (EM) signal at the desired harmonic frequency or frequencies as an output signal 310, shown for example as a filtered output signal 614 in FIG. 6I.

FIG. 4 illustrates an example universal frequency up-conversion (UFU) module 401. The UFU module 401 includes an example switch module 304, which comprises a bias signal 402, a resistor or impedance 404, a universal frequency translator (UFT) 450, and a ground 408. The UFT 450 includes a switch 406. The input signal 302 (designated as "Control Signal" in FIG. 4) controls the switch 406 in the UFT 450, and causes it to close and open. Harmonically rich signal 306 is generated at a node 405 located between the resistor or impedance 404 and the switch 406.

Also in FIG. 4, it can be seen that an example filter 308 is comprised of a capacitor 410 and an inductor 412 shunted to a ground 414. The filter is designed to filter out the undesired harmonics of harmonically rich signal 306.

The invention is not limited to the UFU embodiment shown in FIG. 4.

For example, in an alternate embodiment shown in FIG. 5, an unshaped input signal 501 is routed to a pulse shaping module 502. The pulse shaping module 502 modifies the unshaped input signal 501 to generate a (modified) input signal 302 (designated as the "Control Signal" in FIG. 5). The input signal 302 is routed to the switch module 304, which operates in the manner described above. Also, the filter 308 of FIG. 5 operates in the manner described above.

The purpose of the pulse shaping module 502 is to define the pulse width of the input signal 302. Recall that the input signal 302 controls the opening and closing of the switch 406 in switch module 304. During such operation, the pulse width of the input signal 302 establishes the pulse width of the harmonically rich signal 306. As stated above, the relative amplitudes of the harmonics of the harmonically rich signal 306 are a function of at least the pulse width of the harmonically rich signal 306. As such, the pulse width of the input signal 302 contributes to setting the relative amplitudes of the harmonics ofharmonically rich signal 306.

Further details of up-conversion as described in this section are presented in U.S. patent no. 6091940.

### *3. Enhanced Signal Reception*

Referring to FIG. 21, transmitter 2104 accepts a modulating baseband signal 2102 and generates (transmitted) redundant spectrums 2106a-n, which are sent over communications medium 2108. Receiver 2112 recovers a demodulated baseband signal 2114 from (received) redundant spectrums 21 10a-n. Demodulated baseband signal 2114 is representative of the modulating baseband signal 2102, where the level of similarity between the modulating baseband signal 2114 and the modulating baseband signal 2102 is application dependent.

Modulating baseband signal 2102 is preferably any information signal desired for transmission and/or reception. An example modulating baseband signal 2202 is illustrated in FIG. 22A, and has an associated modulating baseband spectrum 2204 and image spectrum 2203 that are illustrated in FIG. 22B. Modulating baseband signal 2202 is illustrated as an analog signal in FIG. 22a, but could also be a digital signal, or combination thereof. Modulating baseband signal 2202 could be a voltage (or current) characterization of any number of real world occurrences, including for example and without limitation, the voltage (or current) representation for a voice signal.

Each transmitted redundant spectrum 2106a-n contains the necessary information to substantially reconstruct the modulating baseband signal 2102. In other words, each redundant spectrum 2106a-n contains the necessary amplitude, phase, and frequency information to reconstruct the modulating baseband signal 2102.

FIG. 22C illustrates example transmitted redundant spectrums 2206b-d. Transmitted redundant spectrums 2206b-d are illustrated to contain three redundant spectrums for illustration purposes only. Any number of redundant spectrums could be generated and transmitted as will be explained in following discussions.

Transmitted redundant spectrums 2206b-d are centered at $f_1$, with a frequency spacing $f_2$ between adjacent spectrums. Frequencies $f_1$ and $f_2$ are dynamically adjustable in real-time as will be shown below. FIG. 22D illustrates an alternate embodiment, where redundant spectrums 2208c,d are centered on unmodulated oscillating signal 2209 at $f_1$ (Hz). Oscillating signal 2209 may be suppressed if desired using, for example, phasing techniques or filtering techniques. Transmitted redundant spectrums are preferably above baseband frequencies as is represented by break 2205 in the frequency axis of FIGS. 22C and 22D.

Received redundant spectrums 2110a-n are substantially similar to transmitted redundant spectrums 2106a-n, except for the changes introduced by the communications medium 2108. Such changes can include but are not limited to signal attenuation, and signal interference. FIG. 22E illustrates example received redundant spectrums 2210b-d. Received redundant spectrums 2210b-d are substantially similar to transmitted redundant spectrums 2206b-d, except that redundant spectrum 2210c includes an undesired jamming signal spectrum 2211 in order to illustrate some advantages of the present invention. Jamming signal spectrum 2211 is a frequency spectrum associated with a jamming signal. For purposes of this invention, a "jamming signal" refers to any unwanted signal, regardless of origin, that may interfere with the proper reception and reconstruction of an intended signal. Furthermore, the jamming signal is not limited to tones as depicted by spectrum 2211, and can have any spectral shape, as will be understood by those skilled in the art(s).

As stated above, demodulated baseband signal 2114 is extracted from one or more of received redundant spectrums 2210b-d. FIG. 22F illustrates example demodulated baseband signal 2212 that is, in this example, substantially similar to modulating baseband signal 2202 (FIG. 22A); where in practice, the degree of similarity is application dependent.

An advantage of the present invention should now be apparent. The recovery of modulating baseband signal 2202 can be accomplished by receiver 2112 in spite of the fact that high strength jamming signal(s) (e.g. jamming signal spectrum 2211) exist on the communications medium. The intended baseband signal can be recovered because multiple redundant spectrums are transmitted, where each redundant spectrum carries the necessary information to reconstruct the baseband signal. At the destination, the redundant spectrums are isolated from each other so that the baseband signal can be recovered even if one or more of the redundant spectrums are corrupted by a jamming signal.

Transmitter 2104 will now be explored in greater detail. FIG. 23A illustrates transmitter 2301, which is one embodiment of transmitter 2104 that generates redundant spectrums configured similar to redundant spectrums 2206b-d. Transmitter 2301 includes generator 2303, optional spectrum processing module 2304, and optional medium interface module 2320. Generator 2303 includes: first oscillator 2302, second oscillator 2309, first stage modulator 2306, and second stage modulator 2310.

Transmitter 2301 operates as follows. First oscillator 2302 and second oscillator 2309 generate a first oscillating signal 2305 and second oscillating signal 2312, respectively. First stage modulator 2306 modulates first oscillating signal 2305 with modulating baseband signal 2202, resulting in modulated signal 2308. First stage modulator 2306 may implement any type of modulation including but not limited to: amplitude modulation, frequency modulation, phase modulation, combinations thereof, or any other type of modulation. Second stage modulator 2310 modulates modulated signal 2308 with second oscillating signal 2312, resulting in multiple redundant spectrums 2206a-n shown in FIG. 23B. Second stage modulator 2310 is preferably a phase modulator, or a frequency modulator, although other types of modulation may be implemented including but not limited to amplitude modulation. Each redundant spectrum 2206a-n contains the necessary amplitude, phase, and frequency information to substantially reconstruct the modulating baseband signal 2202.

Redundant spectrums 2206a-n are substantially centered around $f_1$, which is the characteristic frequency of first oscillating signal 2305. Also, each redundant spectrum 2206an (except for 2206c) is offset from $f_1$ by approximately a multiple of $f_2$ (Hz), where $f_2$ is the frequency of the second oscillating signal 2312. Thus, each redundant spectrum 2206a-n is offset from an adjacent redundant spectrum by $f_2$ (Hz). This allows the spacing between adjacent redundant spectrums to be adjusted (or tuned) by changing $f_2$ that is associated with second oscillator 2309. Adjusting the spacing between adjacent redundant spectrums allows for dynamic real-time tuning of the bandwidth occupied by redundant spectrums 2206a-n.

In one embodiment, the number of redundant spectrums 2206a-n generated by transmitter 2301 is arbitrary and may be unlimited as indicated by the "a-n" designation for redundant spectrums 2206a-n. However, a typical communications medium will have a physical and/or administrative limitations (i.e. FCC regulations) that restrict the number of redundant spectrums that can be practically transmitted over the communications medium. Also, there may be other reasons to limit the number of redundant spectrums transmitted. Therefore, preferably, the transmitter 2301 will include an optional spectrum processing module 2304 to process the redundant spectrums 2206a-n prior to transmission over communications medium 2108.

In one embodiment, spectrum processing module 2304 includes a filter with a passband 2207 (FIG. 23C) to select redundant spectrums 2206b-d for transmission. This will substantially limit the frequency bandwidth occupied by the redundant spectrums to the passband 2207. In one embodiment, spectrum processing module 2304 also up converts redundant spectrums and/or amplifies redundant spectrums prior to transmission over the communications medium 2108. Finally, medium interface module 2320 transmits redundant spectrums over the communications medium 2108. In one embodiment, communications medium 2108 is an over-the-air link and medium interface module 2320 is an antenna. Other embodiments for communications medium 2108 and medium interface module 2320 will be understood based on the teachings contained herein.

FIG. 23D illustrates transmitter 2321, which is one embodiment of transmitter 2104 that generates redundant spectrums configured similar to redundant spectrums 2208c-d and unmodulated spectrum 2209. Transmitter 2321 includes generator 2311, spectrum processing module 2304, and (optional) medium interface module 2320. Generator 2311 includes: first oscillator 2302, second oscillator 2309, first stage modulator 2306, and second stage modulator 2310.

As shown in FIG. 23D, many of the components in transmitter 2321 are similar to those in transmitter 2301. However, in this embodiment, modulating baseband signal 2202 modulates second oscillating signal 2312. Transmitter 2321 operates as follows. First stage modulator 2306 modulates second oscillating signal 2312 with modulating baseband signal 2202, resulting in modulated signal 2322. As described earlier, first stage modulator 2306 can effect any type of modulation including but not limited to: amplitude modulation frequency modulation, combinations thereof, or any other type of modulation. Second stage modulator 2310 modulates first oscillating signal 2304 with modulated signal 2322, resulting in redundant spectrums 2208a-n, as shown in FIG. 23E. Second stage modulator 2310 is preferably a phase or frequency modulator, although other modulators could used including but not limited to an amplitude modulator.

Redundant spectrums 2208a-n are centered on unmodulated spectrum 2209 (at $f_1$ Hz), and adjacent spectrums are separated by $f_2$ Hz. The number of redundant spectrums 2208a-n generated by generator 2311 is arbitrary and unlimited, similar to spectrums 2206a-n discussed above. Therefore, optional spectrum processing module 2304 may also include a filter with passband 2325 to select, for example, spectrums 2208c,d for transmission over communications medium 2108. In addition, optional spectrum processing module 2304 may also include a filter (such as a bandstop filter) to attenuate unmodulated spectrum 2209. Alternatively, unmodulated spectrum 2209 may be attenuated by using phasing techniques during redundant spectrum generation. Finally, (optional) medium interface module 2320 transmits redundant spectrums 2208c,d over communications medium 2108.

Receiver 2112 will now be explored in greater detail to illustrate recovery of a demodulated baseband signal from received redundant spectrums. FIG. 24A illustrates receiver 2430, which is one embodiment of receiver 2112. Receiver 2430 includes optional medium interface module 2402, down-converter 2404, spectrum isolation module 2408, and data extraction module 2414. Spectrum isolation module 2408 includes filters 2410a-c. Data extraction module 2414 includes demodulators 2416a-c, error check modules 2420a-c, and arbitration module 2424. Receiver 2430 will be discussed in relation to the signal diagrams in FIGS. 24B-24J.

In one embodiment, optional medium interface module 2402 receives redundant spectrums 2210b-d (FIG. 22E, and FIG. 24B). Each redundant spectrum 2210b-d includes the necessary amplitude, phase, and frequency information to substantially reconstruct the modulating baseband signal used to generated the redundant spectnuns. However, in the present example, spectrum 2210c also contains jamming signal 2211, which may interfere with the recovery of a baseband signal from spectrum 2210c. Down-converter 2404 down-converts received redundant spectrums 2210b-d to lower intermediate frequencies, resulting in redundant spectrums 2406a-c (FIG. 24C). Jamming signal 2211 is also down-converted to jamming signal 2407, as it is contained within redundant spectrum 2406b. Spectrum isolation module 2408 includes filters 2410a-c that isolate redundant spectrums 2406a-c from each other (FIGS. 24D-24F, respectively). Demodulators 2416a-c independently demodulate spectrums 2406a-c, resulting in demodulated baseband signals 2418a-c, respectively (FIGS. 24G-24I). Error check modules 2420a-c analyze demodulate baseband signal 2418a-c to detect any errors. In one embodiment, each error check module 2420a-c sets an error flag 2422a-c whenever an error is detected in a demodulated baseband signal. Arbitration module 2424 accepts the demodulated baseband signals and associated error flags, and selects a substantially error-free demodulated baseband signal (FIG. 24J). In one embodiment, the substantially error-free demodulated baseband signal will be substantially similar to the modulating baseband signal used to generate the received redundant spectrums, where the degree of similarity is application dependent.

Referring to FIGS. 24G-I, arbitration module 2424 will select either demodulated baseband signal 2418a or 2418c, because error check module 2420b will set the error flag 2422b that is associated with demodulated baseband signal 2418b.

The error detection schemes implemented by the error detection modules include but are not limited to: cyclic redundancy check (CRC) and parity check for digital signals, and various error detections schemes for analog signal.

Further details of enhanced signal reception as described in this section are presented in US Patent No. 6061555.

### *4. Example Application Embodiments of the Invention*

As noted above, the UFT module of the present invention is a very powerful and flexible device. Its flexibility is illustrated, in part, by the wide range of applications in which it can be used. Its power is illustrated, in part, by the usefulness and performance of such applications.

Example applications of the UFT module were described above. In particular, frequency up-conversion applications of the UFT module were summarized above, and are further described below. These applications of the UFT module are discussed herein for illustrative purposes. The invention is not limited to these example applications. Additional applications of the UFT module will be apparent to persons skilled in the relevant art(s), based on the teachings contained herein.

The present invention can be used in applications that involve frequency up-conversion. This is shown in FIG. 1C, for example, where an example UFT module 117 is used in a frequency up-conversion module 116. In this capacity, the UFT module 117 frequency up-converts an input signal to an output signal. This is also shown in FIG. 8, for example, where an example UFT module 806 is part of up-conversion module 804, which is part of a transmitter 802.

The present invention can be used in environments having one or more transmitters 902 and one or more receivers 906, as illustrated in FIG. 9. In such environments, one or more of the transmitters 902 may be implemented using a UFT module, as shown for example in FIG. 8.

The invention can be used to implement a transceiver. An example transceiver 1002 is illustrated in FIG. 10. The transceiver 1002 includes a transmitter 1004 and a receiver 1008. Either the transmitter 1004 or the receiver 1008 can be implemented using a UFT module. Alternatively, the transmitter 1004 can be implemented using a UFT module 1006, and the receiver 1008 can be implemented using a UFT module 1010. This embodiment is shown in FIG. 10.

Another transceiver embodiment according to the invention is shown in FIG. 11. In this transceiver 1102, the transmitter 1104 and the receiver 1108 are implemented using a single UFT module 1106. In other words, the transmitter 1104 and the receiver 1108 share a UFT module 1106.

As described elsewhere in this application, the invention is directed to methods and systems for enhanced signal reception (ESR). Various ESR embodiments include an ESR module (transmit) in a transmitter 1202, and an ESR module (receive) in a receiver 1210. An example ESR embodiment configured in this manner is illustrated in FIG. 12.

The ESR module (transmit) 1204 includes a frequency up-conversion module 1206. Some embodiments of this frequency up-conversion module 1206 may be implemented using a UFT module, such as that shown in FIG. 1D.

The ESR module (receive) 1212 includes a frequency down-conversion module 1214. Some embodiments of this frequency down-conversion module 1214 may be implemented using a UFT module, such as that shown in FIG. 1C.

As discussed herein, the enhanced signal reception (ESR) module (receive) operates to down-convert a signal containing a plurality of spectrums. The ESR module (receive) also operates to isolate the spectrums in the down-converted signal, where such isolation is implemented via filtering in some embodiments. The ESR module (receive) is implemented using one or more unified down-conversion and filtering (UDF) modules. This is illustrated, for example, in FIG. 15. In the example of FIG. 15, one or more of the UDF modules 1610, 1612, 1614 operates to down-convert a received signal. The UDF modules 1610, 1612, 1614 also operate to filter the down-converted signal so as to isolate the spectrum(s) contained therein. As noted above, the UDF modules 1610, 1612, 1614 are implemented using the universal frequency translation (UFT) modules of the invention.

The invention is not limited to the applications of the UFT module described above. For example, and without limitation, subsets of the applications (methods and/or structures) described herein (and others that would be apparent to persons skilled in the relevant art(s) based on the herein teachings) can be associated to form useful combinations.

For example, transmitters and receivers are two applications of the UFT module. FIG. 10 illustrates a transceiver 1002 that is formed by combining these two applications of the UFT module, i.e., by combining a transmitter 1004 with a receiver 1008.

Also, ESR (enhanced signal reception) and unified down-conversion and filtering are two other applications of the UFT module. FIG. 15 illustrates an example where ESR and unified down-conversion and filtering are combined to form a modified enhanced signal reception system.

The invention is not limited to the example applications of the UFT module discussed herein. Also, the invention is not limited to the example combinations of applications of the UFT module discussed herein. These examples were provided for illustrative purposes only, and are not limiting. Other applications and combinations of such applications will be apparent to persons skilled in the relevant art(s) based on the teachings contained herein.

### *5. Universal Transmitter*

An embodiment of the present invention is directed at a universal transmitter using, in embodiments, two or more UFT modules in a balanced vector modulator configuration. The universal transmitter can be used to create virtually every known and useful waveform used in analog and digital communications applications in wired and wireless markets. By appropriately selecting the inputs to the universal transmitter, a host of signals can be synthesized including but not limited to AM, FM, BPSK, QPSK, MSK, QAM, ODFM, multi-tone, and spread-spectrum signals (including CDMA and frequency hopping). As will be shown, the universal transmitter can up-convert these waveforms using less components than that seen with conventional super-heterodyne approaches. In other words, the universal transmitter does not require multiple IF stages (having intermediate filtering) to up-convert complex waveforms that have demanding spectral growth requirements. The elimination of intermediate IF stages reduces part count in the transmitter and therefore leads to cost savings. As will be shown, the embodiment of the present invention achieves these savings without sacrificing performance.

Furthermore, the use of a balanced configuration means that carrier insertion can be attenuated or controlled during up-conversion of a baseband signal. Carrier insertion is caused by the variation of transmitter components (e.g. resistors, capacitors, etc.), which produces DC offset voltages throughout the transmitter. Any DC offset voltage gets up-converted, along with the baseband signal, and generates spectral energy (or carrier insertion) at the carrier frequency $f_C$. In many transmit applications, it is highly desirable to minimize the carrier insertion in an up-converted signal because the sideband(s) carry the baseband information and any carrier insertion is wasted energy that reduces efficiency.

FIGs. 25A-B graphically illustrate carrier insertion in the context of up-converted signals that carry baseband information in the corresponding signal sidebands. FIG. 25A depicts an up-converted signal 2502 having minimal carrier energy 2504 when compared to sidebands 2506a and 2506b. In these transmitter applications, the present invention can be configured to minimize carrier insertion by limiting the relative DC offset voltage that is present in the transmitter. Alternatively, some transmit applications require sufficient carrier insertion for coherent demodulation of the transmitted signal at the receiver. This is illustrated by FIG. 25B, which shows up-converted signal 2508 having carrier energy 2510 that is somewhat larger than sidebands 2512a and 2512b. In these applications, the present invention can be configured to introduce a DC offset voltage that generates the desired carrier insertion.

### *5.1 Universal Transmitter Having 2 UFT Modules*

FIG. 26A illustrates a transmitter 2602 according to embodiments of the present invention. Transmitter 2602 includes a balanced modulator/up-converter 2604, a control signal generator 2642, an optional filter 2606, and an optional amplifier 2608. Transmitter 2602 up-converts a baseband signal 2610 to produce an output signal 2640 that is conditioned for wireless or wire line transmission. In doing so; the balanced modulator 2604 receives the baseband signal 2610 and samples the baseband signal in a differential and balanced fashion to generate a harmonically rich signal 2638. The harmonically rich signal 2638 includes multiple harmonic images, where each image contains the baseband information in the baseband signal 2610. The optional bandpass filter 2606 may be included to select a harmonic of interest (or a subset of harmonics) in the signal 2558 for transmission. The optional amplifier 2608 may be included to amplify the selected harmonic prior to transmission. The universal transmitter is further described at a high level by the flowchart 6200 that is shown in FIG. 62. A more detailed structural and operational description of the balanced modulator follows thereafter.

Referring to flowchart 6200, in step 6202, the balanced modulator 2604 receives the baseband signal 2610.

In step 6204, the balanced modulator 2604 samples the baseband signal in a differential and balanced fashion according to a first and second control signals that are phase shifted with respect to each other. The resulting harmonically rich signal 2638 includes multiple harmonic images that repeat at harmonics of the sampling frequency, where each image contains the necessary amplitude and frequency information to reconstruct the baseband signal 2610.

In embodiments of the invention, the control signals include pulses having pulse widths (or apertures) that are established to improve energy transfer to a desired harmonic of the harmonically rich signal. In further embodiments of the invention, DC offset voltages are minimized between sampling modules as indicated in step 6206, thereby minimizing carrier insertion in the harmonic images of the harmonically rich signal 2638.

In step 6208, the optional bandpass filter 2606 selects the desired harmonic of interest (or a subset of harmonics) in from the harmonically rich signal 2638 for transmission.

In step 6210, the optional amplifier 2608 amplifies the selected harmonic(s) prior to transmission.

In step 6212, the selected harmonic(s) is transmitted over a communications medium.

### *5.1.1 Balanced Modulator Detailed Description*

Referring to the example embodiment shown in FIG. 26A, the balanced modulator 2604 includes the following components: a buffer/inverter 2612; summer amplifiers 2618, 2619; UFT modules 2624 and 2628 having controlled switches 2648 and 2650, respectively; an inductor 2626; a blocking capacitor 2636; and a DC terminal 2611. As stated above, the balanced modulator 2604 differentially samples the baseband signal 2610 to generate a harmonically rich signal 2638. More specifically, the UFT modules 2624 and 2628 sample the baseband signal in differential fashion according to control signals 2623 and 2627, respectively. A DC reference voltage 2613 is applied to terminal 2611 and is uniformly distributed to the UFT modules 2624 and 2628. The distributed DC voltage 2613 prevents any DC offset voltages from developing between the UFT modules, which can lead to carrier insertion in the harmonically rich signal 2638 as described above. The operation of the balanced modulator 2604 is discussed in greater detail with reference to flowchart 6300 (FIG. 63), as follows.

In step 6302, the buffer/inverter 2612 receives the input baseband signal 2610 and generates input signal 2614 and inverted input signal 2616. Input signal 2614 is substantially similar to signal 2610, and inverted signal 2616 is an inverted version of signal 2614. As such, the buffer/inverter 2612 converts the (single-ended) baseband signal 2610 into differential input signals 2614 and 2616 that will be sampled by the UFT modules. Buffer/inverter 2612 can be implemented using known operational amplifier (op amp) circuits, as will be understood by those skilled in the arts, although the invention is not limited to this example.

In step 6304, the summer amplifier 2618 sums the DC reference voltage 2613 applied to terminal 2611 with the input signal 2614, to generate a combined signal 2620. Likewise, the summer amplifier 2619 sums the DC reference voltage 2613 with the inverted input signal 2616 to generate a combined signal 2622. Summer amplifiers 2618 and 2619 can be implemented using known op amp summer circuits, and can be designed to have a specified gain or attenuation, including unity gain, although the invention is not limited to this example. The DC reference voltage 2613 is also distributed to the outputs of both UFT modules 2624 and 2628 through the inductor 2626 as is shown.

In step 6306, the control signal generator 2642 generates control signals 2623 and 2627 that are shown by way of example in FIG. 27B and FIG. 27C, respectively. As illustrated, both control signals 2623 and 2627 have the same period $T_S$ as a master clock signal 2645 (FIG.27A), but have a pulse width (or aperture) of $T_A$. In the example, control signal 2623 triggers on the rising pulse edge of the master clock signal 2645, and control signal 2627 triggers on the falling pulse edge of the master clock signal 2645. Therefore, control signals 2623 and 2627 are shifted in time by 180 degrees relative to each other. In embodiments of invention, the master clock signal 2645 (and therefore the control signals 2623 and 2627) have a frequency that is a sub-harmonic of the desired output signal 2640. The invention is not limited to the example of FIGs. 27A-27C.

In one embodiment, the control signal generator 2642 includes an oscillator 2646, pulse generators 2644a and 2644b, and an inverter 2647 as shown. In operation, the oscillator 2646 generates the master clock signal 2645, which is illustrated in FIG. 27A as a periodic square wave having pulses with a period of $T_S$. Other clock signals could be used including but not limited to sinusoidal waves, as will be understood by those skilled in the arts. Pulse generator 2644a receives the master clock signal 2645 and triggers on the rising pulse edge, to generate the control signal 2623. Inverter 2647 inverts the clock signal 2645 to generate an inverted clock signal 2643. The pulse generator 2644b receives the inverted clock signal 2643 and triggers on the rising pulse edge (which is the falling edge of clock signal 2645), to generate the control signal 2627.

FIG 16-20 illustrate example embodiments for the pulse generator 2644. FIG. 16 illustrates a pulse generator 7402. The pulse generator 7402 generates pulses 7408 having pulse width $T_A$ from an input signal 7404. Example input signals 7404 and pulses 7408 are depicted in FIGs 17 and 18, respectively. The input signal 7404 can be any type of periodic signal, including, but not limited to, a sinusoid, a square wave, a saw-tooth wave etc. The pulse width (or aperture) $T_A$ of the pulses 7408 is determined by delay 7406 of the pulse generator 7402. The pulse generator 7402 also includes an optional inverter 7410, which is optionally added for polarity considerations as understood by those skilled in the arts. The example logic and implementation shown for the pulse generator 7402 is provided for illustrative purposes only, and is not limiting. The actual logic employed can take many forms. Additional examples of pulse generation logic are shown in FIGs. 19 and 20. FIG. 19 illustrates a rising edge pulse generator 7412 that triggers on the rising edge of input signal 7404. FIG. 20 illustrates a falling edge pulse generator 7416 that triggers on the falling edge of the input signal 7404.

In step 6308, the UFT module 2624 samples the combined signal 2620 according to the control signal 2623 to generate harmonically rich signal 2630. More specifically, the switch 2648 closes during the pulse widths $T_A$ of the control signal 2623 to sample the combined signal 2620 resulting in the harmonically rich signal 2630. FIG. 26B illustrates an exemplary frequency spectrum for the harmonically rich signal 2630 having harmonic images 2652a-n. The images 2652 repeat at harmonics of the sampling frequency $1/T_S$ at infinitum, where each image 2652 contains the necessary amplitude, frequency, and phase information to reconstruct the baseband signal 2610. As discussed further below, the relative amplitude of the frequency images is generally a function of the harmonic number and the pulse width $T_A$. As such, the relative amplitude of a particular harmonic 2652 can be increased (or decreased) by adjusting the pulse width $T_A$ of the control signal 2623. In general, shorter pulse widths of $T_A$ shift more energy into the higher frequency harmonics, and longer pulse widths of $T_A$ shift energy into the lower frequency harmonics. The generation of harmonically rich signals by sampling an input signal according to a controlled aperture have been described earlier in this application in the section titled, "Frequency Up-conversion Using Universal Frequency Translation", and is illustrated by FIGs. 3-6. A more detailed discussion of frequency up-conversion using a switch with a controlled sampling aperture is discussed in US patent no. 6091940.

In step 6310, the UFT module 2628 samples the combined signal 2622 according to the control signal 2627 to generate harmonically rich signal 2634. More specifically, the switch 2650 closes during the pulse widths $T_A$ of the control signal 2627 to sample the combined signal 2622 resulting in the harmonically rich signal 2634. The harmonically rich signal 2634 includes multiple frequency images of baseband signal 2610 that repeat at harmonics of the sampling frequency ($1/T_S$), similar to that for the harmonically rich signal 2630. However, the images in the signal 2634 are phase-shifted compared to those in signal 2630 because of the inversion of signal 2616 compared to signal 2614, and because of the relative phase shift between the control signals 2623 and 2627.

In step 6312, the node 2632 sums the harmonically rich signals 2632 and 2634 to generate harmonically rich signal 2633. FIG. 26C illustrates an exemplary frequency spectrum for the harmonically rich signal 2633 that has multiple images 2654a-n that repeat at harmonics of the sampling frequency $1/T_S$. Each image 2654 includes the necessary amplitude, frequency and phase information to reconstruct the baseband signal 2610. The capacitor 2636 operates as a DC blocking capacitor and substantially passes the harmonics in the harmonically rich signal 2633 to generate harmonically rich signal 2638 at the output of the modulator 2604.

In step 6208, the optional filter 2606 can be used to select a desired harmonic image for transmission. This is represented for example by a passband 2656 that selects the harmonic image 2654c for transmission in FIG. 26C.

An advantage of the modulator 2604 is that it is fully balanced, which substantially minimizes (or eliminates) any DC voltage offset between the two UFT modules 2624 and 2628. DC offset is minimized because the reference voltage 2613 contributes a consistent DC component to the input signals 2620 and 2622 through the summing amplifiers 2618 and 2619, respectively. Furthermore, the reference voltage 2613 is also directly coupled to the outputs of the UFT modules 2624 and 2628 through the inductor 2626 and the node 2632. The result of controlling the DC offset between the UFT modules is that carrier insertion is minimized in the harmonic images of the harmonically rich signal 2638. As discussed above, carrier insertion is substantially wasted energy because the information for a modulated signal is carried in the sidebands of the modulated signal and not in the carrier. Therefore, it is often desirable to minimize the energy at the carrier frequency by controlling the relative DC offset.

### *5.1.2 Balanced Modulator Example Signal Diagrams and Mathematical Description*

In order to further describe the invention, FIGs.27D-27I illustrate various example signal diagrams (vs. time) that are representative of the invention. These signal diagrams are meant for example purposes only and are not meant to be limiting. FIG. 27D illustrates a signal 2702 that is representative of the input baseband signal 2610 (FIG. 26A). FIG. 27E illustrates a step function 2704 that is an expanded portion of the signal 2702 from time $t_0$ to $t_1$, and represents signal 2614 at the output of the buffer/inverter 2612. Similarly, FIG. 27F illustrates a signal 2706 that is an inverted version of the signal 2704, and represents the signal 2616 at the inverted output of buffer/inverter 2612. For analysis purposes, a step function is a good approximation for a portion of a single bit of data (for the baseband signal 2610) because the clock rates of the control signals 2623 and 2627 are significantly higher than the data rates of the baseband signal 2610. For example, if the data rate is in the KHz frequency range, then the clock rate will preferably be in MHZ frequency range in order to generate an output signal in the GHz frequency range.

Still referring to FIGs. 27D-I, FIG. 27G illustrates a signal 2708 that an example of the harmonically rich signal 2630 when the step function 2704 is sampled according to the control signal 2623 in FIG. 27B. The signal 2708 includes positive pulses 2709 as referenced to the DC voltage 2613. Likewise, FIG. 27H illustrates a signal 2710 that is an example of the harmonically rich signal 2634 when the step function 2706 is sampled according to the control signal 2627. The signal 2710 includes negative pulses 2711 as referenced to the DC voltage 2613, which are time-shifted relative the positive pulses 2709 in signal 2708.

Still referring to FIGs. 27D-I, the FIG. 271 illustrates a signal 2712 that is the combination of signal 2708 (FIG. 27G) and the signal 2710 (FIG. 27H), and is an example of the harmonically rich signal 2633 at the output of the summing node 2632. As illustrated, the signal 2712 spends approximately as much time above the DC reference voltage 2613 as below the DC reference voltage 2613 over a limited time period. For example, over a time period 2714, the energy in the positive pulses 2709a-b is canceled out by the energy in the negative pulses 2711a-b. This is indicative of minimal (or zero) DC offset between the UFT modules 2624 and 2628, which results in minimal carrier insertion during the sampling process.

Still referring to FIG. 27I, the time axis of the signal 2712 can be phased in such a manner to represent the waveform as an odd function. For such an arrangement, the Fourier series is readily calculated to obtain:

$$I_c(t) = \sum_{n=1}^{\infty} \left( \frac{4\sin\left(\frac{n\pi T_A}{T_s}\right) \cdot \sin\left(\frac{n\pi}{2}\right)}{n\pi} \right) \cdot \sin\left(\frac{2n\pi t}{T_s}\right) \qquad \textit{Equation 1.}$$

where:

$T_S$ = period of the master clock 2645
$T_A$ = pulse width of the control signals 2623 and 2627
n= harmonic number

**[0097]** As shown by Equation 1, the relative amplitude of the frequency images is generally a function of the harmonic number n, and the ratio of $T_A/T_S$. As indicated, the $T_A/T_S$ ratio represents the ratio of the pulse width of the control signals relative to the period of the sub-harmonic master clock. The $T_A/T_S$ ratio can be optimized in order to maximize the amplitude of the frequency image at a given harmonic. For example, if a passband waveform is desired to be created at 5x the frequency of the sub-harmonic clock, then a baseline power for that harmonic extraction may be calculated for the fifth harmonic (n=5) as:

$$I_c(t) = \left( \frac{4\sin\left(\frac{5\pi T_A}{T_s}\right)}{5\pi} \right) \cdot \sin(5\omega_s t) \qquad \textbf{\textit{Equation 2.}}$$

As shown by Equation 2, $I_C(t)$ for the fifth harmonic is a sinusoidal function having an amplitude that is proportional to the sin $(5\pi T_A/T_S)$ The signal amplitude can be maximized by setting $T_A= (1/10 \cdot T_S)$ so that sin $(5\pi T_A/T_S)=$ sin $(\pi/2)=1$. Doing so results in the equation:

$$I_c(t)\big|_{n=5} = \frac{4}{5\pi}\left(\sin\left(5\omega_s t\right)\right) \qquad \textbf{\textit{Equation 3.}}$$

This component is a frequency at 5x of the sampling frequency of sub-harmonic clock, and can be extracted from the Fourier series via a bandpass filter (such as bandpass filter 2606) that is centered around $5f_S$. The extracted frequency component can then be optionally amplified by the amplifier 2608 prior to transmission on a wireless or wire-line communications channel or channels.

Equation 3 can be extended to reflect the inclusion of a message signal as illustrated by equation 4 below:

$$m(t) \cdot I_c(t)\big|_{\substack{n=5 \\ \theta=\theta(t)}} = \frac{4 \cdot m(t)}{5\pi}\left(\sin\left(5\omega_s t + 5\theta(t)\right)\right) \qquad \textbf{\textit{Equation 4.}}$$

Equation 4 illustrates that a message signal can be carried in harmonically rich signals 2633 such that both amplitude and phase can be modulated. In other words, m(t) is modulated for amplitude and θ(t) is modulated for phase. In such cases, it should be noted that θ(t) is augmented modulo *n* while the amplitude modulation *m(t)* is simply scaled. Therefore, complex waveforms may be reconstructed from their Fourier series with multiple aperture UFT combinations.

As discussed above, the signal amplitude for the 5th harmonic was maximized by setting the sampling aperture width $T_A= 1/10\ T_S$, where $T_S$ is the period of the master clock signal. This can be restated and generalized as setting $T_A= ½$ the period (or π radians) at the harmonic of interest. In other words, the signal amplitude of any harmonic n can be maximized by sampling the input waveform with a sampling aperture of $T_A= ½$ the period of the harmonic of interest *(n)*. Based on this discussion, it is apparent that varying the aperture changes the harmonic and amplitude content of the output waveform. For example, if the sub-harmonic clock has a frequency of 200 MHZ, then the fifth harmonic is at 1Ghz. The amplitude of the fifth harmonic is maximized by setting the aperture width $T_A= 500$ picoseconds, which equates to ½ the period (or π radians) at 1 Ghz.

FIG. 27J depicts a frequency plot 2716 that graphically illustrates the effect of varying the sampling aperture of the control signals on the harmonically rich signal 2633 given a 200 MHZ harmonic clock. The frequency plot 2716 compares two frequency spectrums 2718 and 2720 for different control signal apertures given a 200 MHZ clock. More specifically, the frequency spectrum 2718 is an example spectrum for signal 2633 given the 200 MHZ clock with the aperture $T_A = 500$ psec (where 500 psec is π radians at the 5th harmonic of 1 GHz). Similarly, the frequency spectrum 2720 is an example spectrum for signal 2633 given a 200 MHZ clock that is a square wave (so $T_A = 5000$ psec). The spectrum 2718 includes multiple harmonics 2718a-i, and the frequency spectrum 2720 includes multiple harmonics 2720a-e. [ It is noted that spectrum 2720 includes only the odd harmonics as predicted by Fourier analysis for a square wave.] At 1 Ghz (which is the 5th harmonic), the signal amplitude of the two frequency spectrums 2718e and 2720c are approximately equal. However, at 200 MHZ, the frequency spectrum 2718a has a much lower amplitude than the frequency spectrum 2720a, and therefore the frequency spectrum 2718 is more efficient than the frequency spectrum 2720, assuming the desired harmonic is the 5th harmonic. In other words, assuming 1 Ghz is the desired harmonic, the frequency spectrum 2718 wastes less energy at the 200 MHZ fundamental than does the frequency spectrum 2718.

### *5.1.3 Balanced Modulator Having a Shunt Configuration*

FIG. 56A illustrates a universal transmitter 5600 that is a second embodiment of a universal transmitter having two balanced UFT modules in a shunt configuration, (In contrast, the balanced modulator 2604 can be described as having a series configuration based on the orientation of the UFT modules.) Transmitter 5600 includes a balanced modulator 5601, the control signal generator 2642, the optional bandpass filter 2606, and the optional amplifier 2608. The transmitter 5600 up-converts a baseband signal 5602 to produce an output signal 5636 that is conditioned for wireless or wire line transmission. In doing so, the balanced modulator 5601 receives the baseband signal 5602 and shunts the baseband signal to ground in a differential and balanced fashion to generate a harmonically rich signal 5634. The harmonically rich signal 5634 includes multiple harmonic images, where each image contains the baseband information in the baseband signal 5602. In other words, each harmonic image includes the necessary amplitude, frequency, and phase information to reconstruct the baseband signal 5602. The optional bandpass filter 2606 may be included to select a harmonic of interest (or a subset of harmonics) in the signal 5634 for transmission. The optional amplifier 2608 may be included to amplify the selected harmonic prior to transmission, resulting in the output signal 5636.

The balanced modulator 5601 includes the following components: a buffer/inverter 5604; optional impedances 5610, 5612; UFT modules 5616 and 5622 having controlled switches 5618 and 5624, respectively; blocking capacitors 5628 and 5630; and a terminal 5620 that is tied to ground. As stated above, the balanced modulator 5601 differentially shunts the baseband signal 5602 to ground, resulting in a harmonically rich signal 5634. More specifically, the UFT modules 5616 and 5622 alternately shunts the baseband signal to terminal 5620 according to control signals 2623 and 2627, respectively. Terminal 5620 is tied to ground and prevents any DC offset voltages from developing between the UFT modules 5616 and 5622. As described above, a DC offset voltage can lead to undesired carrier insertion. The operation of the balanced modulator 5601 is described in greater detail according to the flowchart 6400 (FIG. 64) as follows.

In step 6402, the buffer/inverter 5604 receives the input baseband signal 5602 and generates I signal 5606 and inverted I signal 5608. I signal 5606 is substantially similar to the baseband signal 5602, and the inverted I signal 5608 is an inverted version of signal 5602. As such, the buffer/inverter 5604 converts the (single-ended) baseband signal 5602 into differential signals 5606 and 5608 that are sampled by the UFT modules. Buffer/inverter 5604 can be implemented using known operational amplifier (op amp) circuits, as will be understood by those skilled in the arts, although the invention is not limited to this example.

In step 6404, the control signal generator 2642 generates control signals 2623 and 2627 from the master clock signal 2645. Examples of the master clock signal 2645, control signal 2623, and control signal 2627 are shown in FIGs. 27A-C, respectively. As illustrated, both control signals 2623 and 2627 have the same period $T_S$ as a master clock signal 2645, but have a pulse width (or aperture) of $T_A$. Control signal 2623 triggers on the rising pulse edge of the master clock signal 2645, and control signal 2627 triggers on the falling pulse edge of the master clock signal 2645. Therefore, control signals 2623 and 2627 are shifted in time by 180 degrees relative to each other. A specific embodiment of the control signal generator 2642 is illustrated in FIG. 26A, and was discussed in detail above.

In step 6406, the UFT module 5616 shunts the signal 5606 to ground according to the control signal 2623, to generate a harmonically rich signal 5614. More specifically, the switch 5618 closes and shorts the signal 5606 to ground (at terminal 5620) during the aperture width $T_A$ of the control signal 2623, to generate the harmonically rich signal 5614. FIG. 56B illustrates an exemplary frequency spectrum for the harmonically rich signal 5618 having harmonic images 5650a-n. The images 5650 repeat at harmonics of the sampling frequency $1/T_S$, at infinitum, where each image 5650 contains the necessary amplitude, frequency, and phase information to reconstruct the baseband signal 5602. The generation of harmonically rich signals by sampling an input signal according to a controlled aperture have been described earlier in this application in the section titled, "Frequency Up-conversion Using Universal Frequency Translation", and is illustrated by FIGs. 3-6. A more detailed discussion of frequency up-conversion using a switch with a controlled sampling aperture is discussed in US patent no. 6091940.

The relative amplitude of the frequency images 5650 is generally a function of the harmonic number and the pulse width $T_A$. As such, the relative amplitude of a particular harmonic 5650 can be increased (or decreased) by adjusting the pulse width $T_A$ of the control signal 2623. In general, shorter pulse widths of $T_A$ shift more energy into the higher frequency harmonics, and longer pulse widths of $T_A$ shift energy into the lower frequency harmonics. Additionally, the relative amplitude of a particular harmonic 5650 can also be adjusted by adding/tuning an optional impedance 5610. Impedance 5610 operates as a filter that emphasizes a particular harmonic in the harmonically rich signal 5614.

In step 6408, the UFT module 5622 shunts the inverted signal 5608 to ground according to the control signal 2627, to generate a harmonically rich signal 5626. More specifically, the switch 5624 closes during the pulse widths $T_A$ and shorts the inverted I signal 5608 to ground (at terminal 5620), to generate the harmonically rich signal 5626. At any given time, only one of input signals 5606 or 5608 is shorted to ground because the pulses in the control signals 2623 and 2627 are phase shifted with respect to each other, as shown in FIGs. 27B and 27C.

The harmonically rich signal 5626 includes multiple frequency images of baseband signal 5602 that repeat at harmonics of the sampling frequency ($1/T_S$), similar to that for the harmonically rich signal 5614. However, the images in the signal 5626 are phase-shifted compared to those in signal 5614 because of the inversion of the signal 5608 compared to the signal 5606, and because of the relative phase shift between the control signals 2623 and 2627. The optional impedance 5612 can be included to emphasize a particular harmonic of interest, and is similar to the impedance 5610 above.

In step 6410, the node 5632 sums the harmonically rich signals 5614 and 5626 to generate the harmonically rich signal 5634. The capacitors 5628 and 5630 operate as blocking capacitors that substantially pass the respective harmonically rich signals 5614 and 5626 to the node 5632. (The capacitor values may be chosen to substantially block baseband frequency components as well.) FIG. 56C illustrates an exemplary frequency spectrum for the harmonically rich signal 5634 that has multiple images 5652a-n that repeat at harmonics of the sampling frequency $1/T_S$. Each image 5652 includes the necessary amplitude, frequency, and phase information to reconstruct the baseband signal 5602. The optional filter 2606 can be used to select the harmonic image of interest for transmission. This is represented by a passband 5656 that selects the harmonic image 5632c for transmission.

An advantage of the modulator 5601 is that it is fully balanced, which substantially minimizes (or eliminates) any DC voltage offset between the two UFT modules 5612 and 5614. DC offset is minimized because the UFT modules 5616 and 5622 are both connected to ground at terminal 5620. The result of controlling the DC offset between the UFT modules is that carrier insertion is minimized in the harmonic images of the harmonically rich signal 5634. As discussed above, carrier insertion is substantially wasted energy because the information for a modulated signal is carried in the sidebands of the modulated signal and not in the carrier. Therefore, it is often desirable to minimize the energy at the carrier frequency by controlling the relative DC offset.

### *5.1.4 Balanced Modulator FET Configuration*

As described above, the balanced modulators 2604 and 5601 utilize two balanced UFT modules to sample the input baseband signals to generate harmonically rich signals that contain the up-converted baseband information. More specifically, the UFT modules include controlled switches that sample the baseband signal in a balanced and differential fashion. FIGs. 26D and 56D illustrate embodiments of the controlled switch in the UFT module.

FIG. 26D illustrates an example embodiment of the modulator 2604 (FIG. 26B) where the controlled switches in the UFT modules are field effect transistors (FET). More specifically, the controlled switches 2648 and 2628 are embodied as FET 2658 and FET 2660, respectively. The FET 2658 and 2660 are oriented so that their gates are controlled by the control signals 2623 and 2627, so that the control signals control the FET conductance. For the FET 2658, the combined baseband signal 2620 is received at the source of the FET 2658 and is sampled according to the control signal 2623 to produce the harmonically rich signal 2630 at the drain of the FET 2658. Likewise, the combined baseband signal 2622 is received at the source of the FET 2660 and is sampled according to the control signal 2627 to produce the harmonically rich signal 2634 at the drain of FET 2660. The source and drain orientation that is illustrated is not limiting, as the source and drains can be switched for most FETs. In other words, the combined baseband signal can be received at the drain of the FETs, and the harmonically rich signals can be taken from the source of the FETs, as will be understood by those skilled in the relevant arts.

FIG. 56D illustrates an embodiment of the modulator 5600 (FIG. 56) where the controlled switches in the UFT modules are field effect transistors (FET). More specifically, the controlled switches 5618 and 5624 are embodied as FET 5636 and FET 5638, respectively. The FETs 5636 and 5638 are oriented so that their gates are controlled by the control signals 2623 and 2627, respectively, so that the control signals determine FET conductance. For the FET 5636, the baseband signal 5606 is received at the source of the FET 5636 and shunted to ground according to the control signal 2623, to produce the harmonically rich signal 5614. Likewise, the baseband signal 5608 is received at the source of the FET 5638 and is shunted to grounding according to the control signal 2627, to produce the harmonically rich signal 5626. The source and drain orientation that is illustrated is not limiting, as the source and drains can be switched for most FETs, as will be understood by those skilled in the relevant arts.

### *5.1.5 Universal Transmitter Configured for Carrier Insertion*

As discussed above, the transmitters 2602 and 5600 have a balanced configuration that substantially eliminates any DC offset and results in minimal carrier insertion in the output signal 2640. Minimal carrier insertion is generally desired for most applications because the carrier signal carries no information and reduces the overall transmitter efficiency. However, some applications require the received signal to have sufficient carrier energy for the receiver to extract the carrier for coherent demodulation. In support thereof, the present invention can be configured to provide the necessary carrier insertion by implementing a DC offset between the two sampling UFT modules.

FIG. 28A illustrates a transmitter 2802 that up-converts a baseband signal 2806 to an output signal 2822 having carrier insertion. As is shown, the transmitter 2802 is similar to the transmitter 2602 ( FIG. 26A) with the exception that the up-converter/modulator 2804 is configured to accept two DC references voltages. In contrast, modulator 2604 was configured to accept only one DC reference voltage. More specifically, the modulator 2804 includes a terminal 2809 to accept a DC reference voltage 2808, and a terminal 2813 to accept a DC reference voltage 2814. Vr 2808 appears at the UFT module 2624 though summer amplifier 2618 and the inductor 2810. Vr 2814 appears at UFT module 2628 through the summer amplifier 2619 and the inductor 2816. Capacitors 2812 and 2818 operate as blocking capacitors. If Vr 2808 is different from Vr 2814 then a DC offset voltage will be exist between UFT module 2624 and UFT module 2628, which will be up-converted at the carrier frequency in the harmonically rich signal 2820. More specifically, each harmonic image in the harmonically rich signal 2820 will include a carrier signal as depicted in FIG. 28B.

FIG. 28B illustrates an exemplary frequency spectrum for the harmonically rich signal 2820 that has multiple harmonic images 2824a-n. In addition to carrying the baseband information in the sidebands, each harmonic image 2824 also includes a carrier signal 2826 that exists at respective harmonic of the sampling frequency $1/T_S$. The amplitude of the carrier signal increases with increasing DC offset voltage. Therefore, as the difference between Vr 2808 and Vr 2814 widens, the amplitude of each carrier signal 2826 increases. Likewise, as the difference between Vr 2808 and Vr 2814 shrinks, the amplitude of each carrier signal 2826 shrinks. As with transmitter 2802, the optional bandpass filter 2606 can be included to select a desired harmonic image for transmission. This is represented by passband 2828 in FIG. 28B.

### *5.2 Universal Transmitter In I Q Configuration:*

As described above, the balanced modulators 2604 and 5601 up-convert a baseband signal to a harmonically rich signal having multiple harmonic images of the baseband information. By combining two balanced modulators, IQ configurations can be formed for up-converting I and Q baseband signals. In doing so, either the (series type) balanced modulator 2604 or the (shunt type) balanced modulator can be utilized. IQ modulators having both series and shunt configurations are described below.

#### *5.2.1 IQ Transmitter Using Series-Type Balanced Modulator*

FIG. 29 illustrates an IQ transmitter 2920 with an in-phase (I) and quadrature (Q) configuration according to embodiments of the invention. The transmitter 2920 includes an IQ balanced modulator 2910, an optional filter 2914, and an optional amplifier 2916. The transmitter 2920 is useful for transmitting complex IQ waveforms and does so in a balanced manner to control DC offset and carrier insertion. In doing so, the modulator 2910 receives an I baseband signal 2902 and a Q baseband signal 2904 and up-converts these signals to generate a combined harmonically rich signal 2912. The harmonically rich signal 2912 includes multiple harmonic images, where each image contains the baseband information in the I signal 2902 and the Q signal 2904. The optional bandpass filter 2914 may be included to select a harmonic of interest (or subset of harmonics) from the signal 2912 for transmission. The optional amplifier 2916 may be included to amplify the selected harmonic prior to transmission, to generate the IQ output signal 2918.

As stated above, the balanced IQ modulator 2910 up-converts the I baseband signal 2902 and the Q baseband signal 2904 in a balanced manner to generate the combined harmonically rich signal 2912 that carriers the I and Q baseband information. To do so, the modulator 2910 utilizes two balanced modulators 2604 from FIG. 26A, a signal combiner 2908, and a DC terminal 2907. The operation of the balanced modulator 2910 and other circuits in the transmitter is described according to the flowchart 6500 in FIG. 65, as follows.

In step 6502, the IQ modulator 2910 receives the I baseband signal 2902 and the Q baseband signal 2904.

In step 6504, the I balanced modulator 2604a samples the I baseband signal 2902 in a differential fashion using the control signals 2623 and 2627 to generate a harmonically rich signal 2911a. The harmonically rich signal 2911a contains multiple harmonic images of the I baseband information, similar to the harmonically rich signal 2630 in FIG. 26B.

In step 6506, the balanced modulator 2604b samples the Q baseband signal 2904 in a differential fashion using control signals 2623 and 2627 to generate harmonically rich signal 2911b, where the harmonically rich signal 2911b contains multiple harmonic images of the Q baseband signal 2904. The operation of the balanced modulator 2604 and the generation of harmonically rich signals was fully described above and illustrated in FIGs. 26A-C, to which the reader is referred for further details.

In step 6508, the DC terminal 2907 receives a DC voltage 2906 that is distributed to both modulators 2604a and 2604b. The DC voltage 2906 is distributed to both the input and output of both UFT modules 2624 and 2628 in each modulator 2604. This minimizes (or prevents) DC offset voltages from developing between the four UFT modules, and thereby minimizes or prevents any carrier insertion during the sampling steps 6504 and 6506.

In step 6510, the 90 degree signal combiner 2908 combines the harmonically rich signals 2911a and 2911b to generate IQ harmonically rich signal 2912. This is further illustrated in FIGs. 30A-C. FIG. 30A depicts an exemplary frequency spectrum for the harmonically rich signal 2911a having harmonic images 3002a-n. The images 3002 repeat at harmonics of the sampling frequency $1/T_S$, where each image 3002 contains the necessary amplitude and frequency information to reconstruct the I baseband signal 2902. Likewise, FIG. 30B depicts an exemplary frequency spectrum for the harmonically rich signal 2911b having harmonic images 3004a-n. The harmonic images 3004a-n also repeat at harmonics of the sampling frequency $1/T_S$, where each image 3004 contains the necessary amplitude, frequency, and phase information to reconstruct the Q baseband signal 2904. FIG.30C illustrates an exemplary frequency spectrum for the combined harmonically rich signal 2912 having images 3006. Each image 3006 carries the I baseband information and the Q baseband information from the corresponding images 3002 and 3004, respectively, without substantially increasing the frequency bandwidth occupied by each harmonic 3006. This can occur because the signal combiner 2908 phase shifts the Q signal 2911b by 90 degrees relative to the I signal 2911a. The result is that the images 3002a-n and 3004a-n effectively share the signal bandwidth do to their orthogonal relationship. For example, the images 3002a and 3004a effectively share the frequency spectrum that is represented by the image 3006a.

In step 6512, the optional filter 2914 can be included to select a harmonic of interest, as represented by the passband 3008 selecting the image 3006c in FIG. 30c.

In step 6514, the optional amplifier 2916 can be included to amplify the harmonic (or harmonics) of interest prior to transmission.

In step 6516, the selected harmonic (or harmonics) is transmitted over a communications medium.

FIG. 31A illustrates a transmitter 3108 that is a second embodiment for an I Q transmitter having a balanced configuration. Transmitter 3108 is similar to the transmitter 2920 except that the 90 degree phase shift between the I and Q channels is achieved by phase shifting the control signals instead of using a 90 degree signal combiner to combine the harmonically rich signals. More specifically, delays 3104a and 3104b delay the control signals 2623 and 2627 for the Q channel modulator 2604b by 90 degrees relative to the control signals for the I channel modulator 2604a. As a result, the Q modulator 2604b samples the Q baseband signal 2904 with 90 degree delay relative to the sampling of the I baseband signal 2902 by the I channel modulator 2604a. Therefore, the Q harmonically rich signal 2911b is phase shifted by 90 degrees relative to the I harmonically rich signal. Since the phase shift is achieved using the control signals, an in-phase signal combiner 3106 combines the harmonically rich signals 2911a and 2911b, to generate the harmonically rich signal 2912.

FIG. 31B illustrates a transmitter 3118 that is similar to transmitter 3108 in FIG. 31A. The difference being that the transmitter 3118 has a modulator 3120 that utilizes a summing node 3122 to sum the signals 2911a and 2911b instead of the in-phase signal combiner 3106 that is used in modulator 3102 of transmitter 3108.

FIG. 55A-55D illustrate various detailed circuit implementations of the transmitter 2920 in FIG. 29. These circuit implementations are meant for example purposes only, and are not meant to be limiting.

FIG. 55A illustrates I input circuitry 5502a and Q input circuitry 5502b that receive the I and Q input signals 2902 and 2904, respectively. ,

FIG. 55B illustrates the I channel circuitry 5506 that processes an I data 5504a from the I input circuit 5502a.

FIG. 55C illustrates the Q channel circuitry 5508 that processes the Q data 5504b from the Q input circuit 5502b.

FIG. 55D illustrates the output combiner circuit 5512 that combines the I channel data 5507 and the Q channel data 5510 to generate the output signal 2918.

### *5.2.2. IQ Transmitter Using Shunt-Type Balanced Modulalor.*

FIG. 57 illustrates an IQ transmitter 5700 that is another IQ transmitter embodiment according to the present invention. The transmitter 5700 includes an IQ balanced modulator 5701, an optional filter 5712, and an optional amplifier 5714. During operation, the modulator 5701 up-converts an I baseband signal 5702 and a Q baseband signal 5704 to generate a combined harmonically rich signal 5711. The harmonically rich signal 5711 includes multiple harmonics images, where each image contains the baseband information in the I signal 5702 and the Q signal 5704. The optional bandpass filter 5712 may be included to select a harmonic of interest (or subset of harmonics) from the harmonically rich signal 5711 for transmission. The optional amplifier 5714 may be included to amplify the selected harmonic prior to transmission, to generate the IQ output signal 5716.

The IQ modulator 5701 includes two balanced modulators 5601 from FIG. 56, and a 90 degree signal combiner 5710 as shown. The operation of the IQ modulator 5701 is described in reference to the flowchart 6600 (FIG. 66), as follows. The order of the steps in flowchart 6600 is not limiting.

In step 6602, the balanced modulator 5701 receives the I baseband signal 5702 and the Q baseband signal 5704.

In step 6604, the balanced modulator 5601 a differentially shunts the I baseband signal 5702 to ground according the control signals 2623 and 2627, to generate a harmonically rich signal 5706. More specifically, the UFT modules 5616a and 5622a alternately shunt the I baseband signal and an inverted version of the I baseband signal to ground according to the control signals 2623 and 2627, respectively. The operation of the balanced modulator 5601 and the generation ofharmonically rich signals was fully described above and is illustrated in FIGs. 56A-C, to which the reader is referred for further details. As such, the harmonically rich signal 5706 contains multiple harmonic images of the I baseband information as described above.

In step 6606, the balanced modulator 5601b differentially shunts the Q baseband signal 5704 to ground according to control signals 2623 and 2627, to generate harmonically rich signal 5708. More specifically, the UFT modules 5616b and 5622b alternately shunt the Q baseband signal and an inverted version of the Q baseband signal to ground, according to the control signals 2623 and 2627, respectively. As such, the harmonically rich signal 5708 contains multiple harmonic images that contain the Q baseband information.

In step 6608, the 90 degree signal combiner 5710 combines the harmonically rich signals 5706 and 5708 to generate IQ harmonically rich signal 5711. This is further illustrated in FIGs. 58A-C. FIG. 58A depicts an exemplary frequency spectrum for the harmonically rich signal 5706 having harmonic images 5802a-n. The harmonic images 5802 repeat at harmonics of the sampling frequency $1/T_S$, where each image 5802 contains the necessary amplitude, frequency, and phase information to reconstruct the I baseband signal 5702. Likewise, FIG. 58B depicts an exemplary frequency spectrum for the harmonically rich signal 5708 having harmonic images 5804a-n. The harmonic images 5804a-n also repeat at harmonics of the sampling frequency $1/T_S$, where each image 5804 contains the necessary amplitude, frequency, and phase information to reconstruct the Q baseband signal 5704. FIG.58C illustrates an exemplary frequency spectrum for the IQ harmonically rich signal 5711 having images 5806an. Each image 5806 carries the I baseband information and the Q baseband information from the corresponding images 5802 and 5804, respectively, without substantially increasing the frequency bandwidth occupied by each image 5806. This can occur because the signal combiner 5710 phase shifts the Q signal 5708 by 90 degrees relative to the I signal 5706.

Inn step 6610, the optional filter 5712 may be included to select a harmonic of interest, as represented by the passband 5808 selecting the image 5806c in FIG. 58C.

In step 6612, the optional amplifier 5714 can be included to amplify the selected harmonic image 5806 prior to transmission.

In step 6614, the selected harmonic (or harmonics) is transmitted over a communications medium.

FIG. 59 illustrates a transmitter 5900 that is another embodiment for an IQ transmitter having a balanced configuration. Transmitter 5900 is similar to the transmitter 5700 except that the 90 degree phase shift between the I and Q channels is achieved by phase shifting the control signals instead of using a 90 degree signal combiner to combine the harmonically rich signals. More specifically, delays 5904a and 5904b delay the control signals 2623 and 2627 for the Q channel modulator 5601b by 90 degrees relative the control signals for the I channel modulator 5601a. As a result, the Q modulator 5601b samples the Q baseband signal 5704 with a 90 degree delay relative to the sampling of the I baseband signal 5702 by the I channel modulator 5601a. Therefore, the Q harmonically rich signal 5708 is phase shifted by 90 degrees relative to the I harmonically rich signal 5706. Since the phase shift is achieved using the control signals, an in-phase signal combiner 5906 combines the harmonically rich signals 5706 and 5708, to generate the harmonically rich signal 5711.

FIG.60 illustrates a transmitter 6000 that is similar to transmitter 5900 in FIG. 59. The difference being that the transmitter 6000 has a balanced modulator 6002 that utilizes a summing node 6004 to sum the I harmonically rich signal 5706 and the Q harmonically rich signal 5708 instead of the in-phase signal combiner 5906 that is used in the modulator 5902 of transmitter 5900. The 90 degree phase shift between the I and Q channels is implemented by delaying the Q clock signals using 90 degree delays 5904, as shown.

### *5.2.3 IQ Transmitters Configured for Carrier Insertion*

The transmitters 2920 (FIG. 29) and 3108 (FIG. 31A) have a balanced configuration that substantially eliminates any DC offset and results in minimal carrier insertion in the IQ output signal 2918. Minimal carrier insertion is generally desired for most applications because the carrier signal carries no information and reduces the overall transmitter efficiency. However, some applications require the received signal to have sufficient carrier energy for the receiver to extract the carrier for coherent demodulation. In support thereof, FIG. 32 illustrates a transmitter 3202 to provide any necessary carrier insertion by implementing a DC offset between the two sets of sampling UFT modules.

Transmitter 3202 is similar to the transmitter 2920 with the exception that a modulator 3204 in transmitter 3202 is configured to accept two DC reference voltages so that the I channel modulator 2604a can be biased separately from the Q channel modulator 2604b. More specifically, modulator 3204 includes a terminal 3206 to accept a DC voltage reference 3207, and a terminal 3208 to accept a DC voltage reference 3209. Voltage 3207 biases the UFT modules 2624a and 2628a in the I channel modulator 2604a. Likewise, voltage 3209 biases the UFT modules 2624b and 2628b in the Q channel modulator 2604b. When voltage 3207 is different from voltage 3209, then a DC offset will appear between the I channel modulator 2604a and the Q channel modulator 2604b, which results in carrier insertion in the IQ harmonically rich signal 2912. The relative amplitude of the carrier frequency energy increases in proportion to the amount of DC offset.

FIG. 33 illustrates a transmitter 3302 that is a second embodiment of an IQ transmitter having two DC terminals to cause DC offset, and therefore carrier insertion. Transmitter 3302 is similar to transmitter 3202 except that the 90 degree phase shift between the I and Q channels is achieved by phase shifting the control signals, similar to that done in transmitter 3108. More specifically, delays 3304a and 3304b phase shift the control signals 2623 and 2627 for the Q channel modulator 2604b relative to those of the I channel modulator 2604a. As a result, the Q modulator 2604b samples the Q baseband signal 2904 with 90 degree delay relative to the sampling of the I baseband signal 2902 by the I channel modulator 2604a. Therefore, the Q harmonically rich signal 2911b is phase shifted by 90 degrees relative to the I harmonically rich signal, which is then combined by the in-phase combiner 3306.

### *5.3 Universal Transmitter and CDMA*

The universal transmitter 2920 (FIG. 29) and the universal transmitter 5700 (FIG. 57) can be used to up-convert every known useful analog and digital baseband waveform including but not limited to: AM, FM, PM, BPSK, QPSK, MSK, QAM, ODFM, multi-tone, and spread spectrum signals. For further illustration, FIG. 34A and FIG. 34B depict transmitter 2920 configured to up-convert the mentioned modulation waveforms. FIG.34A illustrates transmitter 2920 configured to up-convert non-complex waveform including AM and shaped BPSK. In FIG. 34A, these non-complex (and non-IQ) waveforms are received on the I terminal 3402, and the Q input 3404 is grounded since only a single channel is needed. FIG. 34B illustrates a transmitter 2920 that is configured to receive both I and Q inputs for the up-conversion of complex waveforms including QPSK, QAM, OFDM, GSM, and spread spectrum waveforms (including CDMA and frequency hopping). The transmitters in FIGs. 34A and 34B are presented for illustrative purposes, and are not limiting. Other embodiments are possible, as will be appreciated in view of the teachings herein.

CDMA is an input waveform that is of particular interest for communications applications. CDMA is the fastest growing digital cellular communications standard in many regions, and now is widely accepted as the foundation for the competing third generation (3G) wireless standard. CDMA is considered to be the among the most demanding of the current digital cellular standards in terms of RF performance requirements.

#### *5.3.1 IS-95 CDMA Specifications*

FIG. 35A and FIG. 35B illustrate the CDMA specifications for base station and mobile transmitters as required by the IS-95 standard. FIG. 35A illustrates a base station CDMA signal 3502 having a main lobe 3504 and sidelobes 3506a and 3506b. For base station transmissions, IS-95 requires that the sidelobes 3506a,b are at least 45 dB below the mainlobe 3504 (or 45dbc) at an offset frequency of 750 kHz, and 60dBc at an offset frequency of 1.98 MHZ. FIG. 35B illustrates similar requirements for a mobile CDMA signal 3508 having a main lobe 3510 and sidelobes 3512a and 3512b. For mobile transmissions, CDMA requires that the sidelobes 3512a,b are at least 42 dBc at a frequency offset of 885 kHz, and 54 dBc at a frequency offset 1.98 MHZ.

Rho is another well known performance parameter for CDMA . Rho is a figure-of merit that measures the amplitude and phase distortion of a CDMA signal that has been processed in some manner (e.g. amplified, up-converted, filtered, etc.) The maximum theoretical value for Rho is 1.0, which indicates no distortion during the processing of the CDMA signal. The IS-95 requirement for the baseband-to-RF interface is Rho= .912. As will be shown by the test results below, the transmitter 2920 (in FIG. 29) can up-convert a CDMA baseband signal and achieve Rho values of approximately Rho= 0.9967. Furthermore, the modulator 2910 in the transmitter 2920 achieves these results in standard CMOS (although the invention is not limited to this example implementation), without doing multiple up-conversions and IF filtering that is associated with conventional super-heterodyne configurations.

#### *5.3.2 Conventional CDMA Transmitter*

Before describing the CDMA implementation of transmitter 2920, it is useful to describe a conventional super-heterodyne approach that is used to meet the IS-95 specifications. FIG. 36 illustrates a conventional CDMA transmitter 3600 that up-converts an input signal 3602 to an output CDMA signal 3634. The conventional CDMA transmitter 3600 includes: a baseband processor 3604, a baseband filter 3608, a first mixer 3612, an amplifier 3616, a SAW filter 3620, a second mixer 3624, a power amplifier 3628, and a band-select filter 3632. The conventional CDMA transmitter operates as follows.

The baseband processor 3604 spreads the input signal 3602 with I and Q spreading codes to generate I signal 3606a and Q signal 3606b, which are consistent with CDMA IS-95 standards. The baseband filter 3608 filters the signals 3606 with the aim of reducing the sidelobes so as to meet the sidelobe specifications that were discussed in FIGs. 35A and 35B. Mixer 3612 up-converts the signal 3610 using a first LO signal 3613 to generate an IF signal 3614. IF amplifier 3616 amplifies the IF signal 3614 to generate IF signal 3618. SAW filter 3620 has a bandpass response that filters the IF signal 3618 to suppress any sidelobes caused by the non-linear operations of the mixer 3614. As is understood by those skilled in the arts, SAW filters provide significant signal suppression outside the passband, but are relatively expensive and large compared to other transmitter components. Furthermore, SAW filters are typically built on specialized materials that cannot be integrated onto a standard CMOS chip with other components. Mixer 3624 up-converts the signal 3622 using a second LO signal 3625 to generate RF signal 3626. Power amplifier 3628 amplifies RF signal 3626 to generate signal 3630. Band-select filter 3632 bandpass filters RF signal 3630 to suppress any unwanted harmonics in output signal 3634.

It is noted that transmitter 3602 up-converts the input signal 3602 using an IF chain 3636 that includes the first mixer 3612, the amplifier 3616, the SAW filter 3620, and the second mixer 3624. The IF chain 3636 up-converts the input signal to an IF frequency and does IF amplification and SAW filtering in order to meet the IS-95 sidelobe and figure-of merit specifications. This is done because conventional wisdom teaches that a CDMA baseband signal cannot be up-converted directly from baseband to RF, and still meet the IS-95 linearity requirements.

### *5.3.3 CDMA Transmitter Using the Present Invention*

For comparison, FIG. 37A illustrates an example CDMA transmitter 3700 according to embodiments of the present invention. The CDMA transmitter 3700 includes (it is noted that the invention is not limited to this example): the baseband processor 3604; the baseband filter 3608; the IQ modulator 2910 (from FIG. 29), the control signal generator 2642, the sub-harmonic oscillator 2646, the power amplifier 3628, and the filter 3632. In the example of FIG. 37A, the baseband processor 3604, baseband filter 3608, amplifier 3628, and the band-select filter 3632 are the same as that used in the conventional transmitter 3602 in FIG.36. The difference is that the IQ modulator 2910 in transmitter 3700 completely replaces the IF chain 3636 in the conventional transmitter 3602. This is possible because the modulator 2910 up-converts a CDMA signal directly from baseband-to-RF without any IF processing. The detailed operation of the CDMA transmitter 3700 is described with reference to the flowchart 7300 (FIG. 73) as follows.

In step 7302, the input baseband signal 3702 is received.

In step 7304, the CDMA baseband processor 3604 receives the input signal 3702 and spreads the input signal 3702 using I and Q spreading codes, to generate an I signal 3704a and a Q signal 3704b. As will be understood, the I spreading code and Q spreading codes can be different to improve isolation between the I and Q channels.

In step 7306, the baseband filter 3608 bandpass filters the I signal 3704a and the Q signal 3704b to generate filtered I signal 3706a and filtered Q signal 3706b. As mentioned above, baseband filtering is done to improve sidelobe suppression in the CDMA output signal.

FIGs. 37B- 37D illustrate the effect of the baseband filter 3608 on the I an Q inputs signals. FIG. 37B depicts multiple signal traces (over time) for the filtered I signal 3706a, and FIG. 37C depicts multiple signal traces for the filtered Q signal 3706b. As shown, the signals 3706a,b can be described as having an "eyelid" shape having a thickness 3715. The thickness 3715 reflects the steepness of passband roll off of the baseband filter 3608. In other words, a relatively thick eyelid in the time domain reflects a steep passband roll off in the frequency domain, and results in lower sidelobes for the output CDMA signal. However, there is a tradeoff, because as the eyelids become thicker, then there is a higher probability that channel noise will cause a logic error during decoding at the receiver. The voltage rails 3714 represent the +1/-1 logic states for the I and Q signals 3706, and correspond to the logic states in complex signal space that are shown in FIG. 37D.

In step 7308, the IQ modulator 2910 samples I and Q input signals 3706A, 3706B in a differential and balanced fashion according to sub-harmonic clock signals 2623 and 2627, to generate a harmonically rich signal 3708. FIG 37E illustrates the harmonically rich signal 3708 that includes multiple harmonic images 3716a-n that repeat at harmonics ofthe sampling frequency $1/T_S$. Each image 3716a-n is a spread spectrum signal that contains the necessary amplitude, frequency, and phase information to reconstruct the input baseband signal 3702.

In step 7310, the amplifier 3628 amplifies the harmonically rich signal 3708 to generate an amplified harmonically rich signal 3710.

Finally, the band-select filter 3632 selects the harmonic of interest from signal 3710, to generate an CDMA output signal 3712 that meets IS-95 CDMA specifications. This is represented by passband 3718 selecting harmonic image 3716b in FIG. 37E.

An advantage ofthe CDMA transmitter 3700 is in that the modulator 2910 up-converts a CDMA input signal directly from baseband to RF without any IF processing, and still meets the IS-95 sidelobe and figure-of-merit specifications. In other words, the modulator 2910 is sufficiently linear and efficient during the up-conversion process that no IF filtering or amplification is required to meet the IS-95 requirements. Therefore, the entire IF chain 3636 can be replaced by the modulator 2910, including the expensive SAW filter 3620. Since the SAW filter is eliminated, substantial portions of the transmitter 3702 can be integrated onto a single CMOS chip, for example, that uses standard CMOS process. More specifically, and for illustrative purposes only, the baseband processor 3604, the baseband filter 3608, the modulator 2910, the oscillator 2646,and the control signal generator 2642 can be integrated on a single CMOS chip, as illustrated by CMOS chip 3802 in FIG. 38, although the invention is not limited to this implementation example.

FIG. 37F illustrates a transmitter 3720 that is similar to transmitter 3700 (FIG. 37A) except that modulator 5701 replaces the modulator 2910. Transmitter 3700 operates similar to the transmitter 3700 and has all the same advantages of the transmitter 3700.

Other embodiments discussed or suggested herein can be used to implement other CDMA transmitters according to the invention.

### *5.3.4 CDMA Transmitter Measured Test Results*

As discussed above, the UFT-based modulator 2910 directly up-converts baseband CDMA signals to RF without any IF filtering, while maintaining the required figures-of merit for IS-95. The modulator 2910 has been extensively tested in order to specifically determine the performance parameters when up-converting CDMA signals. The test system and measurement results are discussed as follows.

FIG. 39 illustrates a test system 3900 that measures the performance of the modulator 2910 when up-converting CDMA baseband signals. The test system 3900 includes: a Hewlett Packerd (HP) generator E4433B, attenuators 3902a and 3902b, control signal generator 2642, UFT-based modulator 2910, amplifer/filter module 3904, cable/attenuator 3906, and HP 4406A test set. The HP generator E4433B generates I and Q CDMA baseband waveforms that meet the IS-95 test specifications. The waveforms are routed to the UFT-based modulator 2910 through the 8-dB attenuators 3902a and 3902b. The HP generator E4433B also generates the sub-harmonic clock signal 2645 that triggers the control signal generator 2642, where the sub-harmonic clock 2645 has a frequency of 279 MHZ. The modulator 2910 up-converts the I and Q baseband signals to generate a harmonic rich signal 3903 having multiple harmonic images that represent the input baseband signal and repeat at the sampling frequency. The amplifier/filter module 3904 selects and amplifies the 3rd harmonic (of the 279 MHZ clock signal) in the signal 3903 to generate the signal 3905 at 837 MHZ. The HP 4406A test set accepts the signal 3905 for analysis through the cable/attenuator 3906. The HP 4406A measures CDMA modulation attributes including: Rho, EVM, phase error, amplitude error, output power, carrier insertion, and ACPR. In addition, the signal is demodulated and Walsh code correlation parameters are analyzed. Both forward and reverse links have been characterized using pilot, access, and traffic channels. For further illustration, FIGs. 40-60Z display the measurement results for the RF spectrum 3905 based on various base station and mobile waveforms that are generated by the HP E443B generator.

FIGs. 40 and 41 summarize the performance parameters of the modulator 2910 as measured by the test set 3900 for base station and mobile station input waveforms, respectively. For the base station, table 4002 includes lists performance parameters that were measured at a base station middle frequency and includes: Rho, EVM, phase error, magnitude error, carrier insertion, and output power. It is noted that Rho= .997 for the base station middle frequency and exceeds the IS-95 requirement of Rho= 0.912. For the mobile station, FIG. 41 illustrates a table 4102 that lists performance parameters that were measured at low, middle, and high frequencies. It is noted that the Rho exceeds the IS-95 requirement (0.912) for each of the low, middle, high frequencies of the measured waveform.

FIG. 42 illustrates a base station constellation 4202 measured during a pilot channel test. A signal constellation plots the various logic combinations for the I and Q signals in complex signal space, and is the raw data for determining the performance parameters (including Rho) that are listed in Table 40. The performance parameters (in table 40) are also indicated beside the constellation measurement 4202 for convenience. Again, it is noted that Rho= 0.997 for this test. A value of 1 is perfect, and 0.912 is required by the IS-95 CDMA specification, although most manufactures strive for values greater than 0.94. This is a remarkable result since the modulator 2910 up-converts directly from baseband-to-RF without any IF filtering.

FIG. 43 illustrates a base station sampled constellation 4302, and depicts the tight constellation samples that are associated with FIG. 42. The symmetry and sample scatter compactness are illustrative of the superior performance of the modulator 2910

FIG. 44 illustrates a mobile station constellation 4402 measured during an access channel test. As shown, Rho= 0.997 for the mobile station waveforms. Therefore, the modulator 2910 operates very well with conventional and offset shaped QPSK modulation schemes.

FIG. 45 illustrates a mobile station sampled constellation 4502. Constellation 4502 illustrates excellent symmetry for the constellation sample scatter diagram.

FIG. 46 illustrates a base station constellation 4602 using only the HP test equipment. The modulator 2910 has been removed so that the base station signal travels only through the cables that connect the HP signal generator E4433B to the HP 4406A test set. Therefore, constellation 4602 measures signal distortion caused by the test set components (including the cables and the attenuators). It is noted that Rho=0.9994 for this measurement using base station waveforms. Therefore, at least part of the minimal signal distortion that is indicated in FIGs. 42 and 43 is caused by the test set components, as would be expected by those skilled in the relevant arts.

FIG. 47 illustrates a mobile station constellation 4702 using only the HP test equipment. As in FIG. 46, the modulator 2910 has been removed so that the mobile station signal travels only through the cables that connect the HP signal generator E4433B to the HP 4406A test set. Therefore, constellation 4602 measures signal distortion caused by the test setcomponents (including the cables and the attenuators). It is noted that Rho=0.9991 for this measurement using mobile station waveforms. Therefore, at least part of the signal distortion indicated in FIGs. 44 and 45 is caused by the test set components, as would be expected.

FIG. 48 illustrates a frequency spectrum 4802 of the signal 3905 with a base station input waveform. The frequency spectrum 4802 has a main lobe and two sidelobes, as expected for a CDMA spread spectrum signal. The adjacent channel power ratio (ACPR) measures the spectral energy at a particular frequency of the side lobes relative to the main lobe. As shown, the frequency spectrum 4802 has an ACPR= -48.34 dBc and -62.18 dBc at offset frequencies of 750 KHz and 1.98 MHZ, respectively. The IS-95 ACPR requirement for a base station waveform is -45dBc and -60 dBc maximum, at the offset frequencies of 750 kHz and 1.98 MHZ, respectively. Therefore, the modulator 2910 has more than 3dB and 2 dB of margin over the IS-95 requirements for the 750 kHz and 1.98 MHZ offsets, respectively.

FIG. 49 illustrates a histogram 4902 that corresponds to the spectrum plot in FIG. 48. The histogram 4902 illustrates the distribution of the spectral energy in the signal 3905 for a base station waveform.

FIG. 50 illustrates a frequency spectrum 5002 of the signal 3905 with a mobile station input waveform. As shown, the ACPR measurement is -52.62 dBc and -60.96 dBc for frequency offsets of 885 kHz and 1.98 MHZ, respectively. The IS-95 ACPR requirement for a mobile station waveform is approximately -42dBc and -54 dBc, respectively. Therefore, the modulator 2910 has over 10 dB and 6 dB of margin above the IS-95 requirements for the 885 kHz and 1.98 MHZ frequency offsets, respectively.

FIG. 51 illustrates a histogram 5102 that corresponds to the mobile station spectrum plot in FIG.50. The histogram 5102 illustrates the distribution of the spectral energy in the signal 3905 for a mobile station waveform.

FIG. 52A illustrates a histogram 5202 for crosstalk vs. CDMA channel with a base station input waveform. More specifically, the HP E4406A was utilized as a receiver to analyze the orthogonality of codes superimposed on the base station modulated spectrum. The HP E4406A demodulated the signal provided by the modulator/transmitter and determined the crosstalk to non-active CDMA channels. The pilot channel is in slot '0' and is the active code for this test. All non-active codes are suppressed in the demodulation process by greater than 40 dB. The IS-95 requirement is 27 dB of suppression so that there is over 13 dB of margin. This implies that the modulator 2910 has excellent phase and amplitude linearity.

In additions to the measurements described above, measurements were also conducted to obtain the timing and phase delays associated with a base station transmit signal composed of pilot and active channels. Delta measurements were extracted with the pilot signal as a reference. The delay and phase are -5.7 ns (absolute) and 7.5 milli radians, worst case. The standard requires less than 50. ns (absolute) and 50 milli radians, which the modulator 2910 exceeded with a large margin.

The performance sensitivity of modulator 2910 was also measured over multiple parameter variations. More specifically, the performance sensitivity was measured vs. IQ input signal level variation and LO signal level variation, for both base station and mobile station modulation schemes. (LO signal level is the signal level of the subharmonic clock 2645 in FIG. 39.) FIGs. 52B-O depict performance sensitivity of the modulator 2910 using the base station modulation scheme, and FIGs. 52P-Z depict performance sensitivity using the mobile station modulation scheme. These plots reveal that the modulator 2910 is expected to enable good production yields since there is a large acceptable operating performance range for I/Q and LO peak to peak voltage inputs. The plots are described fiuther as follows.

FIG. 52B illustrates Rho vs. shaped IQ input signal level using base station modulation.

FIG. 52C illustrates transmitted channel power vs. shaped IQ input signal level using base station modulation.

FIG. 52D illustrates ACPR vs. shaped IQ Input signal level using base station modulation.

FIG. 52E illustrates EVM and Magnitude error vs shaped IQ input level using base station modulation.

FIG. 52F illustrates carrier feed thru vs. shaped IQ input signal level using base station modulation.

FIG. 52G illustrates Rho vs. LO signal level using base station modulation. FIG. 52H illustrates transmitted channel power vs. LO signal level using base station modulation.

FIG. 52I illustrates ACPR vs. LO signal level using base station modulation. FIG. 52J illustrates EVM and magnitude error vs LO signal level using base station modulation.

FIG. 52K illustrates carrier feed thru vs. LO signal level using base station modulation.

FIG. 52L illustrates carrier feed thru vs IQ input level over a wide range using base station modulation.

FIG. 52M illustrates ACPR vs. shaped IQ input signal level using base station modulation.

FIG. 52N illustrates Rho vs. shaped IQ input signal level using base station modulation.

FIG. 52O illustrates EVM, magnitude error, and phase error vs. shaped IQ input signal level using base station modulation.

FIG. 52P illustrates Rho vs. shaped IQ input signal level using mobile station modulation.

FIG. 52Q illustrates transmitted channel power vs. shaped IQ input signal level using mobile station modulation.

FIG. 52R illustrates ACPR vs. shaped IQ Input signal level using mobile station modulation.

FIG. 52S illustrates EVM, magnitude error, and phase error vs. shaped IQ input level using mobile station modulation.

FIG. 52T illustrates carrier feed thru vs. shaped I Q input signal level using mobile station modulation.

FIG. 52U illustrates Rho vs. LO signal level using mobile station modulation.

FIG. 52V illustrates transmitted channel power vs. LO signal level using mobile station modulation.

FIG. 52W illustrates ACPR vs. LO signal level using mobile station modulation.

FIG. 52X illustrates EVM and magnitude error vs. LO signal level using mobile station modulation.

FIG. 52Y illustrates carrier feed thru vs. LO signal level using mobile station modulation.

FIG. 52Z illustrates an approximate power budget for a CDMA modulator based on the modulator 2910.

Figures 52B-Z illustrate that the UFT-based complex modulator 2910 comfortably exceeds the IS-95 transmitter performance requirements for both mobile and base station modulations, even with signal level variations. Testing indicates that Rho as well as carrier feed through and ACPR are not overly sensitive to variations in I/Q levels and LO levels. Estimated power consumption for the modulator 2910 is lower than equivalent two-state superheterodyne architecture. This means that a practical UFT based CDMA transmitter can be implemented in bulk CMOS and efficiently produced in volume.

The UFT architecture achieves the highest linearity per milliwatt of power consumed of any radio technology of which the inventors are aware. This efficiency comes without a performance penalty, and due to the inherent linearity of the UFT technology, several important performance parameters may actually be improved when compared to traditional transmitter techniques.

Since the UFT technology can be implemented in standard CMOS, new system partitioning options are available that have not existed before. As an example, since the entire UFT-based modulator can be implemented in CMOS, it is plausible that the modulator and other transmitter functions can be integrated with the digital baseband processor leaving only a few external components such as the final bandpass filter and the power amplifier. In addition to the UFT delivering the required linearity and dynamic range performance, the technology also has a high level of immunity to digital noise that would be found on the same substrate when integrated with other digital circuitry. This is a significant step towards enabling a complete wireless system-on-chip solution.

It is noted that the test setup, procedures, and results discussed above and shown in the figures were provided for illustrative purposes only, and do not limit the invention to any particular embodiment, implementation or application.

### *6.0 Integrated Up-conversion and Spreading of a Baseband Signal*

Previous sections focused on up-converting a spread spectrum signal directly from baseband-to-RF, without performing any IF processing. In these embodiments, the baseband signal was already a spread spectrum signal prior to up-conversion. The following discussion focuses on embodiments that perform the spreading function and the frequency translation function in a simultaneously and in an integrated manner. One type of spreading code is Code Division Multiple Access (or CDMA), although the invention is not limited to this. The present invention can be implemented in CDMA, and other spread spectrum systems as will be understood by those skilled in the arts based on the teachings herein.

### *6.1 Integrated Up-Conversion and Spreading Using an Amplitude Shaper*

FIG. 53A illustrates a spread spectrum transmitter 5300 that is based on the UFT-based modulator 2604 that was discussed in FIG. 26A. Spread spectrum transmitter 5300 performs simultaneous up-conversion and spreading of an input baseband signal 5302 to generate an output signal 5324. As will shown, the spreading is accomplished by placing the spreading code on the control signals that operate the UFT modules in the modulator 2604 so that the spreading and up-conversion are accomplished in an integrated manner. In order to limit sidelobe spectral growth in the output signal 5324, the amplitude of the input baseband signal 5302 is shaped so as to correspond with the spreading code. The operation of spread spectrum transmitter 5300 is described in detail as follows with reference to flowchart 6700 that is shown in FIG 67. The order of the steps in flowchart 6700 are not limiting and may be rearranged as will be understood by those skilled in the arts. (This is generally true of all flowcharts discussed herein).

In step 6701, the spread spectrum transmitter 5300 receives the input baseband signal 5302.

In step 6702, the oscillator 2646 generates the clock signal 2645. As described earlier, the clock signal 2645 is in embodiments a sub-harmonic of the output signal 5324. Furthermore, in embodiments of the invention, the clock signal 2645 is a periodic square wave or sinusoidal clock signal.

In step 6704, a spreading code generator 5314 generates a spreading code 5316. In embodiments of the invention, the spreading code 5316 is a PN code, or any other type of spreading code that is useful for generating spread spectrum signals.

In step 6706, the multiplier 5318 modulates the clock signal 2645 with the spreading code 5316 to generate spread clock signal 5320. As such, the spread clock signal 5320 carries the spreading code 5316.

In step 6708, the control signal generator 2642 receives the spread clock signal 5320, and generates control signals 5321 and 5322 that operate the UFT modules in the modulator 2604. The control signals 5321 and 5322 are similar to clock signals 2623 and 2627 that were discussed in FIG. 26. In other words, the clock signals 5321 and 5322 include a plurality of pulses having a pulse width $T_A$ that is established to improve energy transfer to a desired harmonic in the resulting harmonically rich signal. Additionally, the control signals 5321 and 5322 are phase shifted with respect to each other by approximately 180 degrees (although the invention is not limited to this example), as were the control signals 2623 and 2627. However, the control signals 5321 and 5322 are modulated with (and carry) the spreading code 5316 because they were generated-from spread clock signal 5320.

In step 6710, the amplitude shaper 5304 receives the input baseband signal 5302 and shapes the amplitude so that it corresponds with the spreading code 5316 that is generated by the code generator 5314, resulting in a shaped input signal 5306. This is achieved by feeding the spreading code 5316 back to the amplitude shaper 5304 and smoothing the amplitude of the input baseband signal 5302, accordingly.

FIG. 53B illustrates the resulting shaped input signal 5306 and the corresponding spreading code 5316. The amplitude of the input signal 5302 is shaped such that it is smooth and so that it has zero crossings that are in time synchronization with the spreading code 5316. By smoothing input signal amplitude, high frequency components are removed from the input signal prior to sampling, which results lower sidelobe energy in the harmonic images produced during sampling. Implementation of amplitude shaper 5304 will be apparent to persons skilled in the art base on the functional teachings combined herein.

In step 6712, the low pass filter 5308 filters the shaped input signal 5306 to remove any unwanted high frequency components, resulting in a filtered signal 5310.

In step 6714, the modulator 2604 samples the signal 5310 in a balanced and differential manner according to the control signals 5320 and 5322, to generate a harmonically rich signal 5312. As discussed in reference to FIG. 26, the control signals 5320 and 5322 trigger the controlled switches in the modulator 2604, resulting in multiple harmonic images of the baseband signal 5302 in the harmonically rich signal 5312. Since the control signals carry the spreading code 5316, the modulator 2604 up-converts and spreads the filtered signal 5310 in an integrated manner during the sampling process. As such, the harmonic images in the harmonically rich signal 5312 are spread spectrum signals. FIG. 53C illustrates the harmonically rich signal 5312 that includes multiple harmonic images.5320a-n that repeat at harmonics of the sampling frequency $1/T_S$. Each image 5320a-n is a spread spectrum signal that contains the necessary amplitude and frequency information to reconstruct the input baseband signal 5302.

In step 6716, the optional filter 2606 selects a desired harmonic (or harmonics) from the harmonically rich signal 5312. This is presented by the passband 5322 selecting the spread harmonic 5320c in FIG. 53C.

In step 6718, the optional amplifier 2608 amplifies the desired harmonic (or harmonics) for transmission.

As mentioned above, an advantage of the spread spectrum transmitter 5300 is that the spreading and up-conversion is accomplished in a simultaneous and integrated manner. This is a result of modulating the control signals that operate the UFT modules in the balanced modulator 2604 with the spreading code prior to sampling of the baseband signal. Furthermore, by shaping the amplitude of the baseband signal prior to sampling, the sidelobe energy in the spread spectrum harmonics is minimized. As discussed above, minimal sidelobe energy is desirable in order to meet the sidelobe standards of the CDMA IS-95 standard (see FIGs.43A and 43B).

FIG. 61 illustrates an IQ spread spectrum modulator 6100 that is based on the spread spectrum transmitter 5300. Spread spectrum modulator 6100 performs simultaneous up-conversion and spreading of an I baseband signal 6102 and a Q baseband signal 6118 to generate an output signal 6116 that carries both the I and Q baseband information. The operation of the modulator 6100 is described in detail with reference to the flowchart 6800 that is shown in FIGs. 68A and 68B. The steps in flowchart 6800 are not limiting and may be rearranged as will be understood by those skilled in the arts.

In step 6801, the IQ modulator 6100 receives the I data signal 6102 and the Q data signal 6118.

In step 6802, the oscillator 2646 generates the clock signal 2645. As described earlier, the clock signal 2645 is in embodiments a sub-harmonic of the output signal 6116. Furthermore, in embodiments of the invention, the clock signal 2645 is a periodic square wave or sinusoidal clock signal.

In step 6804, an I spreading code generator 6140 generates an I spreading code 6144 for the I channel. Likewise, a Q spreading code generator 6138 generates a Q spreading code 6142 for the Q channel. In embodiments of the invention, the spreading codes are PN codes, or any other type of spreading code that is useful for generating spread spectrum signals. In embodiments of the invention, the I spreading code and Q spreading code can be the same spreading code. Alternatively, the I and Q spreading codes can be different to improve isolation between the I and Q channels, as will be understood by those skilled in the arts.

In step 6806, the multiplier 5318a modulates the clock signal 2645 with the I spreading code 6144 to generate a spread clock signal 6136. Likewise, the multiplier 5318b modulates the clock signal 2645 with the Q spreading code 6142 to generate a spread clock signal 6134.

In step 6808, the control signal generator 2642a receives the I clock signal 6136 and generates control signals 6130 and 6132 that operate the UFT modules in the modulator 2604a. The controls signals 6130 and 6132 are similar to clock signals 2623 and 2627 that were discussed in FIG. 26. The difference being that signals 6130 and 6132 are modulated with (and carry) the I spreading code 6144. Likewise, the control signal generator 2642b receives the Q clock signal 6134 and generates control signals 6126 and 6128 that operate the UFT modules in the modulator 2604b. In step 6810, the amplitude shaper 5304a receives the I data signal 6102 and the shapes the amplitude so that it corresponds with the spreading code 6144, resulting in I shaped data signal 6104. This is achieved by feeding the spreading code 6144 back to the amplitude shaper 5304a.. The amplitude shaper then shapes the amplitude of the input baseband signal 6102 to correspond to the spreading code 6144, as described for spread spectrum transmitter 5300. More specifically, the amplitude of the input signal 6102 is shaped such that it is smooth and so that it has zero crossings that are in time synchronization with the I spreading code 6144. Likewise, the amplitude shaper 5304b receives the Q data signal 6118 and shapes amplitude of the Q data signal 6118 so that it corresponds with the Q spreading code 6142, resulting in Q shaped data signal 6120.

In step 6812, the low pass filter 5308a filters the I shaped data signal 6104 to remove any unwanted high frequency components, resulting in a I filtered signal 6106. Likewise, the low pass filter 5308b filters the Q shaped data signal 6120, resulting in Q filtered signal 6122.

In step 6814, the modulator 2604a samples the I filtered signal 6106 in a balanced and differential manner according to the control signals 6130 and 6132, to generate a harmonically rich signal 6108. As discussed in reference to FIG. 26, the control signals 6130 and 6132 trigger the controlled switches in the modulator 2604a, resulting in multiple harmonic images in the harmonically rich signal 6108, where each image contains the I baseband information. Since the control signals 6130 and 6132 also carry the I spreading code 6144, the modulator 2604a up-converts and spreads the filtered signal 6106 in an integrated manner during the sampling process. As such, the harmonic images in the harmonically rich signal 6108 are spread spectrum signals.

In step 6816, the modulator 2604b samples the Q filtered signal 6122 in a balanced and differential manner according to the control signals 6126 and 6128, to generate a harmonically rich signal 6124. The control signals 6126 and 6128 trigger the controlled switches in the modulator 2604b, resulting in multiple harmonic images in the harmonically rich signal 6124, where each image contains the Q baseband information. As with modulator 2604a, the control signals 6126 and 6128 carry the Q spreading code 6142 so that the modulator 2604b up-converts and spreads the filtered signal 6122 in an integrated manner during the sampling process. In other words, the harmonic images in the harmonically rich signal 6124 are also spread spectrum signals.

In step 6818, a 90 signal combiner 6146 combines the I harmonically rich signal 6108 and the Q harmonically rich signal 6124, to generate the IQ harmonically rich signal 6148. The IQ harmonically rich signal 6148 contains multiple harmonic images, where each images contains the spread I data and the spread Q data. The 90 degree combiner phase shifts the Q signal 6124 relative to the I signal 6108 so that no increase in spectrum width is needed for the IQ signal 6148, when compared the I signal or the Q signal.

In step 6820, the optional bandpass filter 2606 select the harmonic (or harmonics) of interest from the harmonically rich signal 6148, to generate signal 6114.

In step 6222, the optional amplifier 2608 amplifies the desired harmonic 6114 for transmission.

### *6.2 Integrated Up-Conversion and Spreading Using a Smoothing Varying Clock Signal*

FIG. 54A illustrates a spread spectrum transmitter 5400 that is a second embodiment of balanced UFT modules that perform up-conversion and spreading simultaneously. More specifically, the spread spectrum transmitter 5400 does simultaneous up-conversion and spreading of an I data signal 5402a and a Q data signal 5402b to generate an IQ output signal 5428. Similar to modulator 6100, transmitter 5400 modulates the clock signal that controls the UFT modules with the spreading codes to spread the input I and Q signals during up-conversion. However, the transmitter 5400 modulates the clock signal by smoothly varying the instantaneous frequency or phase of a voltage controlled oscillator (VCO) with the spreading code. The transmitter 5400 is described in detail as follows with reference to a flowchart 6900 that is shown in FIGs. 69A and 69B.

In step 6901, the transmitter 5400 receives the I baseband signal 5402a and the Q baseband signal 5402b.

In step 6902, a code generator 5423 generates a spreading code 5422. In embodiments of the invention, the spreading code 5422 is a PN code or any other type off useful code for spread spectrum systems. Additionally, in embodiments of the invention, there are separate spreading codes for the I and Q channels.

In step 6904, a clock driver circuit 5421generates a clock driver signal 5420 that is phase modulated according to a spreading code 5422. FIG. 54B illustrates the clock driver signal 5420 as series of pulses, where the instantaneous frequency (or phase) of the pulses is determined by the spreading code 5422, as shown. In embodiments of the invention, the phase of the pulses in the clock driver 5420 is varied smoothly in correlation with the spreading code 5422.

In step 6906, a voltage controlled oscillator 5418 generates a clock signal 5419 that has a frequency that varies according to a clock driver signal 5420. As mentioned above, the phase of the pulses in the clock driver 5420 is varied smoothly in correlation with the spreading code 5422 in embodiments of the invention. Since the clock driver 5420 controls the oscillator 5418, the frequency of the clock signal 5419 varies smoothly as a function of the PN code 5422. By smoothly varying the frequency of the clock signal 5419, the sidelobe growth in the spread spectrum images is minimized during the sampling process.

In step 6908, the pulse generator 2644 generates a control signal 5415 based on the clock signal 5419 that is similar to either one the controls signals 2623 or 2627 (in FIGs. 27A and 27B). The control signal 5415 carries the spreading code 5422 via the clock signal 5419. In embodiments of the invention, the pulse width ($T_A$) of the control signal 5415 is established to enhance or optimize energy transfer to specific harmonics in the harmonically rich signal 5428 at the output. For the Q channel, a phase shifter 5414 shifts the phase of the control signal 5415 by 90 degrees to implement the desired quadrature phase shift between the I and Q channels, resulting in a control signal 5413.

In step 6910, a low pass filter (LPF) 5406a filters the I data signal 5402a to remove any unwanted high frequency components, resulting in an I signal 5407a Likewise, a LPF 5406b filters the Q data signal 5402b to remove any unwanted high frequency components, to generate the Q signal 5407b.

In step 6912, a UFT module 5408a samples the I data signal 5407a according to the control signal 5415 to generate a harmonically rich signal 5409a. The harmonically rich signal 5409a contains multiple spread spectrum harmonic images that repeat at harmonics of the sampling frequency Similar to transmitter 5300, the harmonic images in signal 5409a carry the I baseband information, and are spread spectrum due to the spreading code on the control signal 5415.

In step 6914, a UFT module 5408b samples the Q data signal 5407b according to the control signal 5413 to generate harmonically rich signal 5409b. The harmonically rich signal 5409b contains multiple spread spectrum harmonic images that repeat at harmonics of the sampling frequency. The harmonic images in signal 5409a carry the Q baseband information, and are spread spectrum due to the spreading code on the control signal 5413.

In step 6916, a signal combiner 5410 combines the harmonically rich signal 5409a with the harmonically rich signal 5409b to generate an IQ harmonically rich signal 5412. The harmonically rich signal 5412 carries multiple harmonic images, where each image carries the spread I data and the spread Q data.

In step 6918, the optional bandpass filter 5424 selects a harmonic (or harmonics) of interest for transmission, to generate the IQ output signal 5428.

FIG. 54C illustrates a transmitter 5430 that is similar to the transmitter 5400 except that the UFT modules are replaced by balanced UFT modulators 2604 that were described in FIG. 26. Also, the pulse generator is replaced by the control signal generator 2642 to generate the necessary control signals to operate the UFT modules in the balanced modulators. By replacing the UFF modules with balanced UFT modulators, sidelobe suppression can be improved.

### *7 Shunt Transceiver Embodiments Using UFT Modules*

In this section, example transceiver embodiments are presented that utilize UFT modules in a shunt configuration for balanced up-conversion and balanced down-conversion. More specifically, a signal channel transceiver embodiment is presented that incorporates the balanced transmitter 5600 (FIG. 56A) and the receiver 7091 (FIG. 70Q). Additionally, an IQ transceiver embodiment is presented that incorporate balanced IQ transmitter 5700 (FIG. 57) and IQ receiver 7000 (FIG. 70A).

These transceiver embodiments incorporate the advantages described above for the balanced transmitter 5600 and the balanced receiver 7091. More specifically, during up-conversion, an input baseband signal is up-converted in a balanced and differential fashion, so as to minimize carrier insertion and unwanted spectral growth. Additionally, during down-conversion, an input RF input signal is down-converted so that DC offset and re-radiation is reduced or eliminated. Additionally, since both transmitter and receiver utilize UFT modules for frequency translation, integration and cost saving can be realized.

These embodiments are described herein for purposes of illustration, and not limitation. The invention is not limited to these embodiments. Alternate embodiments (including equivalents, extensions, variations, deviations, etc., ofthe embodiments described herein) will be apparent to persons skilled in the relevant art(s) based on the teachings contained herein. The invention is intended and adapted to include such alternate embodiments.

FIG. 13 illustrates a transceiver 7100 according to embodiments of the present invention. Transceiver 7100 includes the single channel receiver 7091, the balanced transmitter 5600, a diplexer 7108, and an antenna 7112.

Transceiver 7100 up-converts a baseband input signal 7110 using the balanced transmitter 5600 resulting in an output RF signal 7106 that is radiated by the antenna 7112. Additionally, the transceiver 7100 also down-converts a received RF input signal 7104 using the receiver 7091 to output baseband signal 7102. The diplexer 7108 separates the transmit signal 7106 from the receive signal 7104 so that the same antenna 7112 can be used for both transmit and receive operations. The operation of transmitter 5600 is described above in section 7.1.3, to which the reader is referred for greater detail.

During up-conversion, the transmitter 5600 shunts the input baseband signal 7110 to ground in a differential and balanced fashion according to the control signals 2623 and 2627, resulting in the harmonically rich signal 7114. The harmonically rich signal 7114 includes multiple harmonic images that repeat at harmonics of the sampling frequency of the control signals, where each harmonic image contains the necessary amplitude, frequency, and phase information to reconstruct the baseband signal 7110. The optional filter 2606 can be included to select a desired harmonic from the harmonically rich signal 7114. The optional amplifier 2608 can be included to amplify the desired harmonic resulting in the output RF signal 7106, which is transmitted by antenna 7112 after the diplexer 7108. A detailed, description of the transmitter 5600 is included in section 7.1.3, to which the reader is referred for further details.

During down-conversion, the receiver 7091 alternately shunts the received RF signal 7104 to ground according to control signals 7093 and 7095, resulting in the down-converted output signal 7102. A detailed description of receiver 7091 is included in sections 9.1 and 9.2, to which the reader is referred for further details.

FIG. 14 illustrates IQ transceiver 7200 according to embodiments of the present invention. IQ transceiver 7200 includes the IQ receiver 7000, the IQ transmitter 5700, a diplexer 7214, and an antenna 7216. Transceiver 7200 up-converts an I baseband signal 7206 and a Q baseband signal 7208 using the IQ transmitter 5700 (FIG. 57) to generate an IQ RF output signal 7212. A detailed description of the IQ transmitter 5700 is included in section 7.2.2, to which the reader is referred for further details. Additionally, the transceiver 7200 also down-converts a received RF signal 7210 using the IQ Receiver 7000, resulting in I baseband output signal 7202 and a Q baseband output signal 7204. A detailed description of the IQ receiver 7000 is included in section 7.1, to which the reader is referred for further details.

### *8. Conclusion*

Example implementations of the methods, systems and components of the invention have been described herein. As noted elsewhere, these example implementations have been described for illustrative purposes only, and are not limiting. Other implementation embodiments are possible and covered by the invention, such as but not limited to software and software/hardware implementations of the systems and components of the invention. Such implementation embodiments will be apparent to persons skilled in the relevant art(s) based on the teachings contained herein.

While various application embodiments of the present invention have been described above, it should be understood that they have been presented by way of example only, and not limitation. Thus, the breadth and scope of the present invention should not be limited by any of the above-described exemplary embodiments.

## Claims

**1.** A method for up-converting a baseband signal, comprising the steps of:

(1) receiving the baseband signal (2610; 5310; 5602);
(2) converting said baseband signal (2610; 5602) into a differential baseband signal having a first differential baseband component (2614; 5606) and a second differential baseband component (2616; 5608);
(3) sampling said first differential baseband component (2614; 5606) according to a first control signal (2623) to generate a first harmonically rich signal (2630; 5614), and sampling said second differential baseband component (2616; 5608) according to a second control signal (2627) to generate a second harmonically rich signal (2634; 5626), wherein said second control signal (2627) is phase shifted relative to said first control signal (2623) as measured by a clock signal (2645);
(4) combining said first harmonically rich signal (2630; 5614) and said second harmonically rich signal (2634; 5626) to generate a plurality of harmonic images; and
(5) adding a reference voltage (2613) to said first differential baseband component (2614) and said second differential baseband component (2616) prior to step (3), and thereby reducing any DC offset voltages during sampling of said first differential baseband component (2614) and said second differential baseband component (2616).

**2.** The method of claim 1, further comprising the steps of:

(6) selecting a desired harmonic image from said harmonic images that are generated in step (4); and
(7) transmitting said desired harmonic image over a communications medium.

**3.** The method of claim 1, wherein said step (3) of sampling comprises the steps of:

(i) generating said first control signal (2623; 5321) comprising a first plurality of pulses and said second control signal (2627; 5322) comprising a second plurality of pulses; and
(ii) operating a first switch (2648) according to said first control signal (2623; 5321) to periodically sample said first differential baseband component (2614), and operating a second switch (2650) according to said second control signal (2627; 5322) to periodically sample said second differential baseband component (2616).

**4.** The method of claim 3, wherein said step (i) comprises the step of widening pulse widths ($T_A$) of said first control signal (2623; 5321) and said second control signal (2627; 5322) by a non-negligible amount that tends away from zero time duration to extend the time that said first switch (2648) and said second switch (2650) is closed in step (ii).

**5.** The method of claim 4, wherein said step of widening pulse widths comprises the step of widening pulse widths ($T_A$) for said first and second control signals (2623, 2627; 5321, 5322) to a non-zero fraction of a period of the desired harmonic image.

**6.** The method of claim. 4, wherein said step of widening pulse widths comprises the step of widening pulse widths ($T_A$) for said first and second control signals (2623, 2627) to approximately one-half of a period of the desired harmonic image (2206b-d).

**7.** The method of any preceding claim, wherein said first control signal (2623; 5321) and said second control signal (2627; 5322) have a period of $T_S$ so that said harmonics images repeat at $1/T_S$ in frequency, and wherein said second control signal (2627; 5322) is phase-shifted relative to said first control signal (2623; 5321) by approximately 180 degrees.

**8.** The method of any preceding claim, wherein said pulse widths ($T_A$) of said first control signal (2623; 5321) and said second control signal (2627; 5322) are a non-zero fraction of a period of the desired harmonic image.

**9.** The method of any preceding claim, wherein said pulse widths ($T_A$) of said first control signal (2623) and said second control signal (2627) are approximately one-half of a period of said desired harmonic image, and thereby improve energy transfer to the desired harmonic image.

**10.** The method of any preceding claim, wherein said harmonic images have a relative amplitude $Amp_n$ represented by the following equation:

$$Amp_n = \left[ \frac{4\sin\left(\frac{n\pi T_A}{T_s}\right)\cdot\sin\left(\frac{n\pi}{2}\right)}{n\pi} \right]$$

where:

$T_S$ = period of said first and second control signals (2623, 2627)
$T_A$ = pulse width of said first and second control signals (2623, 2627)
n = harmonic number of said harmonic image whose amplitude is determined.

**11.** The method of any preceding claim, wherein said harmonic images have an amplitude that is based on $n^*(T_A/T_S)$, where $T_S$ is a period of said first and second control signals (2623, 2627), $T_A$ is a pulse width of pulses in said first and second control signals (2623, 2627), and n is a harmonic number of said harmonic image.

**12.** Apparatus for up-converting a baseband signal, comprising:

means (2612; 5604) for inverting said baseband signal (2610; 5310; 5602), resulting in an inverted baseband signal (2616; 5608);
first sampling means (2624; 5616) for sampling said baseband signal (2610; 5310; 5602) according to a first control signal (2623), resulting in a first harmonically rich signal (2630; 5614);
second sampling means (2628; 5622) for sampling said inverted baseband signal (2616; 5608) according to a second control signal (2627), resulting in a second harmonically rich signal (2634; 5626);
means (2632; 5632) for combining said first harmonically rich signal (2630; 5614) and said second harmonically rich signal (2634; 5626), resulting in a third harmonically rich signal (2633; 5634) containing multiple harmonic images that are each representative of said baseband signal (2610; 5602); and
means (2611, 2618, 2619) for limiting offset voltages between said first sampling means (2624) and said second sampling means (2628);

wherein said first and second control signals (2623, 2627; 5321, 5322) comprise pulses having an associated pulse width $T_A$;
wherein said means for limiting comprises a means (2611, 2618, 2619) for distributing a reference voltage (2613) to said first sampling means (2624) and said second sampling means (2628); and
wherein said means for distributing comprises a means (2618, 2619) for summing said reference voltage (2613) with said baseband signal (2614) and said inverted baseband signal (2616).

**13.** The apparatus of claim 12, wherein said first and second control signals. (2623, 2627; 5321, 5322) have a period of $T_S$ so that said harmonic images repeat at multiples of $1/T_S$.

**14.** The apparatus of claim 12 or 13, wherein said second control signal (2627; 5322) is phase shifted relative to said first control signal (2623; 5321).

**15.** The apparatus of any one of claims 12 to 14, wherein said pulse width $T_A$ is approximately one-half a period associated with the desired harmonic image.

**16.** The apparatus of any one of claims 12 to 15, wherein a relative amplitude $Amp_n$ of said harmonic images is represented by the following equation:

$$\mathrm{Amp}_n = \left[\frac{4\sin\left(\frac{n\pi T_A}{T_s}\right)\cdot\sin\left(\frac{n\pi}{2}\right)}{n\pi}\right]$$

wherein:

$T_S$ = period of said first and second control signals (2623, 2627);
$T_A$ = pulse width of said first and second control signals (2623, 2627); and
n = harmonic number of said harmonic image whose amplitude is determined.

**17.** The apparatus of any one of claims 12 to 16, further comprising means (2606) for selecting the desired harmonic image from said third harmonically rich signal (2630; 5634).

**18.** The apparatus of claim 17, wherein the means for selecting comprises a bandpass filter (2606) coupled to an output of the means for combining (2632; 5632).

**19.** The apparatus of claim 12, wherein said first sampling means comprises a means (5618) for shunting said baseband signal (5602) to ground according to said first control signal (2623), and wherein said second sampling means comprises a means (5624) for shunting said inverted baseband signal (5608) to ground, according to said second control signal (2627).

**20.** The apparatus of any one of claims 12 to 18, wherein said means for inverting includes a buffer/inverter (2612) for receiving said baseband signal (2610) and having a first output passing said baseband signal (2614) and a second output generating said inverted baseband signal (2616); said system further including:

a terminal (2611) for receiving a reference voltage (2613);
a first summer (2618), coupled to said first output of said buffer/inverter (2612) and said terminal (2611), said first summer (2618) summing said reference voltage (2613) with said inverted baseband signal (2614); and
a second summer (2619), coupled to said second output of said buffer/inventer (2612) and said terminal (2611), said second summer (2619) summing said reference voltage (2613) with said inverted baseband signal (2616);

wherein said first sampling means (2624) receives said baseband signal summed with said reference signal (2620) and said second sampling means (2628) receives said inverted baseband signal summed with said reference signal (2622).

**21.** The apparatus of claim 20, wherein:

said first sampling means (2624) includes a first controlled switch (2648) coupled to an output of said first summer (2618), said first controlled switch (2648) sampling said baseband signal summed with said reference signal (2620) according to said first control signal (2623), and resulting in said first harmonically rich signal (2630); and
said second sampling means (2628) includes a second controlled switch (2650) coupled to an output of said second summer (2619), said second controlled switch sampling said inverted baseband signal summed with said reference signal (2622) according to a second control signal (2627), and resulting in said second harmonically rich signal (2634).

**22.** The apparatus of claim 12, wherein:

said means for inverting said baseband signal includes a buffer/inverter (5604), for receiving said baseband signal (5602) and having a first output passing said baseband signal (5606) and a second output generating said inverted baseband signal (5608);
said first sampling means (5616) includes a first controlled switch (5618), coupled to said first output of said buffer/inverter (5604), said first controlled switch controlled switch shunting said baseband signal (5606) to ground according to said first control signal (2623), and resulting in said first harmonically rich signal (5614); and
said second sampling means (5622) includes a second controlled switch (5624), coupled to said second output of said buffer/inverter (5604), said second controlled switch (5624) shunting said inverted baseband signal (5608) to ground according to said second control signal (2627), and resulting in said second harmonically rich signal (5626).

**23.** The apparatus of claim 22, wherein:

said first controlled switch (5618) comprises a first field effect transistor (FET) (5636), a gate of said first FET coupled to said first control signal (2623), a source of said FET receiving said baseband signal (5606) and outputting said first harmonically rich signal (5614), and a drain of said first FET coupled to ground; and
said second controlled switch (5624) comprises a second field effect transistor (FET) (5638), a gate of said second FET coupled to said second control signal (2627), a source of said second FET receiving said inverted baseband signal (5608) and outputting said second harmonically rich signal (5626), and a drain of said second FET coupled to ground.

**24.** The apparatus of claim 23, wherein said first FET (5636) and said second FET (5638) alternately shunt said baseband signal (5606) and said inverted baseband signal (5608) to ground, respectively, according to said first control signal (2623) and said second control signal (2627), respectively, to generate said harmonically rich signals (5614, 5626).

**Patentansprüche**

**1.** Verfahren zum Aufwärtsmischen eines Basisbandsignals, das die folgenden Schritte aufweist:

(1) Empfangen eines Basisbandsignals (2610; 5310; 5602);

(2) Umwandeln des Basisbandsignals (2610; 5602) in ein differentielles Basisbandsignal mit einer ersten differentiellen Basisbandkomponente (2614; 5606) und einer zweiten differentiellen Basisbandkomponente (2616; 5608);

(3) Abtasten der ersten differentiellen Basisbandkomponente (2614; 5606) gemäß einem ersten Steuersignal (2623), um ein erstes Signal (2630; 5614) mit vielen Harmonischen zu erzeugen, und Abtasten der zweiten differentiellen Basisbandkomponente (2616; 5608) gemäß einem zweiten Steuersignal (2627), um ein zweites Signal (2634; 5626) mit vielen Harmonischen zu erzeugen, wobei das zweite Steuersignal (2627) relativ zu dem ersten Steuersignal (2623), wie durch ein Taktsignal (2645) gemessen, phasenverschoben ist;

(4) Kombinieren des ersten Signals (2630; 5614) mit vielen Harmonischen und des zweiten Signals (2634; 5626) mit vielen Harmonischen, um mehrere harmonische Bilder zu erzeugen;

(5) vor dem Schritt (3) Addieren einer Referenzspannung (2613) zu der ersten differentiellen Basisbandkomponente (2614) und der zweiten differentiellen Basisbandkomponente (2616) und dadurch Verringern jeglicher Gleichspannungsversätze während des Abtastens der ersten differentiellen Basisbandkomponente (2614) und der zweiten differentiellen Basisbandkomponente (2616).

**2.** Verfahren nach Anspruch 1, das ferner die folgenden Schritte aufweist:

(6) Auswählen eines gewünschten harmonischen Bilds aus den harmonischen Bildern, die in Schritt (4) erzeugt werden;

(7) Übertragen des gewünschten harmonischen Bilds über ein Kommunikationsmedium.

**3.** Verfahren nach Anspruch 1, wobei der Abtastschritt (3) die folgenden Schritte aufweist:

(i) Erzeugen des ersten Steuersignals (2623; 5321), das mehrere erste Impulse aufweist, und des zweiten Steuersignals (2627; 5322), das mehrere zweite Impulse aufweist; und

(ii) Betätigen eines ersten Schalters (2648) gemäß dem ersten Steuersignal (2623; 5321), um die erste differentielle Basisbandkomponente (2614) regelmäßig abzutasten, und Betätigen eines zweiten Schalters (2650) gemäß dem zweiten Steuersignal (2627; 5322), um die zweite differentielle Basisbandkomponente (2616) regelmäßig abzutasten.

**4.** Verfahren nach Anspruch 3, wobei der Schritt (i) den Schritt Verbreitern der Impulsbreiten ($T_A$) des ersten Steuersignals (2623; 5321) und des zweiten Steuersignals (2627; 5322) um einen nicht vernachlässigbaren Betrag aufweist, welcher von einer Zeitdauer von null weg tendiert, um die Zeit zu verlängern, in der der erste Schalter (2648) und der zweite Schalter (2650) in Schritt (ii) geschlossen sind.

**5.** Verfahren nach Anspruch 4, wobei der Schritt Verbreitern der Impulsbreiten den Schritt Verbreitern der Impulsbreiten ($T_A$) für die ersten und zweiten Steuersignale (2623, 2627; 5321, 5322) auf einen Bruchteil einer Periode des gewünschten harmonischen Bilds ungleich null aufweist.

**6.** Verfahren nach Anspruch 4, wobei der Schritt Verbreitern der Impulsbreiten den Schritt Verbreitern der Impulsbreiten ($T_A$) für die ersten und zweiten Steuersignale (2623, 2627) auf etwa eine halbe Periode des gewünschten harmonischen Bilds (2206b-d) aufweist.

**7.** Verfahren nach einem der vorhergehenden Ansprüche, wobei das erste Steuersignal (2623; 5321) und das zweite Steuersignal (2627; 5322) eine Periode von $T_S$ haben, so daß die harmonischen Bilder sich mit einer Frequenz von $1/T_S$ wiederholen, und wobei das zweite Steuersignal (2627; 5322) relativ zu dem ersten Steuersignal (2623; 5321) um etwa 180 Grad phasenverschoben ist.

**8.** Verfahren nach einem der vorhergehenden Ansprüche, wobei die Impulsbreiten ($T_A$) des ersten Steuersignals (2623; 5321) und des zweiten Steuersignals (2627; 5322) ein Bruchteil einer Periode des gewünschten harmonischen Bilds ungleich null sind.

**9.** Verfahren nach einem der vorhergehenden Ansprüche, wobei die Impulsbreiten ($T_A$) des ersten Steuersignals (2623) und des zweiten Steuersignals (2627) etwa eine halbe Periode des gewünschten harmonischen Bilds sind und dadurch die Energieübertragung auf das gewünschte harmonische Bild verbessern.

**10.** Verfahren nach einem der vorhergehenden Ansprüche, wobei die harmonischen Bilder eine relative Amplitude $Amp_n$ haben, welche durch die folgende Gleichung dargestellt wird:

$$Amp_n = \frac{4 \sin\left(\frac{n\pi T_A}{T_S}\right) \cdot \sin\left(\frac{n\pi}{2}\right)}{n\pi}$$

wobei

$T_S$ = Periode der ersten und zweiten Steuersignale (2623, 2627)
$T_A$ = Impulsbreite der ersten und zweiten Steuersignale (2623, 2627)

n = harmonische Ordnung des harmonischen Bilds, dessen Amplitude bestimmt wird.

**11.** Verfahren nach einem der vorhergehenden Ansprüche, wobei die harmonischen Bilder eine Amplitude haben, die auf $n^*(T_A/T_S)$ basiert, wobei $T_S$ eine Periode der ersten und zweiten Steuersignale (2623, 2627) ist, $T_A$ eine Impulsbreite von Impulsen in den ersten und zweiten Steuersignalen (2623, 2627) ist und n eine harmonische Ordnung des harmonischen Bilds ist, dessen Amplitude bestimmt wird.

**12.** Vorrichtung zum Aufwärtsmischen eines Basisbandsignals, die aufweist:

eine Einrichtung (2612; 5604) zum Invertieren des Basisbandsignals (2610; 5310; 5602), wobei sich ein invertiertes Basisbandsignal (2616; 5608) ergibt;
eine erste Abtasteinrichtung (2624; 5616) zum Abtasten des Basisbandsignals (2610; 5310; 5602) gemäß einem ersten Steuersignal (2623), wobei sich ein erstes Signal (2630; 5614) mit vielen Harmonischen ergibt;
eine zweite Abtasteinrichtung (2628; 5622) zum Abtasten des invertierten Basisbandsignals (2616; 5608) gemäß einem zweiten Steuersignal (2627), wobei sich ein zweites Signal (2634; 5626) mit vielen Harmonischen ergibt;
eine Einrichtung (2632; 5632) zum Kombinieren des ersten Signals (2630; 5614) mit vielen Harmonischen und des zweiten Signals (2634; 5626) mit vielen Harmonischen, wobei sich ein drittes Signal (2633; 5634) mit vielen Harmonischen ergibt, welches mehrere harmonische Bilder enthält, die jeweils repräsentativ für das Basisbandsignal (2610; 5602) sind; und
eine Einrichtung (2611, 2618, 2619) zum Begrenzen von Versatzspannungen zwischen der ersten Abtasteinrichtung (2624) und der zweiten Abtasteinrichtung (2628);

wobei die ersten und zweiten Steuersignale (2623, 2627; 5321, 5322) Impulse mit einer zugehörigen Impulsbreite $T_A$, aufweisen;
wobei die Begrenzungseinrichtung eine Einrichtung (2611, 2618, 2619) zum Verteilen einer Referenzspannung (2613) an die erste Abtasteinrichtung (2624) und die zweite Abtasteinrichtung (2628) aufweist; und
wobei die Verteilungseinrichtung eine Einrichtung (2618, 2619) zum Summieren der Referenzspannung (2613) mit dem Basisbandsignal (2614) und dem invertierten Basisbandsignal (2616) aufweist.

**13.** Vorrichtung nach Anspruch 12, wobei die ersten und zweiten Steuersignale (2623, 2627; 5321, 5322) eine Periode von $T_S$ haben, so daß sich die harmonischen Bilder bei Vielfachen von $1/T_S$ wiederholen.

**14.** Vorrichtung nach Anspruch 12 oder 13, wobei das zweite Steuersignal (2627; 5322) relativ zu dem ersten Steuersignal (2623; 5321) phasenverschoben ist.

**15.** Vorrichtung nach einem der Ansprüche 12 bis 14, wobei die Impulsbreite $T_A$ etwa eine halbe Periode ist, die zu dem gewünschten harmonischen Bild gehört.

**16.** Vorrichtung nach einem der Ansprüche 12 bis 15, eine relative Amplitude $Amp_n$ der harmonischen Bilder durch die folgende Gleichung dargestellt wird:

$$Amp_n = \frac{4 \sin\left(\frac{n\pi T_A}{T_S}\right) \cdot \sin\left(\frac{n\pi}{2}\right)}{n\pi}$$

wobei

$T_S$ = Periode der ersten und zweiten Steuersignale (2623, 2627);
$T_A$ = Impulsbreite der ersten und zweiten Steuersignale (2623, 2627); und

n = harmonische Ordnung des harmonischen Bilds, dessen Amplitude bestimmt wird.

**17.** Vorrichtung nach einem der Ansprüche 12 bis 16, die ferner eine Einrichtung (2606) zum Auswählen des gewünschten harmonischen Bilds aus dem dritten Signal (2630; 5634) mit vielen Harmonischen aufweist.

**18.** Vorrichtung nach Anspruch 17, wobei die Auswahleinrichtung ein Bandpaßfilter (2606) aufweist, das mit einem Ausgang der Kombinationseinrichtung (2632; 5632) verbunden ist.

**19.** Vorrichtung nach Anspruch 12, wobei die erste Abtasteinrichtung eine Einrichtung (5618) zum Parallelschalten des Basisbandsignals (5602) mit Erde gemäß dem ersten Steuersignal (2623) aufweist, und wobei die zweite Abtasteinrichtung eine Einrichtung (5624) zum Parallelschalten des invertierten Basisbandsignals (5608) mit Erde gemäß dem zweiten Steuersignal (2627) aufweist.

**20.** Vorrichtung nach einem der Ansprüche 12 bis 18, wobei die Invertiereinrichtung einen Puffer/Inverter (2612) zum Empfangen des Basisbandsignals (2610) aufweist, der einen ersten Ausgang, durch den das Basisbandsignal (2614) geht, und einen zweiten Ausgang, welcher das invertierte Basissignal (2616) erzeugt, hat; wobei das System ferner aufweist:

einen Anschluß (2611) zum Empfangen einer Referenzspannung (2613);
ein erstes Summierglied (2618), das mit dem ersten Ausgang des Puffers/Inverters (2612) und dem genannten Anschluß (2611) verbunden ist, wobei das erste Summierglied (2618) die Referenzspannung (2613) und das Basisbandsignal (2614) summiert; und
ein zweites Summierglied (2619), das mit dem zweiten Ausgang des Puffers/Inverters (2612) und dem genannten Anschluß (2611) verbunden ist, wobei das zweite Summierglied (2619) die Referenzspannung (2613) und das invertierte Basisbandsignal (2616) summiert;

wobei die erste Abtasteinrichtung (2624) das mit dem Referenzsignal (2620) summierte Basisbandsignal empfängt und die zweite Abtasteinrichtung (2628) das mit dem Referenzsignal (2622) summierte invertierte Basisbandsignal empfängt.

**21.** Vorrichtung nach Anspruch 20, wobei
die erste Abtasteinrichtung (2624) einen mit einem Ausgang des ersten Summierglieds (2618) verbundenen ersten gesteuerten Schalter (2648) aufweist, wobei der erste gesteuerte Schalter (2648) das mit dem Referenzsignal (2620) summierte erste Basisbandsignal gemäß einem ersten Steuersignal (2623) abtastet, was ein erstes Signal (2630) mit vielen Harmonischen ergibt; und
die zweite Abtasteinrichtung (2628) einen mit einem Ausgang des zweiten Summierglieds (2619) verbundenen zweiten gesteuerten Schalter (2650) aufweist, wobei der zweite gesteuerte Schalter das mit dem Referenzsignal (2622) summierte invertierte Basisbandsignal gemäß einem zweiten Steuersignal (2627) abtastet, was ein zweites Signal (2634) mit vielen Harmonischen ergibt.

**22.** Vorrichtung nach Anspruch 12, wobei:

die Einrichtung zum Invertieren des Basisbandsignals einen Puffer/Inverter (5604) umfaßt, um das Basisbandsignal (5602) zu empfangen, und einen ersten Ausgang, durch den das Basisbandsignal (5606) geht, und einen zweiten Ausgang, der das invertierte Basisbandsignal (5608) erzeugt, hat;
die erste Abtasteinrichtung (5616) einen mit dem ersten Ausgang des Puffers/Inverters (5604) verbundenen ersten gesteuerten Schalter (5618) umfaßt, wobei der erste gesteuerte Schalter das Basisbandsignal (5606) gemäß dem ersten Steuersignal (2623) mit Erde parallelschaltet, was das erste Signal (5614) mit vielen Harmonischen ergibt; und
die zweite Abtasteinrichtung (5622) einen mit einem Ausgang des Puffers/Inverters (5604) verbundenen zweiten gesteuerten Schalter (5624) umfaßt, wobei der zweite gesteuerte Schalter (5624) das invertierte Basisbandsignal (5608) gemäß dem zweiten Steuersignal (2627) mit Erde parallelschaltet, was das zweite Signal (5626) mit vielen Harmonischen ergibt.

**23.** Vorrichtung nach Anspruch 22, wobei:

der erste gesteuerte Schalter (5618) einen ersten Feldeffekttransistor (FET) (5636) aufweist, wobei ein Gate des ersten FET mit dem ersten Steuersignal (2623) verbunden ist, eine Source des FET das Basisbandsignal (5606) empfängt und das erste Signal (5614) mit vielen Harmonischen ausgibt und ein Drain des FET mit Erde verbunden ist; und

der zweite gesteuerte Schalter (5624) einen zweiten Feldeffekttransistor (FET) (5638) aufweist, wobei ein Gate des zweiten FET mit dem zweiten Steuersignal (2627) verbunden ist, eine Source des zweiten FET das invertierte Basisbandsignal (5608) empfängt und das zweite Signal (5626) mit vielen Harmonischen ausgibt und ein Drain des zweiten FET mit Erde verbunden ist.

**24.** Vorrichtung nach Anspruch 23, wobei der erste FET (5636) und der zweite FET (5638) jeweils abwechselnd das Basisbandsignal (5606) und das invertierte Basisbandsignal (5608) jeweils gemäß dem ersten Steuersignal (2623) und dem zweiten Steuersignal (2627) mit Erde parallelschalten, um die Signale (5614, 5626) mit vielen Harmonischen zu erzeugen.

## Revendications

**1.** Procédé de conversion d'un signal de bande de base par élévation de fréquence, comprenant les étapes consistant à :

(1) recevoir le signal de bande de base (2610 ; 5310 ; 5602) ;

(2) convertir ledit signal de bande de base (2610 ; 5602) en un signal de bande de base différentiel ayant une première composante de bande de base différentielle (2614 ; 5606) et une deuxième composante de bande de base différentielle (2616 ; 5608) ;

(3) échantillonner ladite première composante de bande de base différentielle (2614 ; 5606) selon un premier signal de commande (2623) pour produire un premier signal riche en harmoniques (2630 ; 5614), et échantillonner ladite deuxième composante de bande de base différentielle (2616 ; 5608) selon un deuxième signal de commande (2627) pour produire un deuxième signal riche en harmoniques (2634 ; 5626), ledit deuxième signal de commande (2627) étant déphasé par rapport audit premier signal de commande (2623), la mesure étant faite par un signal d'horloge (2645) ;

(4) combiner ledit premier signal riche en harmoniques (2630 ; 5614) et ledit deuxième signal riche en harmoniques (2634 ; 5626) pour produire une pluralité d'images harmoniques ; et

(5) ajouter une tension de référence (2613) à ladite première composante de bande de base différentielle (2614) et à ladite deuxième composante de bande de base différentielle (2616) avant l'étape (3), et réduire de ce fait toute tension de décalage continue pendant l'échantillonnage de ladite première composante de bande de base différentielle (2614) et de ladite deuxième composante de bande de base différentielle (2616).

**2.** Procédé selon la revendication 1, comprenant en outre les étapes consistant à :

(6) sélectionner une image harmonique voulue parmi lesdites images harmoniques produites à l'étape (4) ; et

(7) transmettre ladite image harmonique voulue via un support de télécommunications.

**3.** Procédé selon la revendication 1, dans lequel ladite étape (3) d'échantillonnage comprend les étapes consistant à :

(i) produire ledit premier signal de commande (2623 ; 5321) comprenant une première pluralité d'impulsions et ledit deuxième signal de commande (2627 ; 5322) comprenant une deuxième pluralité d'impulsions ; et

(ii) actionner un premier interrupteur (2648) selon ledit premier signal de commande (2623 ; 5321) pour échantillonner périodiquement ladite première composante de bande de base différentielle (2614), et actionner un deuxième interrupteur (2650) selon ledit deuxième signal de commande (2627 ; 5322) pour échantillonner périodiquement ladite deuxième composante de bande de base différentielle (2616).

**4.** Procédé selon la revendication 3, dans lequel ladite étape (i) comprend l'étape consistant à élargir les largeurs d'impulsions ($T_A$) dudit premier signal de commande (2623 ; 5321) et dudit deuxième signal de commande (2627 ; 5322) d'un degré non négligeable qui s'éloigne de la durée nulle pour étendre la durée pendant laquelle ledit premier interrupteur (2648) et ledit deuxième interrupteur (2650) est fermé à l'étape (ii).

**5.** Procédé selon la revendication 4, dans lequel ladite étape d'élargissement des impulsions comprend l'étape consistant à élargir les largeurs d'impulsions ($T_A$) pour lesdits premier et deuxième signaux de commande (2623, 2627 ; 5321, 5322) jusqu'à une fraction non nulle d'une période de l'image harmonique voulue.

**6.** Procédé selon la revendication 4, dans lequel ladite étape d'élargissement des impulsions comprend l'étape consistant à élargir les largeurs d'impulsions ($T_A$) pour lesdits premier et deuxième signaux de commande (2623, 2627) jusqu'à à peu près la moitié d'une période de l'image harmonique voulue (2206b-d).

**7.** Procédé selon l'une quelconque des revendications précédentes, dans lequel ledit premier signal de commande (2623 ; 5321) et ledit deuxième signal de commande (2627 ; 5322) ont une période $T_S$ telle que lesdites images harmoniques se répètent à une fréquence de $1/T_S$, et dans lequel ledit deuxième signal de commande (2627 ; 5322) est déphasé par rapport audit premier signal de commande (2623 ; 5321) d'à peu près 180 degrés.

**8.** Procédé selon l'une quelconque des revendications précédentes, dans lequel lesdites largeurs d'impulsions ($T_A$) dudit premier signal de commande (2623 ; 5321) et dudit deuxième signal de commande (2627 ; 5322) sont une fraction non nulle d'une période de l'image harmonique voulue.

**9.** Procédé selon l'une quelconque des revendications précédentes, dans lequel lesdites largeurs d'impulsions ($T_A$) dudit premier signal de commande (2623) et dudit deuxième signal de commande (2627) font à peu près la moitié d'une période de ladite image harmonique voulue, et améliorent de ce fait le transfert d'énergie vers l'image harmonique voulue.

**10.** Procédé selon l'une quelconque des revendications précédentes, dans lequel lesdites images harmoniques ont une amplitude relative $Amp_n$ représentée par l'équation suivante :

$$\mathrm{Amp_n} = \left| \frac{4\sin\left(\frac{n\pi T_A}{T_S}\right)\cdot\sin\left(\frac{n\pi}{2}\right)}{n\pi} \right|$$

où :

$T_S$= période desdits premier et deuxième signaux de commande (2623, 2627)
$T_A$ = largeur d'impulsion desdits premier et deuxième signaux de commande (2623, 2627)
n = rang d'un harmonique de ladite image harmonique dont l'amplitude est déterminée.

**11.** Procédé selon l'une quelconque des revendications précédentes, dans lequel lesdites images harmoniques ont une amplitude qui est basée sur $n*(T_A/T_S)$, où $T_S$ est une période desdits premier et deuxième signaux de commande (2623, 2627), $T_A$ est une largeur d'impulsion des impulsions desdits premier et deuxième signaux de commande (2623, 2627), et n est un rang d'un harmonique de ladite image harmonique.

**12.** Appareil pour convertir un signal de bande de base par élévation de fréquence, comprenant :

un moyen (2612 ; 5604) permettant d'inverser ledit signal de bande de base (2610 ; 5310 ; 5602), pour obtenir un signal de bande de base inversé (2616 ; 5608) ;
un premier moyen d'échantillonnage (2624 ; 5616) pour échantillonner ledit signal de bande de base (2610 ; 5310 ; 5602) selon un premier signal de commande (2623), pour obtenir un premier signal riche en harmoniques (2630 ; 5614) ;
un deuxième moyen d'échantillonnage (2628 ; 5622) pour échantillonner ledit signal de bande de base inversé (2616 ; 5608) selon un deuxième signal de commande (2627), pour obtenir un deuxième signal riche en harmoniques (2634 ; 5626) ;
un moyen (2632 ; 5632) permettant de combiner ledit premier signal riche en harmoniques (2630 ; 5614) et ledit deuxième signal riche en harmoniques (2634 ; 5626) pour produire un troisième signal riche en harmoniques (2633 ; 5634) contenant plusieurs images harmoniques qui sont représentatives chacune dudit signal de bande de base (2610 ; 5602) ; et
un moyen (2611, 2618, 2619) permettant de limiter les tensions de décalage entre ledit premier moyen d'échantillonnage (2624) et ledit deuxième moyen d'échantillonnage (2628) ;

dans lequel lesdits premier et deuxième signaux de commande (2623, 2627 ; 5321, 5322) comprennent des impulsions ayant une largeur d'impulsion associée $T_A$ ;

dans lequel ledit moyen de limitation comprend un moyen (2611, 2618, 2619) permettant de distribuer une tension de référence (2613) audit premier moyen d'échantillonnage (2624) et audit deuxième moyen d'échantillonnage (2628) ; et

dans lequel ledit moyen de distribution comprend un moyen (2618, 2619) permettant d'additionner ladite tension de référence (2613) avec ledit signal de bande de base (2614) et ledit signal de bande de base inversé (2616).

**13.** Appareil selon la revendication 12, dans lequel lesdits premier et deuxième signaux de commande (2623, 2627 ; 5321, 5322) ont une période $T_S$ telle que lesdites images harmoniques se répètent à des multiples de $1/T_S$.

**14.** Appareil selon la revendication 12 ou 13, dans lequel ledit deuxième signal de commande (2627 ; 5322) est déphasé par rapport audit premier signal de commande (2623 ; 5321).

**15.** Appareil selon l'une quelconque des revendications 12 à 14, dans lequel ladite largeur d'impulsion $T_A$ vaut à peu près la moitié d'une période associée à l'image harmonique voulue.

**16.** Appareil selon l'une quelconque des revendications 12 à 15, dans lequel une amplitude relative $Amp_n$ desdites images harmoniques est représentée par l'équation suivante :

$$Amp_n = \left| \frac{4 \sin\left(\frac{n\pi T_A}{T_S}\right) \cdot \sin\left(\frac{n\pi}{2}\right)}{n\pi} \right|$$

où :

$T_S$ = période desdits premier et deuxième signaux de commande (2623, 2627) ;
$T_A$ = largeur d'impulsion desdits premier et deuxième signaux de commande (2623, 2627) ; et
n = rang d'un harmonique de ladite image harmonique dont l'amplitude est déterminée.

**17.** Appareil selon l'une quelconque des revendications 12 à 16, comprenant en outre un moyen (2606) permettant de choisir l'image harmonique voulue à partir dudit troisième signal riche en harmoniques (2630 ; 5634).

**18.** Appareil selon la revendication 17, dans lequel le moyen de sélection comprend un filtre passe-bande (2606) couplé à une sortie du moyen de combinaison (2632 ; 5632).

**19.** Appareil selon la revendication 12, dans lequel ledit premier moyen d'échantillonnage comprend un moyen (5618) permettant de mettre ledit signal de bande de base (5602) à la masse selon ledit premier signal de commande (2623), et dans lequel ledit deuxième moyen d'échantillonnage comprend un moyen (5624) permettant de mettre ledit signal de bande de base inversé (5608) à la masse selon ledit deuxième signal de commande (2627).

**20.** Appareil selon l'une quelconque des revendications 12 à 18, dans lequel ledit moyen d'inversion comprend une porte de transfert/inverseuse (2612) destinée à recevoir ledit signal de bande de base (2610) et ayant une première sortie qui laisse passer ledit signal de bande de base (2614) et une deuxième sortie qui produit ledit signal de bande de base inversé (2616) ; ledit système comprenant en outre :

une borne (2611) destinée à recevoir une tension de référence (2613) ;
un premier additionneur (2618) couplé à ladite première sortie de ladite porte de transfert/inverseuse (2612) et à ladite borne (2611), ledit premier additionneur (2618) additionnant ladite tension de référence (2613) et ledit signal de bande de base inversé (2614) ; et

un deuxième additionneur (2619) couplé à ladite deuxième sortie de ladite porte de transfert/inverseuse (2612) et à ladite borne (2611), ledit deuxième additionneur (2619) additionnant ladite tension de référence (2613) et ledit signal de bande de base inversé (2616) ;

dans lequel ledit premier moyen d'échantillonnage (2624) reçoit ledit signal de bande de base additionné audit signal de référence (2620) et ledit deuxième moyen d'échantillonnage (2628) reçoit ledit signal de bande de base inversé additionné audit signal de référence (2622).

**21.** Appareil selon la revendication 20, dans lequel :

ledit premier moyen d'échantillonnage (2624) comporte un premier interrupteur commandé (2648) couplé à une sortie dudit premier additionneur (2618), ledit premier interrupteur commandé (2648) échantillonnant ledit signal de bande de base additionné audit signal de référence (2620) selon ledit premier signal de commande (2623), pour obtenir ledit premier signal riche en harmoniques (2630) ; et
ledit deuxième moyen d'échantillonnage (2628) comporte un deuxième interrupteur commandé (2650) couplé à une sortie dudit deuxième additionneur (2619), ledit deuxième interrupteur commandé échantillonnant ledit signal de bande de base additionné audit signal de référence (2622) selon un deuxième signal de commande (2627), pour obtenir ledit deuxième signal riche en harmoniques (2634).

**22.** Appareil selon la revendication 12, dans lequel :

ledit moyen permettant d'inverser ledit signal de bande de base comprend une porte de transfert/inverseuse (5604) destinée à recevoir ledit signal de bande de base (5602) et ayant une première sortie qui laisse passer ledit signal de bande de base (5606) et une deuxième sortie qui produit ledit signal de bande de base inversé (5608) ;
ledit premier moyen d'échantillonnage (5616) comporte un premier interrupteur commandé (5618) couplé à ladite première sortie de ladite porte de transfert/inverseuse (5604), ledit premier interrupteur commandé mettant ledit signal de bande de base (5606) à la masse selon ledit premier signal de commande (2623), pour obtenir ledit premier signal riche en harmoniques (5614) ; et
ledit deuxième moyen d'échantillonnage (5622) comporte un deuxième interrupteur commandé (5624) couplé à ladite deuxième sortie de ladite porte de transfert/inverseuse (5604), ledit deuxième interrupteur commandé (5624) mettant ledit signal de bande de base inversé (5608) à la masse selon ledit deuxième signal de commande (2627), pour obtenir ledit deuxième signal riche en harmoniques (5626).

**23.** Appareil selon la revendication 22, dans lequel :

ledit premier interrupteur commandé (5618) comprend un premier transistor à effet de champ (transistor FET) (5636), une grille dudit premier transistor FET étant couplée audit premier signal de commande (2623), une source dudit transistor FET recevant ledit signal de bande de base (5606) et délivrant ledit premier signal riche en harmoniques (5614), et un drain dudit premier transistor FET étant relié à la masse ; et
ledit deuxième interrupteur commandé (5624) comprend un deuxième transistor à effet de champ (transistor FET) (5638), une grille dudit deuxième transistor FET étant couplée audit deuxième signal de commande (2627), une source dudit deuxième transistor FET recevant ledit signal de bande de base inversé (5608) et délivrant ledit deuxième signal riche en harmoniques (5626), et un drain dudit deuxième transistor FET étant relié à la masse.

**24.** Appareil selon la revendication 23, dans lequel ledit premier transistor FET (5636) et ledit deuxième transistor FET (5638) mettent alternativement ledit signal de bande de base (5606) et ledit signal de bande de base inversé (5608) à la masse, respectivement, selon ledit premier signal de commande (2623) et ledit deuxième signal de commande (2627), respectivement, pour produire lesdits signaux riches en harmoniques (5614, 5626).

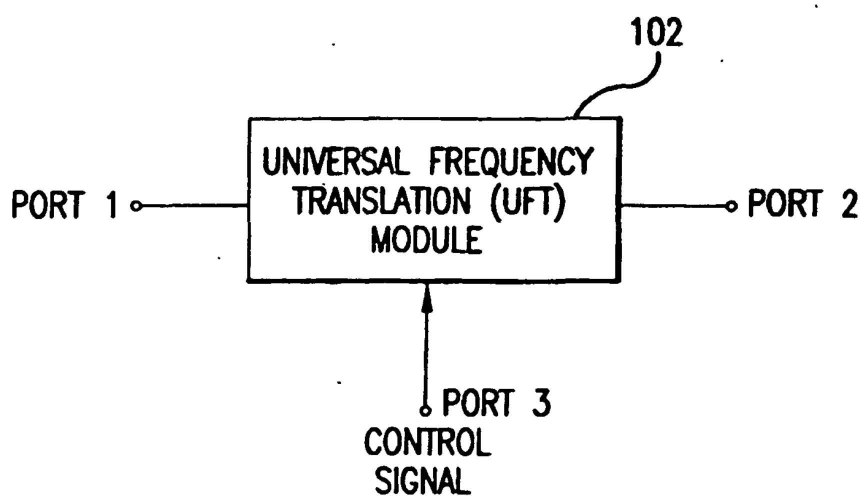
102
UNIVERSAL FREQUENCY
TRANSLATION (UFT)
MODULE
PORT 1
PORT 2
PORT 3
CONTROL
SIGNAL

FIG. 1A

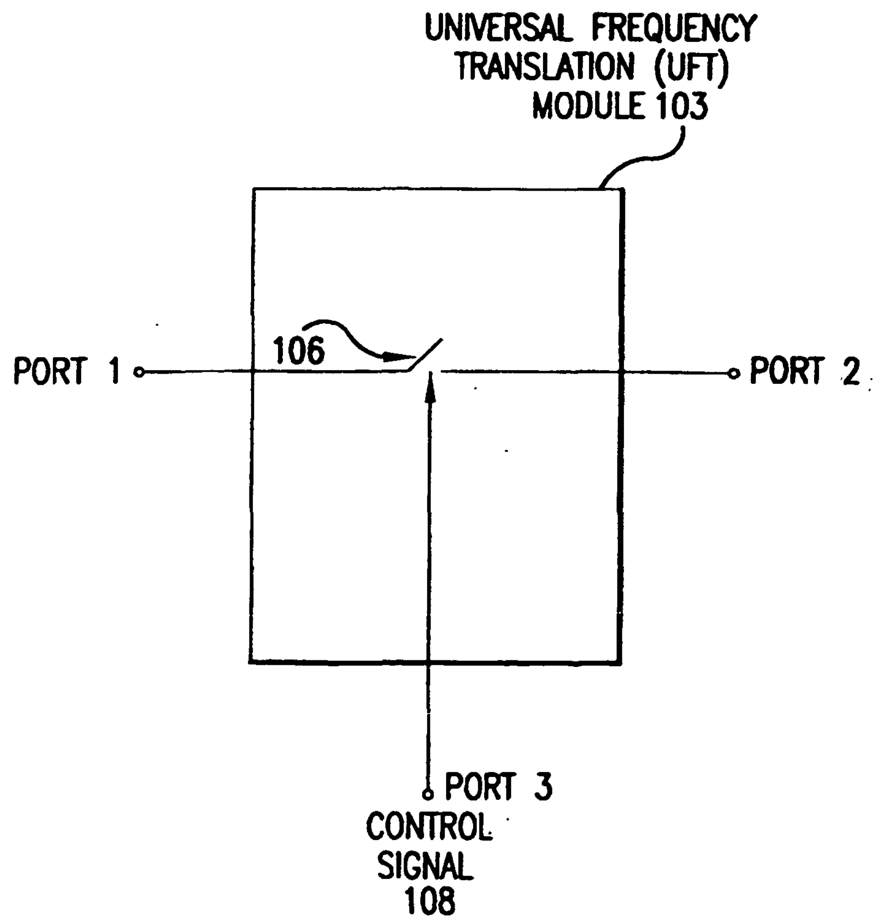
UNIVERSAL FREQUENCY
TRANSLATION (UFT)
MODULE 103
106
PORT 1
PORT 2
PORT 3
CONTROL
SIGNAL
108

FIG. 1B

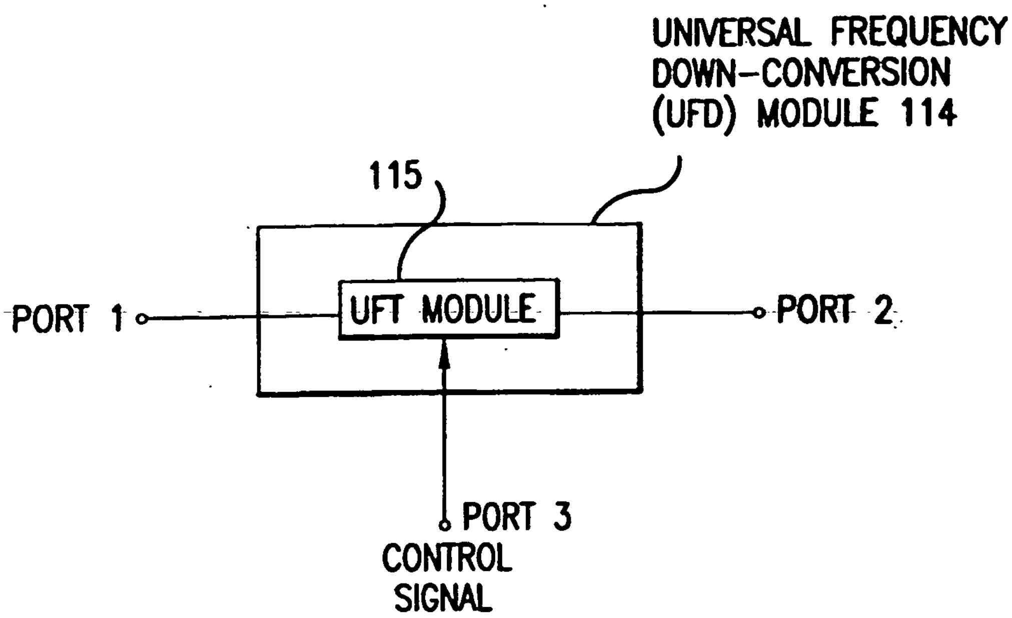
UNIVERSAL FREQUENCY
DOWN-CONVERSION
(UFD) MODULE 114
115
PORT 1
UFT MODULE
PORT 2
PORT 3
CONTROL
SIGNAL

FIG. 1C

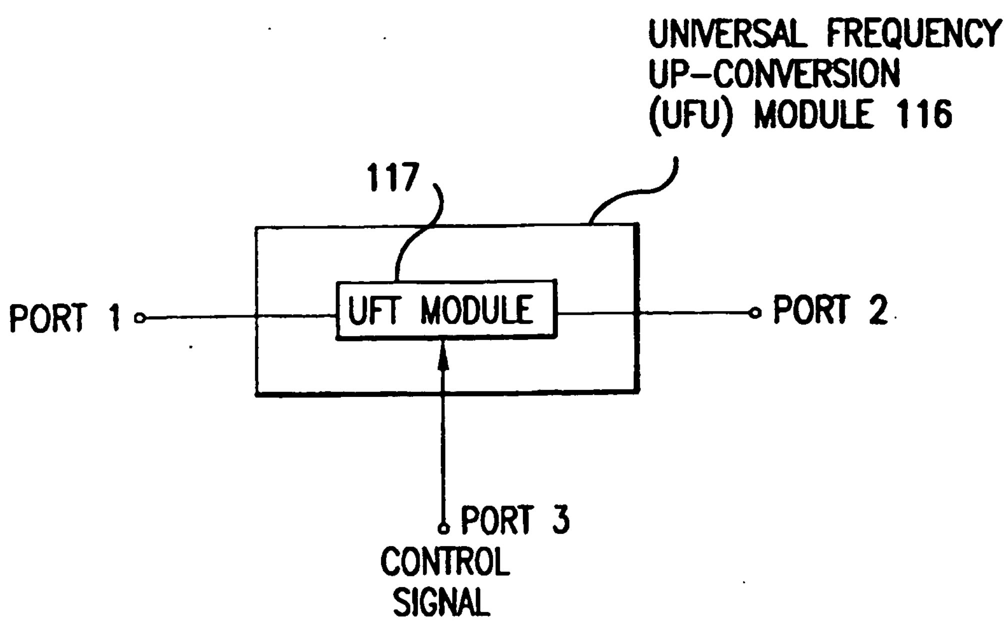
UNIVERSAL FREQUENCY
UP-CONVERSION
(UFU) MODULE 116
117
PORT 1
UFT MODULE
PORT 2
PORT 3
CONTROL
SIGNAL

FIG. 1D

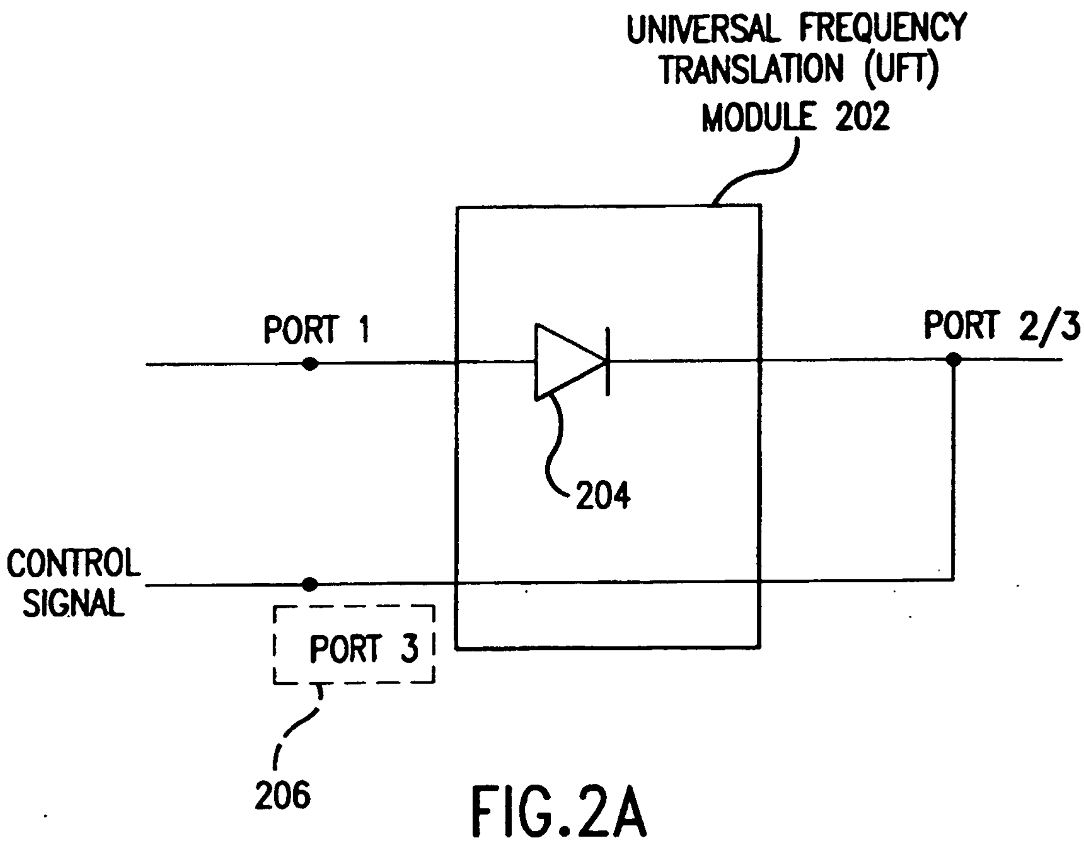
UNIVERSAL FREQUENCY
TRANSLATION (UFT)
MODULE 202
PORT 1
PORT 2/3
204
CONTROL
SIGNAL
PORT 3
206

FIG.2A

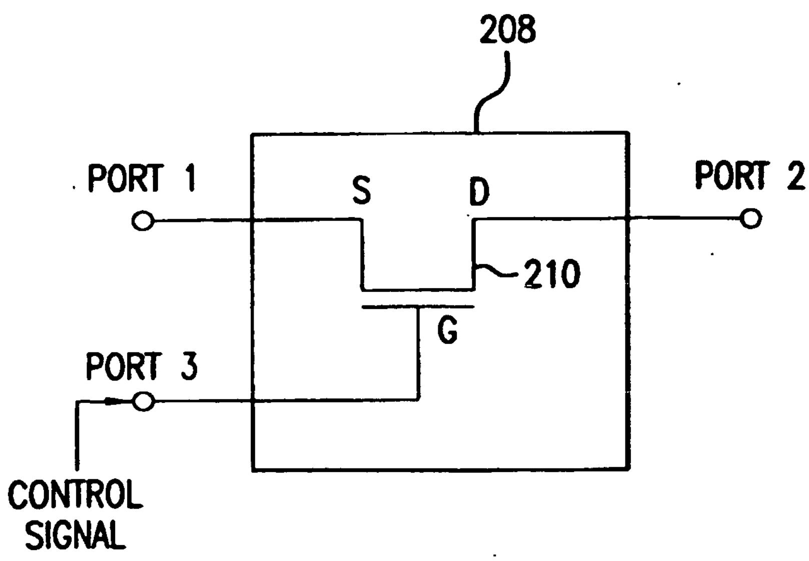
208
PORT 1
S
D
PORT 2
210
G
PORT 3
CONTROL
SIGNAL

FIG.2B

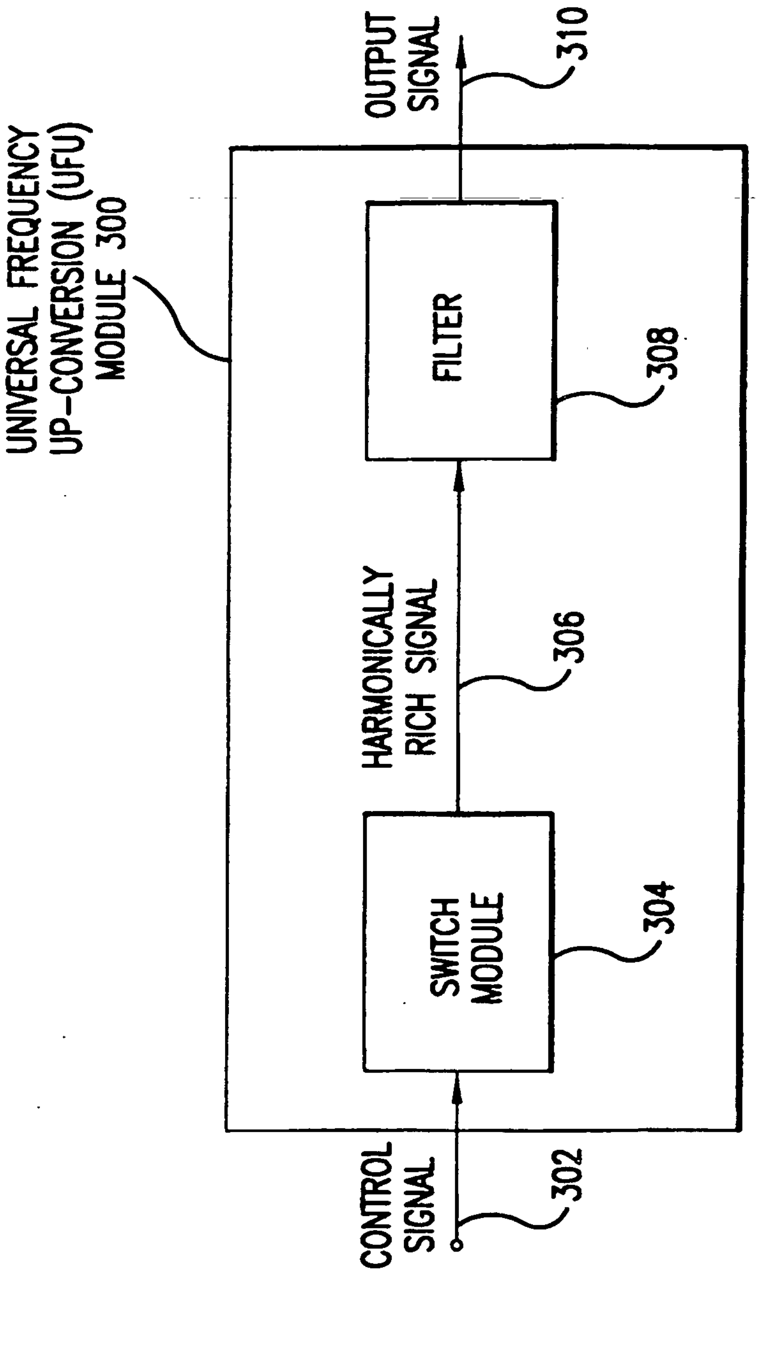
UNIVERSAL FREQUENCY UP-CONVERSION (UFU) MODULE 300
OUTPUT SIGNAL
310
FILTER
308
HARMONICALLY RICH SIGNAL
306
SWITCH MODULE
304
CONTROL SIGNAL
302

FIG. 3

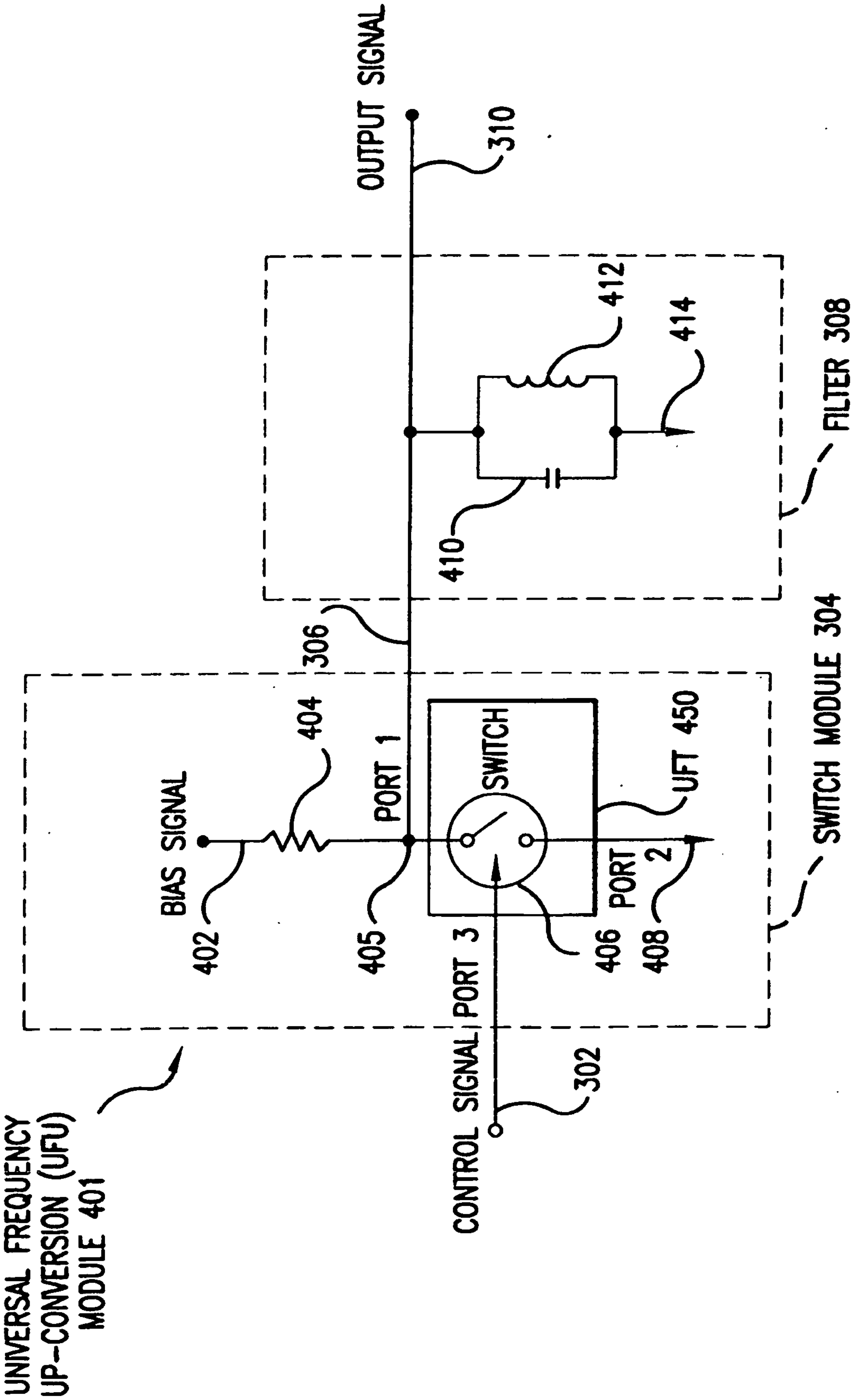
OUTPUT SIGNAL
310
412
414
FILTER 308
410
306
404
BIAS SIGNAL
PORT 1
SWITCH
UFT 450
SWITCH MODULE 304
PORT 2
402
405
CONTROL SIGNAL PORT 3
406
408
302
UNIVERSAL FREQUENCY
UP-CONVERSION (UFU)
MODULE 401

FIG. 4

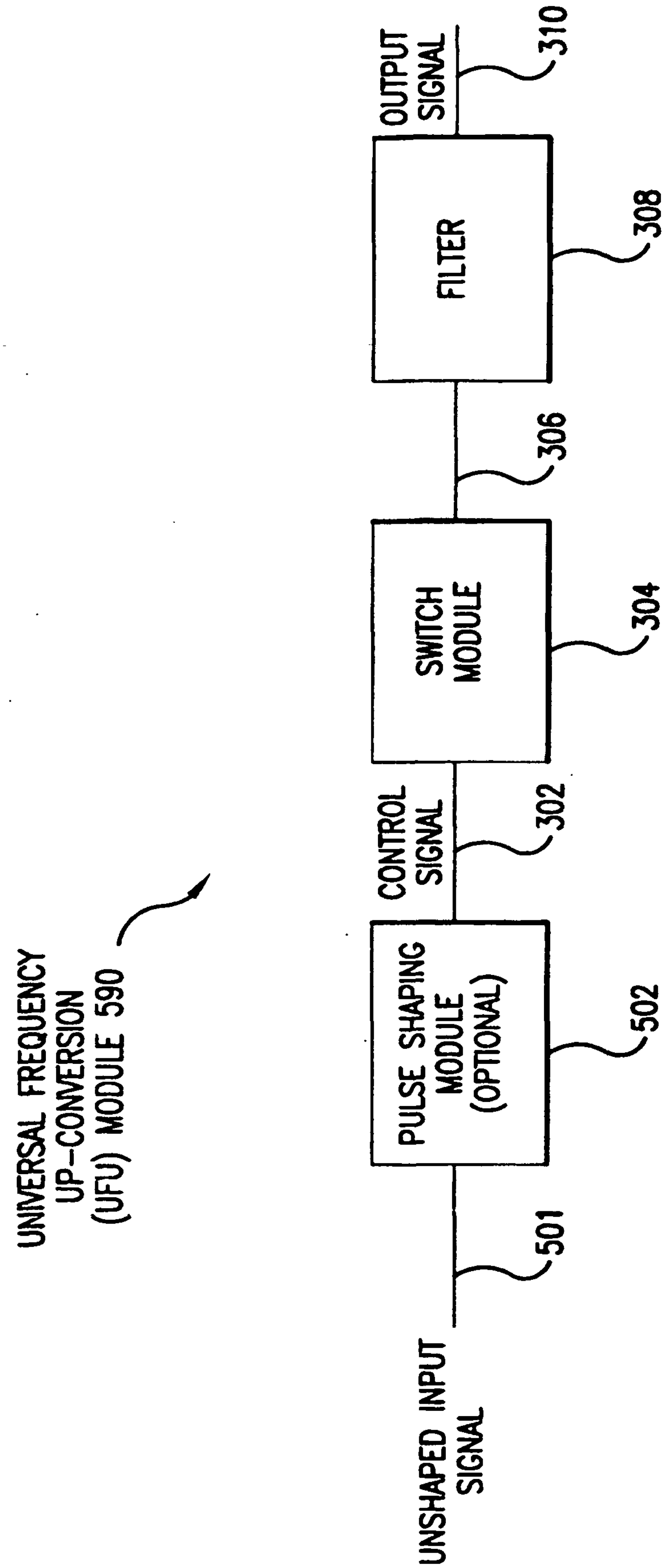
UNIVERSAL FREQUENCY UP-CONVERSION (UFU) MODULE 590
UNSHAPED INPUT SIGNAL
501
PULSE SHAPING MODULE (OPTIONAL)
502
CONTROL SIGNAL
302
SWITCH MODULE
304
306
FILTER
308
OUTPUT SIGNAL
310

FIG. 5

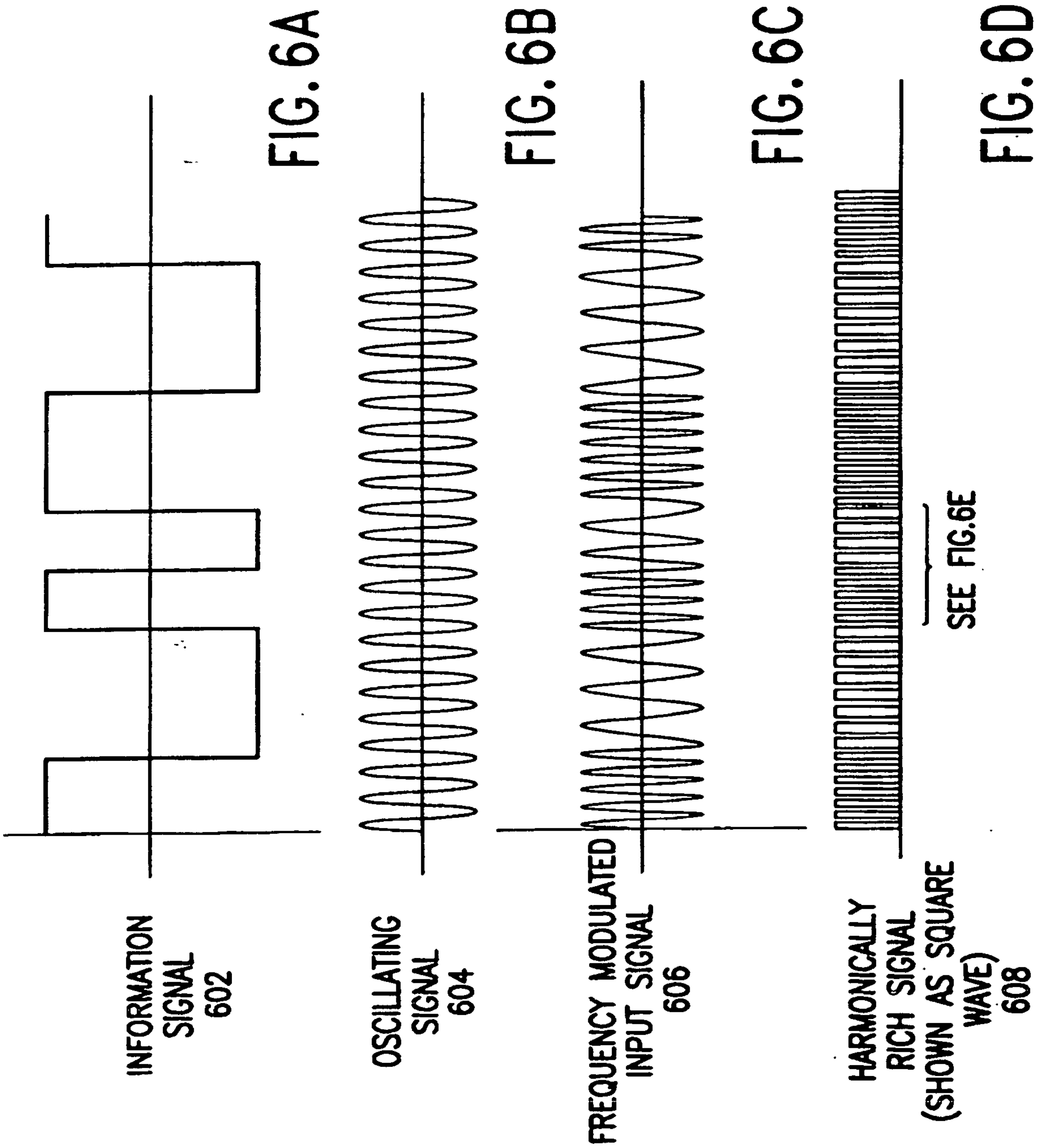
INFORMATION SIGNAL 602
FIG. 6A
OSCILLATING SIGNAL 604
FIG. 6B
FREQUENCY MODULATED INPUT SIGNAL 606
FIG. 6C
HARMONICALLY RICH SIGNAL (SHOWN AS SQUARE WAVE) 608
SEE FIG.6E
FIG. 6D

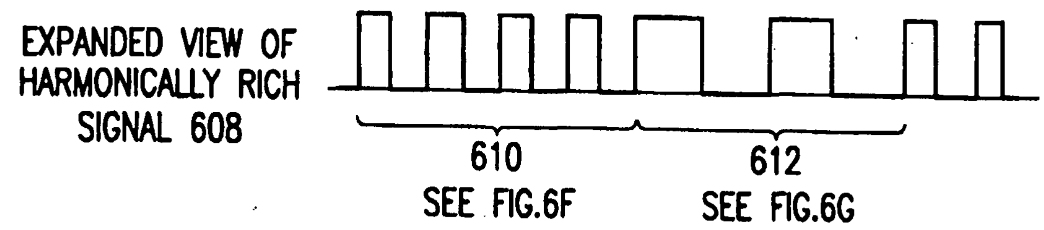


FIG. 6E

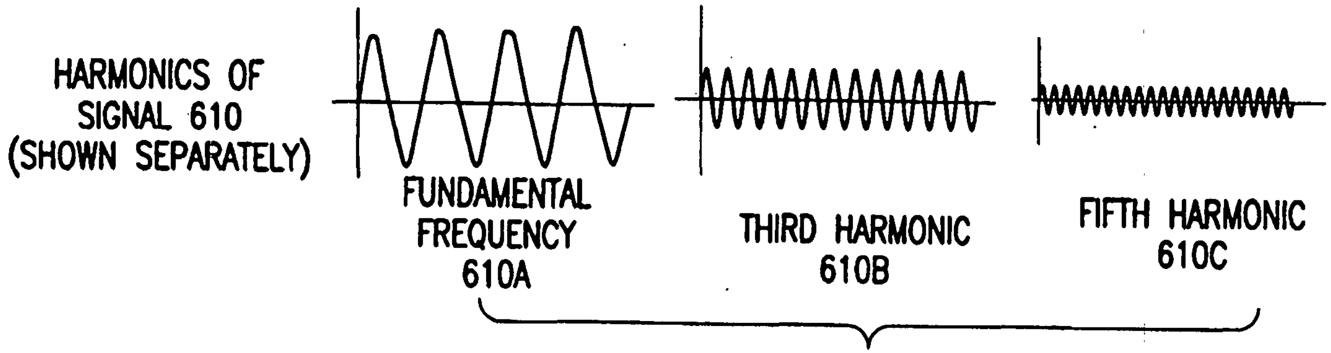


FIG. 6F

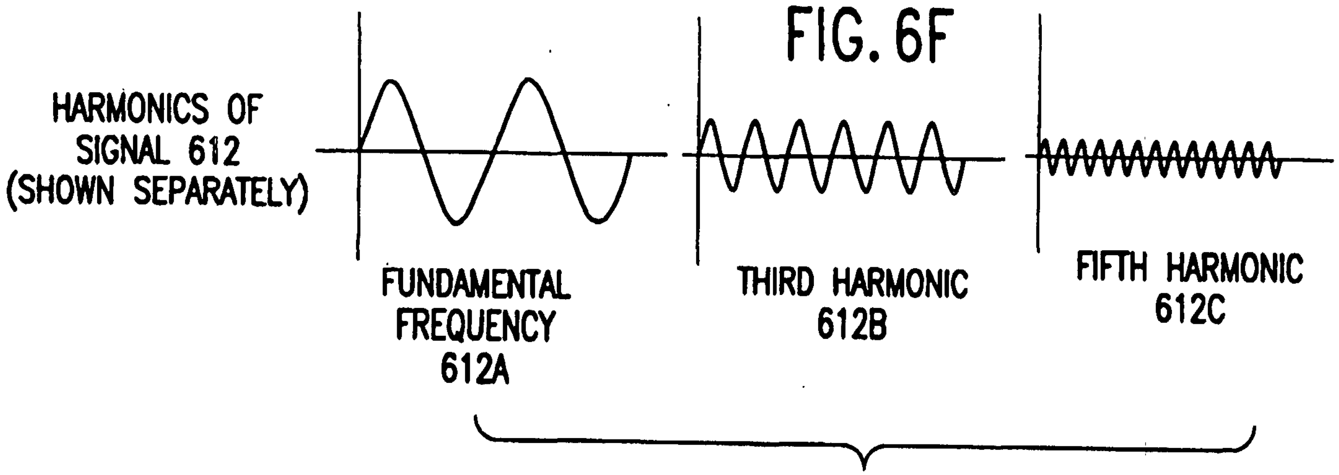


FIG. 6G

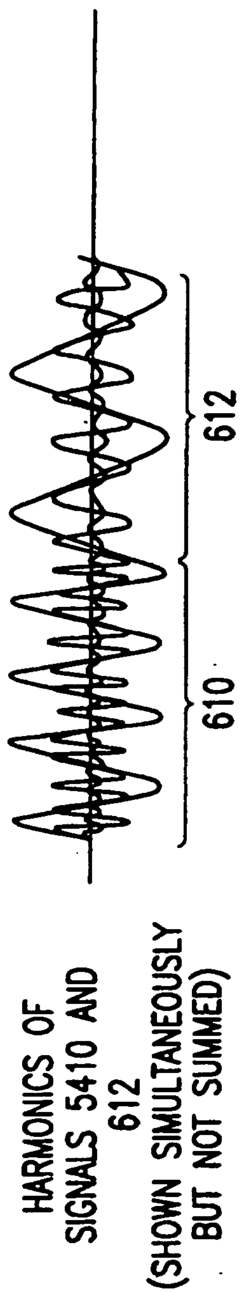
HARMONICS OF SIGNALS 5410 AND 612 (SHOWN SIMULTANEOUSLY BUT NOT SUMMED)
610
612

FIG. 6H

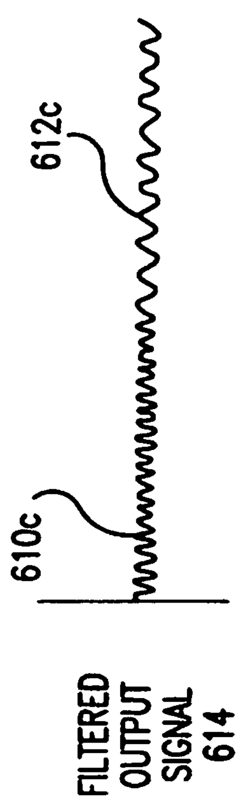
FILTERED OUTPUT SIGNAL 614
610c
612c

FIG. 6I

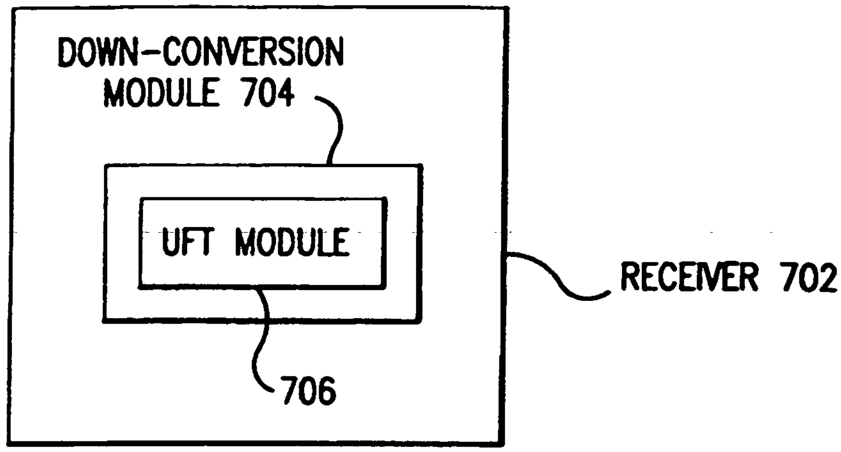
DOWN-CONVERSION
MODULE 704
UFT MODULE
RECEIVER 702
706

FIG.7

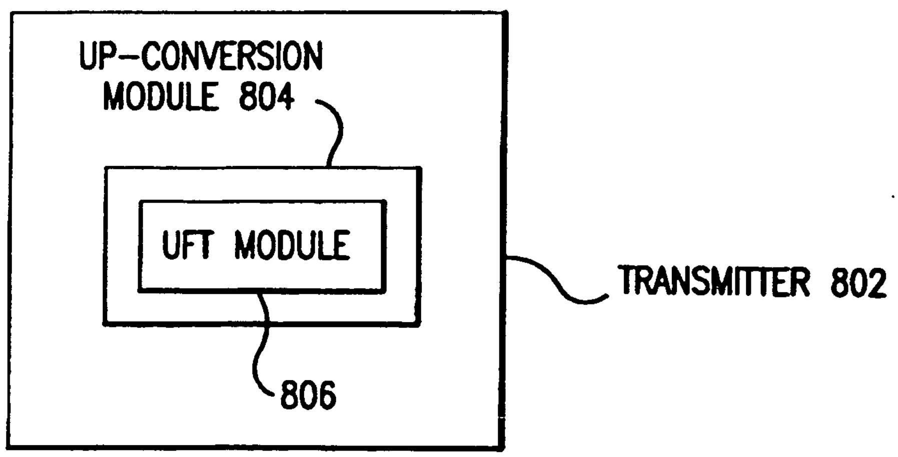
UP-CONVERSION
MODULE 804
UFT MODULE
TRANSMITTER 802
806

FIG.8

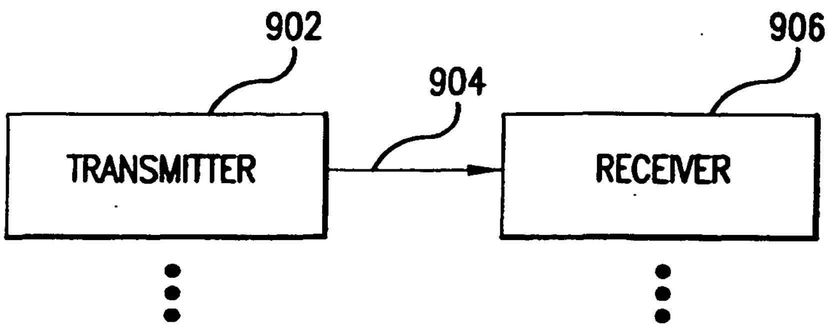
902
904
906
TRANSMITTER
RECEIVER

FIG. 9

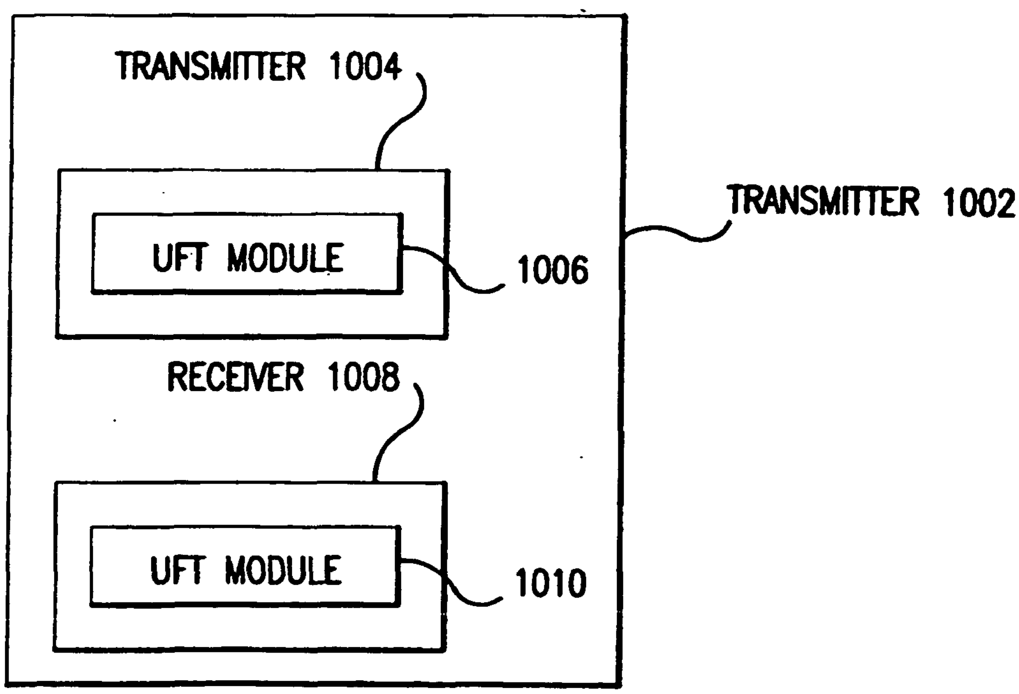
TRANSMITTER 1004
UFT MODULE
1006
RECEIVER 1008
UFT MODULE
1010
TRANSMITTER 1002

FIG. 10

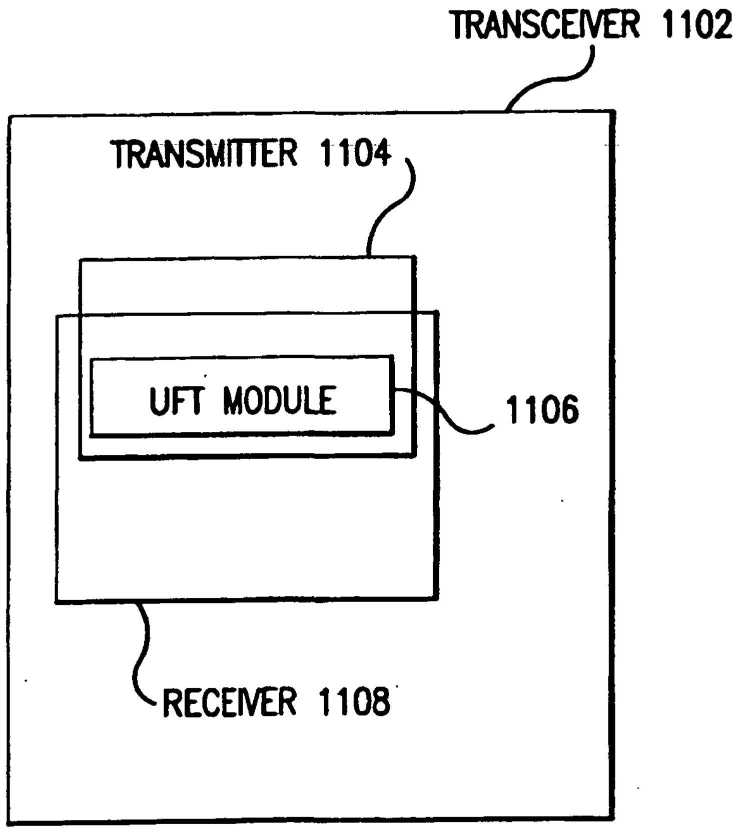
TRANSCEIVER 1102
TRANSMITTER 1104
UFT MODULE
1106
RECEIVER 1108

FIG. 11

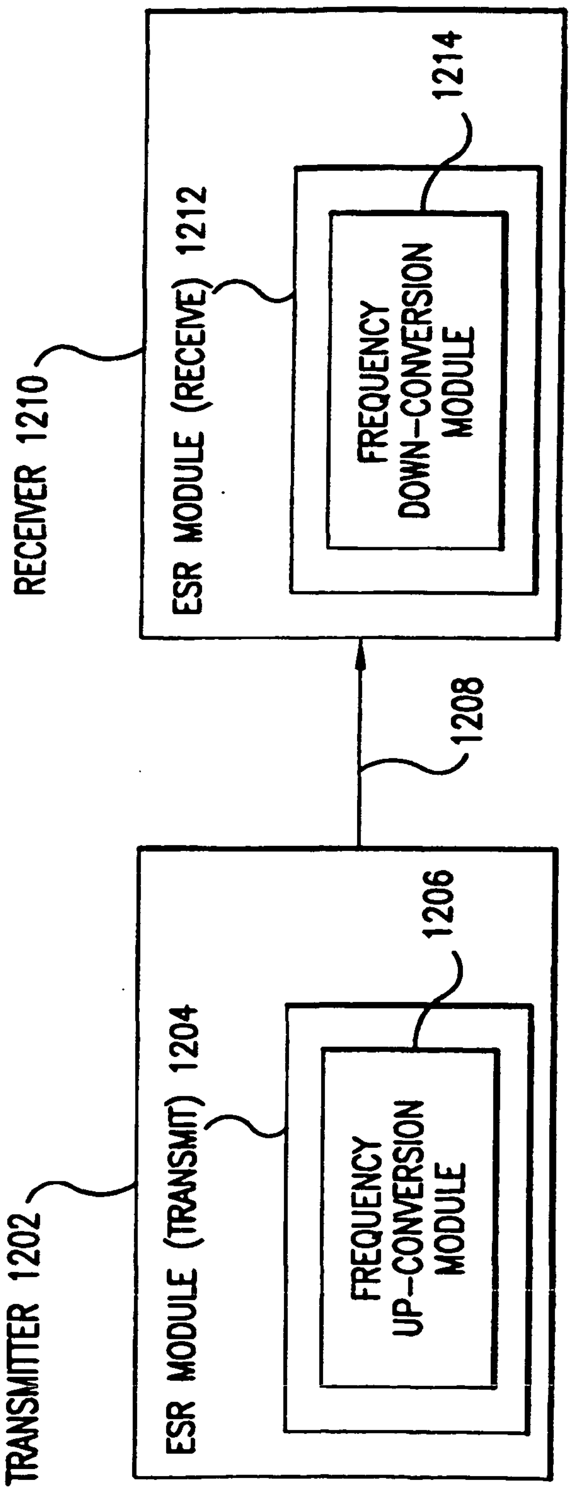
RECEIVER 1210
ESR MODULE (RECEIVE) 1212
1214
FREQUENCY
DOWN-CONVERSION
MODULE
1208
TRANSMITTER 1202
ESR MODULE (TRANSMIT) 1204
1206
FREQUENCY
UP-CONVERSION
MODULE

FIG. 12

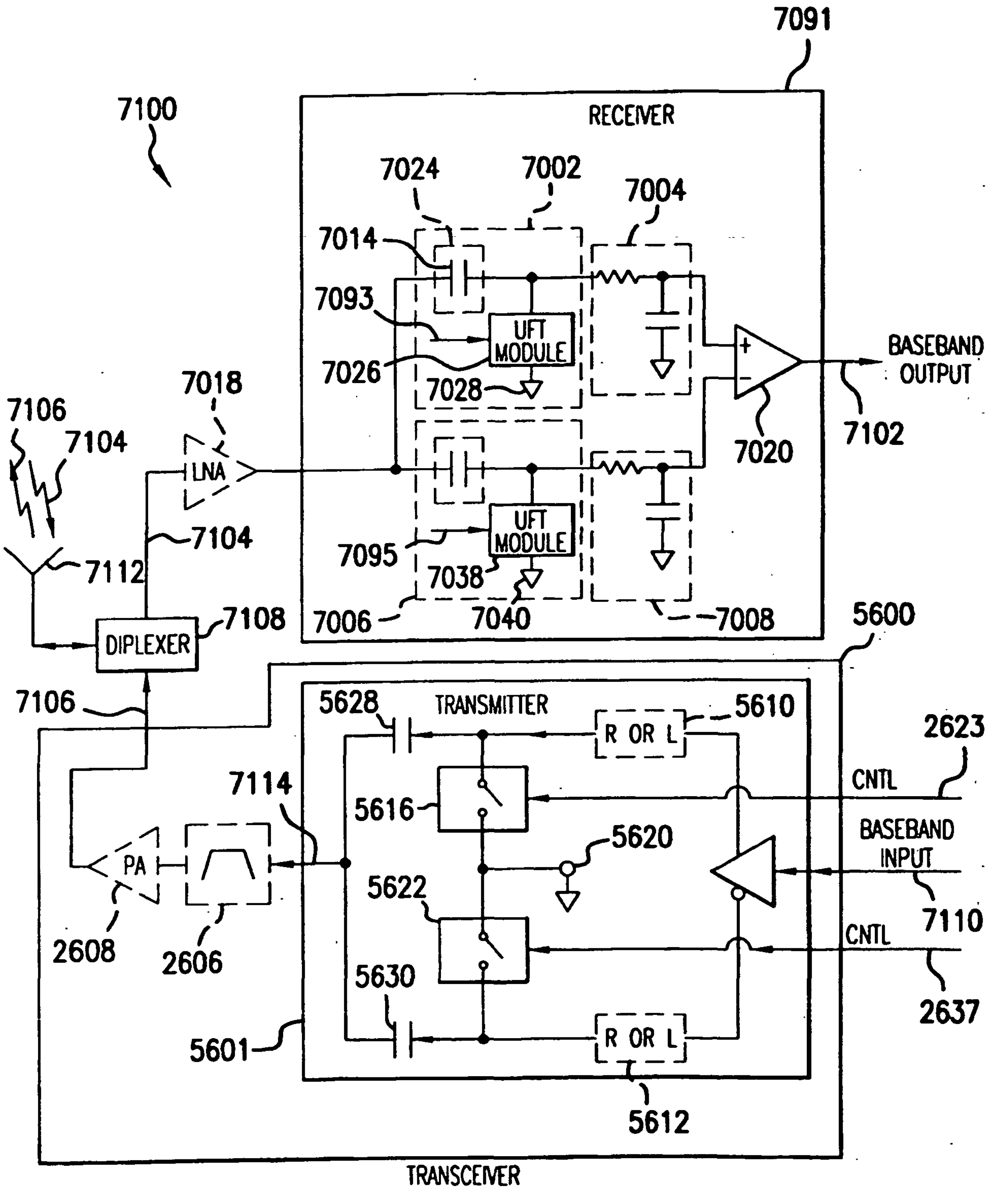
7091
7100
RECEIVER
7024
7002
7004
7014
7093
UFT MODULE
7026
7028
7018
7106
7104
LNA
BASEBAND OUTPUT
7020
7102
UFT MODULE
7095
7104
7112
7038
7006
7040
7008
DIPLEXER
7108
5600
7106
5628
TRANSMITTER
R OR L
5610
2623
CNTL
7114
5616
5620
BASEBAND INPUT
PA
5622
7110
CNTL
2608
2606
5630
2637
5601
R OR L
5612
TRANSCEIVER

FIG.13

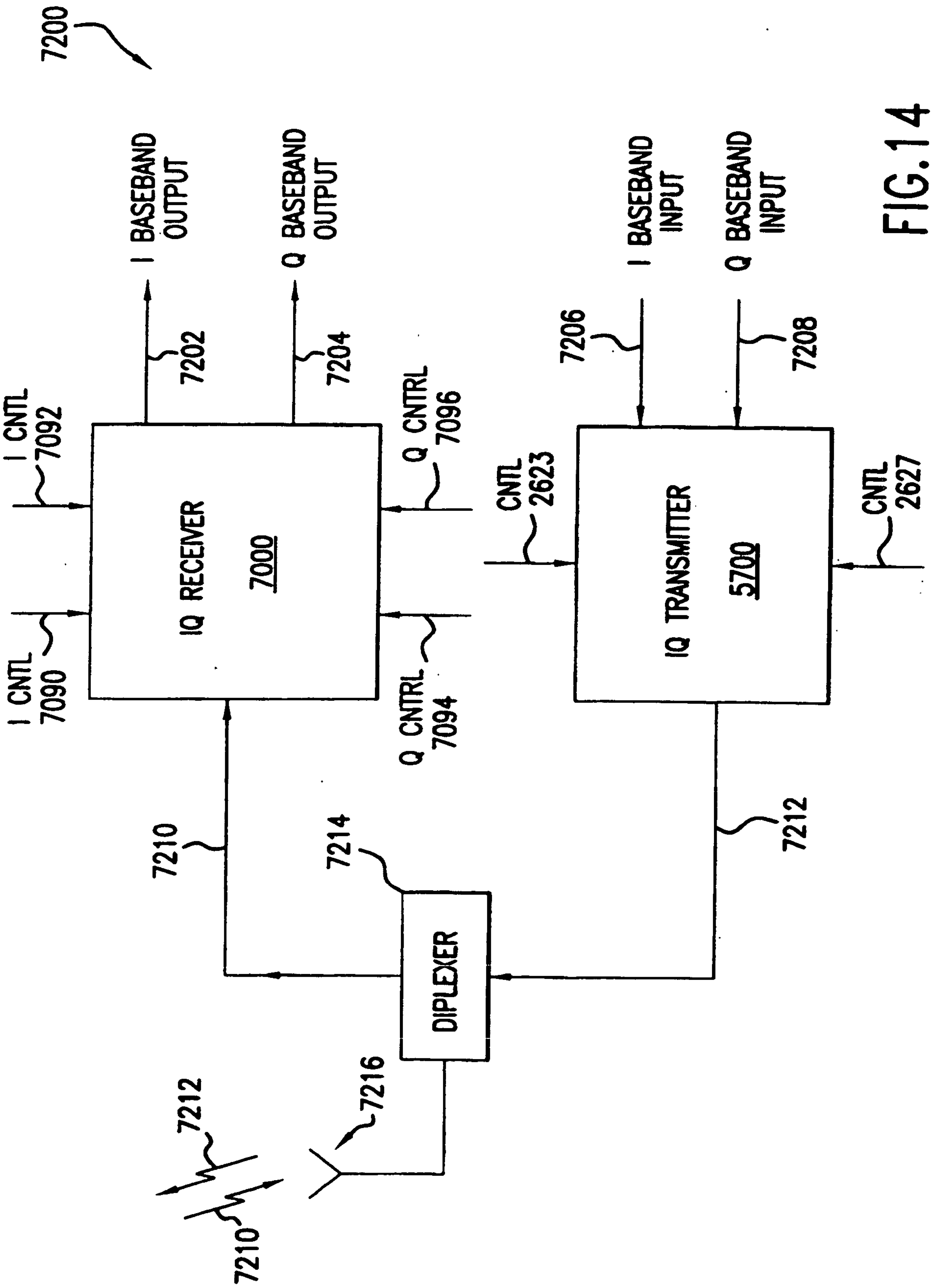
7200
I BASEBAND OUTPUT
Q BASEBAND OUTPUT
I BASEBAND INPUT
Q BASEBAND INPUT
I CNTL 7092
7202
7204
Q CNTRL 7096
7206
7208
CNTL 2623
CNTL 2627
I CNTL 7090
IQ RECEIVER
7000
Q CNTRL 7094
IQ TRANSMITTER
5700
7210
7214
7212
DIPLEXER
7216
7212
7210

FIG.14

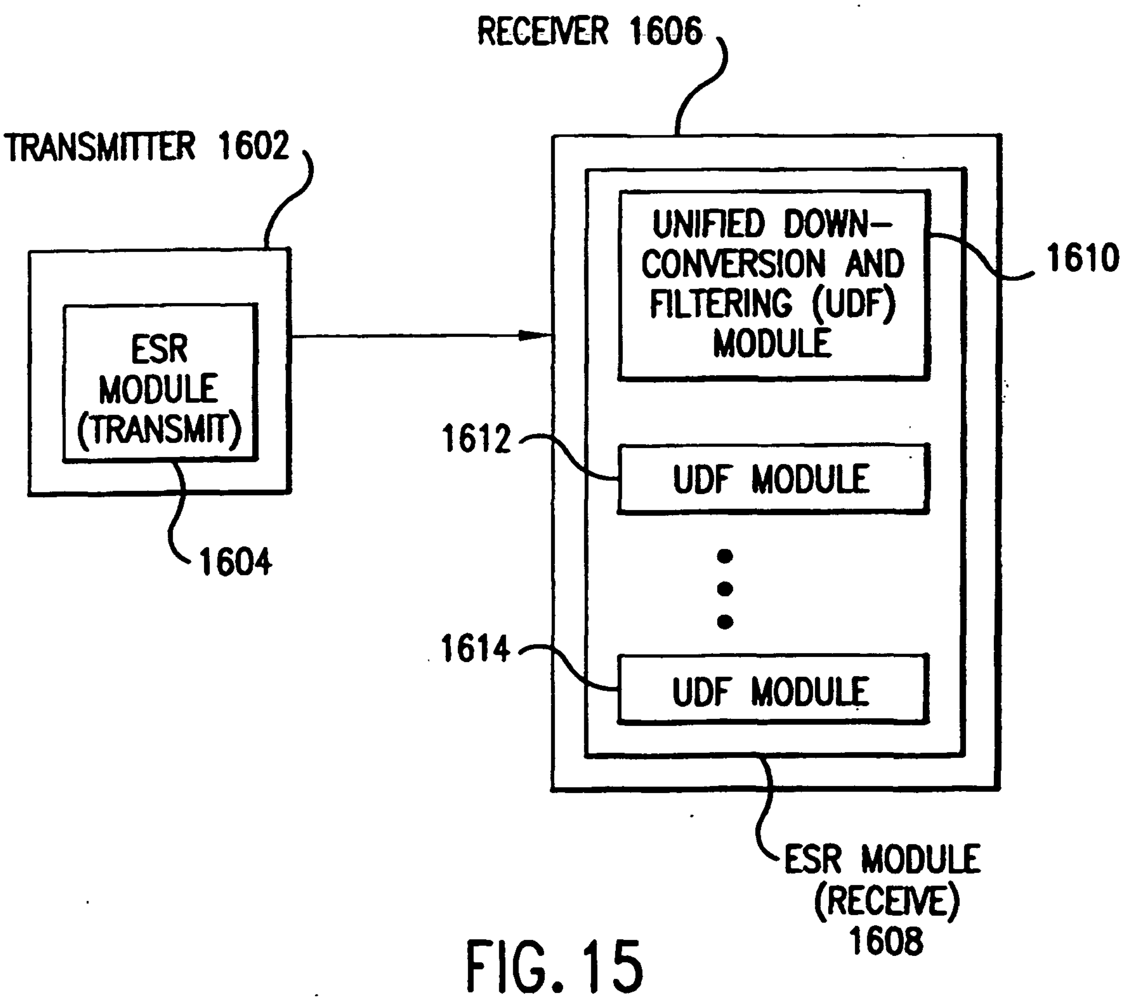
RECEIVER 1606
TRANSMITTER 1602
ESR MODULE (TRANSMIT)
1604
UNIFIED DOWN-CONVERSION AND FILTERING (UDF) MODULE
1610
1612
UDF MODULE
1614
UDF MODULE
ESR MODULE (RECEIVE) 1608

FIG. 15

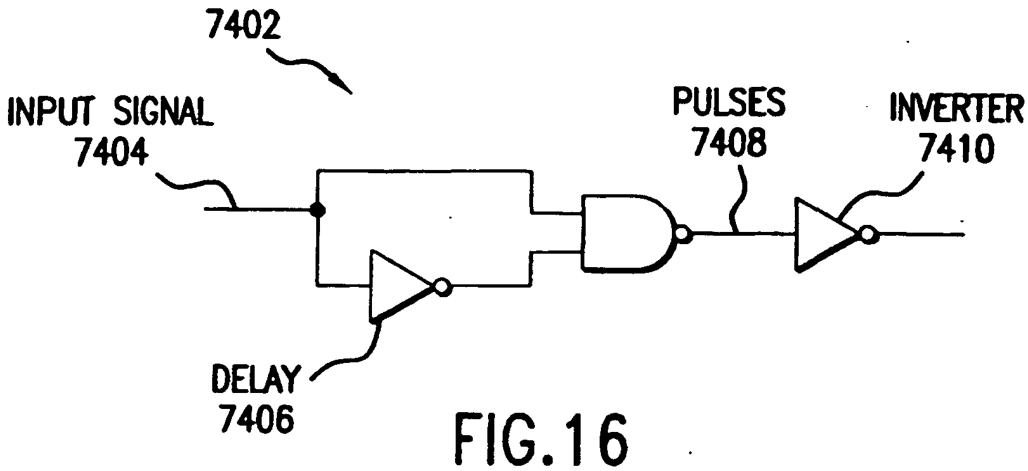


FIG.16

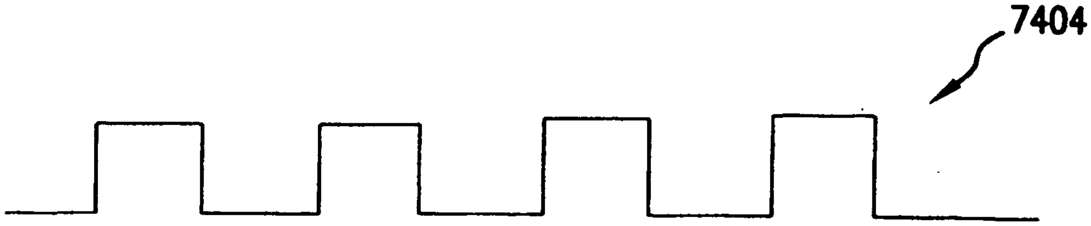


FIG.17

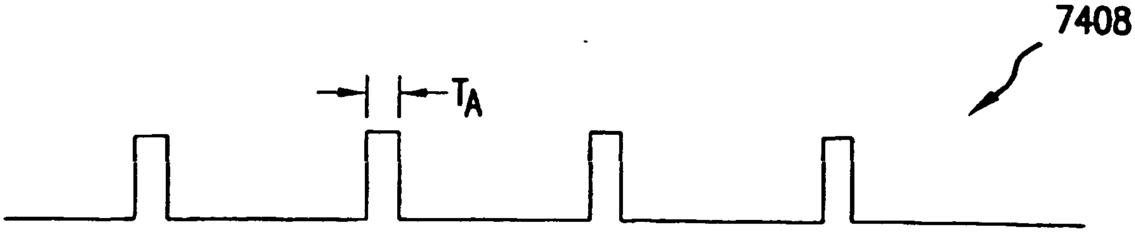


FIG.18

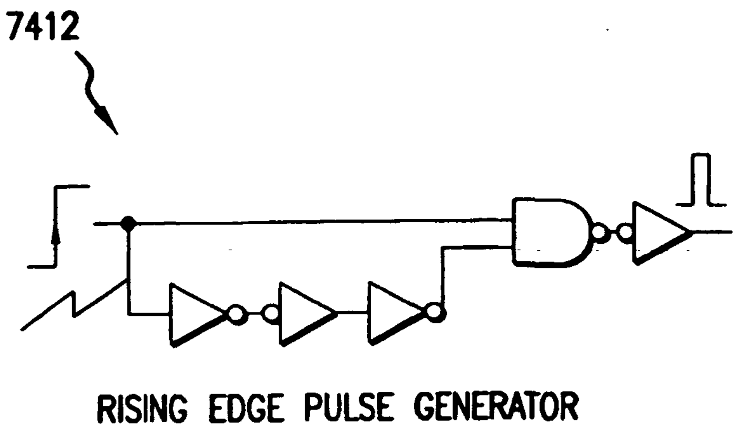
7412
RISING EDGE PULSE GENERATOR

FIG.19

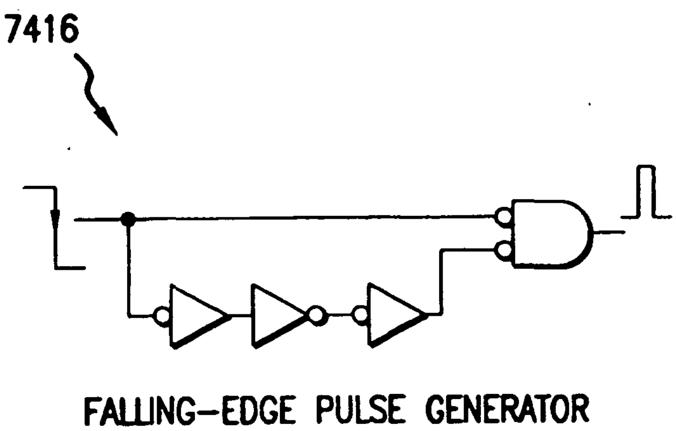
7416
FALLING-EDGE PULSE GENERATOR

FIG.20

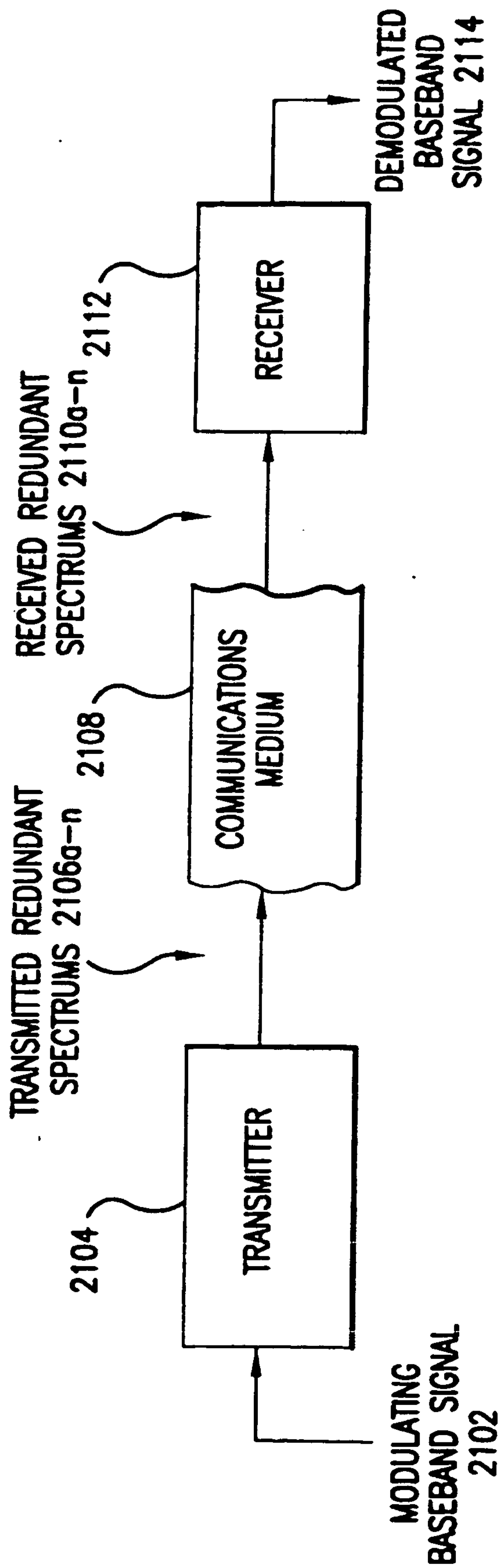
MODULATING BASEBAND SIGNAL 2102
2104
TRANSMITTER
TRANSMITTED REDUNDANT SPECTRUMS 2106a-n
2108
COMMUNICATIONS MEDIUM
RECEIVED REDUNDANT SPECTRUMS 2110a-n
2112
RECEIVER
DEMODULATED BASEBAND SIGNAL 2114

FIG. 21

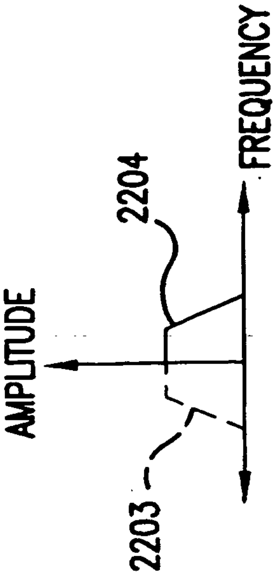

FIG. 22B

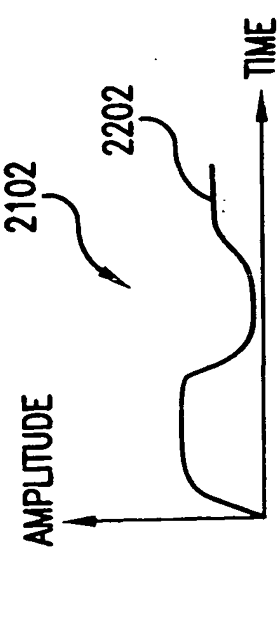

FIG. 22A

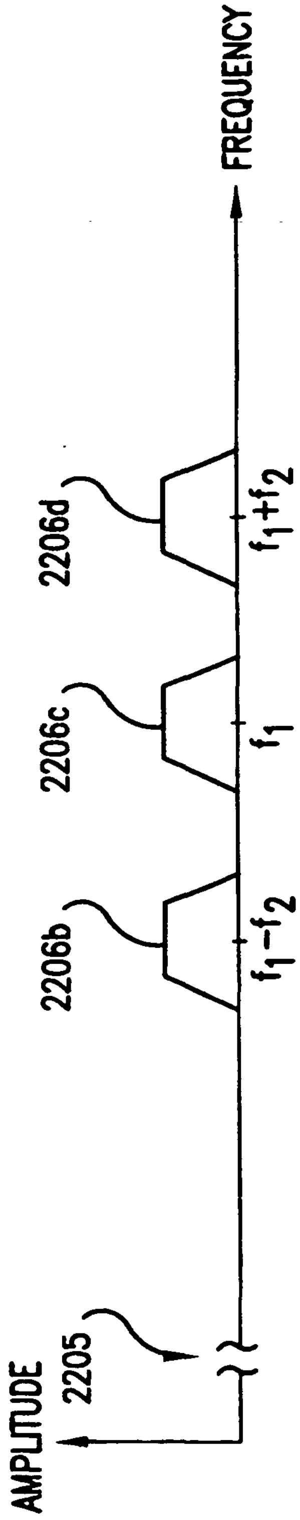

FIG. 22C

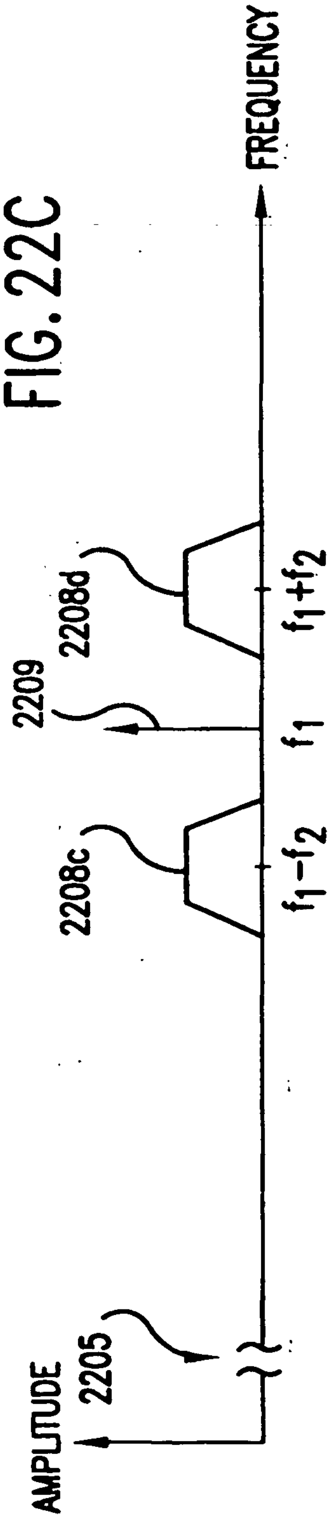

FIG. 22D

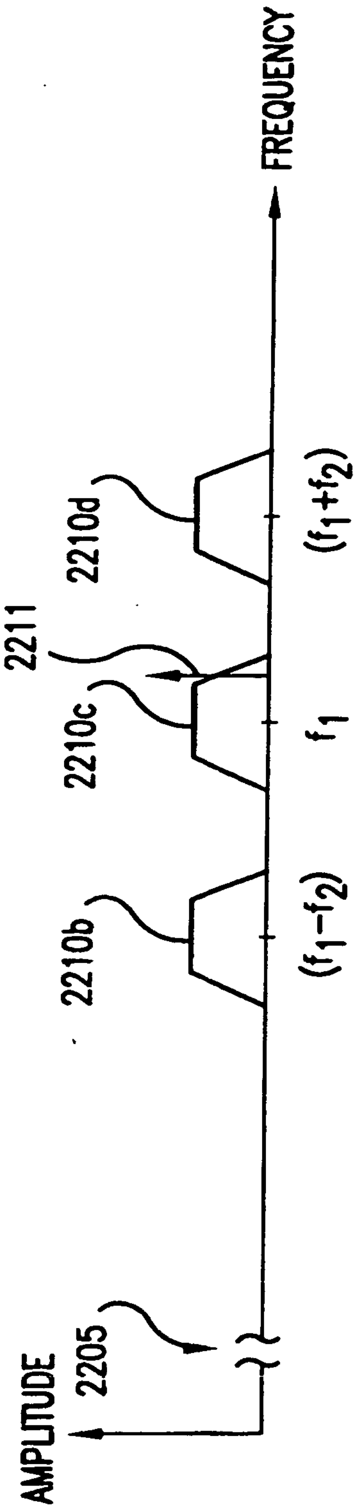


FIG. 22E

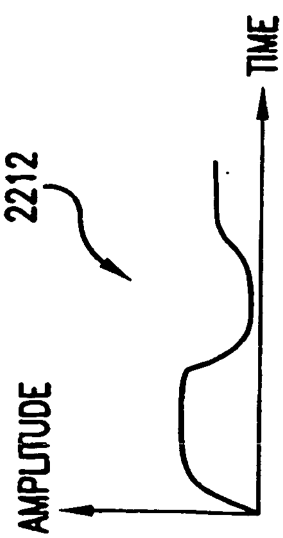


FIG. 22F

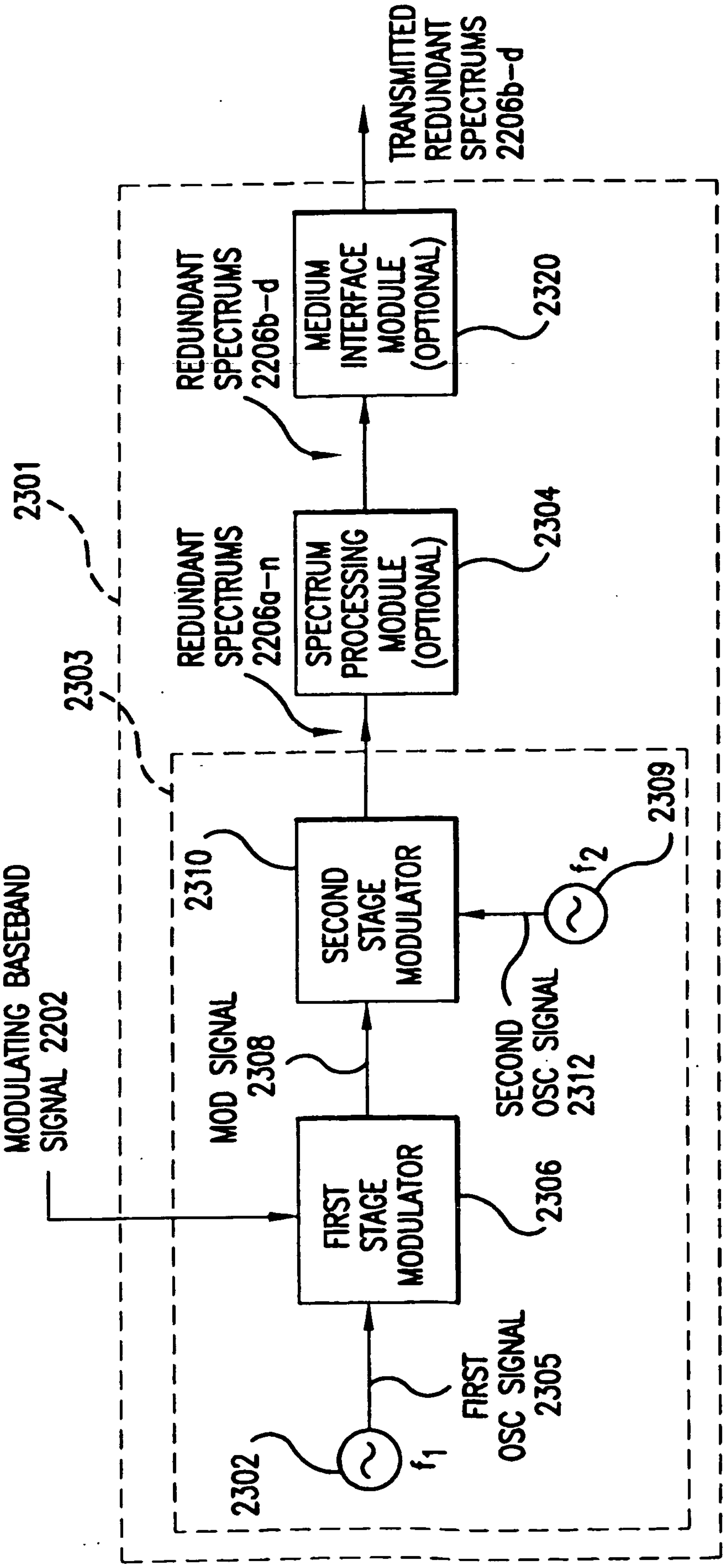
MODULATING BASEBAND SIGNAL 2202
2302
$f_1$
FIRST OSC SIGNAL 2305
FIRST STAGE MODULATOR
2306
MOD SIGNAL 2308
SECOND STAGE MODULATOR
2310
SECOND OSC SIGNAL 2312
$f_2$
2309
2303
2301
REDUNDANT SPECTRUMS 2206a–n
SPECTRUM PROCESSING MODULE (OPTIONAL)
2304
REDUNDANT SPECTRUMS 2206b–d
MEDIUM INTERFACE MODULE (OPTIONAL)
2320
TRANSMITTED REDUNDANT SPECTRUMS 2206b–d

FIG. 23A

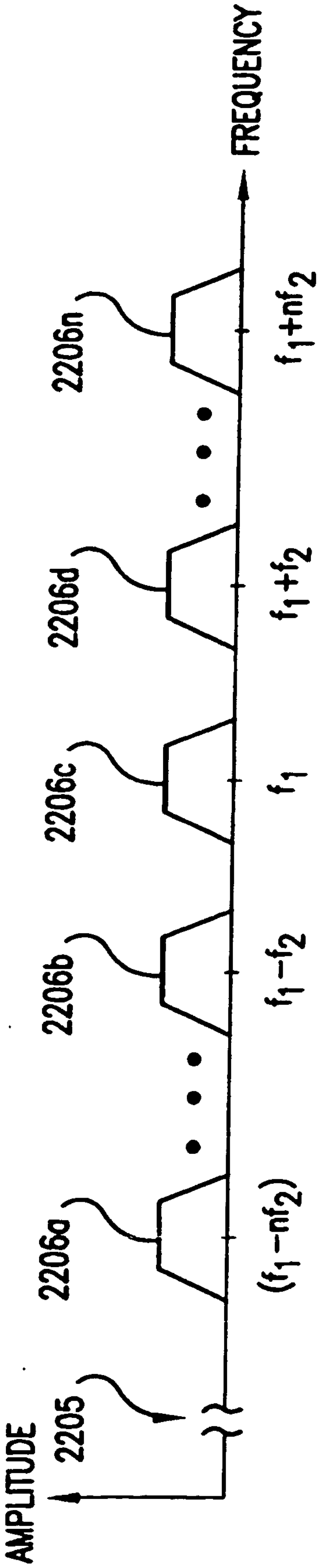


FIG. 23B

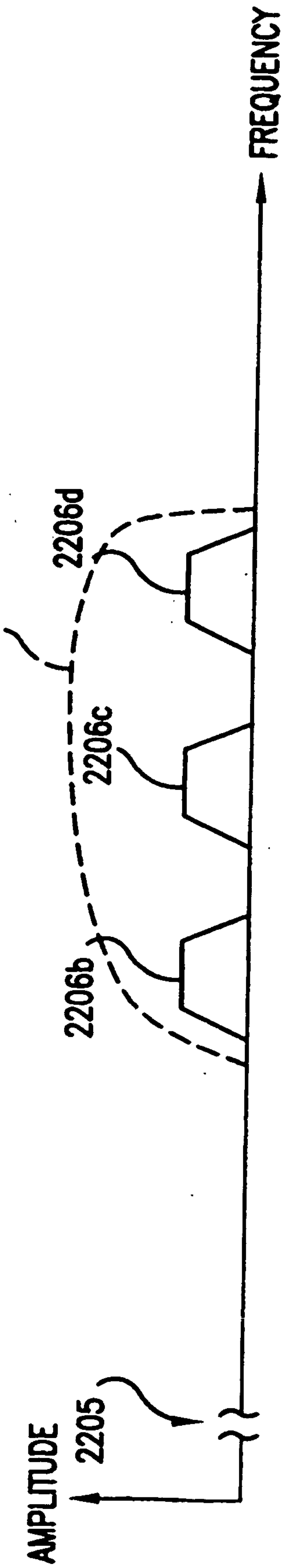


FIG. 23C

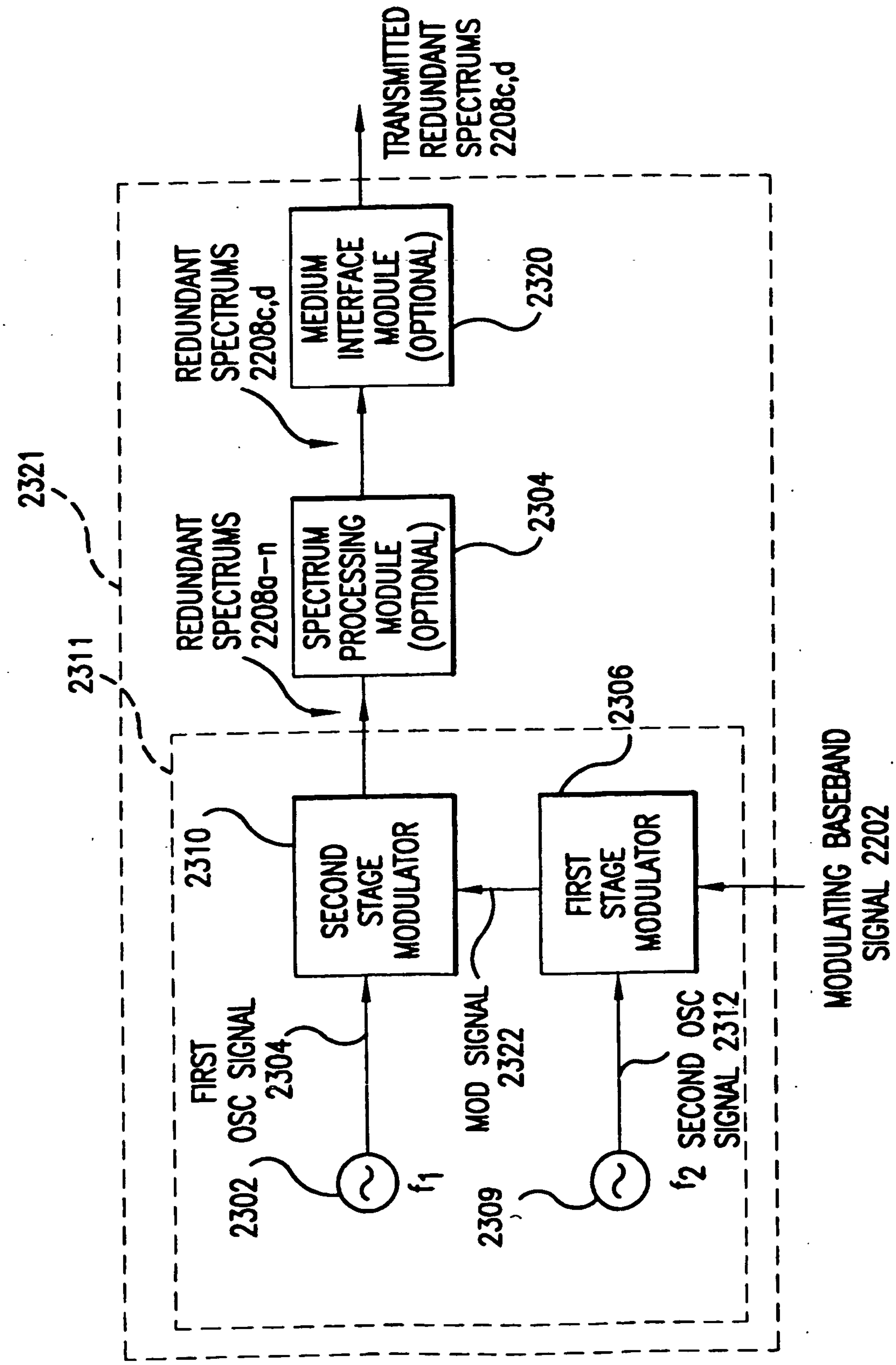
2321
2311
REDUNDANT SPECTRUMS 2208a–n
REDUNDANT SPECTRUMS 2208c,d
TRANSMITTED REDUNDANT SPECTRUMS 2208c,d
SPECTRUM PROCESSING MODULE (OPTIONAL)
2304
MEDIUM INTERFACE MODULE (OPTIONAL)
2320
2310
SECOND STAGE MODULATOR
2306
FIRST STAGE MODULATOR
MODULATING BASEBAND SIGNAL 2202
FIRST OSC SIGNAL 2304
MOD SIGNAL 2322
SECOND OSC SIGNAL 2312
2302
$f_1$
2309
$f_2$

FIG. 23D

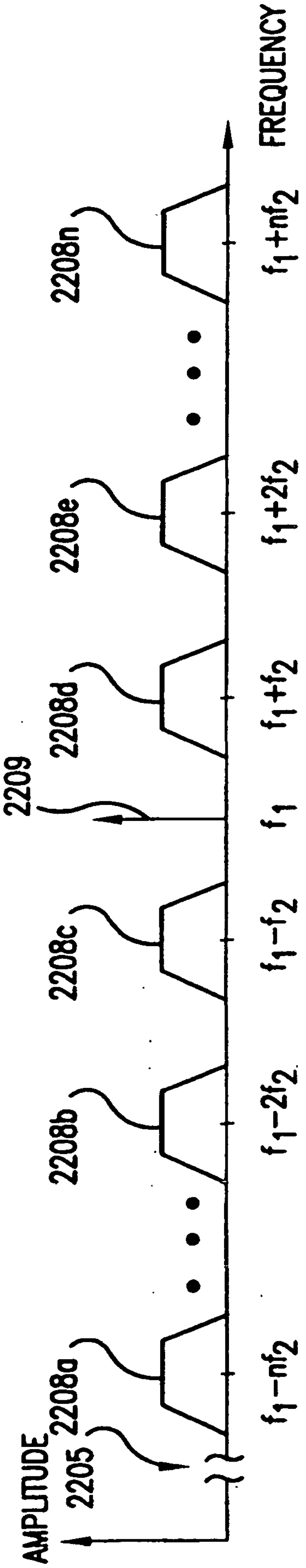


FIG. 23E

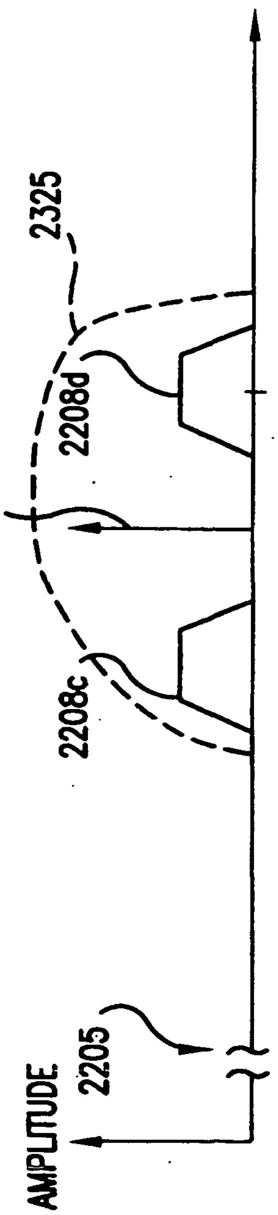


FIG. 23F

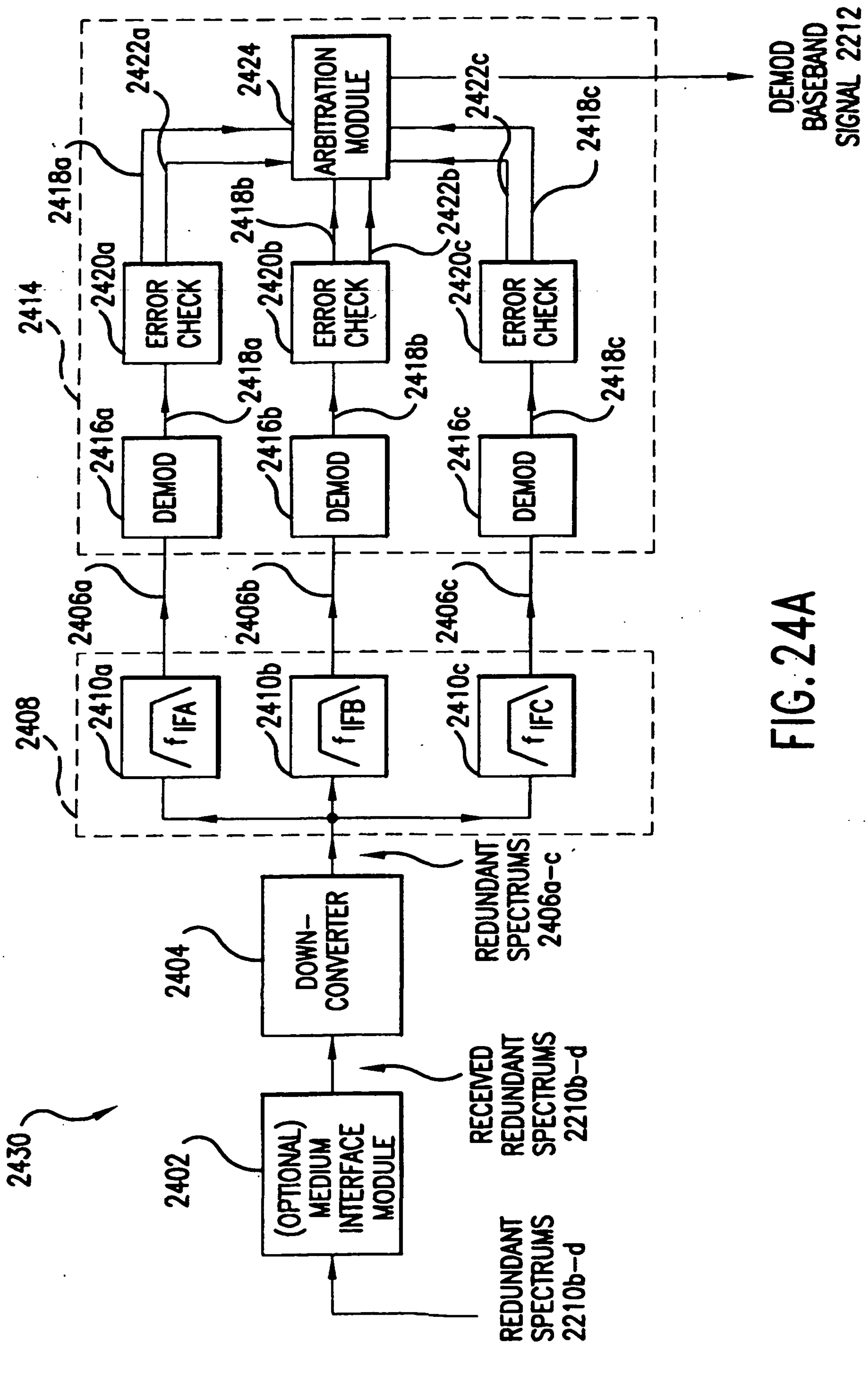
2430
2402
(OPTIONAL) MEDIUM INTERFACE MODULE
REDUNDANT SPECTRUMS 2210b–d
RECEIVED REDUNDANT SPECTRUMS 2210b–d
2404
DOWN-CONVERTER
REDUNDANT SPECTRUMS 2406a–c
2408
2410a
f IFA
2410b
f IFB
2410c
f IFC
2406a
2406b
2406c
2414
2416a
DEMOD
2416b
DEMOD
2416c
DEMOD
2418a
2418b
2418c
2420a
ERROR CHECK
2420b
ERROR CHECK
2420c
ERROR CHECK
2418a
2422a
2418b
2422b
2422c
2418c
2422c
2424
ARBITRATION MODULE
DEMOD BASEBAND SIGNAL 2212

FIG. 24A

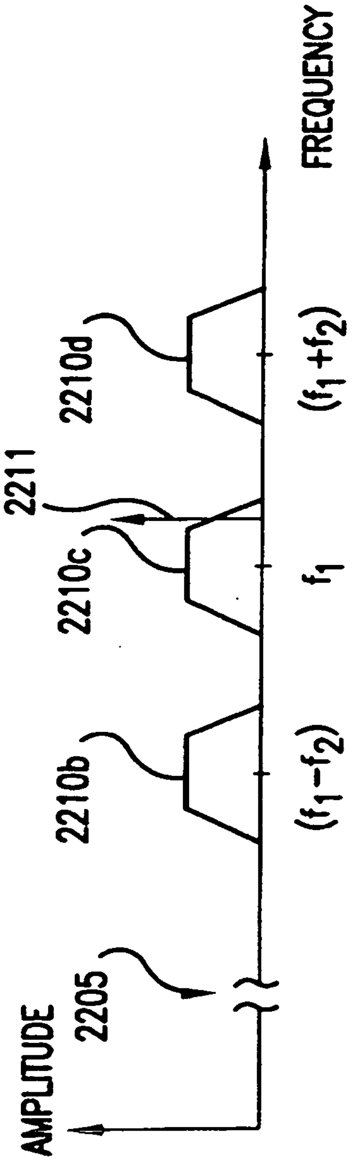


FIG. 24B

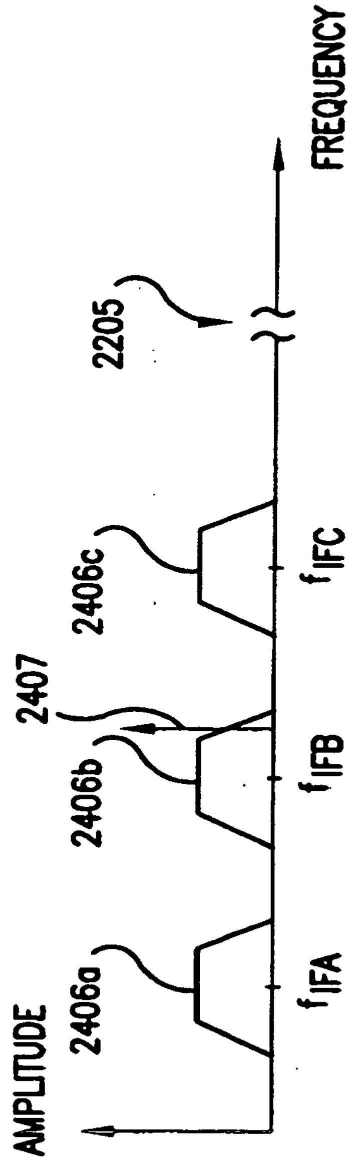


FIG. 24C

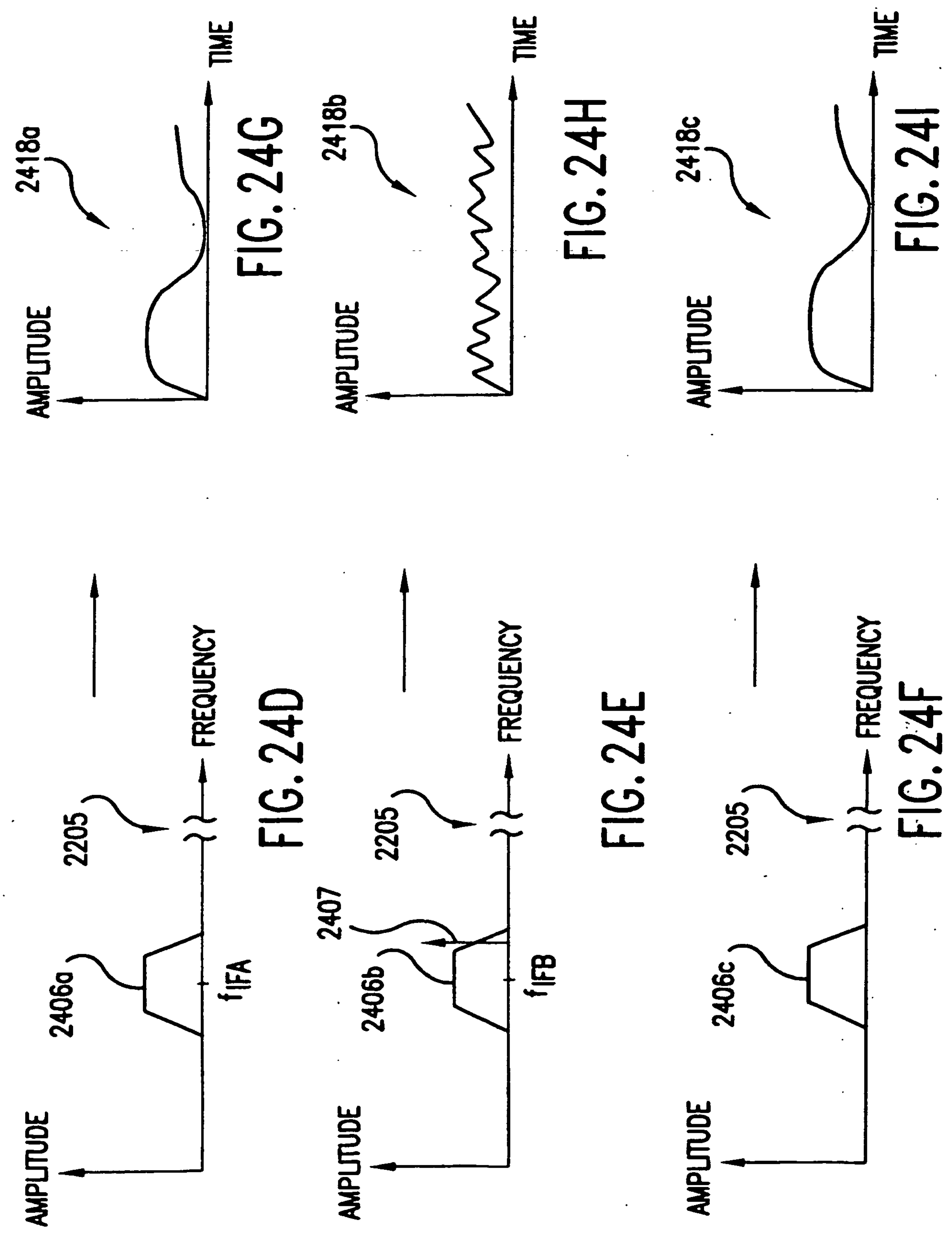


FIG. 24G

FIG. 24H

FIG. 24I

FIG. 24D

FIG. 24E

FIG. 24F

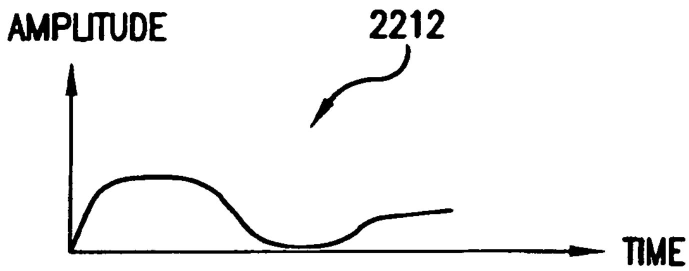


FIG. 24J

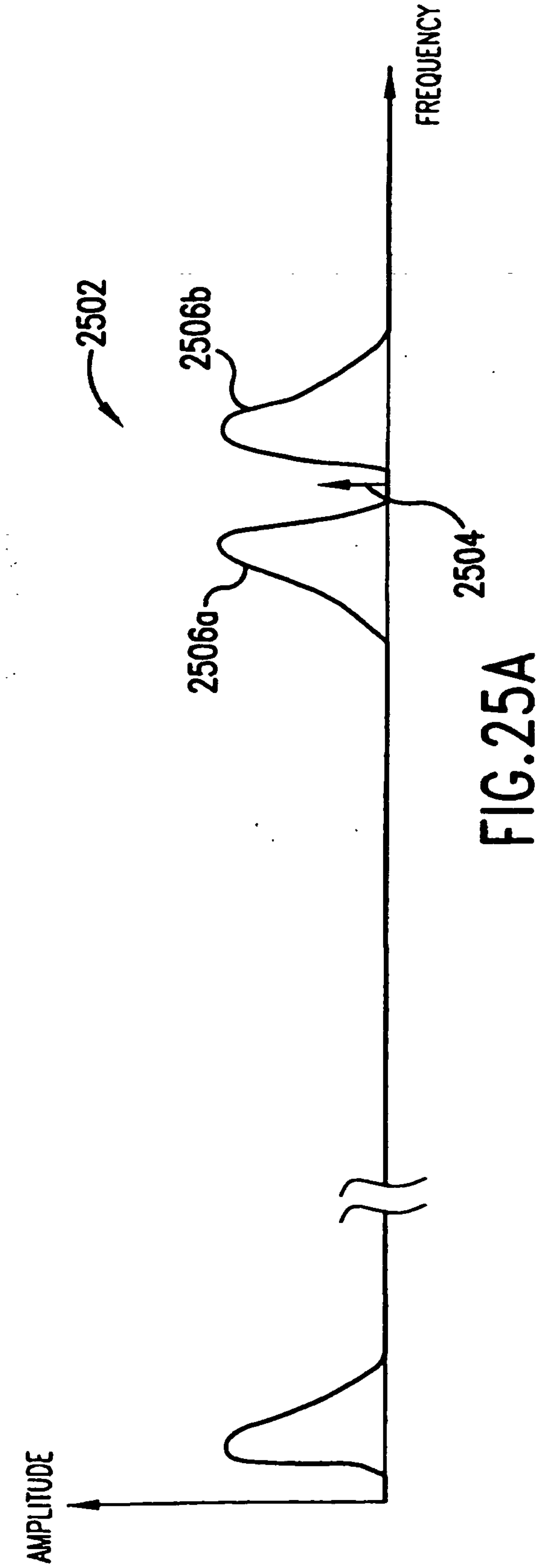


FIG.25A

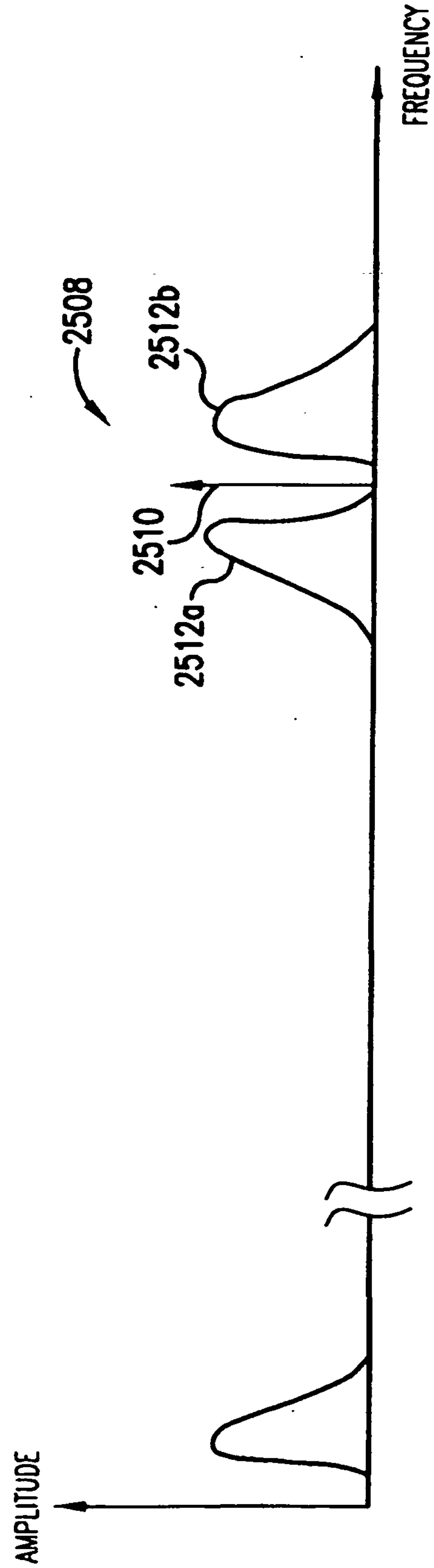


FIG.25B

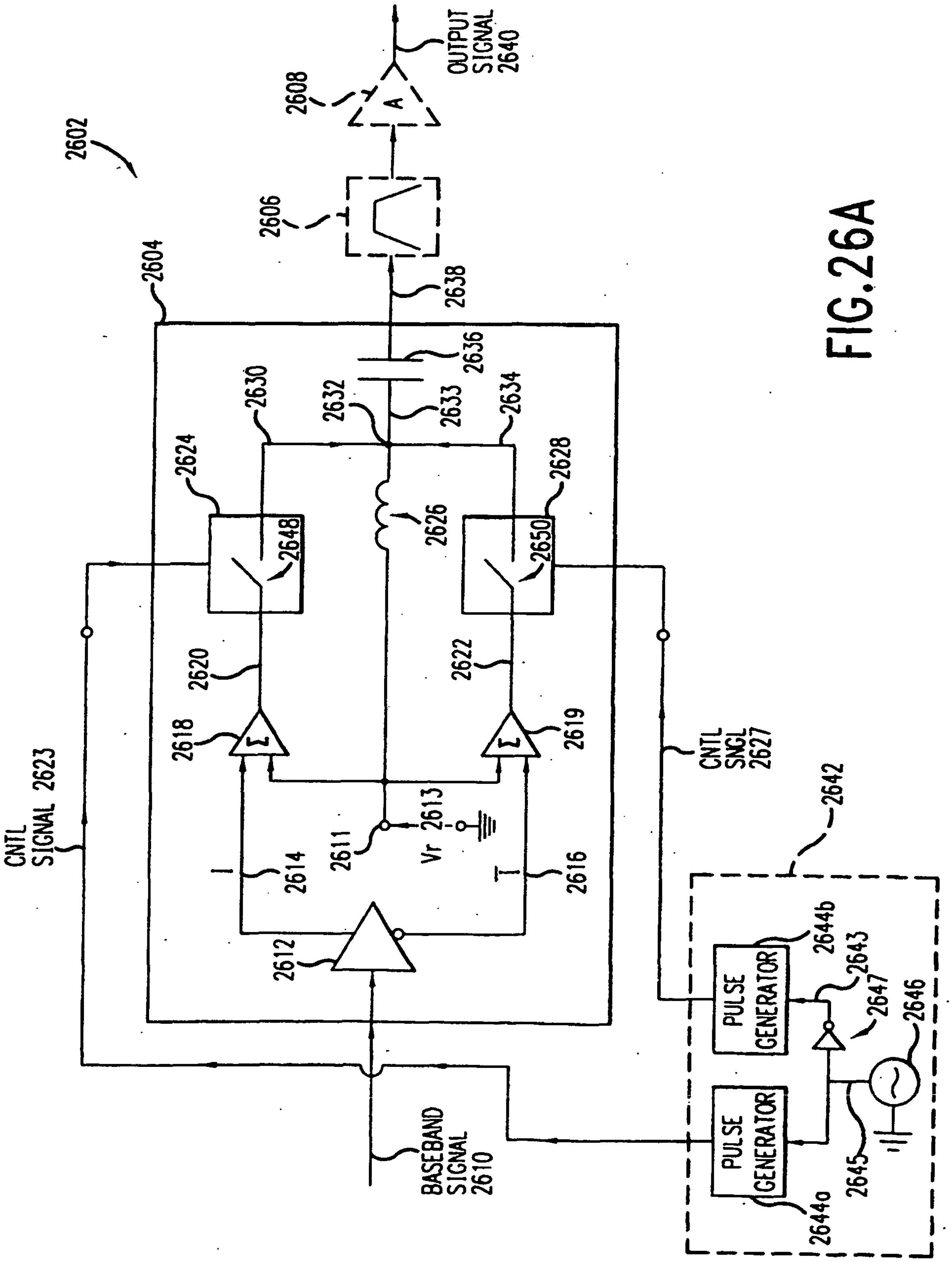
2602
2604
2606
2608
A
OUTPUT SIGNAL 2640
2638
2636
2630
2632
2633
2634
2624
2648
2626
2628
2650
2620
2622
2618
2619
CNTL SIGNAL 2623
CNTL SNGL 2627
2614
2611
Vr
2613
2616
I
2612
BASEBAND SIGNAL 2610
2642
PULSE GENERATOR
2644b
2643
2647
2646
PULSE GENERATOR
2644a
2645

FIG.26A

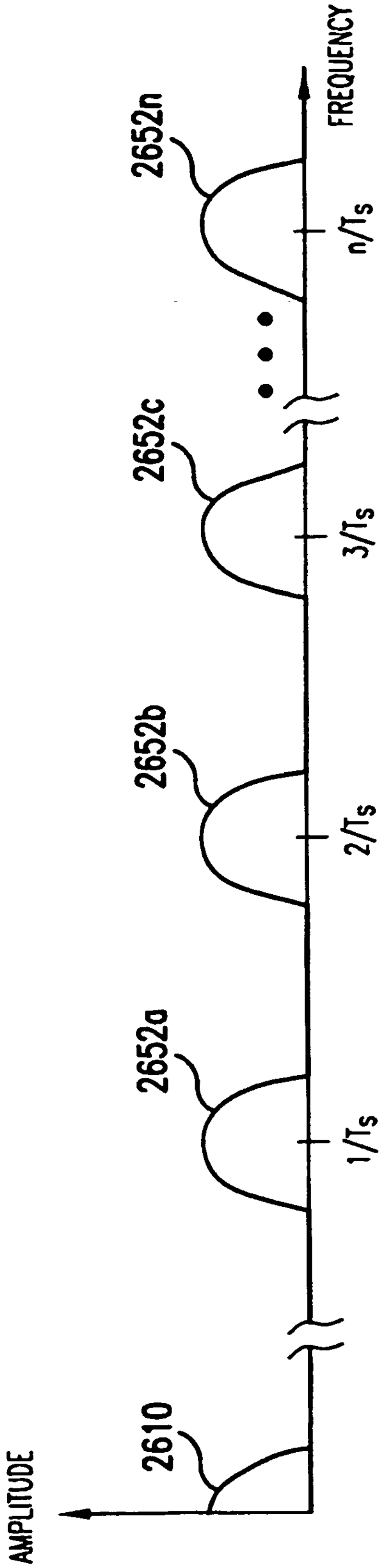
2630
FREQUENCY
2652n
n/$T_s$
2652c
3/$T_s$
2652b
2/$T_s$
2652a
1/$T_s$
2610
AMPLITUDE

FIG.26B

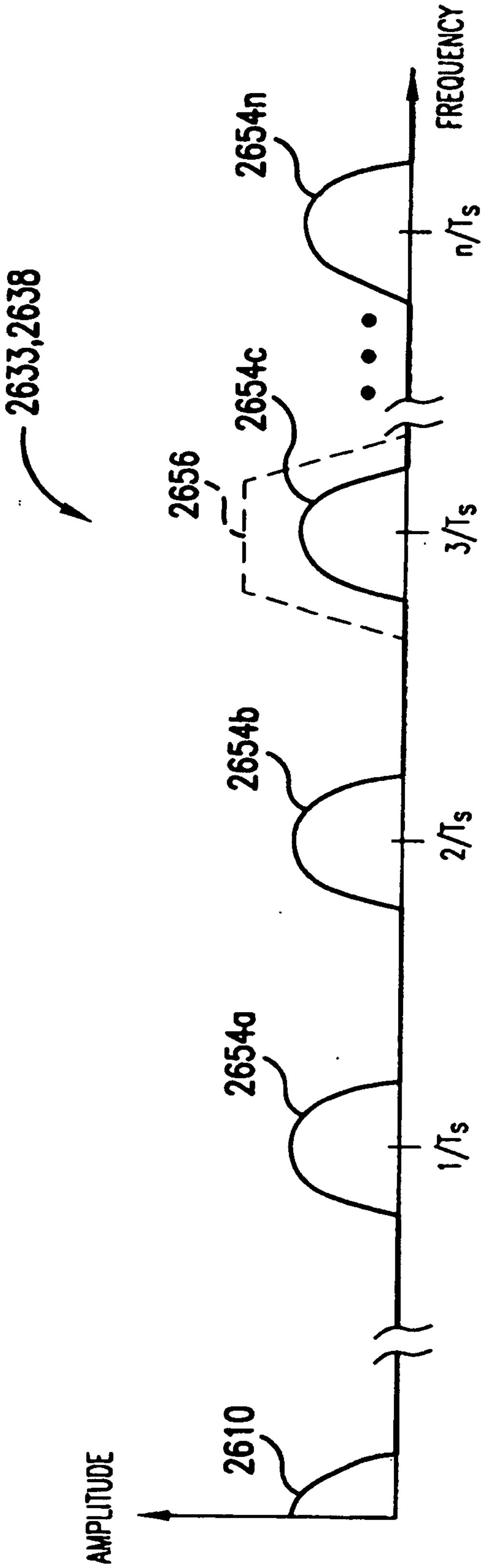
2633,2638
FREQUENCY
AMPLITUDE
2610
2654a
2654b
2654c
2654n
2656
$1/T_s$
$2/T_s$
$3/T_s$
$n/T_s$

FIG.26C

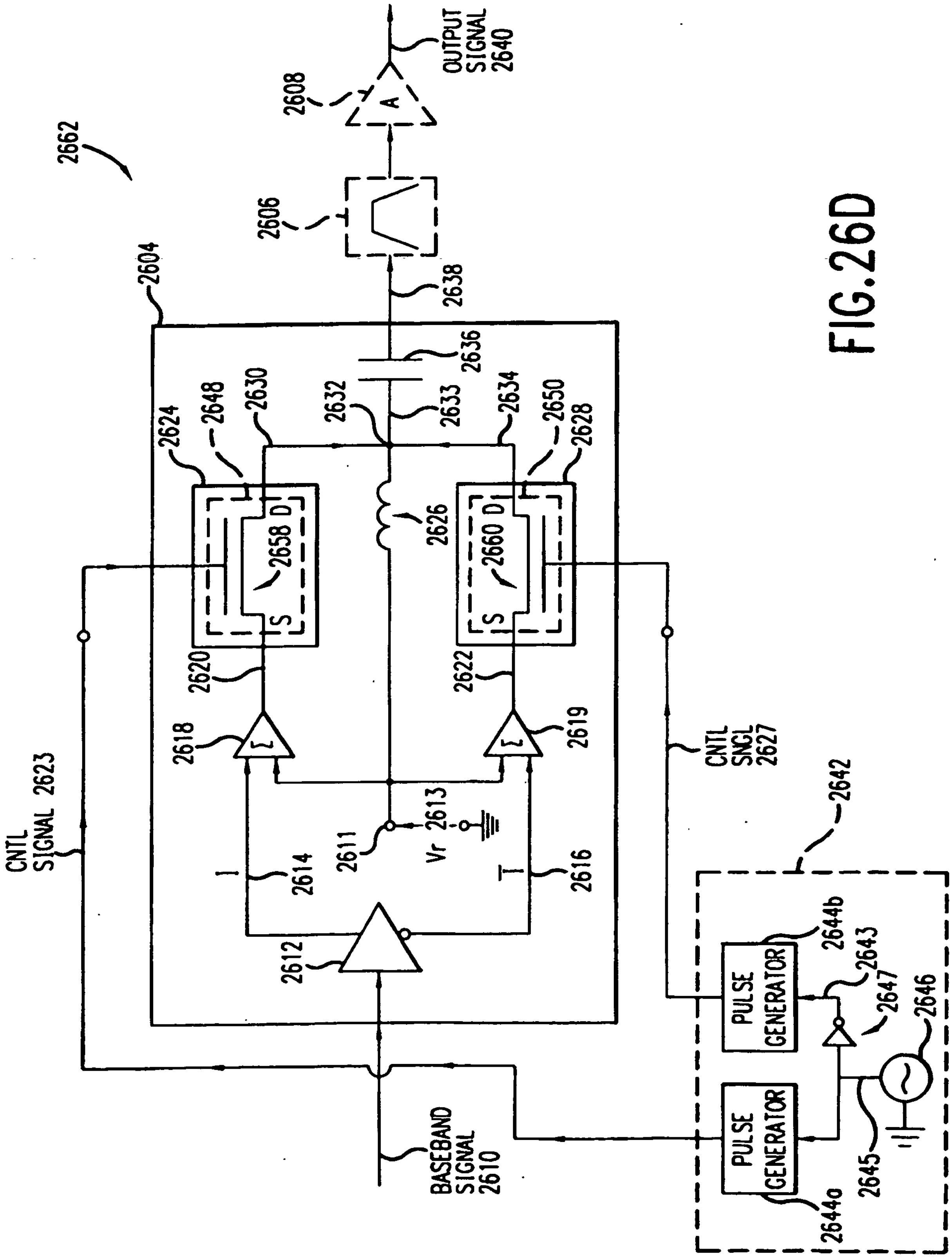
2662
2604
2606
2608
OUTPUT SIGNAL 2640
2638
2636
2624
2648
2630
2632
2633
2634
2650
2628
2658 D
S
2626
2660 D
S
2620
2622
2618
2619
CNTL SIGNAL 2623
CNTL SNGL 2627
2613
2611
Vr
2614
2616
2612
2642
PULSE GENERATOR
2644b
2643
2647
2646
PULSE GENERATOR
2644a
2645
BASEBAND SIGNAL 2610

FIG.26D

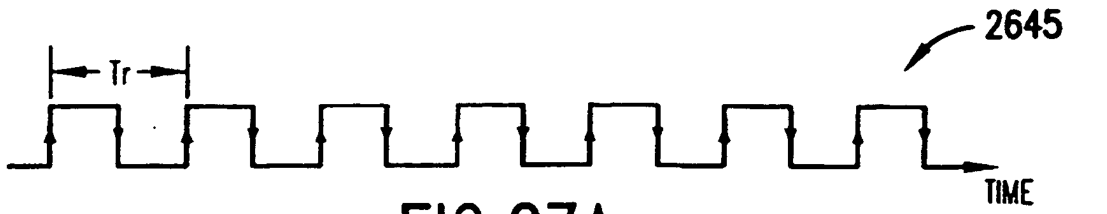


FIG.27A

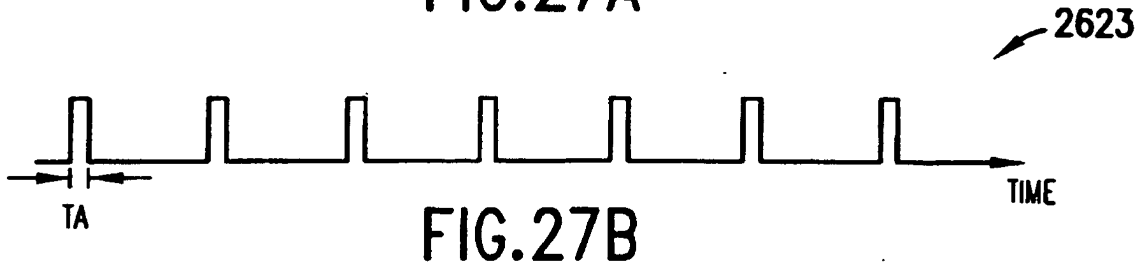


FIG.27B

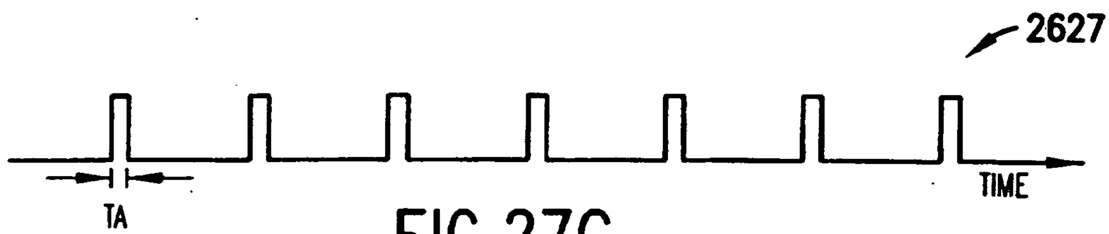


FIG.27C

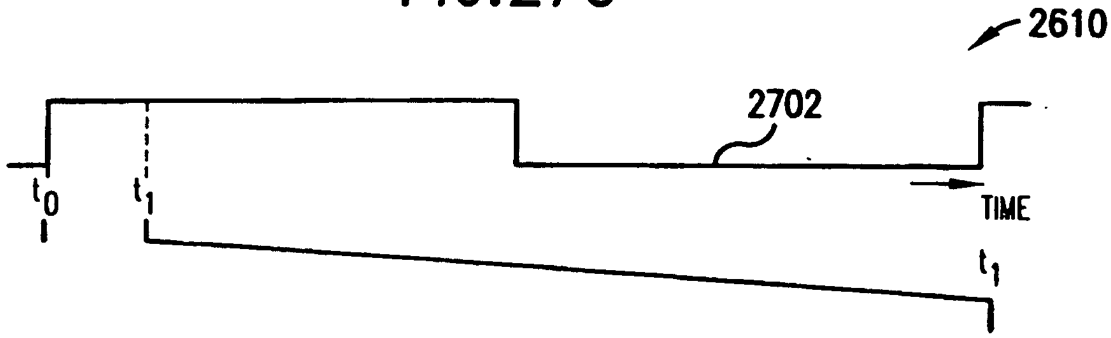


FIG.27D

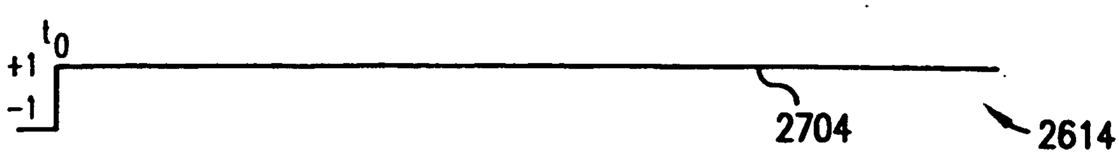


FIG.27E

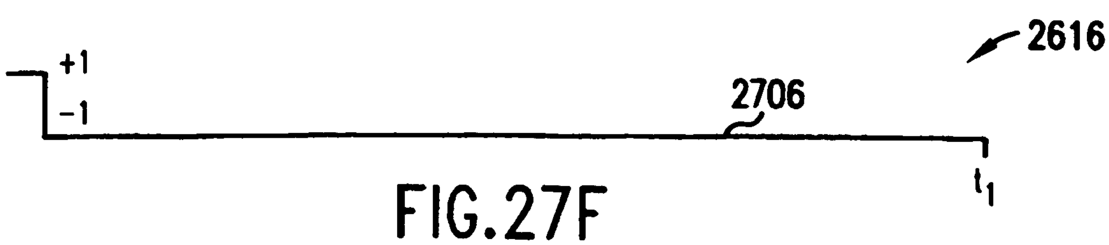


FIG.27F

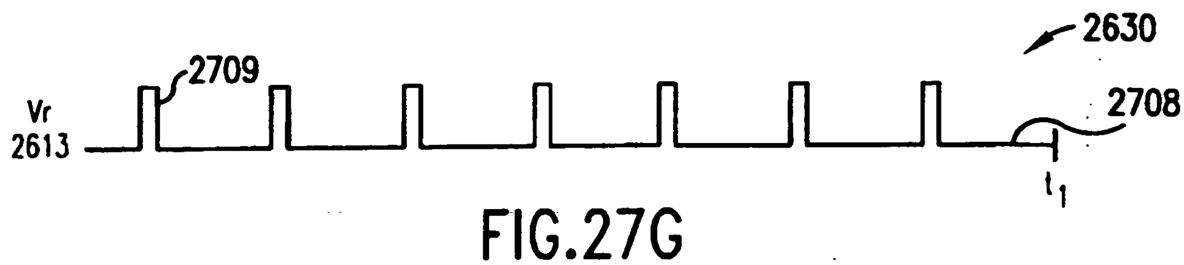


FIG.27G

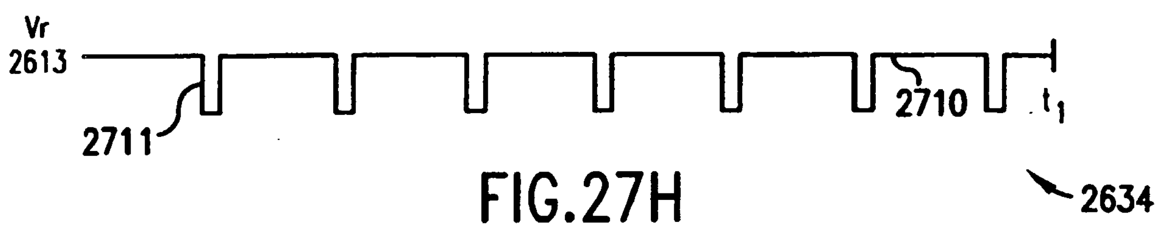


FIG.27H

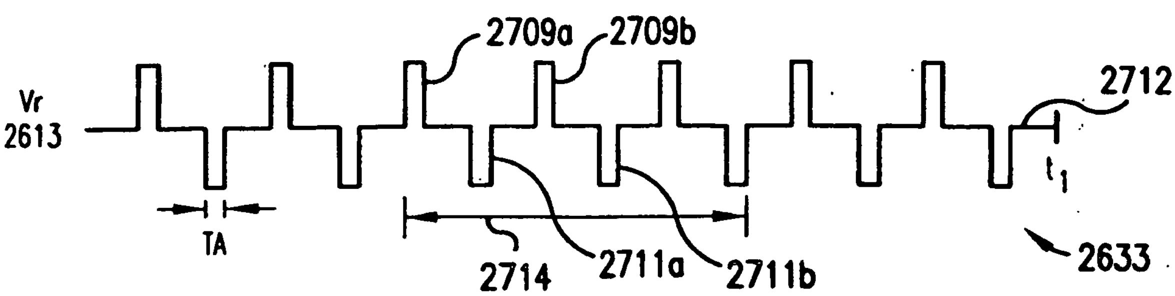


FIG.27I

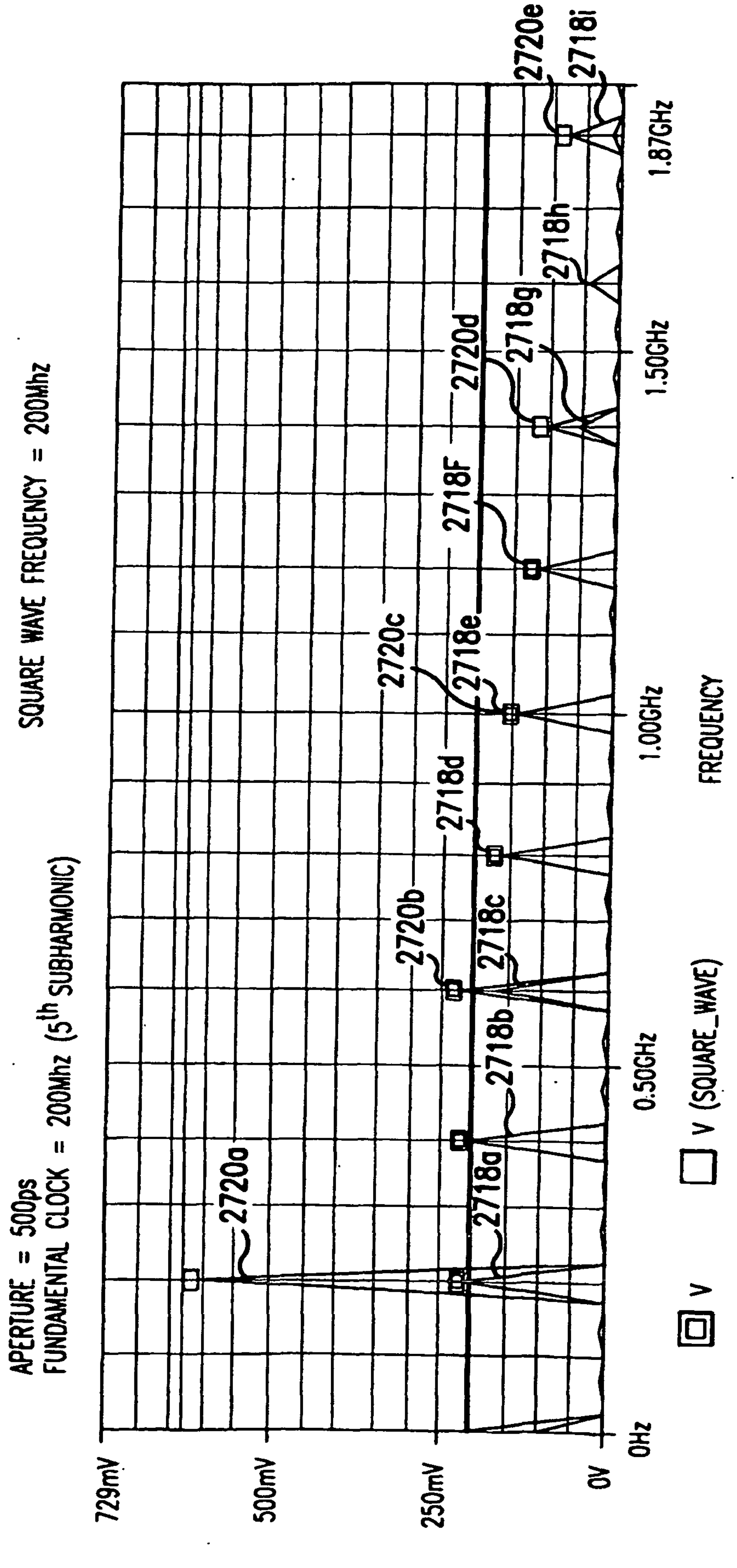
APERTURE = 500ps
FUNDAMENTAL CLOCK = 200Mhz (5th SUBHARMONIC)
SQUARE WAVE FREQUENCY = 200Mhz
729mV
500mV
250mV
0V
0Hz
0.50GHz
1.00GHz
1.50GHz
1.87GHz
FREQUENCY
V
V (SQUARE_WAVE)
2720a
2718a
2718b
2720b
2718c
2718d
2720c
2718e
2718F
2720d
2718g
2718h
2720e
2718i

FIG.27J

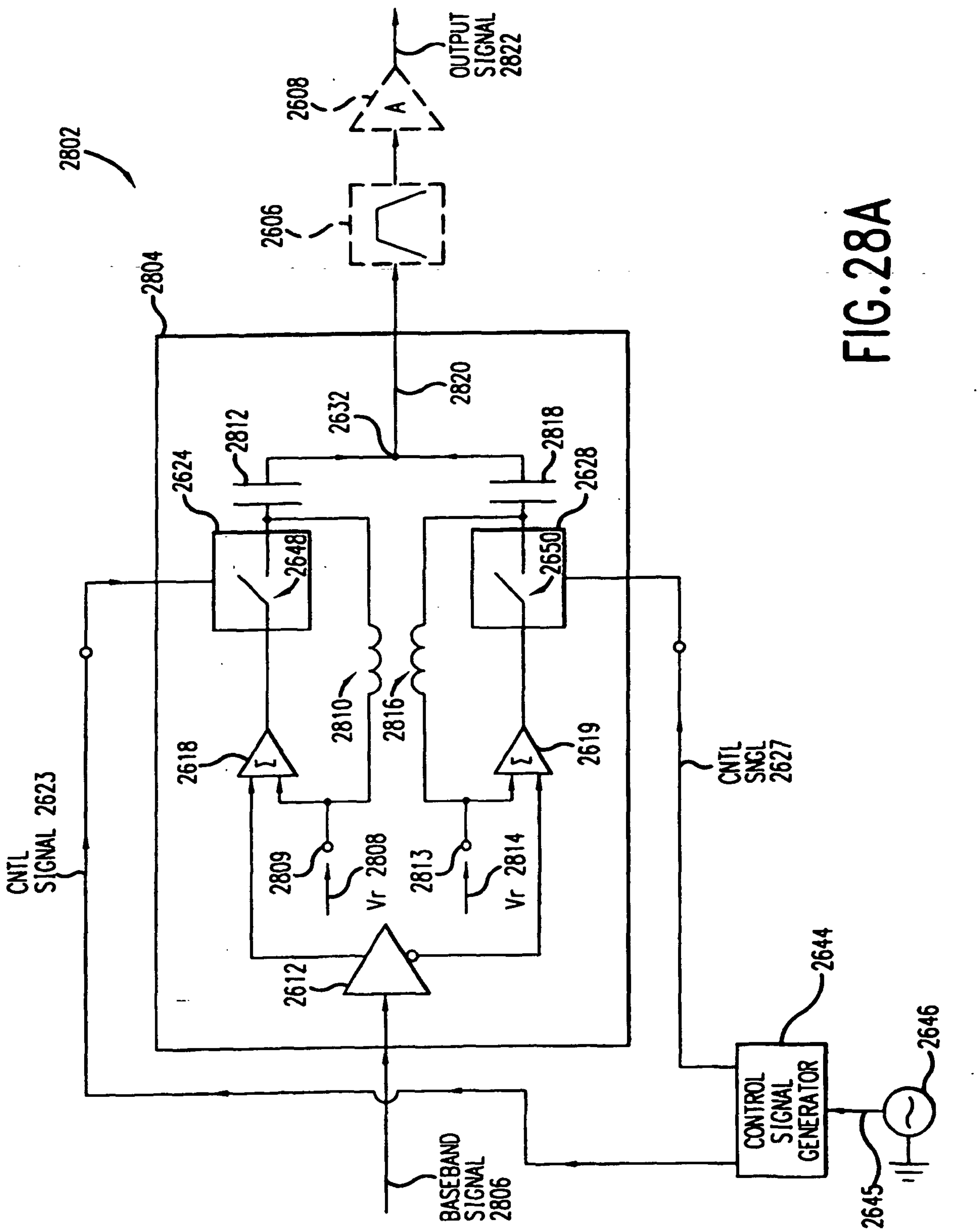
2802
2804
2606
2608
A
OUTPUT SIGNAL 2822
2820
2632
2812
2818
2624
2628
2648
2650
2810
2816
2618
2619
CNTL SIGNAL 2623
CNTL SNGL 2627
2809
2808
Vr
2813
2814
Vr
2612
2644
CONTROL SIGNAL GENERATOR
2646
2645
BASEBAND SIGNAL 2806

FIG.28A

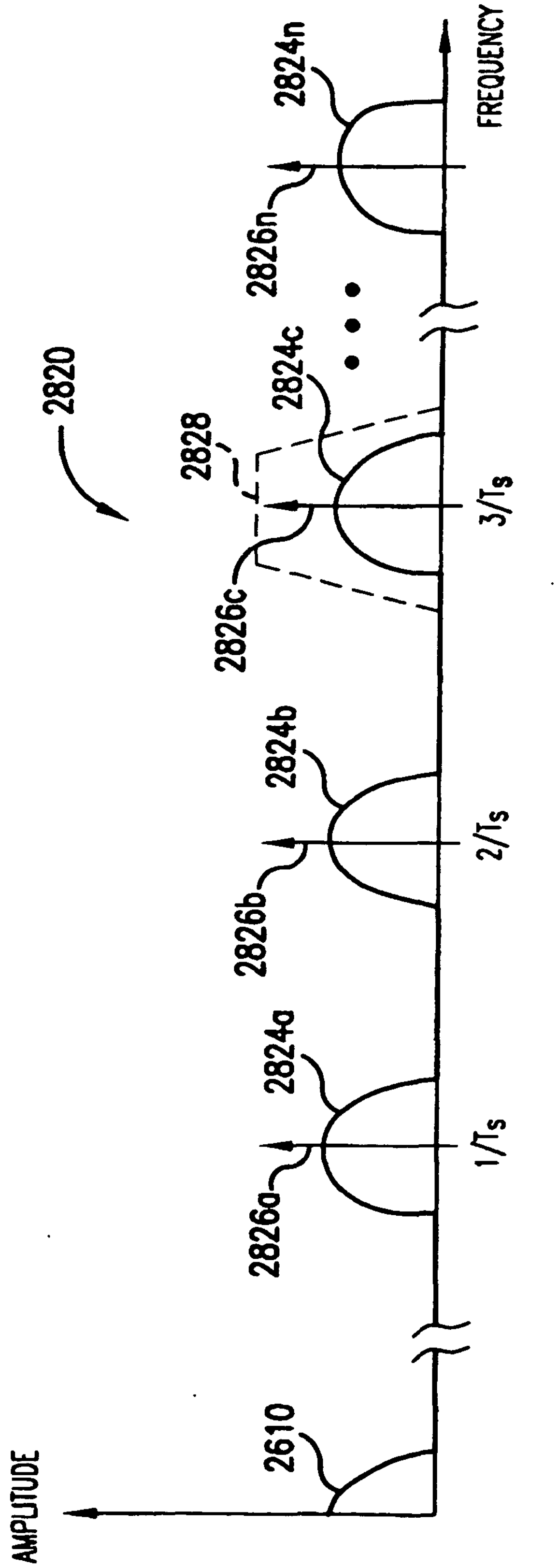
2820
2828
2824n
2826n
2824c
2826c
2824b
2826b
2824a
2826a
2610
FREQUENCY
AMPLITUDE
1/Ts
2/Ts
3/Ts

FIG.28B

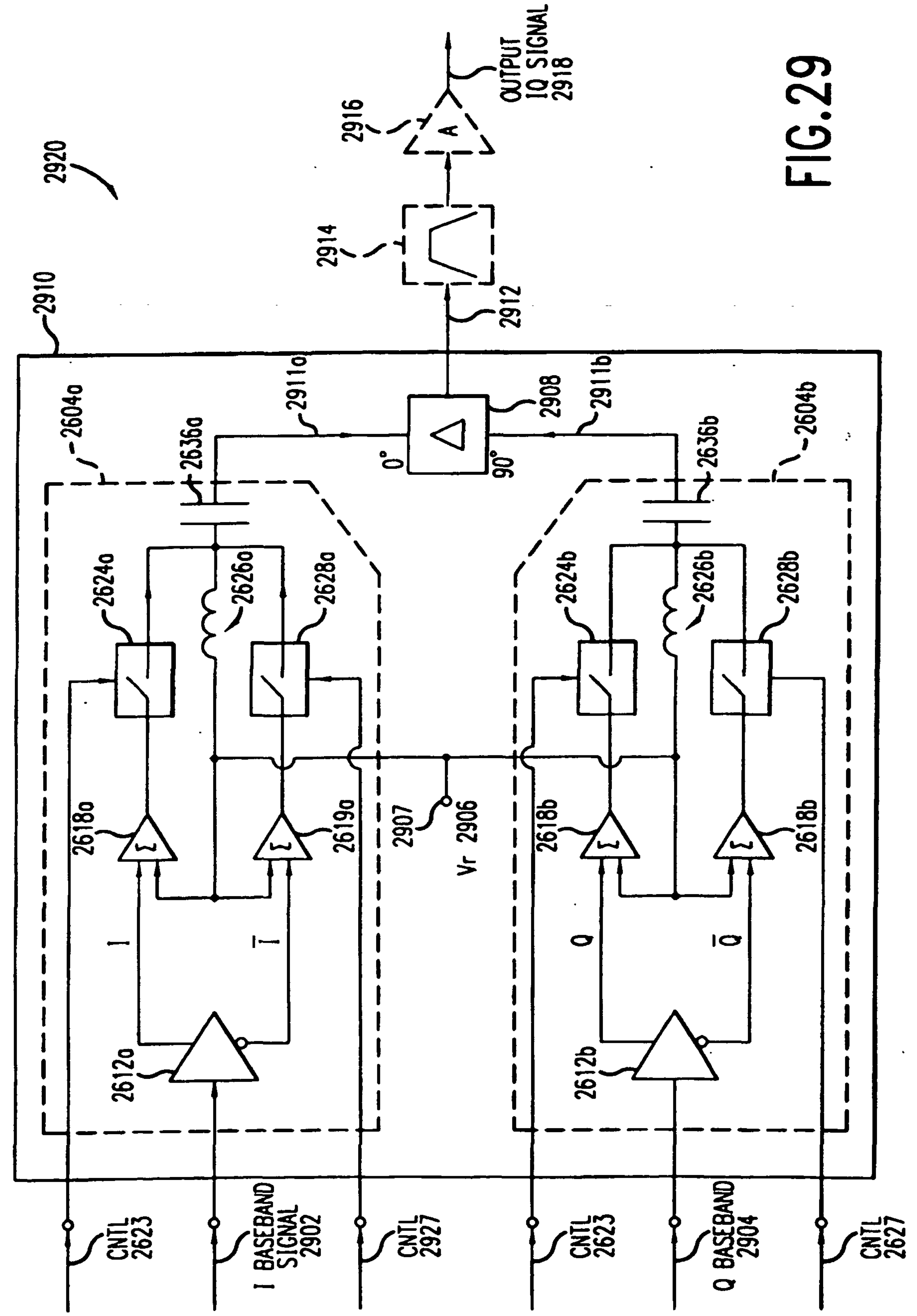

2920
2910
2604a
2636a
2911a
2908
2911b
2636b
2604b
0°
90°
2624a
2626a
2628a
2624b
2626b
2628b
2618a
2619a
2907
Vr 2906
2618b
2618b
I
Ī
Q
Q̄
2612a
2612b
2912
2914
2916
A
OUTPUT
IQ SIGNAL
2918
CNTL
2623
I BASEBAND
SIGNAL
2902
CNTL
2927
CNTL
2623
Q BASEBAND
2904
CNTL
2627


FIG.29

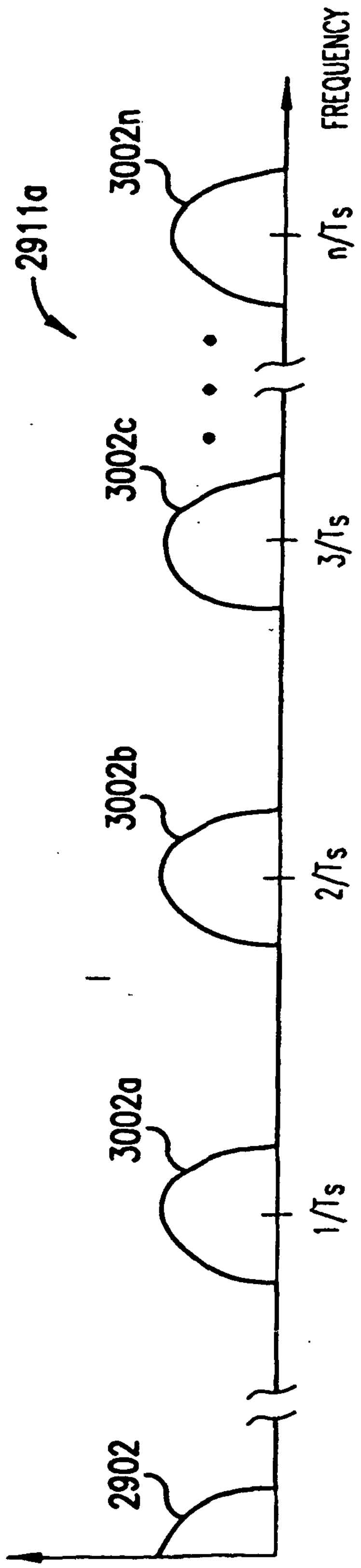


FIG.30A

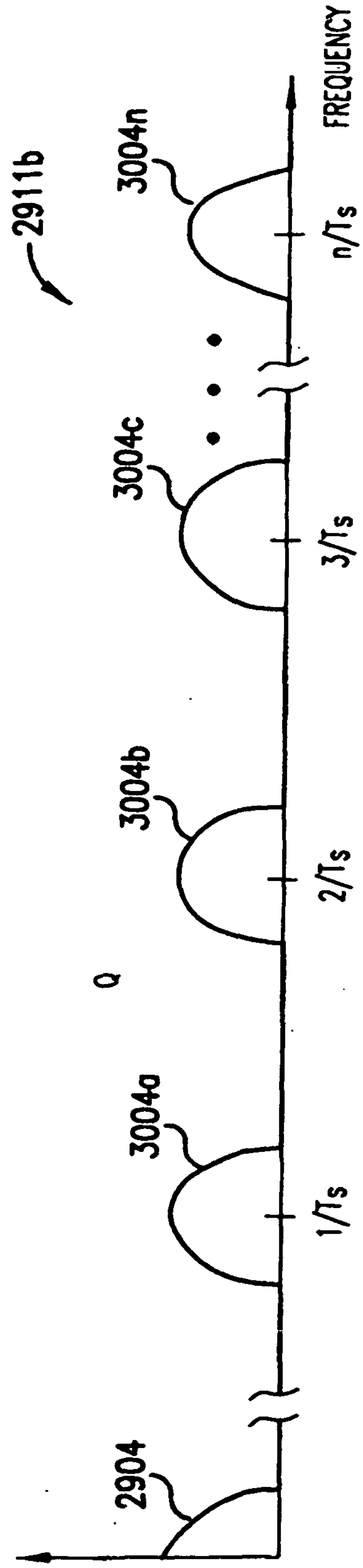


FIG.30B

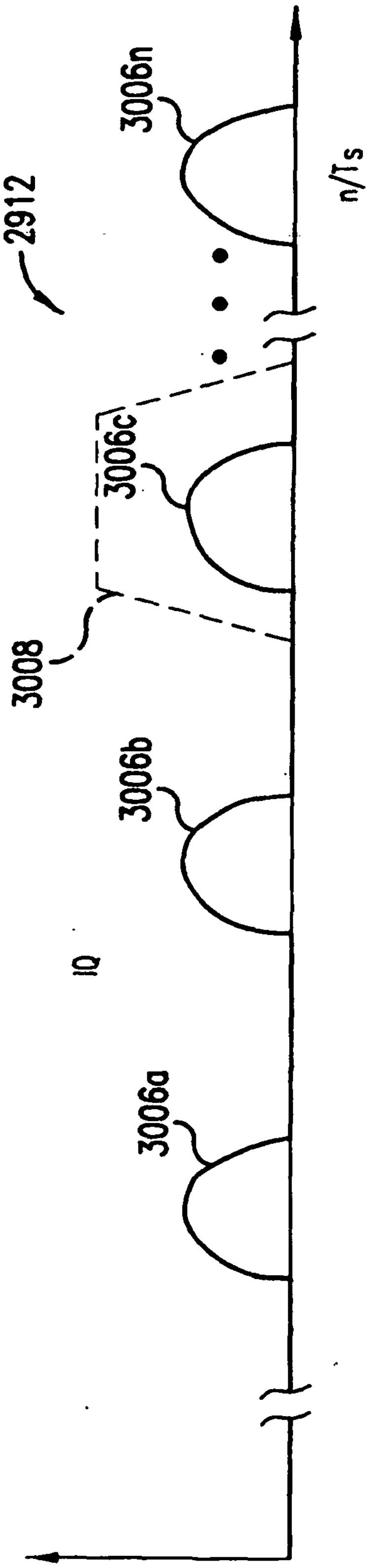


FIG.30C

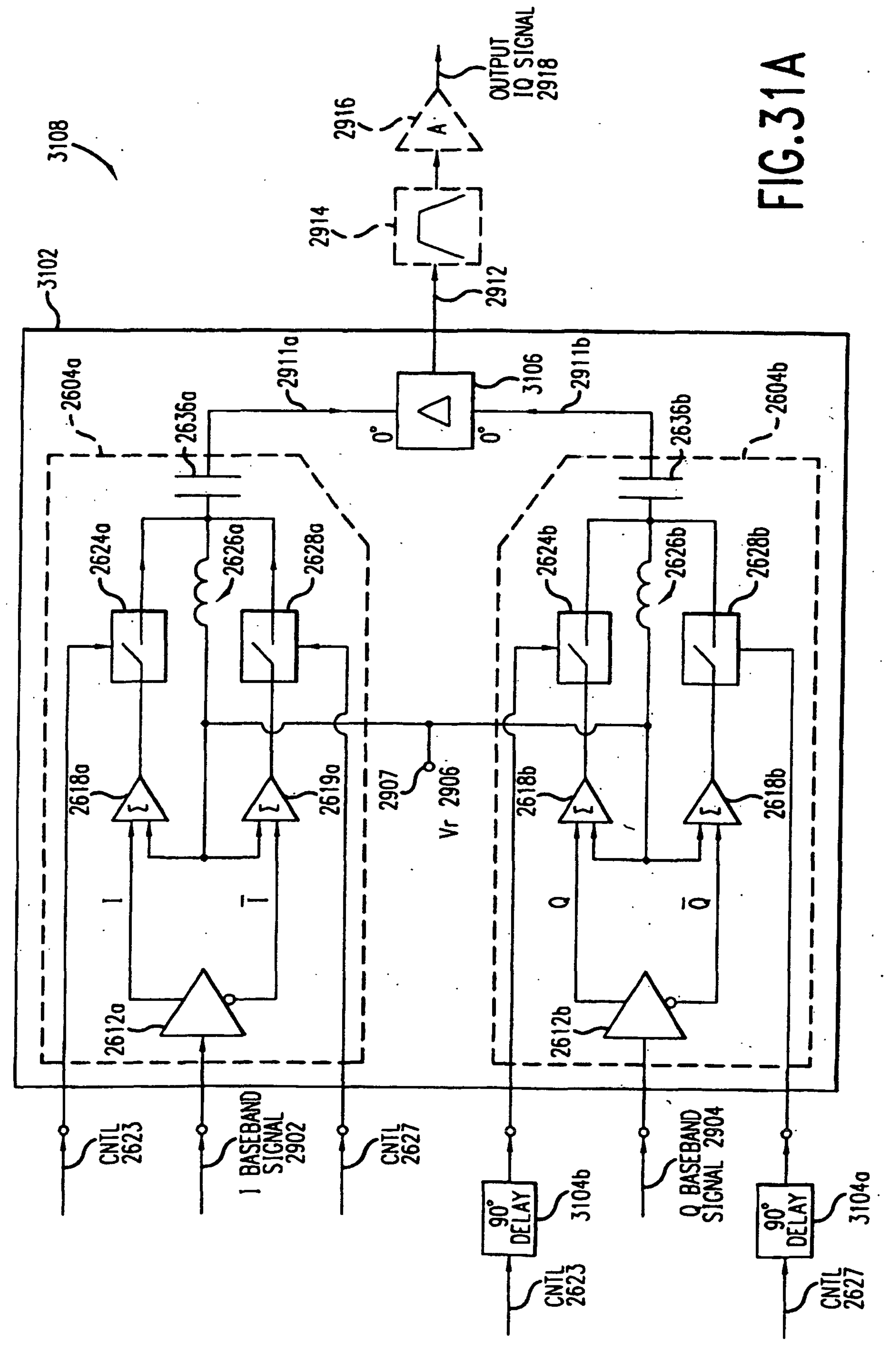
3108
3102
2604a
2604b
2636a
2636b
2911a
2911b
3106
0°
0°
2912
2914
2916
A
OUTPUT
IQ SIGNAL
2918
2624a
2626a
2628a
2624b
2626b
2628b
2618a
2619a
2618b
2618b
2907
Vr 2906
I
Ī
Q
Q̄
2612a
2612b
CNTL
2623
I BASEBAND
SIGNAL
2902
CNTL
2627
90°
DELAY
3104b
Q BASEBAND
SIGNAL 2904
90°
DELAY
3104a
CNTL
2623
CNTL
2627

FIG.31A

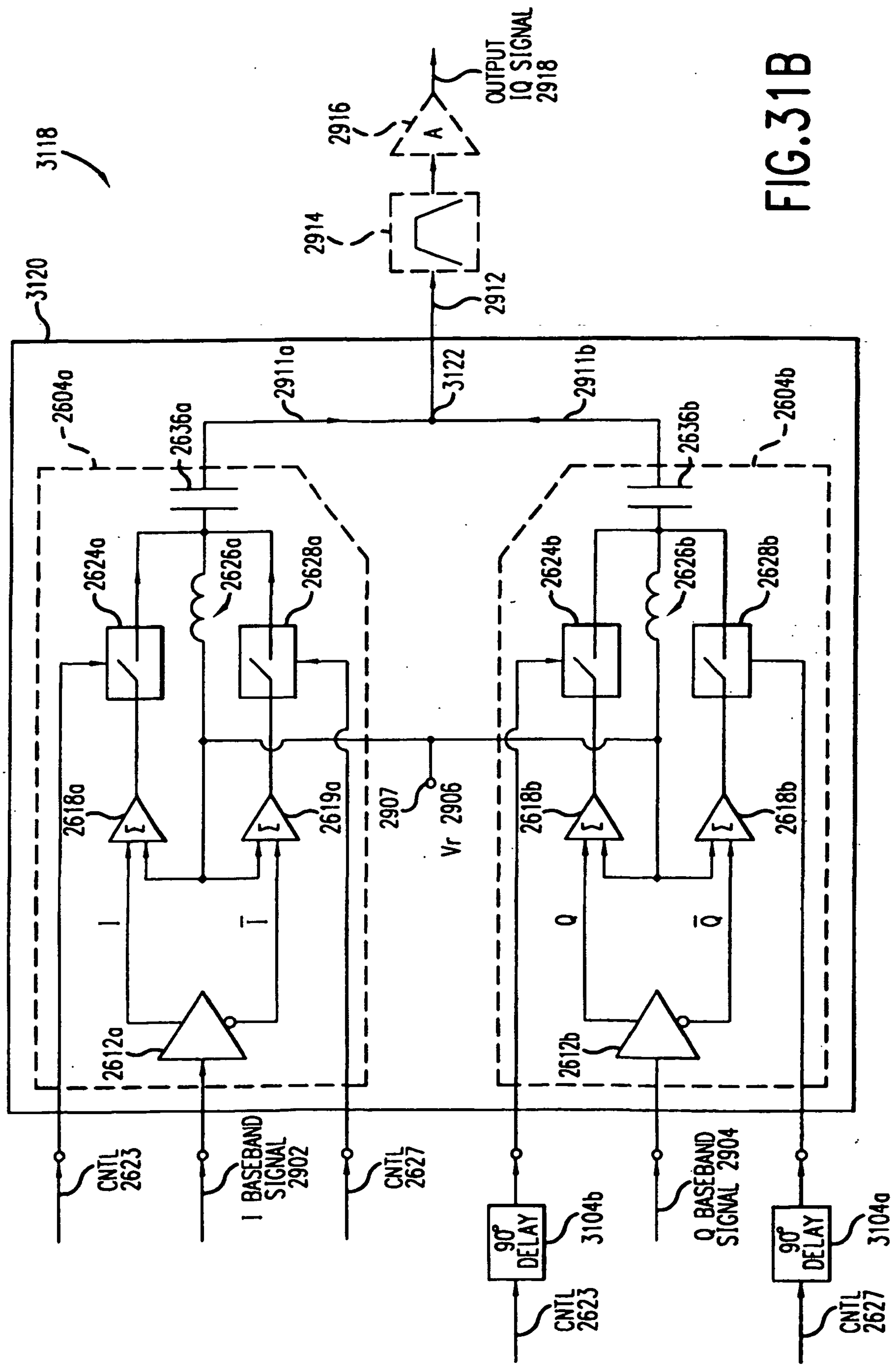
3118
3120
2604a
2604b
2636a
2636b
2911a
2911b
3122
2912
2914
2916
A
OUTPUT
IQ SIGNAL
2918
2624a
2626a
2628a
2624b
2626b
2628b
2618a
2619a
2618b
2907
Vr 2906
2612a
2612b
CNTL
2623
I BASEBAND
SIGNAL
2902
CNTL
2627
Q BASEBAND
SIGNAL 2904
90°
DELAY
3104b
3104a

FIG.31B

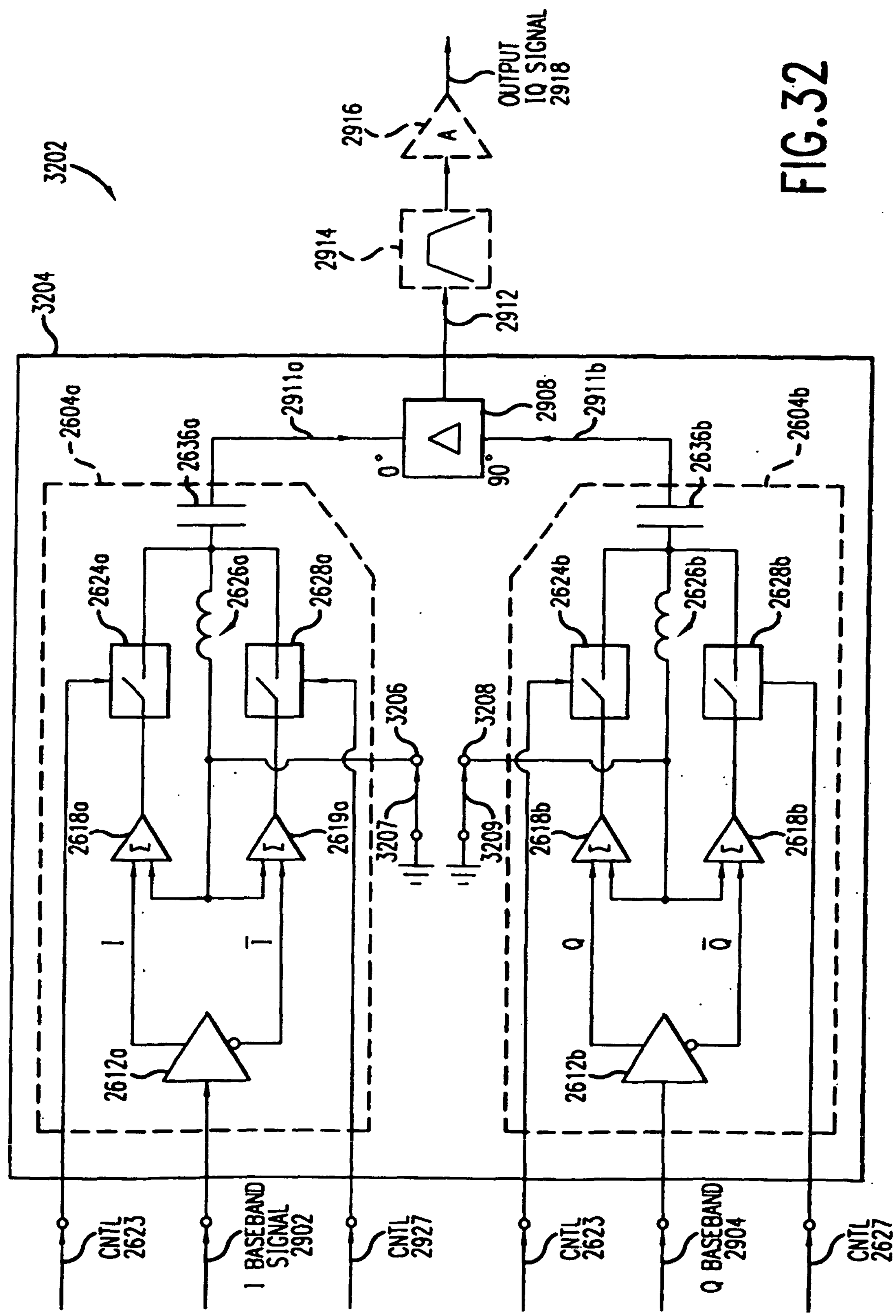
3202
3204
2604a
2636a
2911a
2908
2911b
2636b
2604b
0°
90°
2912
2914
2916
A
OUTPUT
IQ SIGNAL
2918
2624a
2626a
2628a
2624b
2626b
2628b
3206
3207
3208
3209
2618a
2619a
2618b
2618b
I
Ī
Q
Q̄
2612a
2612b
CNTL
2623
I BASEBAND
SIGNAL
2902
CNTL
2927
CNTL
2623
Q BASEBAND
2904
CNTL
2627

FIG.32

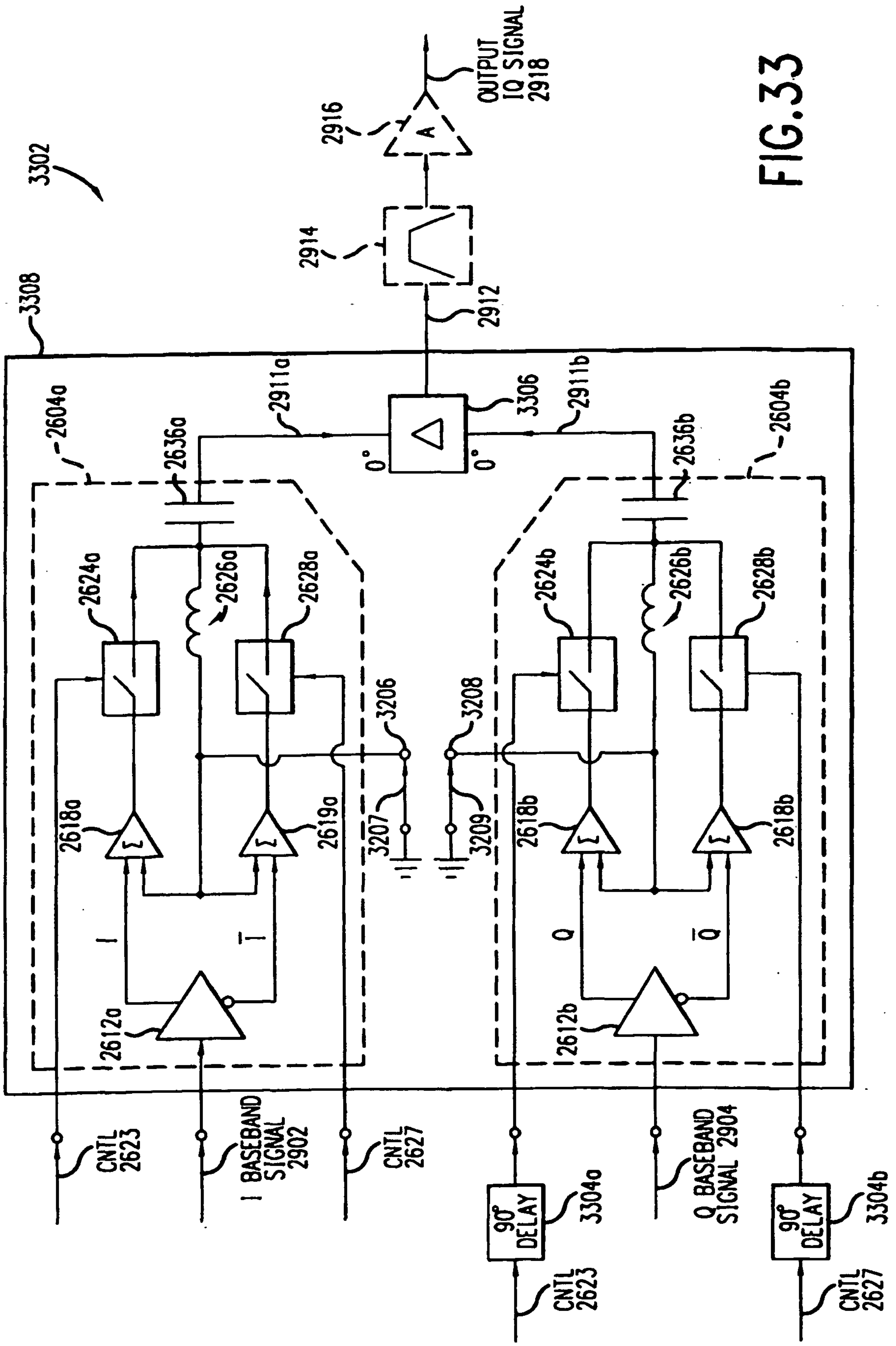
3302
3308
2604a
2604b
2636a
2636b
2911a
2911b
3306
0°
0°
2912
2914
2916
A
OUTPUT
IQ SIGNAL
2918
2624a
2626a
2628a
2624b
2626b
2628b
3206
3207
3208
3209
2618a
2619a
2618b
2618b
I
Ī
Q
Q̄
2612a
2612b
CNTL
2623
I BASEBAND
SIGNAL
2902
CNTL
2627
90°
DELAY
3304a
Q BASEBAND
SIGNAL 2904
90°
DELAY
3304b
CNTL
2623
CNTL
2627

FIG.33

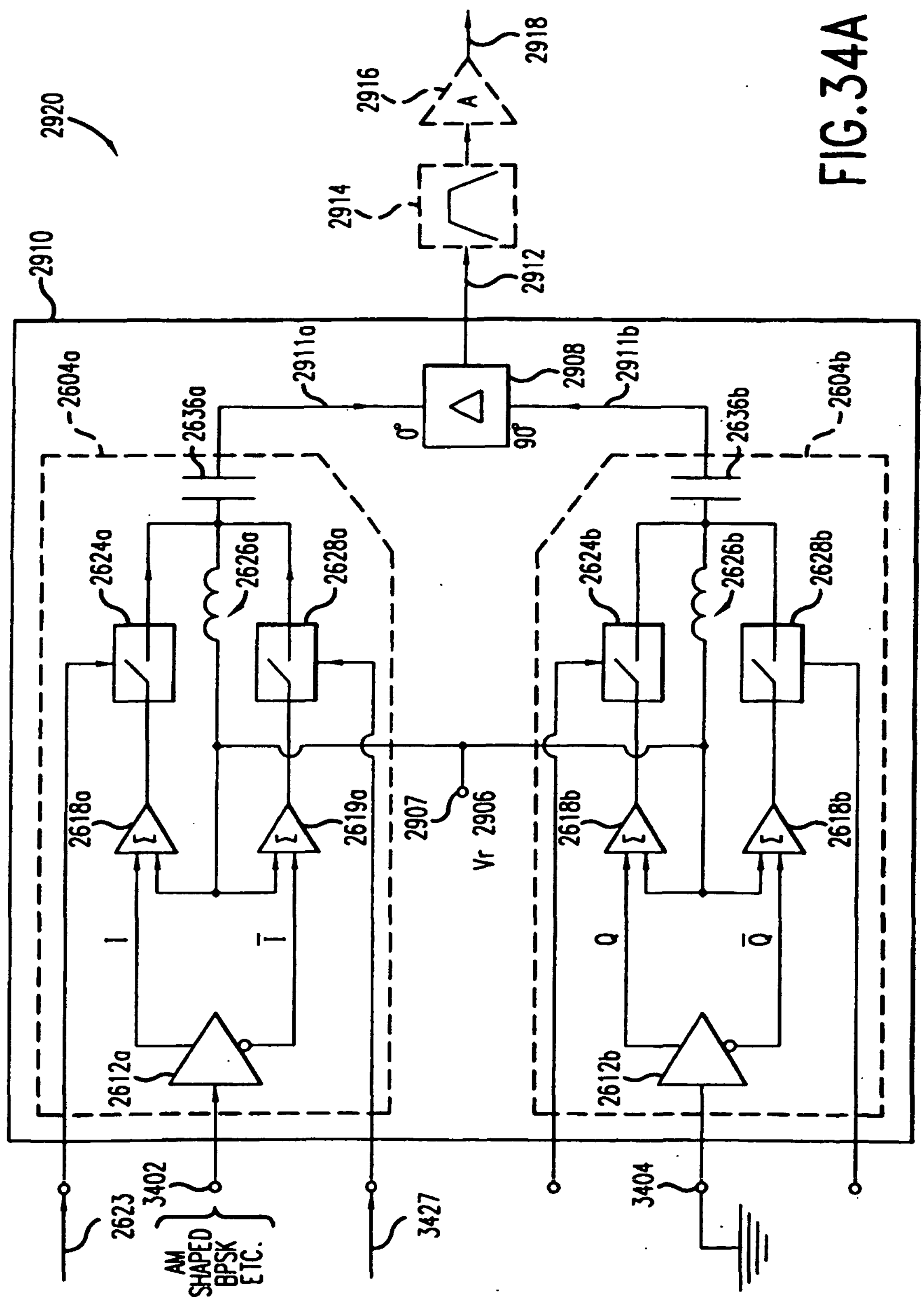
2920
2910
2912
2914
2916
A
2918
2604a
2636a
2911a
2908
0°
90°
2911b
2636b
2604b
2624a
2626a
2628a
2624b
2626b
2628b
2618a
2619a
2907
Vr 2906
2618b
2618b
I
Ī
Q
Q̄
2612a
2612b
2623
3402
AM
SHAPED
BPSK
ETC.
3427
3404

FIG.34A

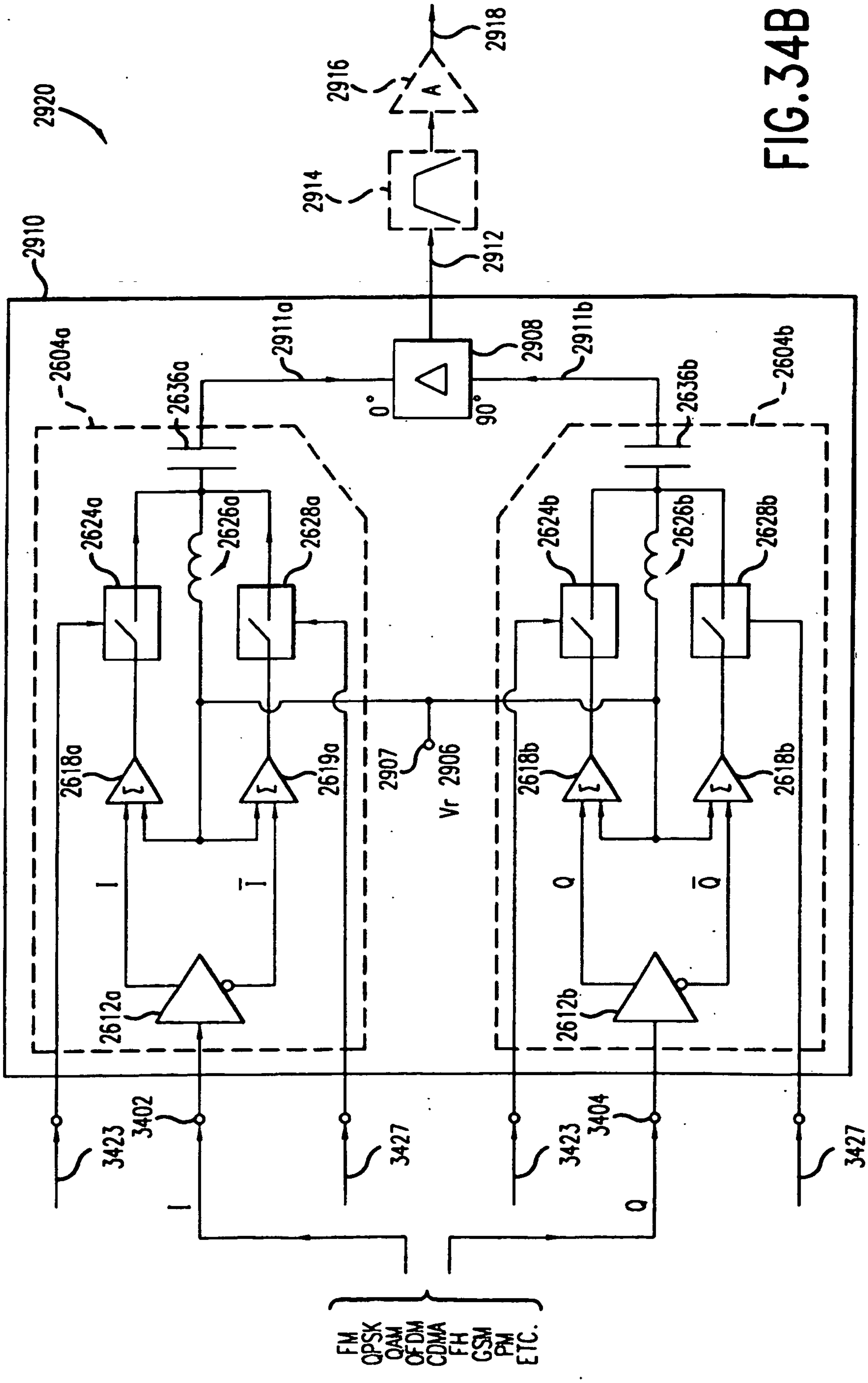
2920
2910
2914
2916
A
2918
2912
2604a
2636a
2911a
2908
2911b
2636b
2604b
0°
90°
2624a
2626a
2628a
2624b
2626b
2628b
2618a
2619a
2907
Vr 2906
2618b
2618b
I
Ī
Q
Q̄
2612a
2612b
3423
3402
3427
3423
3404
3427
I
Q
FM
QPSK
QAM
OFDM
CDMA
FH
GSM
PM
ETC.

FIG.34B

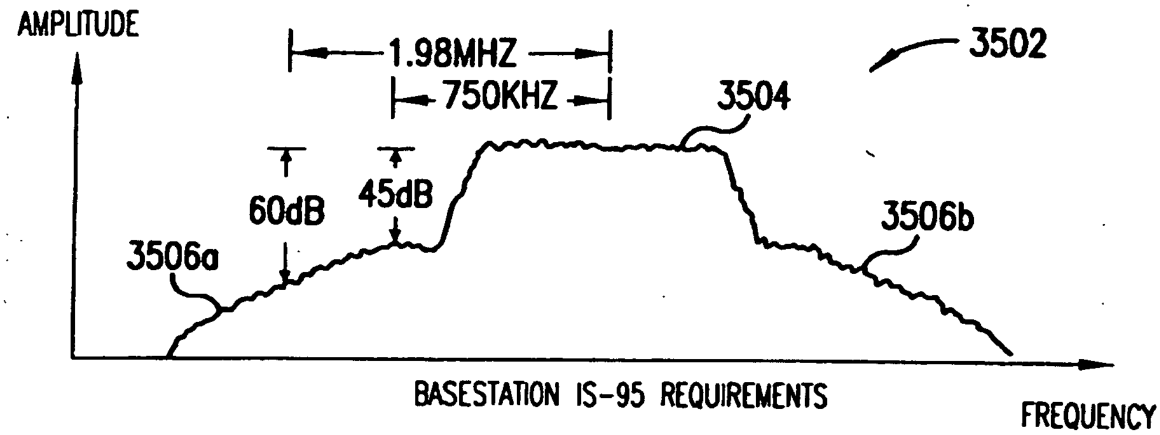


FIG.35A

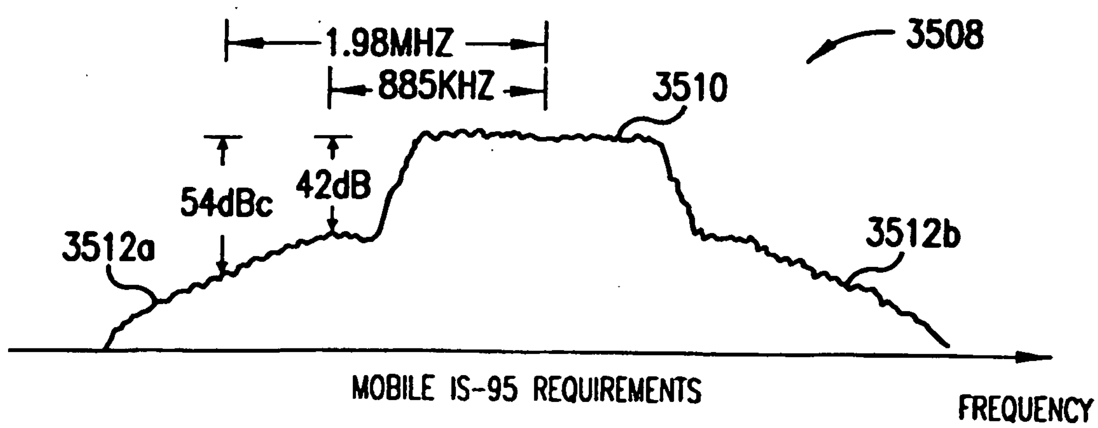


FIG.35B

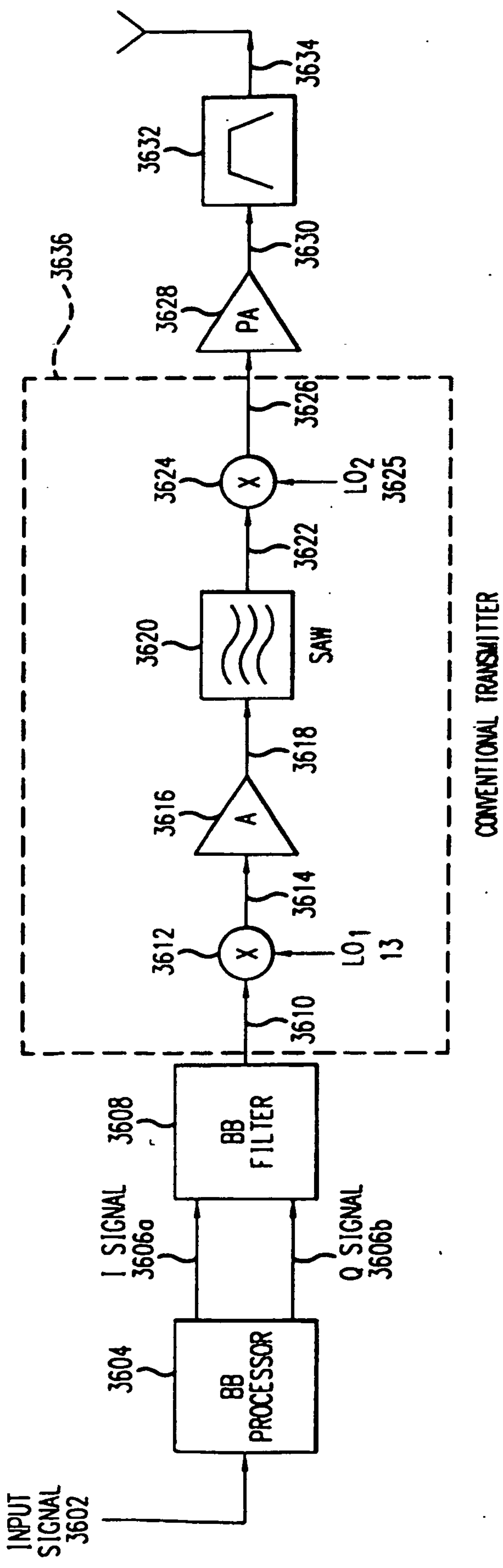
3600
3636
INPUT SIGNAL 3602
BB PROCESSOR
3604
I SIGNAL 3606a
Q SIGNAL 3606b
BB FILTER
3608
3610
X
3612
LO1
13
3614
A
3616
3618
SAW
3620
3622
X
3624
LO2
3625
3626
PA
3628
3630
3632
3634
CONVENTIONAL TRANSMITTER

FIG.36

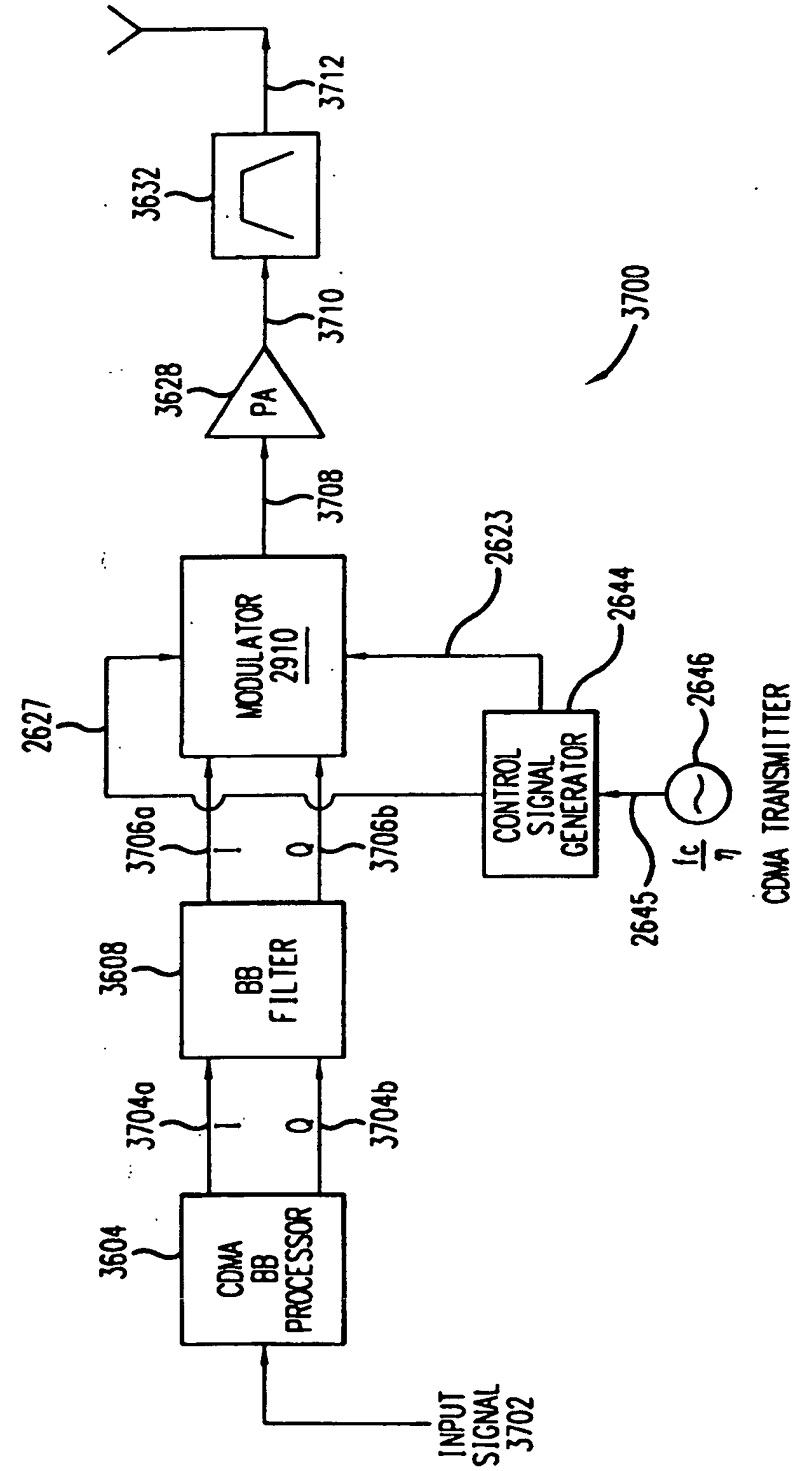
INPUT SIGNAL 3702
CDMA BB PROCESSOR
3604
I
Q
3704a
3704b
BB FILTER
3608
3706a
3706b
MODULATOR 2910
2627
2623
CONTROL SIGNAL GENERATOR
2644
2645
2646
fc/n
CDMA TRANSMITTER
3708
PA
3628
3710
3632
3712
3700

FIG.37A

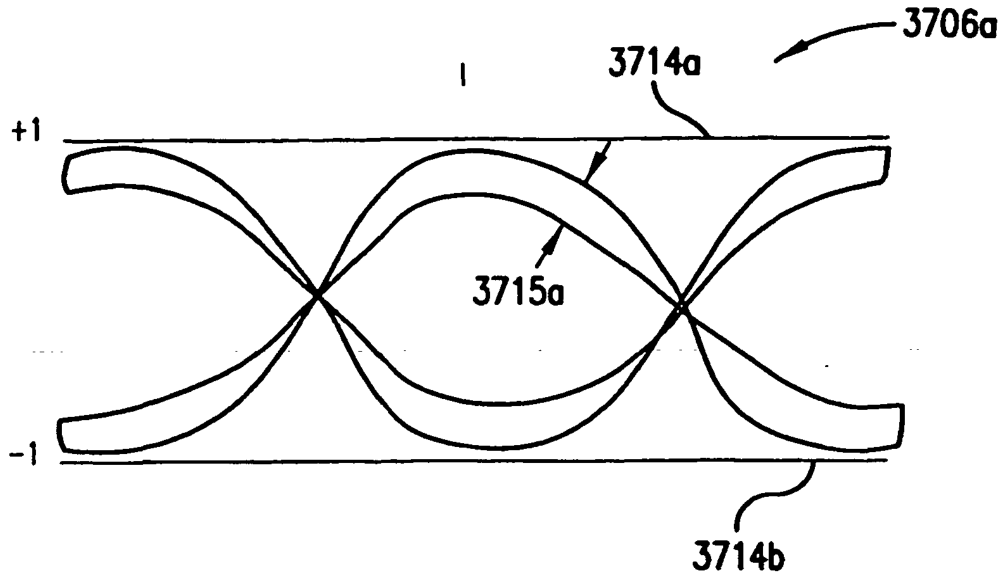


FIG.37B

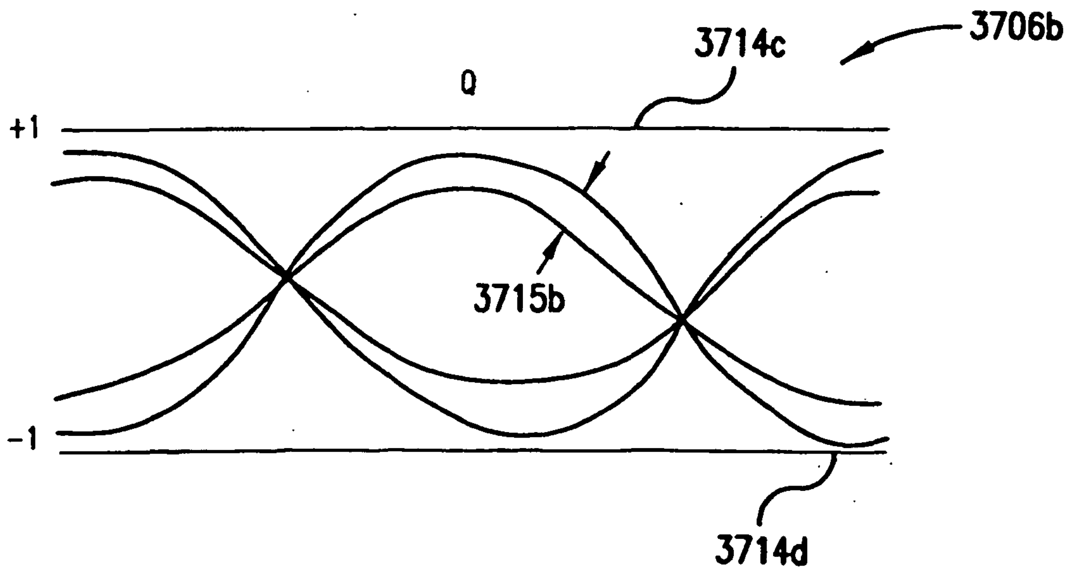


FIG.37C

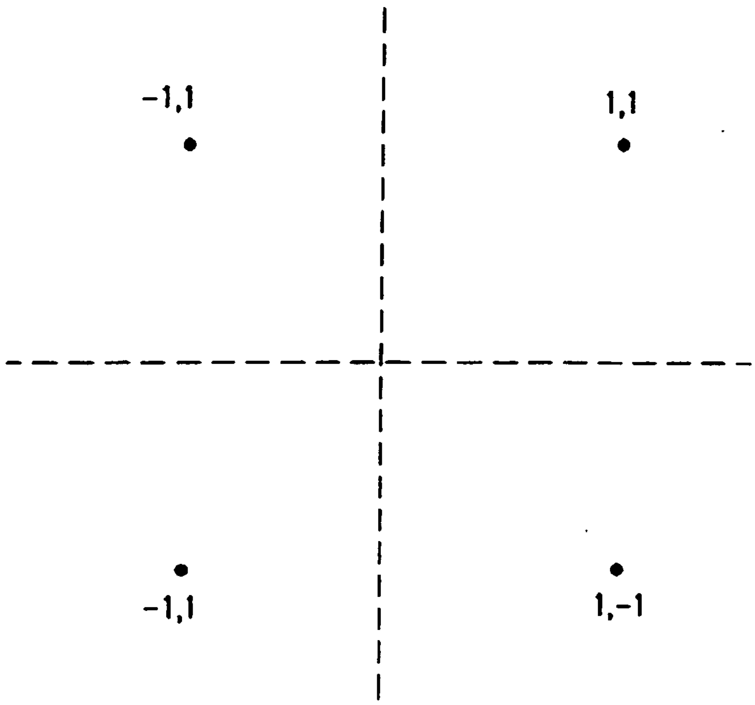


FIG.37D

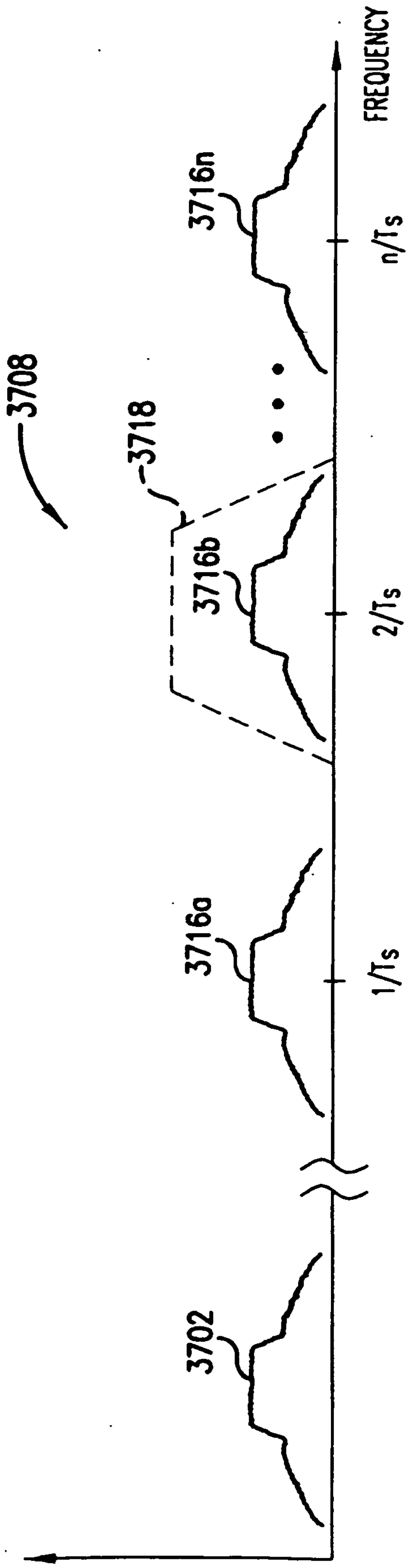


FIG.37E

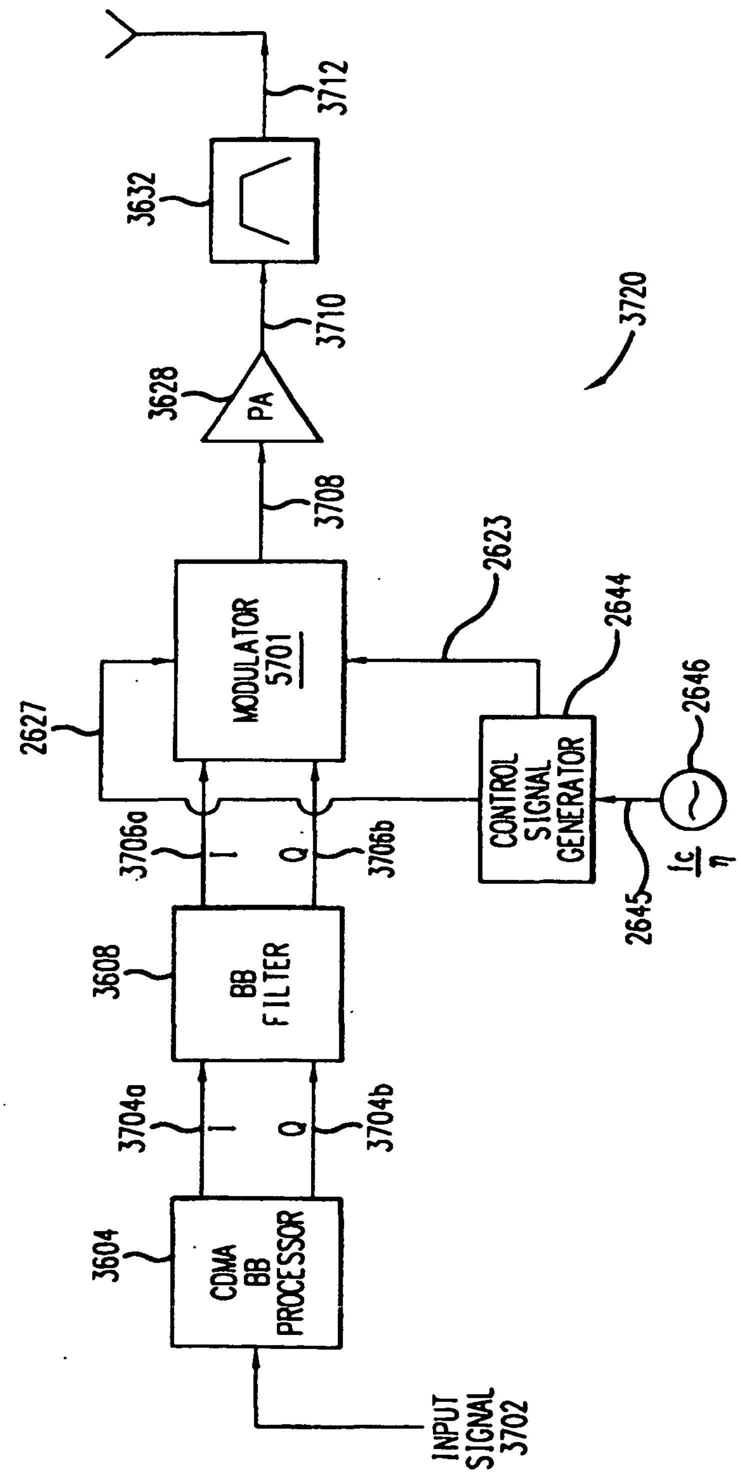


CDMA TRANSMITTER

FIG.37F

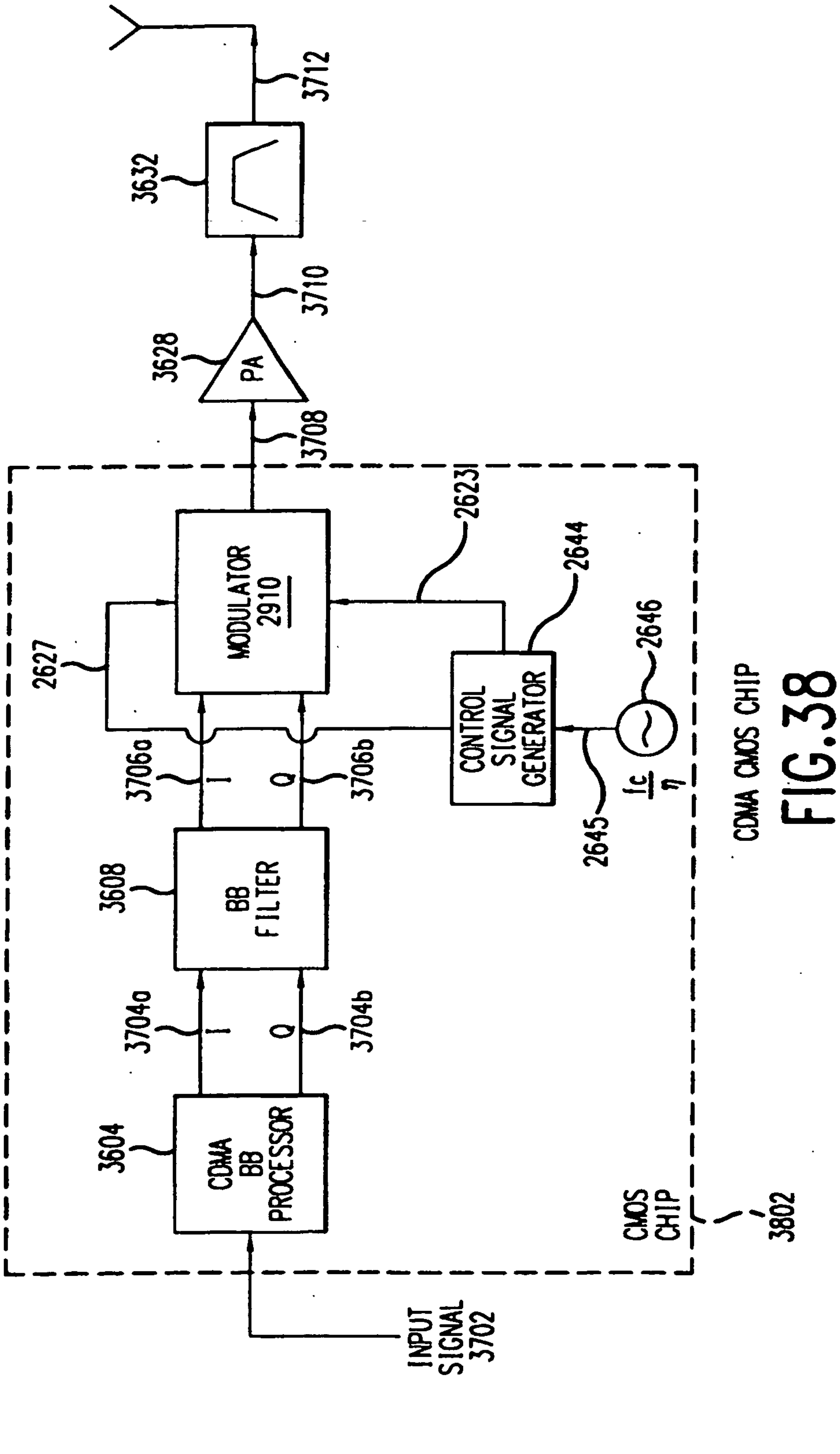

INPUT SIGNAL 3702
3604
CDMA BB PROCESSOR
3704a
I
Q
3704b
3608
BB FILTER
3706a
I
Q
3706b
2627
MODULATOR 2910
2623I
2644
CONTROL SIGNAL GENERATOR
2645
fc/n
2646
3708
3628
PA
3710
3632
3712
CMOS CHIP
3802
CDMA CMOS CHIP


FIG.38

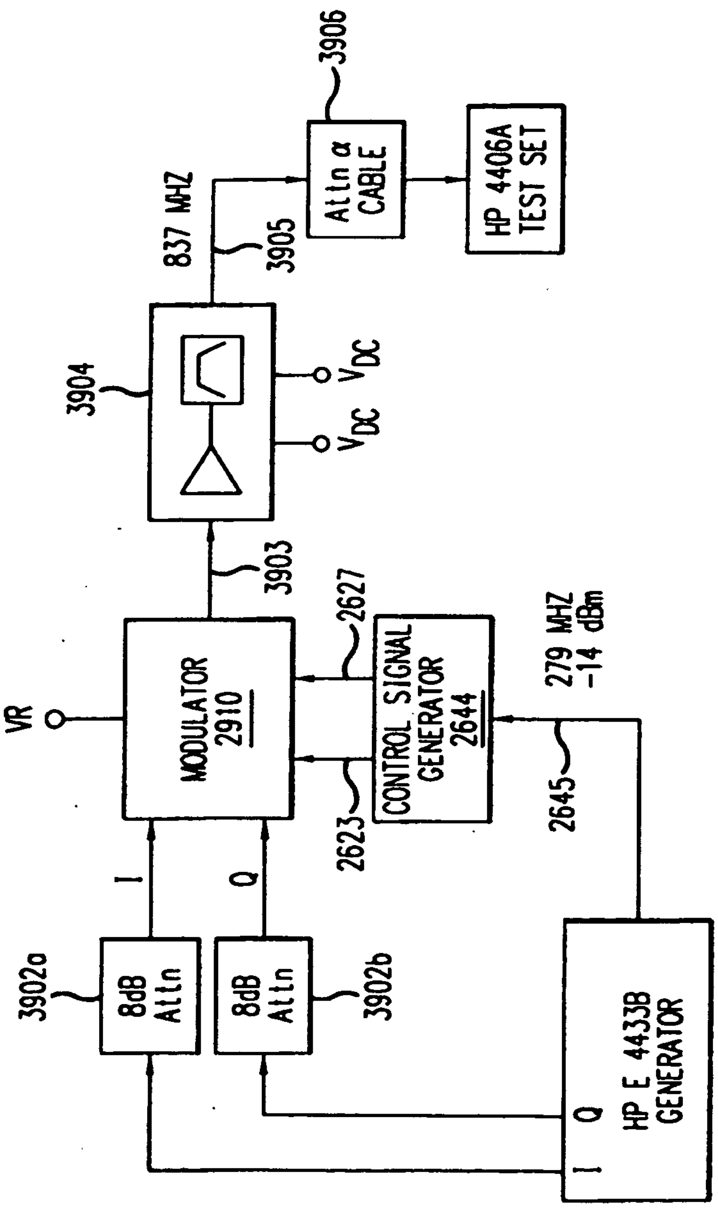
3900
3906
Attn α CABLE
HP 4406A TEST SET
837 MHZ
3905
3904
VDC
VDC
3903
2627
VR
MODULATOR 2910
CONTROL SIGNAL GENERATOR 2644
279 MHZ -14 dBm
2623
2645
I
Q
3902a
8dB Attn
8dB Attn
3902b
HP E 4433B GENERATOR
I
Q

FIG.39

4002

BASE STATION

| | |
|---|---|
| RHO | 0.9970 |
| EVM | 5.51% |
| PHASE ERROR | 1.80° |
| MAGNITUDE ERROR | 4.53% |
| CARRIER INSERTION | -37.91 dB |
| PA POWER OUT | 28.06 dBm |

FIG.40

FREQUENCY (MHz) (MOBILE STATION)

4102

| | LOW | MIDDLE | HIGH |
|---|---|---|---|
| RHO | 0.9892 | 0.9969 | 0.9892 |
| EVM | 10.39% | 5.54% | 10.39% |
| PHASE ERROR | 4.47° | 2.24° | 4.08° |
| MAGNITUDE ERROR | 6.84% | 4.21% | 8.27% |
| CARRIER INSERTION | -40.15 dB | -44.58 dB | -35.27 dB |
| PA POWER OUT | 27.36 dBm | 28.11 dBm | 27.55 dBm |

FIG.41

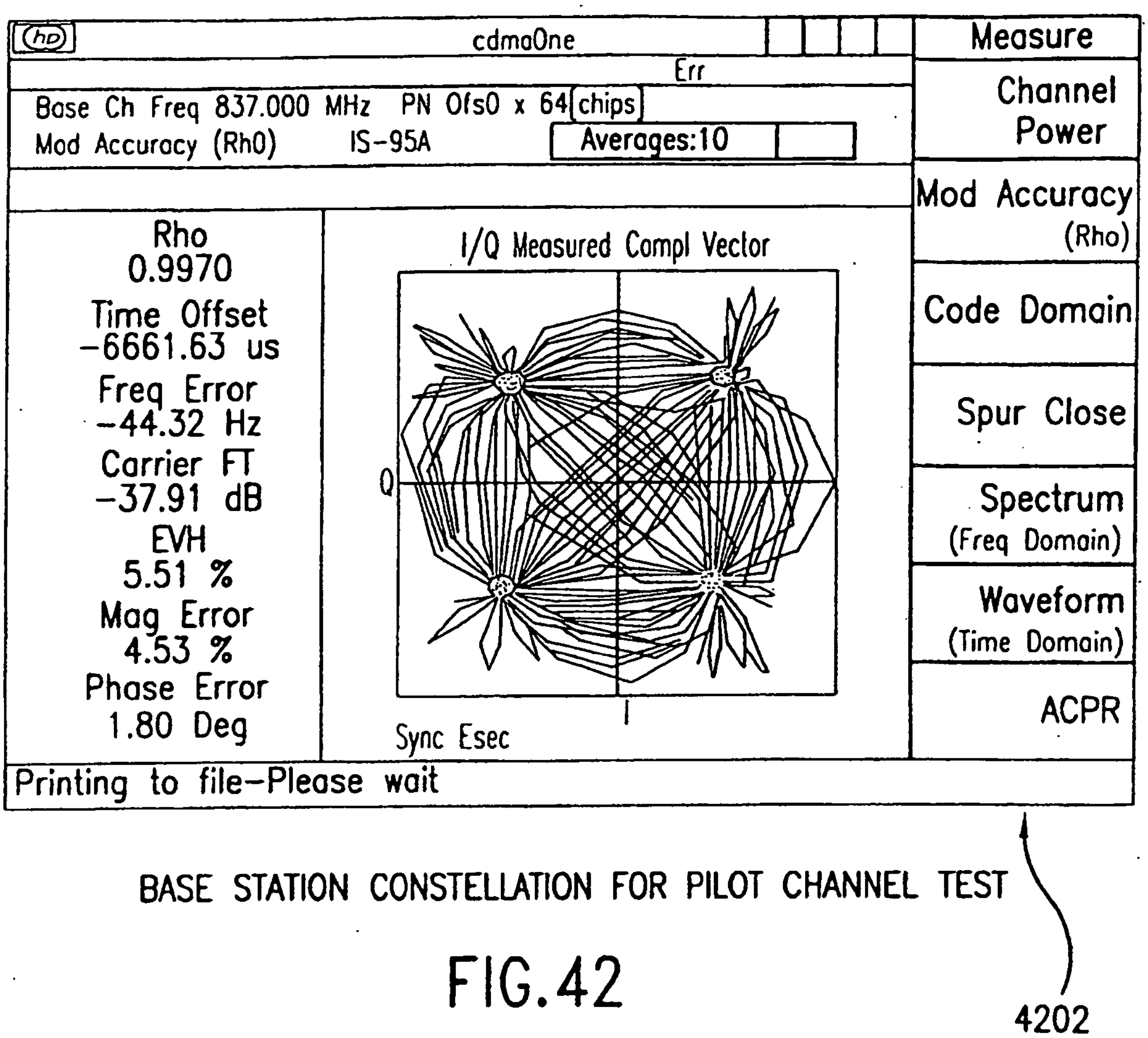


BASE STATION CONSTELLATION FOR PILOT CHANNEL TEST

FIG.42

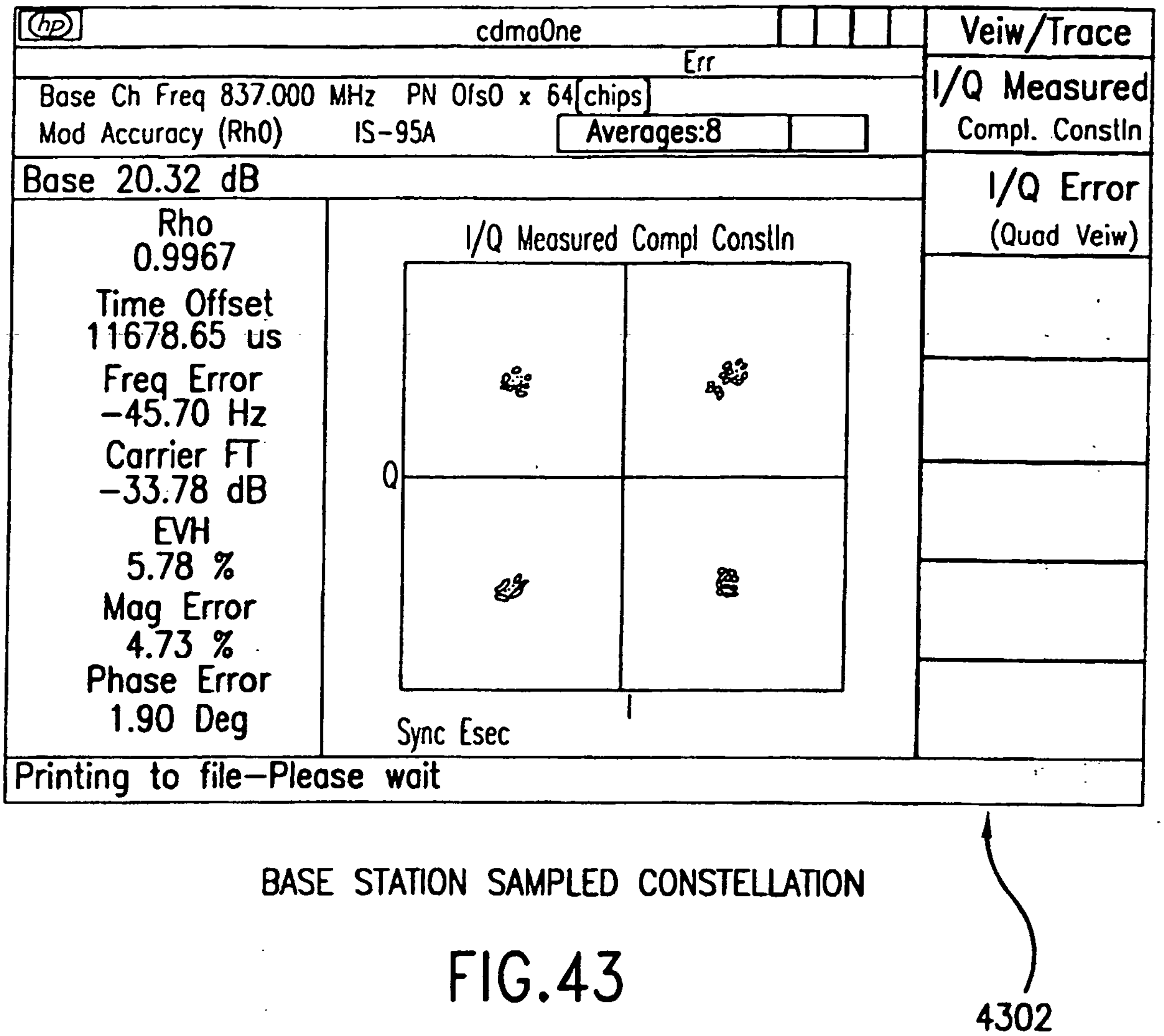


BASE STATION SAMPLED CONSTELLATION

FIG.43

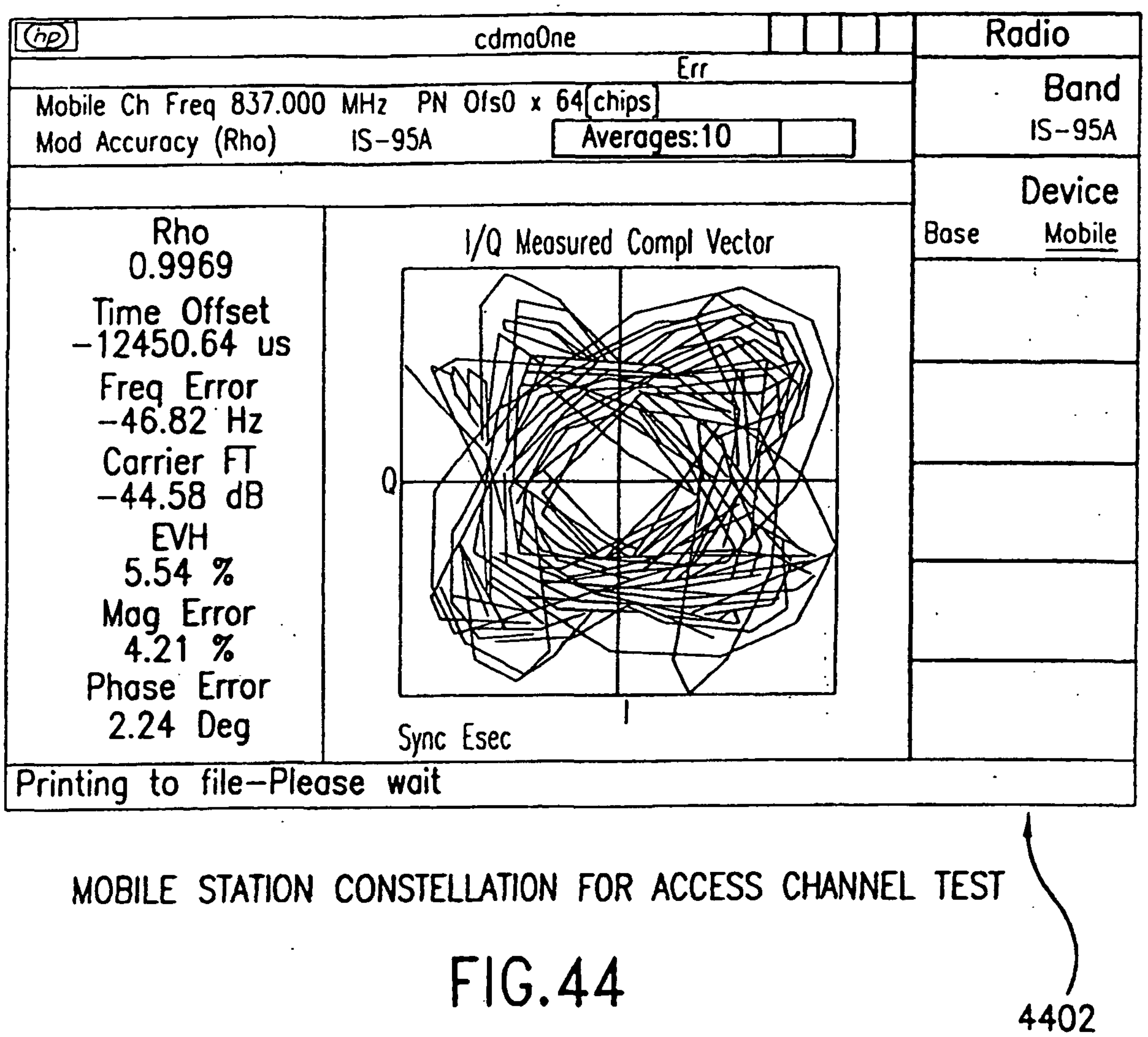


MOBILE STATION CONSTELLATION FOR ACCESS CHANNEL TEST

FIG.44

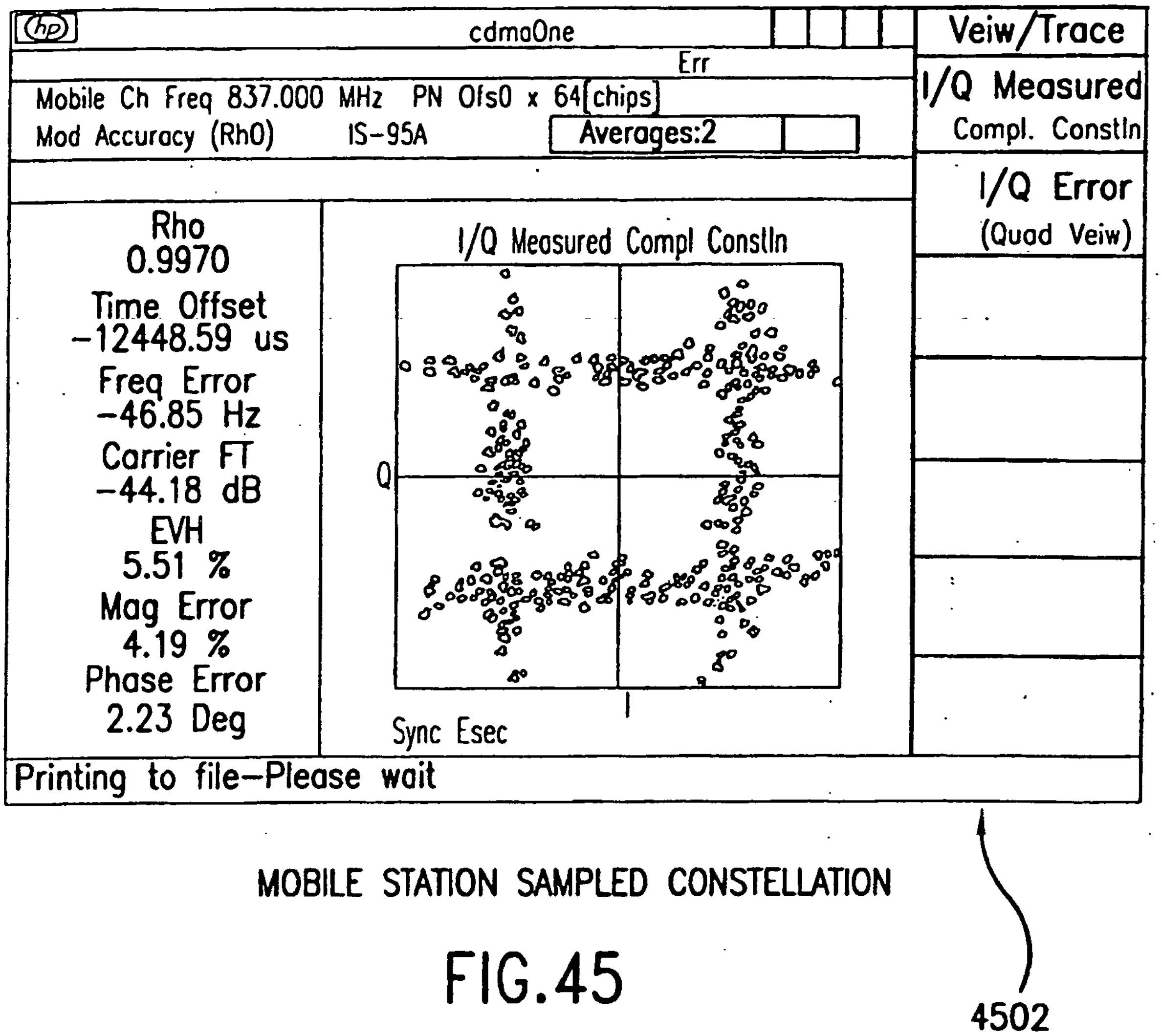


MOBILE STATION SAMPLED CONSTELLATION

FIG.45

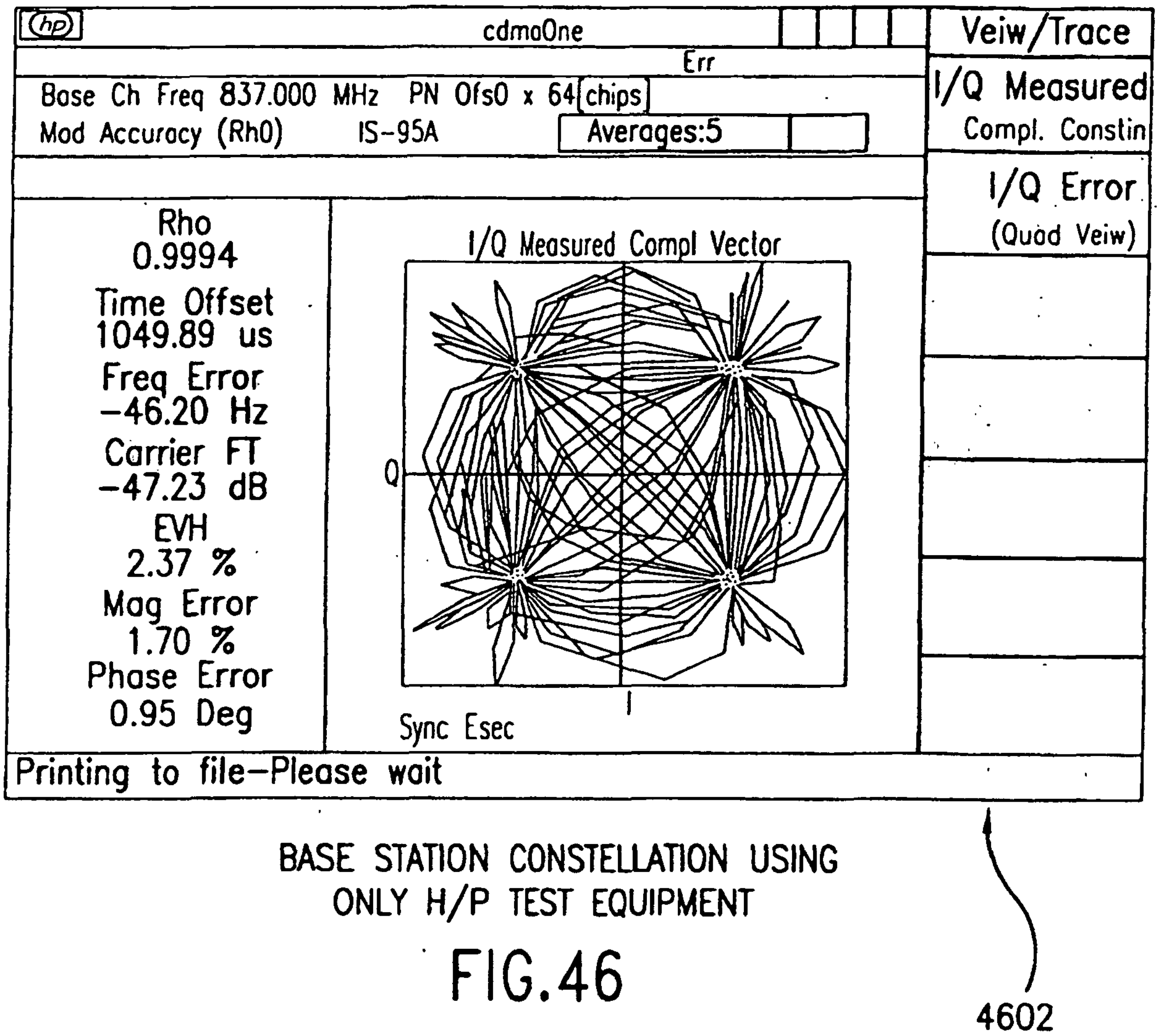


BASE STATION CONSTELLATION USING
ONLY H/P TEST EQUIPMENT

FIG.46

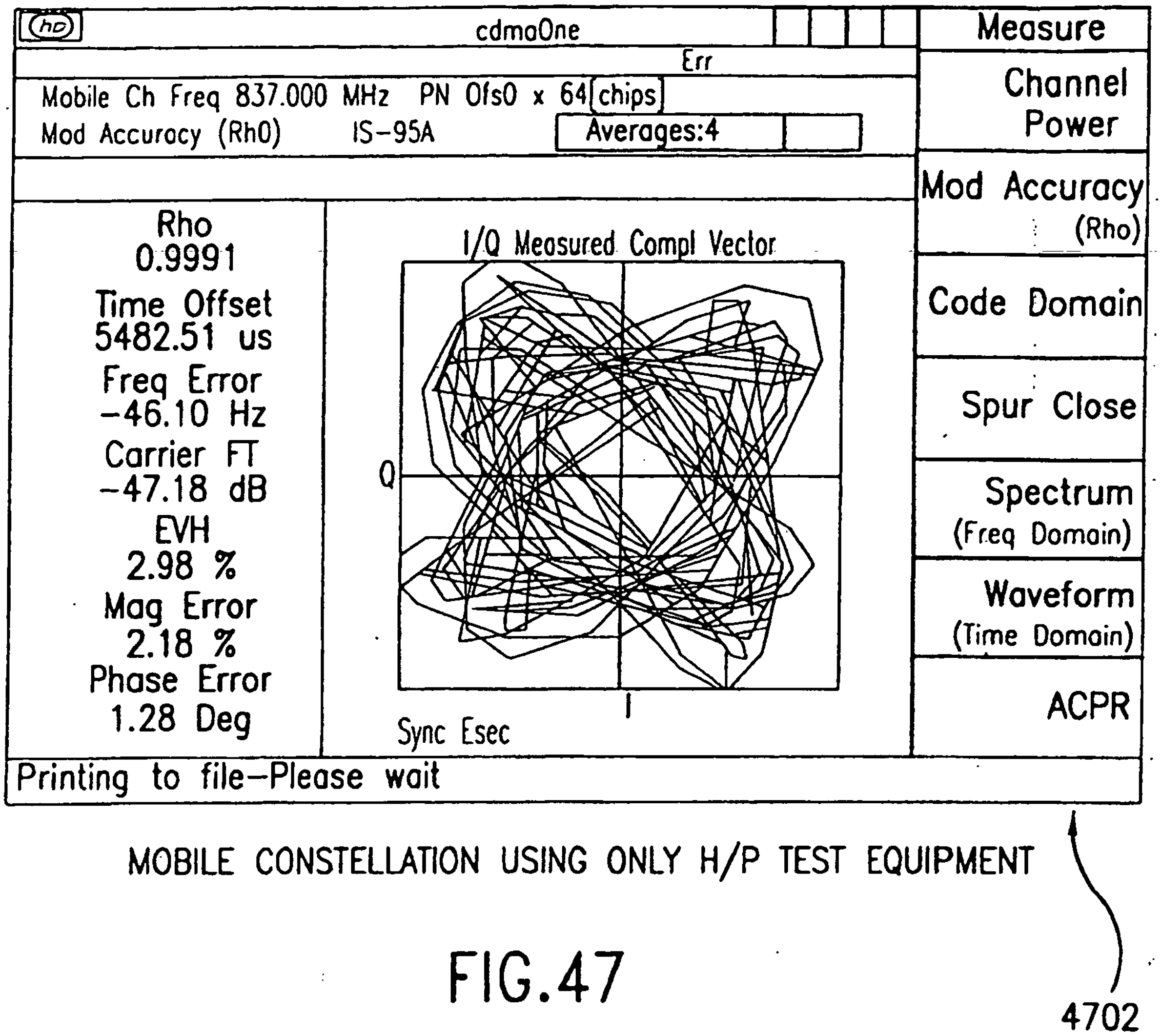
cdmaOne
Measure
Err
Mobile Ch Freq 837.000 MHz PN Ofs0 x 64 chips
Mod Accuracy (Rh0) IS-95A
Averages:4
Channel Power
Mod Accuracy (Rho)
Rho
0.9991
Time Offset
5482.51 us
Freq Error
-46.10 Hz
Carrier FT
-47.18 dB
EVH
2.98 %
Mag Error
2.18 %
Phase Error
1.28 Deg
I/Q Measured Compl Vector
Q
I
Sync Esec
Code Domain
Spur Close
Spectrum (Freq Domain)
Waveform (Time Domain)
ACPR
Printing to file-Please wait
MOBILE CONSTELLATION USING ONLY H/P TEST EQUIPMENT
4702

FIG.47

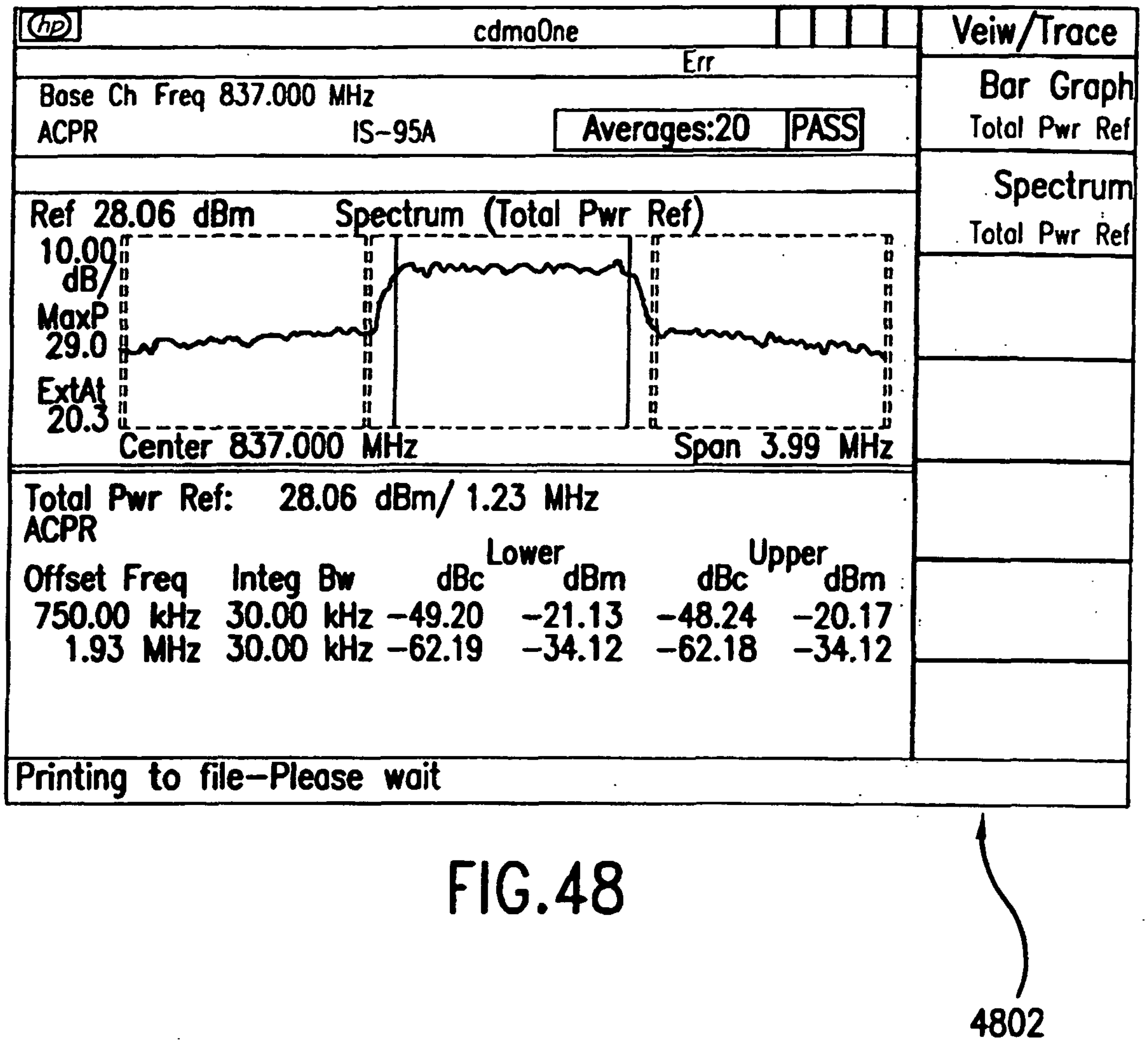
hp
cdmaOne
Err
Base Ch Freq 837.000 MHz
ACPR
IS-95A
Averages:20
PASS
Ref 28.06 dBm
Spectrum (Total Pwr Ref)
10.00 dB/
MaxP 29.0
ExtAt 20.3
Center 837.000 MHz
Span 3.99 MHz
Total Pwr Ref: 28.06 dBm/ 1.23 MHz
ACPR
Lower
Upper
Offset Freq Integ Bw dBc dBm dBc dBm
750.00 kHz 30.00 kHz -49.20 -21.13 -48.24 -20.17
1.93 MHz 30.00 kHz -62.19 -34.12 -62.18 -34.12
Printing to file-Please wait
Veiw/Trace
Bar Graph
Total Pwr Ref
Spectrum
Total Pwr Ref
4802

FIG.48

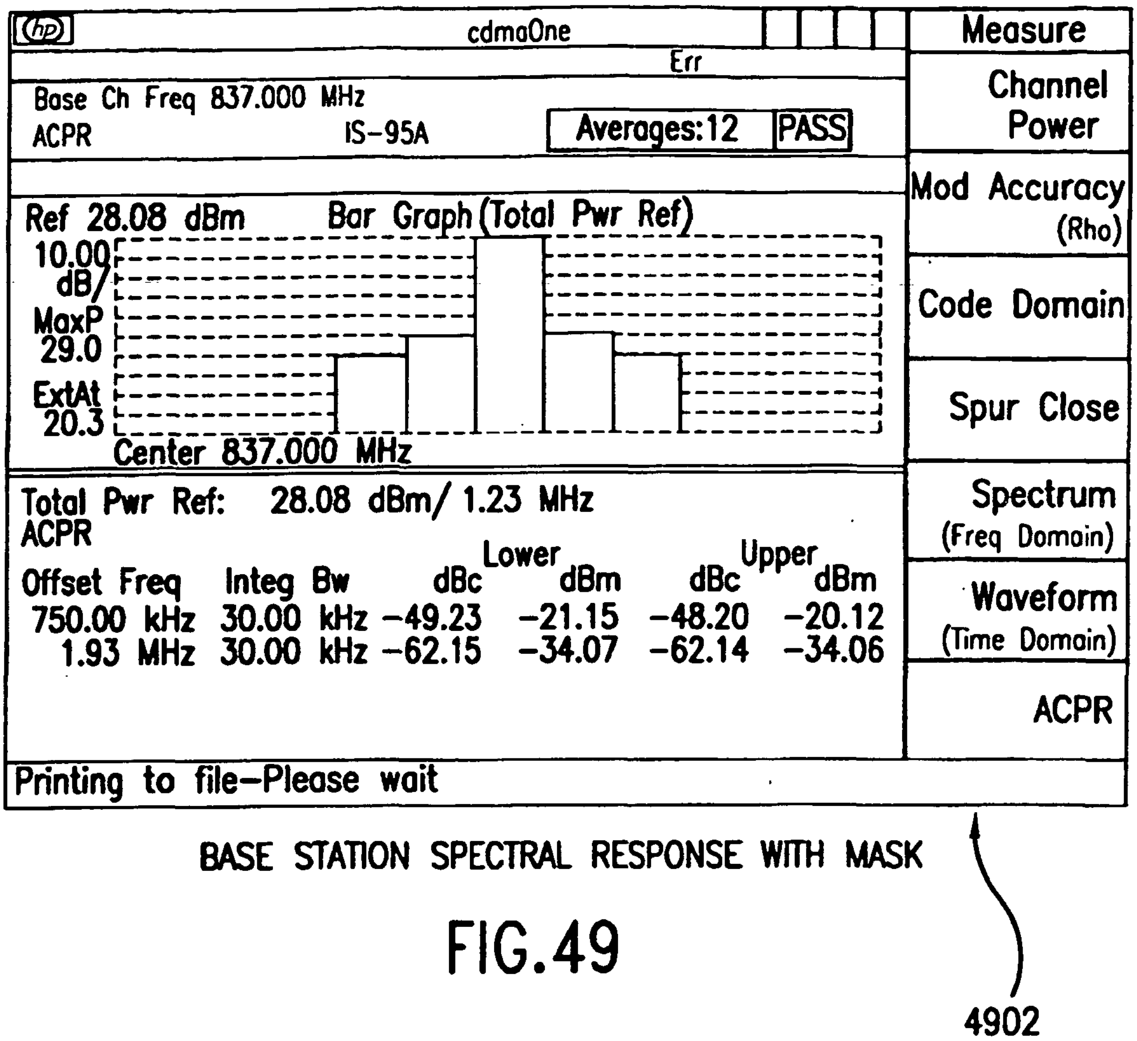


BASE STATION SPECTRAL RESPONSE WITH MASK

FIG.49

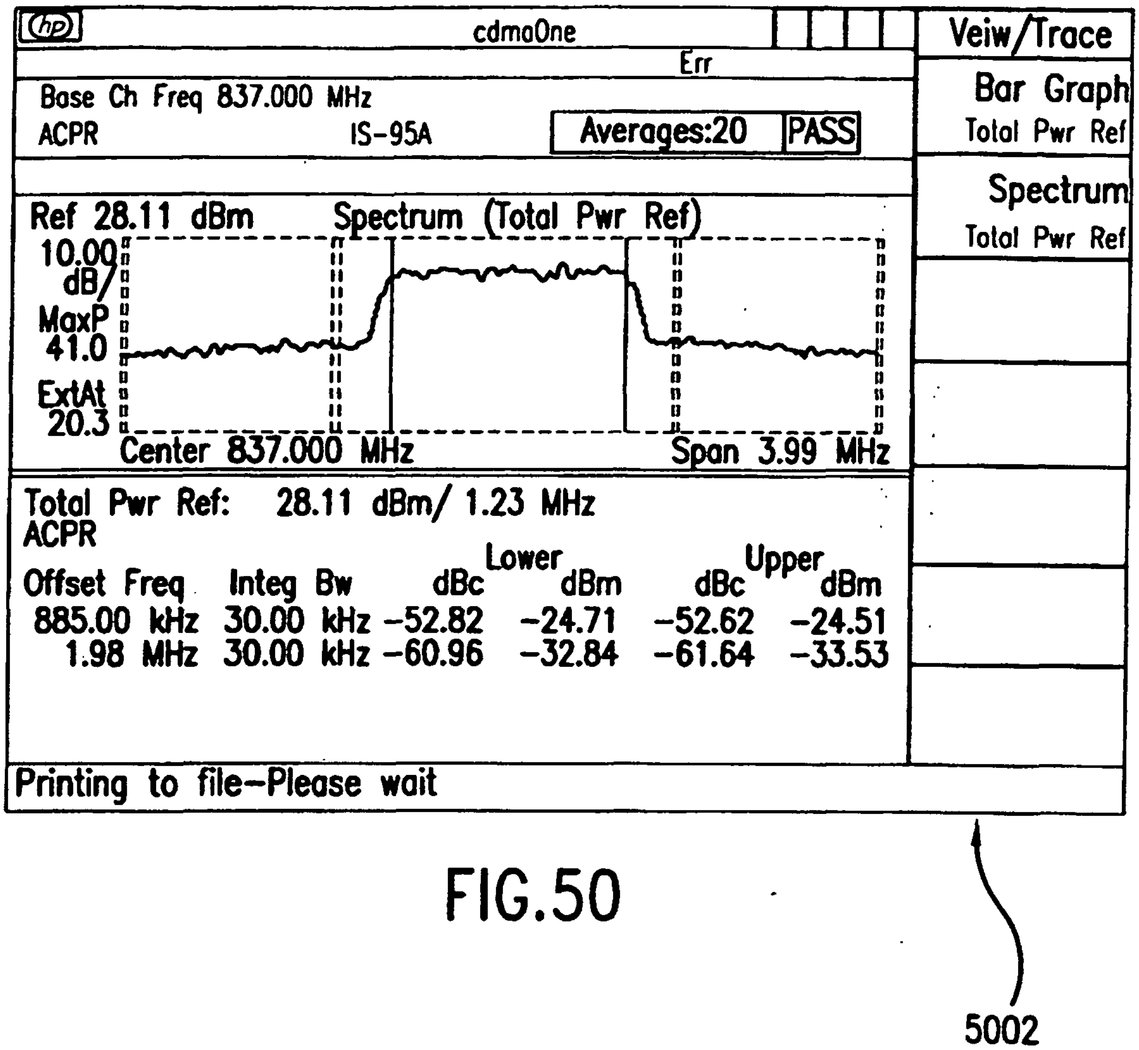
cdmaOne
Err
Base Ch Freq 837.000 MHz
ACPR
IS-95A
Averages:20
PASS
Veiw/Trace
Bar Graph
Total Pwr Ref
Spectrum
Total Pwr Ref
Ref 28.11 dBm
Spectrum (Total Pwr Ref)
10.00 dB/
MaxP 41.0
ExtAt 20.3
Center 837.000 MHz
Span 3.99 MHz
Total Pwr Ref: 28.11 dBm/ 1.23 MHz
ACPR
Offset Freq Integ Bw Lower dBc dBm Upper dBc dBm
885.00 kHz 30.00 kHz -52.82 -24.71 -52.62 -24.51
1.98 MHz 30.00 kHz -60.96 -32.84 -61.64 -33.53
Printing to file-Please wait
5002

FIG.50

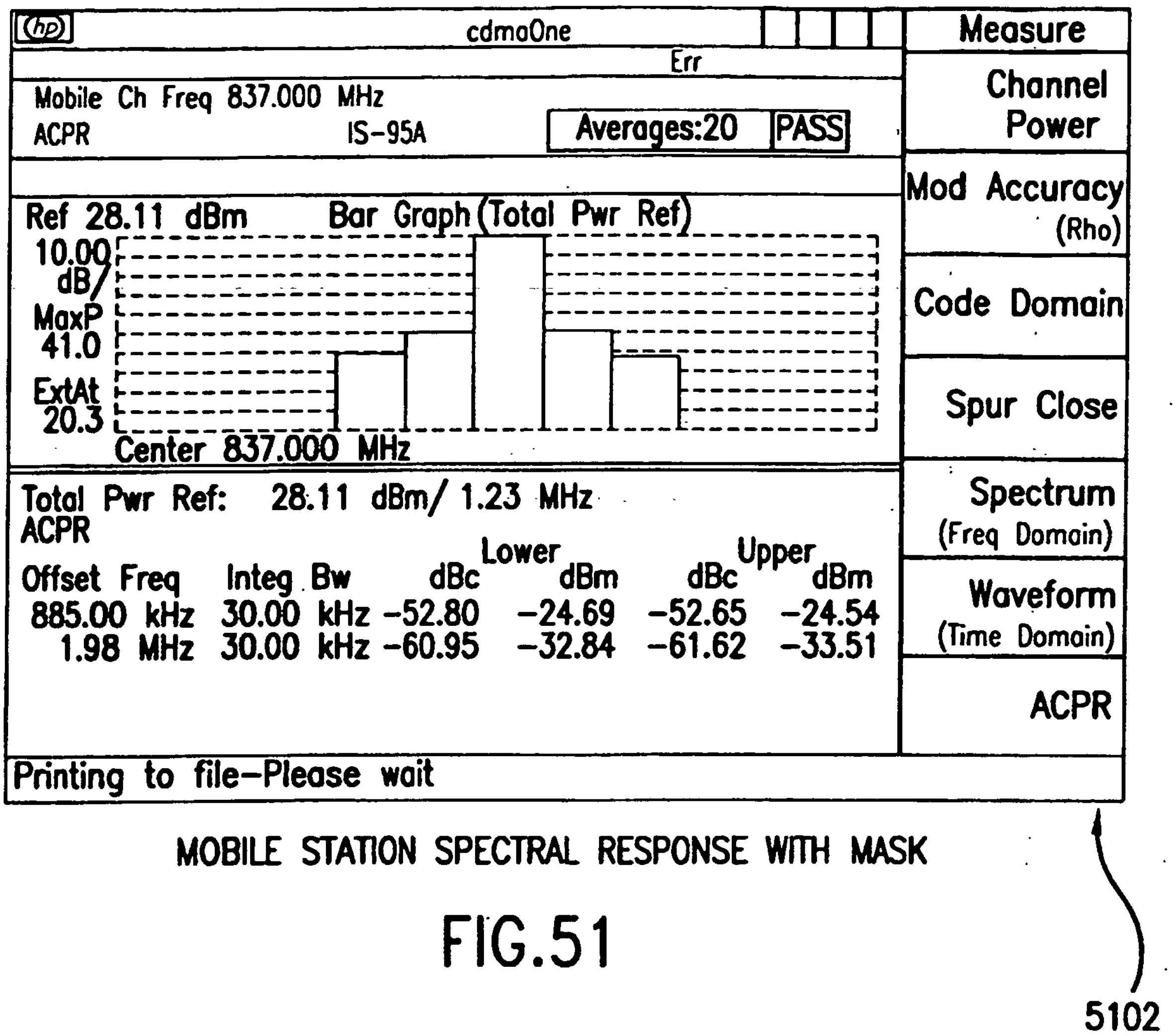


MOBILE STATION SPECTRAL RESPONSE WITH MASK

FIG.51

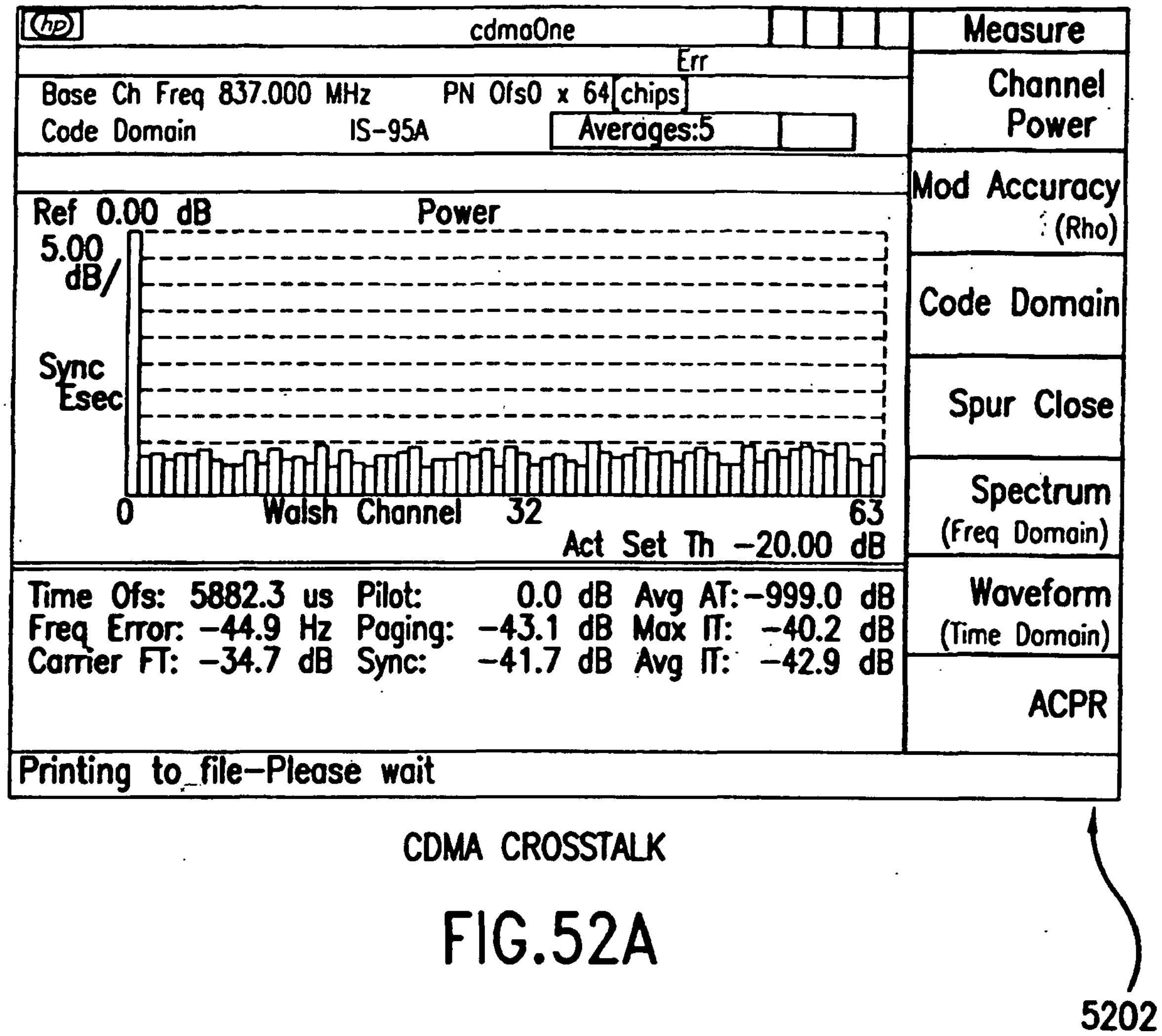


CDMA CROSSTALK

FIG.52A

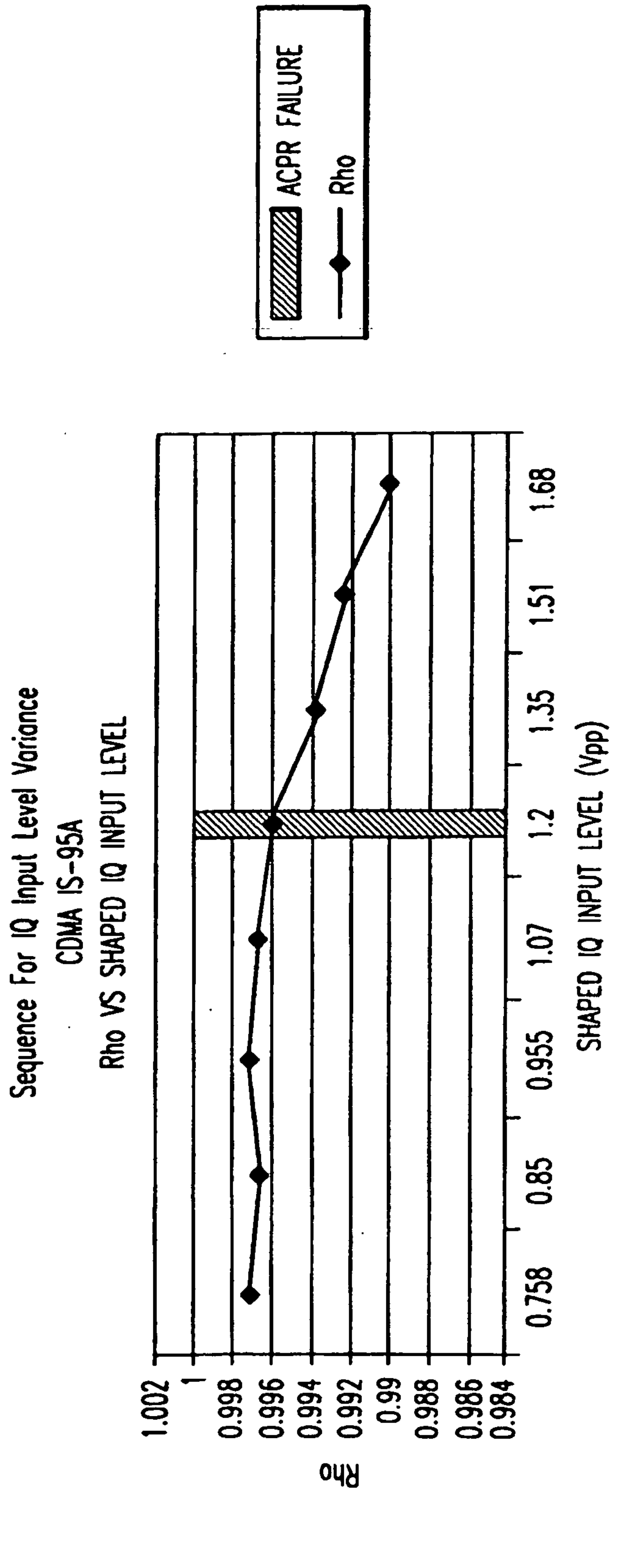
Sequence For IQ Input Level Variance
CDMA IS-95A
Rho VS SHAPED IQ INPUT LEVEL
ACPR FAILURE
Rho
Rho
1.002
1
0.998
0.996
0.994
0.992
0.99
0.988
0.986
0.984
0.758
0.85
0.955
1.07
1.2
1.35
1.51
1.68
SHAPED IQ INPUT LEVEL (Vpp)

FIG.52B

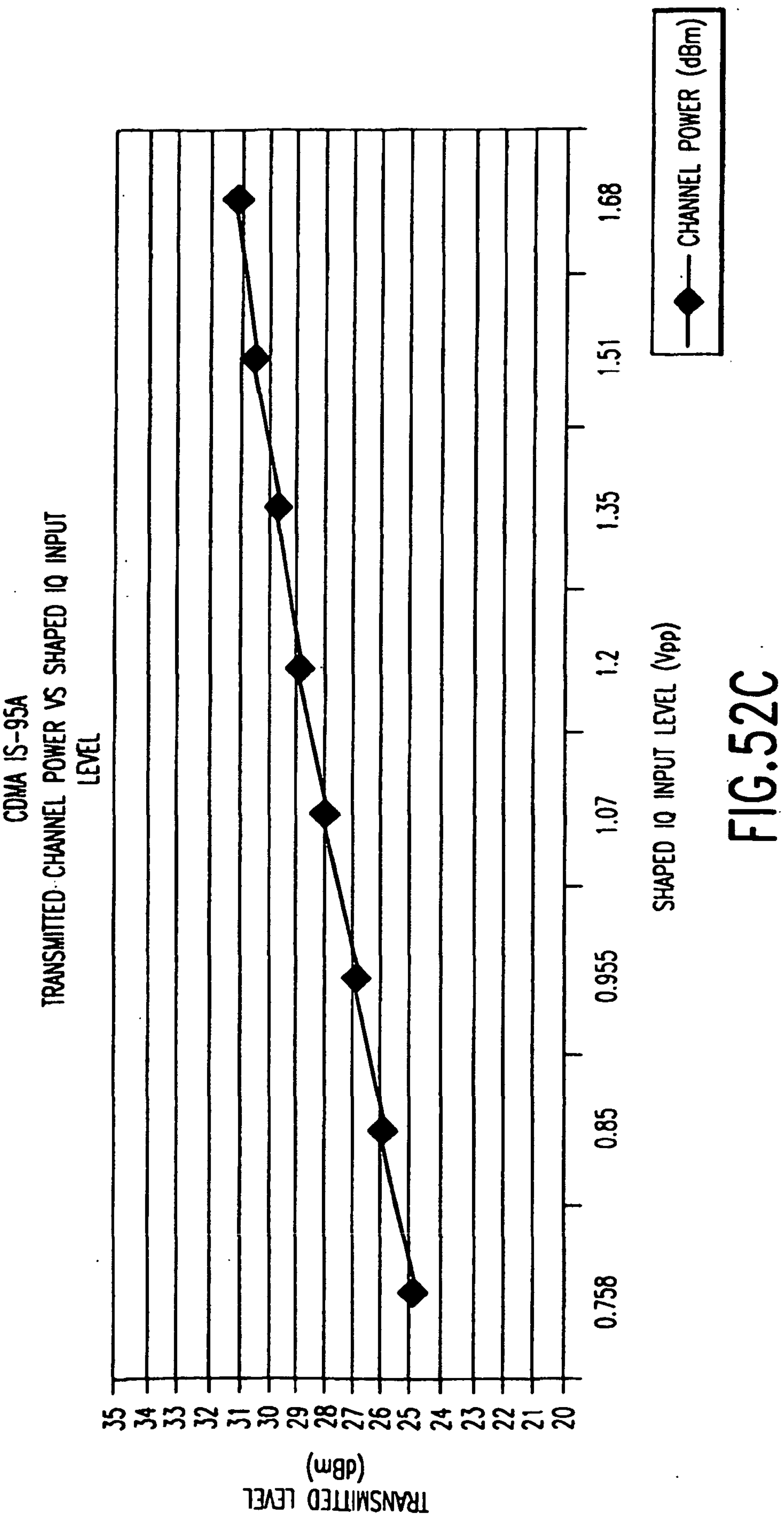

CDMA IS-95A
TRANSMITED CHANNEL POWER VS SHAPED IQ INPUT LEVEL
TRANSMITTED LEVEL (dBm)
35
34
33
32
31
30
29
28
27
26
25
24
23
22
21
20
0.758
0.85
0.955
1.07
1.2
1.35
1.51
1.68
SHAPED IQ INPUT LEVEL (Vpp)
CHANNEL POWER (dBm)


FIG.52C

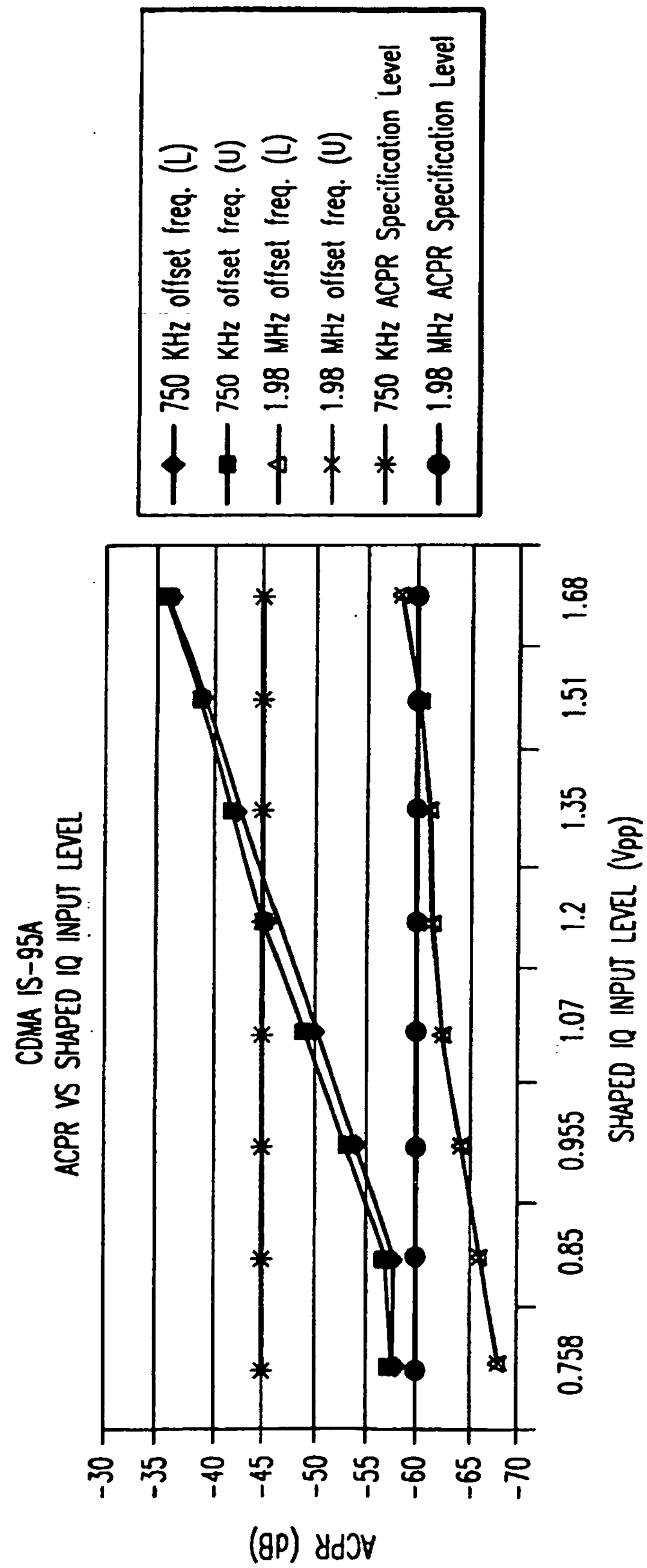
CDMA IS-95A
ACPR VS SHAPED IQ INPUT LEVEL
750 KHz offset freq. (L)
750 KHz offset freq. (U)
1.98 MHz offset freq. (L)
1.98 MHz offset freq. (U)
750 KHz ACPR Specification Level
1.98 MHz ACPR Specification Level
ACPR (dB)
-30
-35
-40
-45
-50
-55
-60
-65
-70
0.758
0.85
0.955
1.07
1.2
1.35
1.51
1.68
SHAPED IQ INPUT LEVEL (Vpp)

FIG.52D

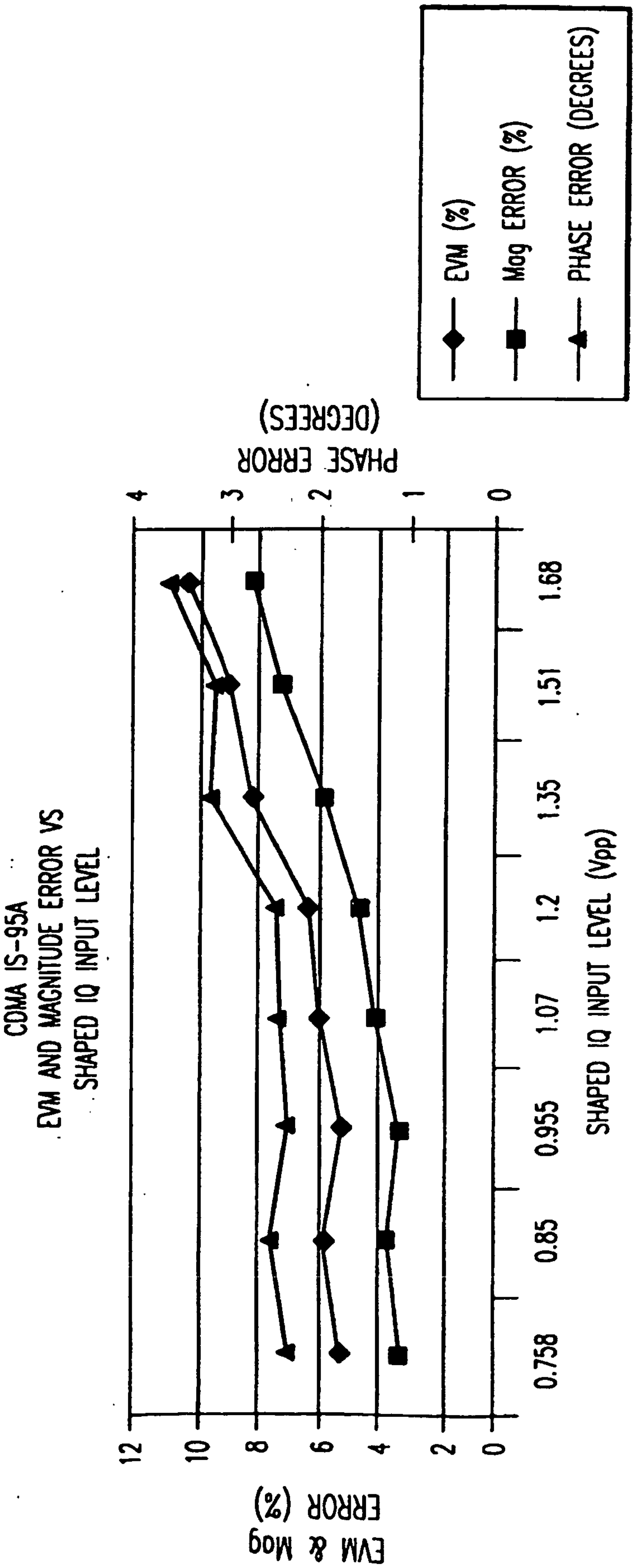
CDMA IS-95A
EVM AND MAGNITUDE ERROR VS
SHAPED IQ INPUT LEVEL
EVM & Mag ERROR (%)
12
10
8
6
4
2
0
PHASE ERROR (DEGREES)
4
3
2
1
0
0.758
0.85
0.955
1.07
1.2
1.35
1.51
1.68
SHAPED IQ INPUT LEVEL (Vpp)
EVM (%)
Mag ERROR (%)
PHASE ERROR (DEGREES)

FIG.52E

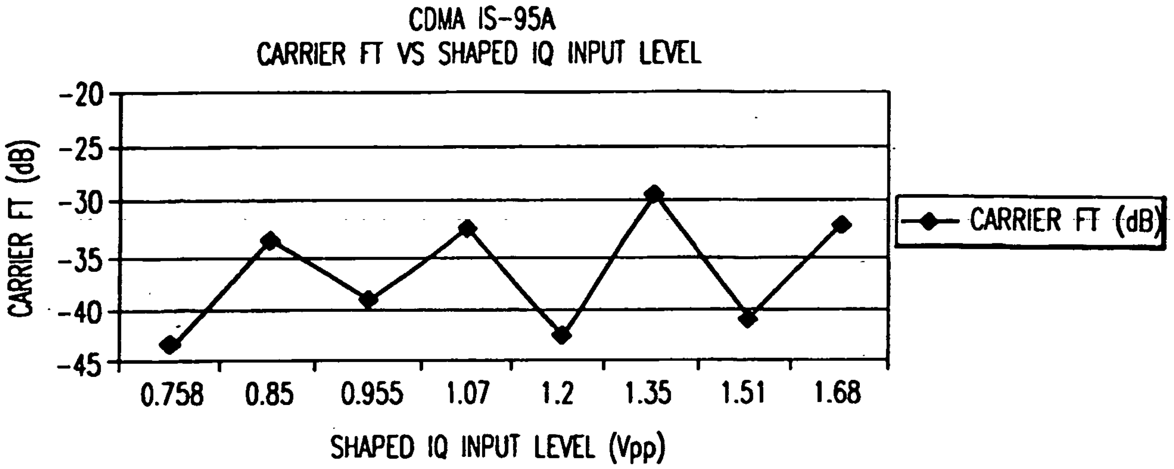


FIG.52F

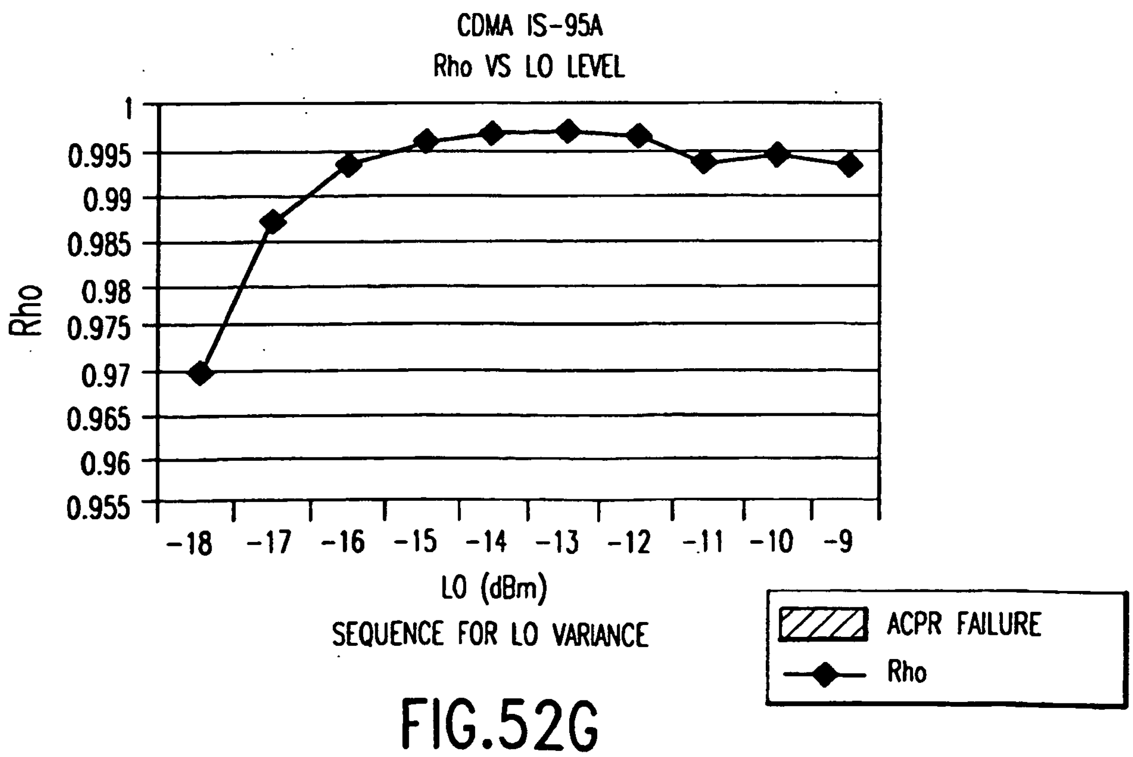


FIG.52G

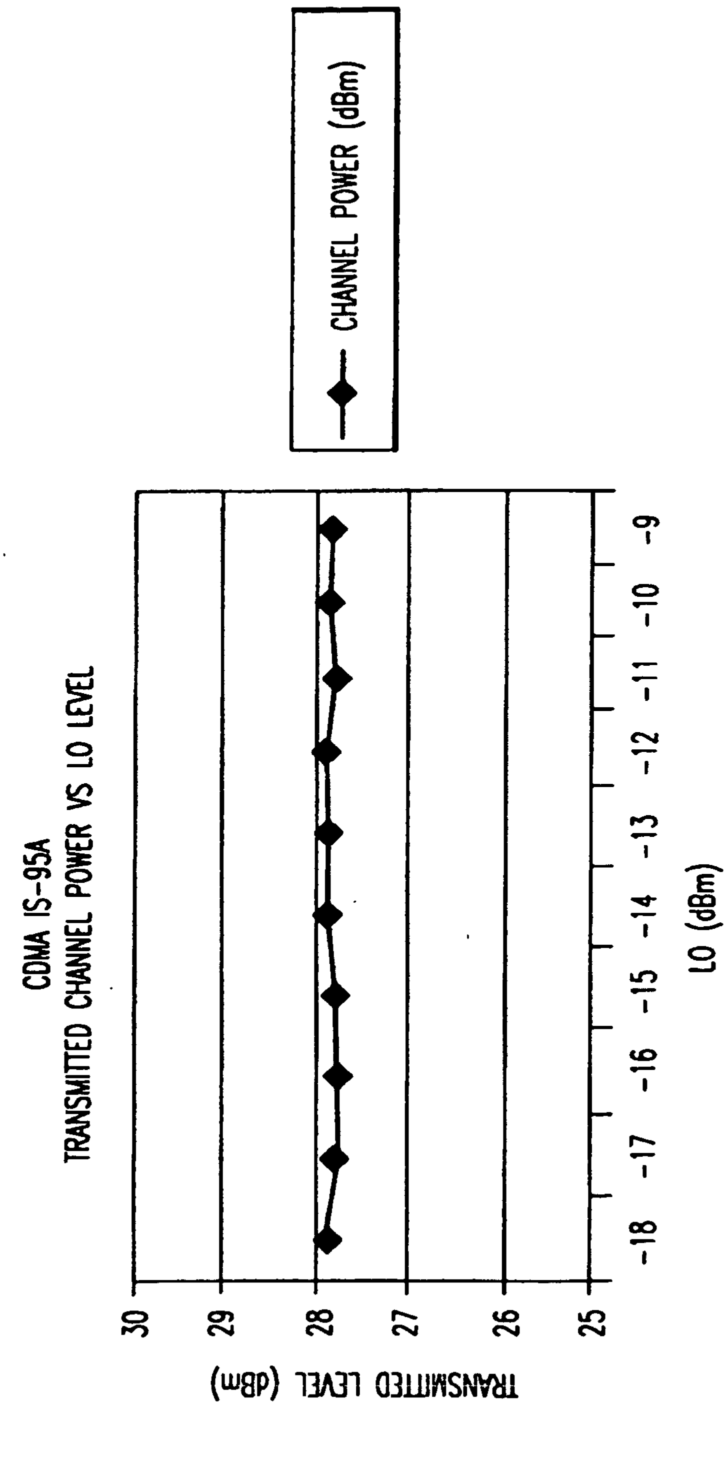
CDMA IS-95A
TRANSMITTED CHANNEL POWER VS LO LEVEL
CHANNEL POWER (dBm)
TRANSMITTED LEVEL (dBm)
30
29
28
27
26
25
-18
-17
-16
-15
-14
-13
-12
-11
-10
-9
LO (dBm)

FIG.52H

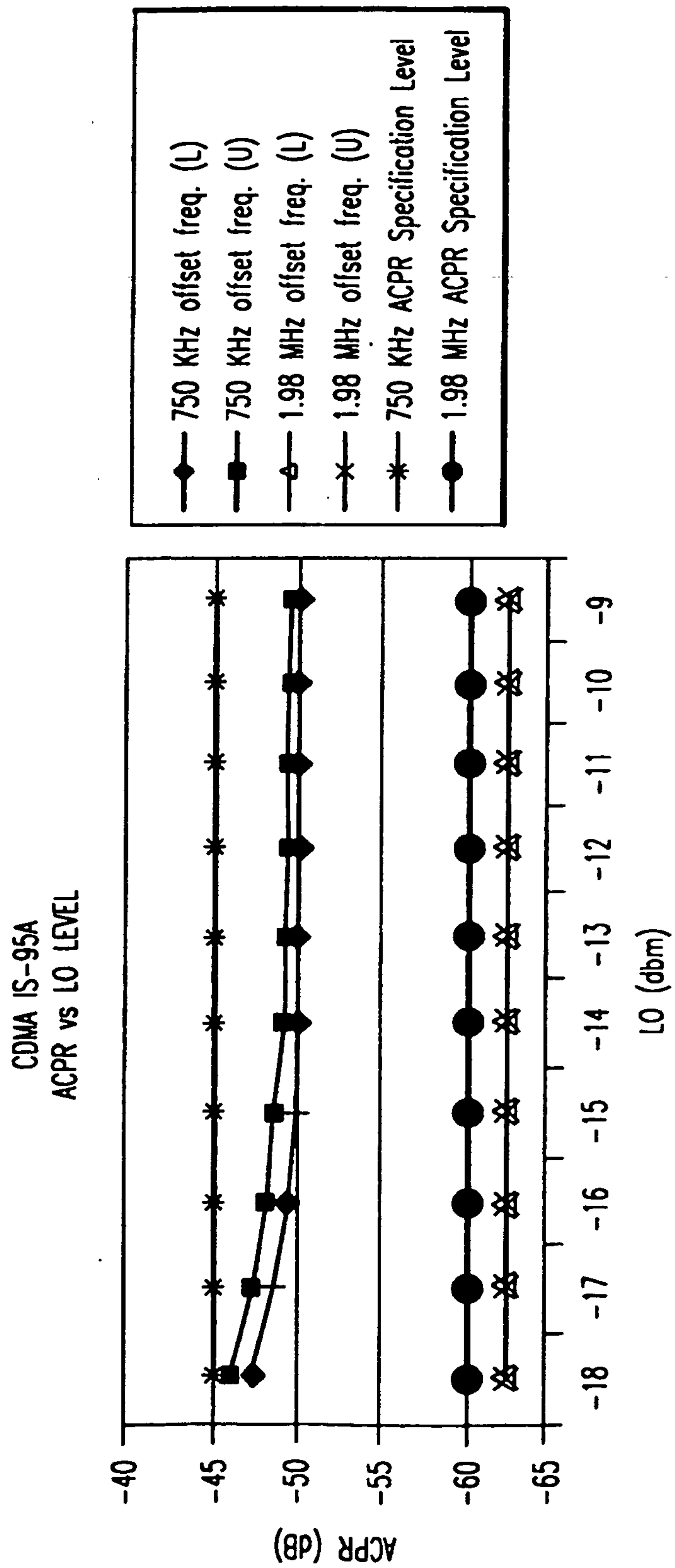
CDMA IS-95A
ACPR vs LO LEVEL
ACPR (dB)
-40
-45
-50
-55
-60
-65
-18
-17
-16
-15
-14
-13
-12
-11
-10
-9
LO (dbm)
750 KHz offset freq. (L)
750 KHz offset freq. (U)
1.98 MHz offset freq. (L)
1.98 MHz offset freq. (U)
750 KHz ACPR Specification Level
1.98 MHz ACPR Specification Level

FIG.52I

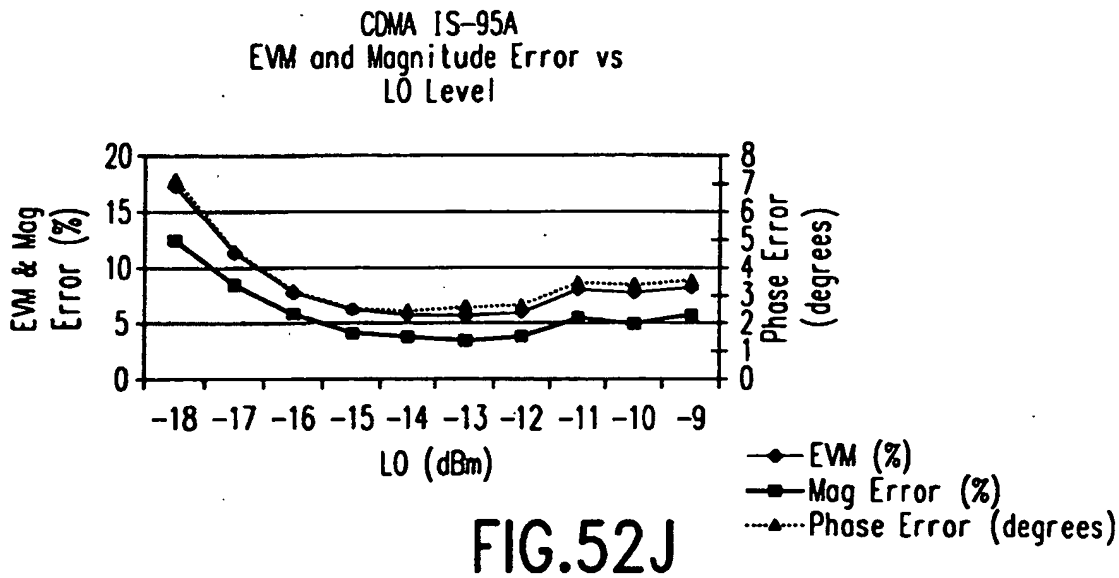


FIG.52J

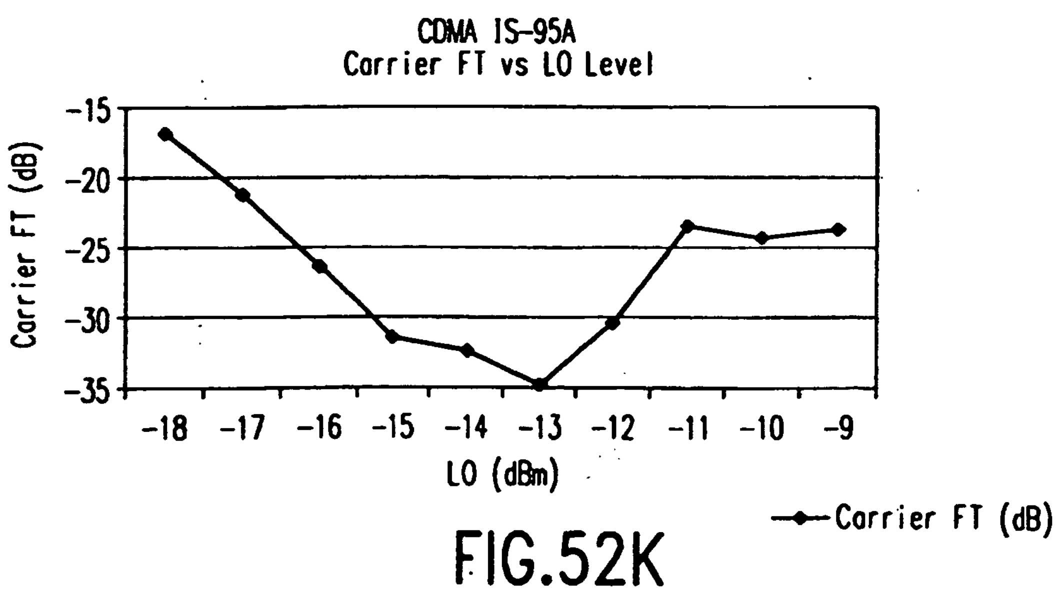


FIG.52K

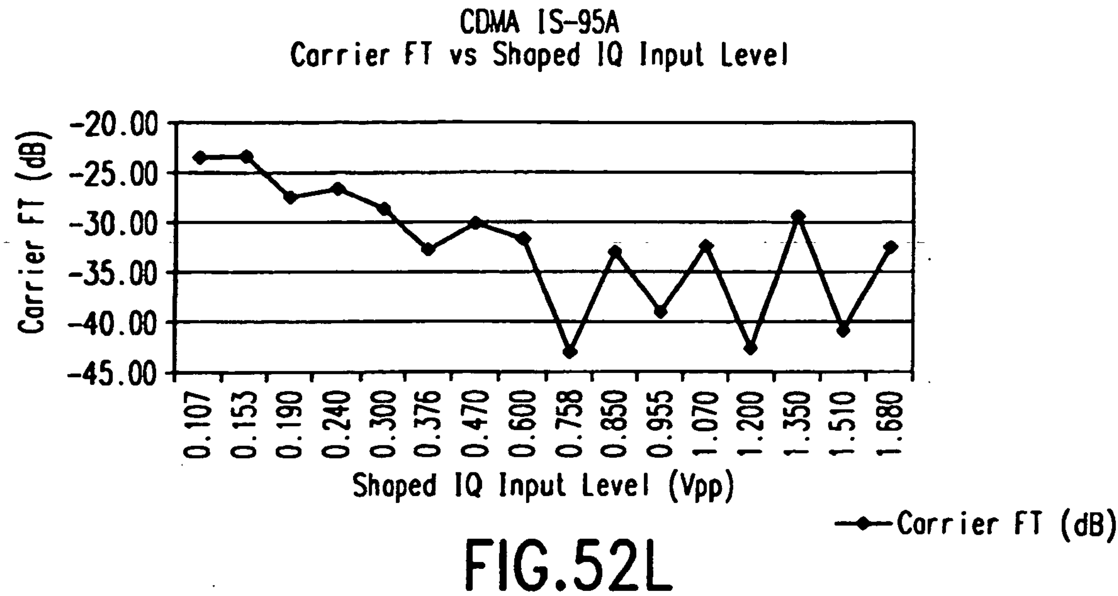


FIG.52L

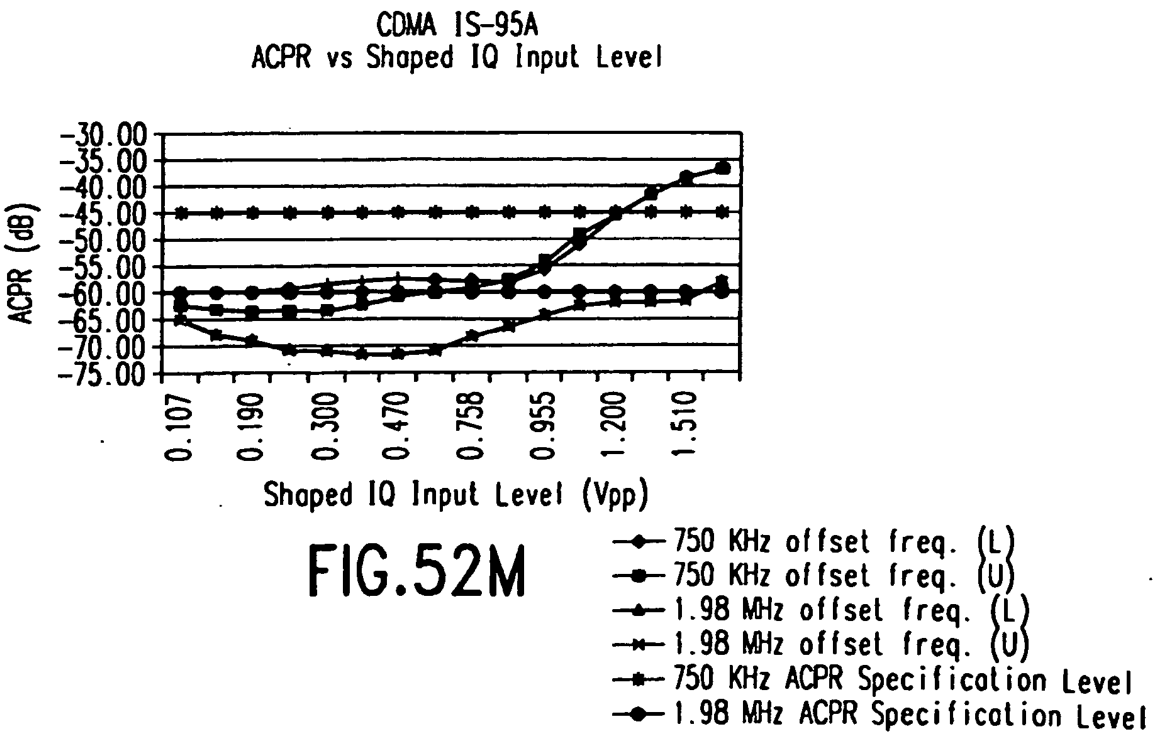


FIG.52M

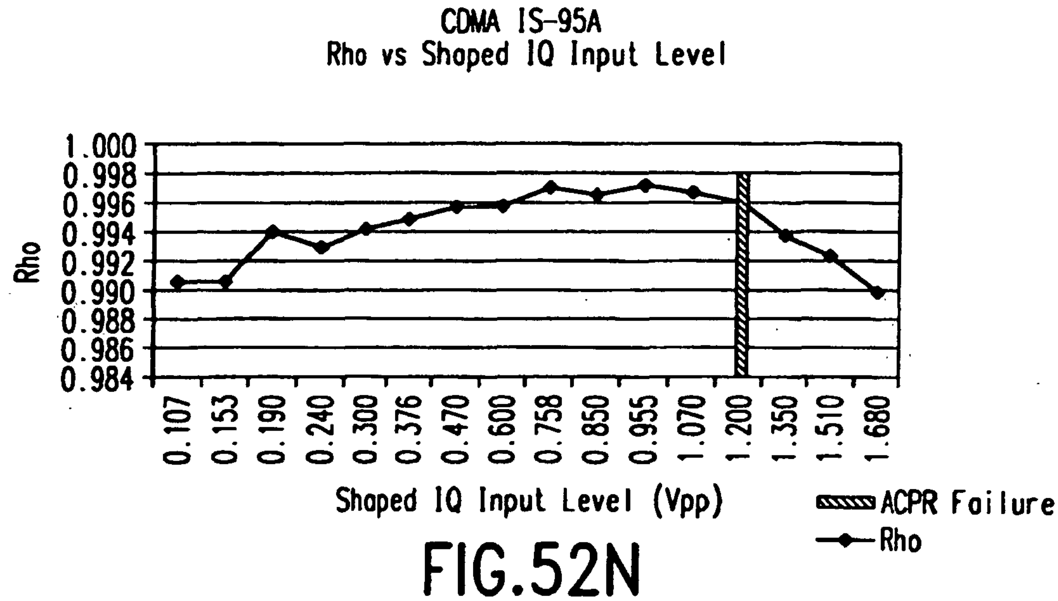


FIG.52N

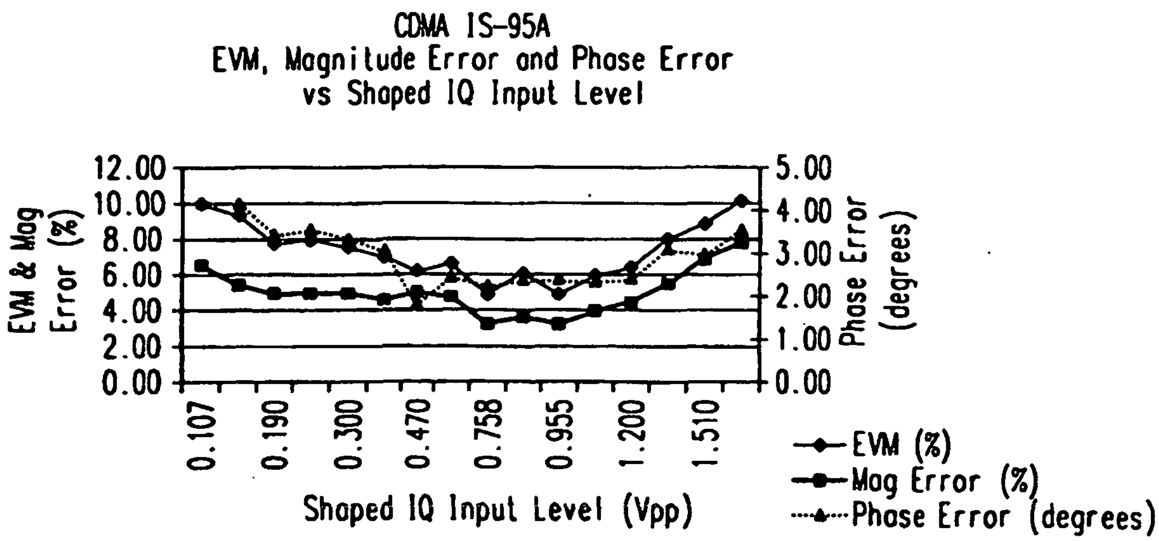


FIG.52O

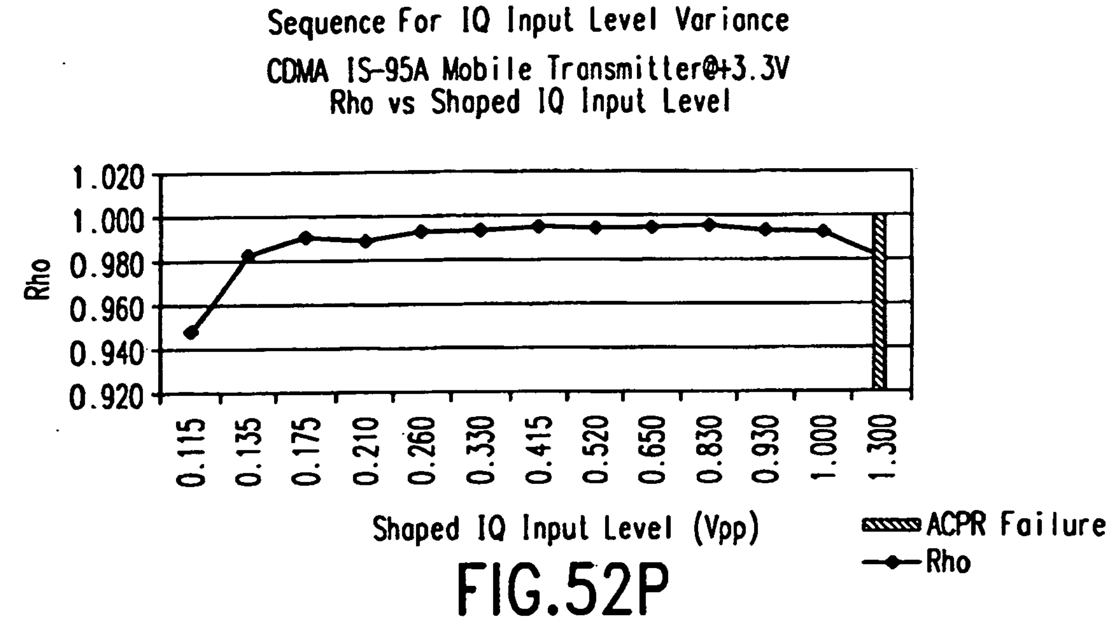


FIG.52P

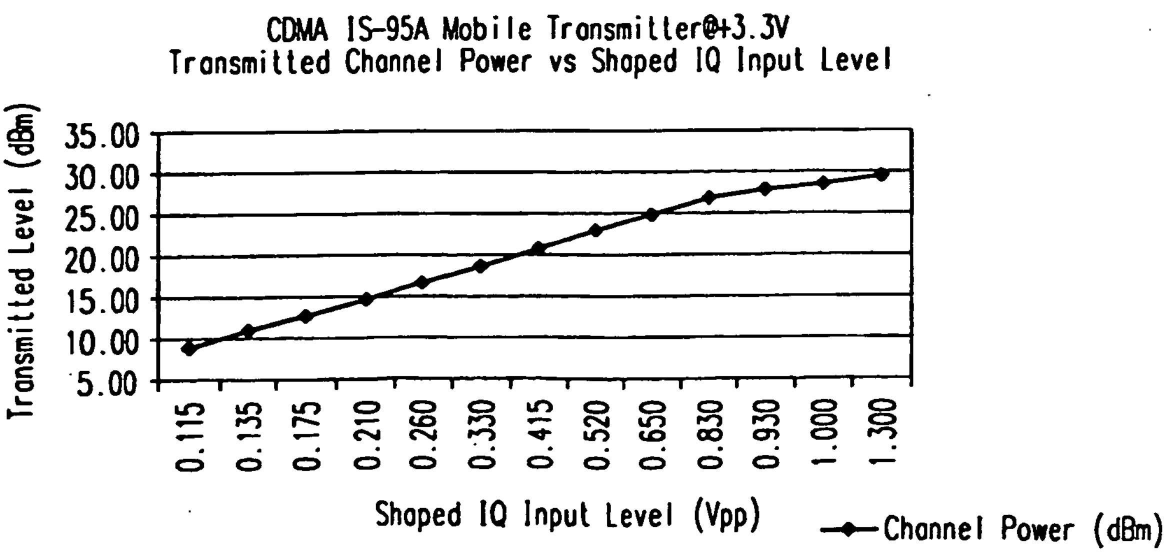


FIG.52Q

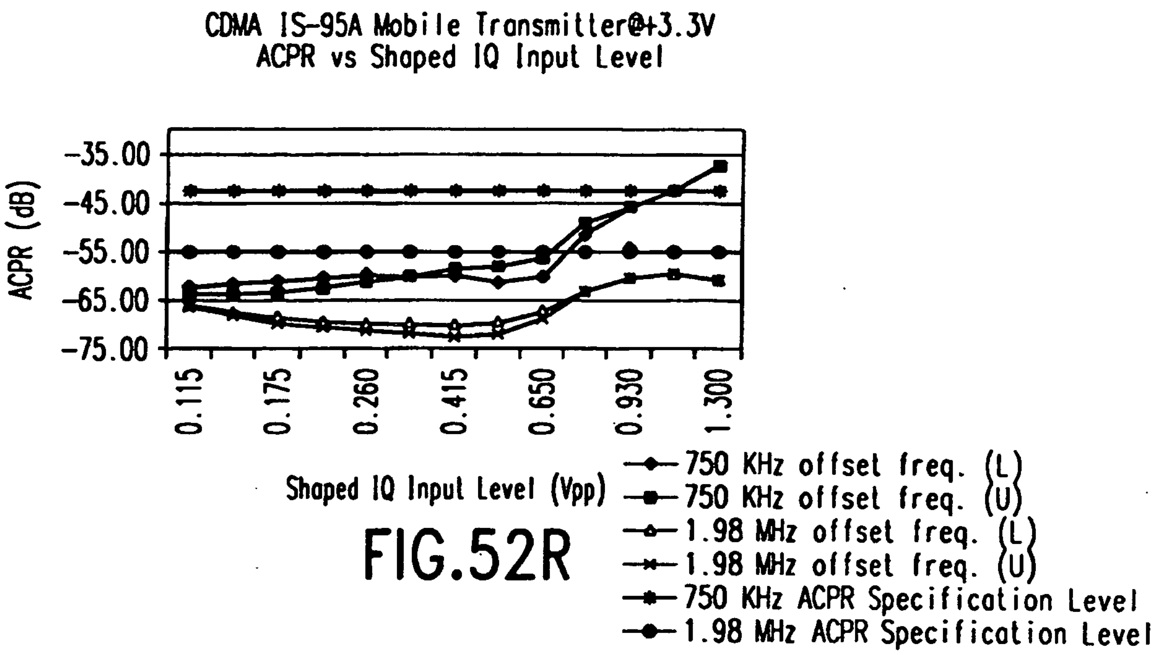


FIG.52R

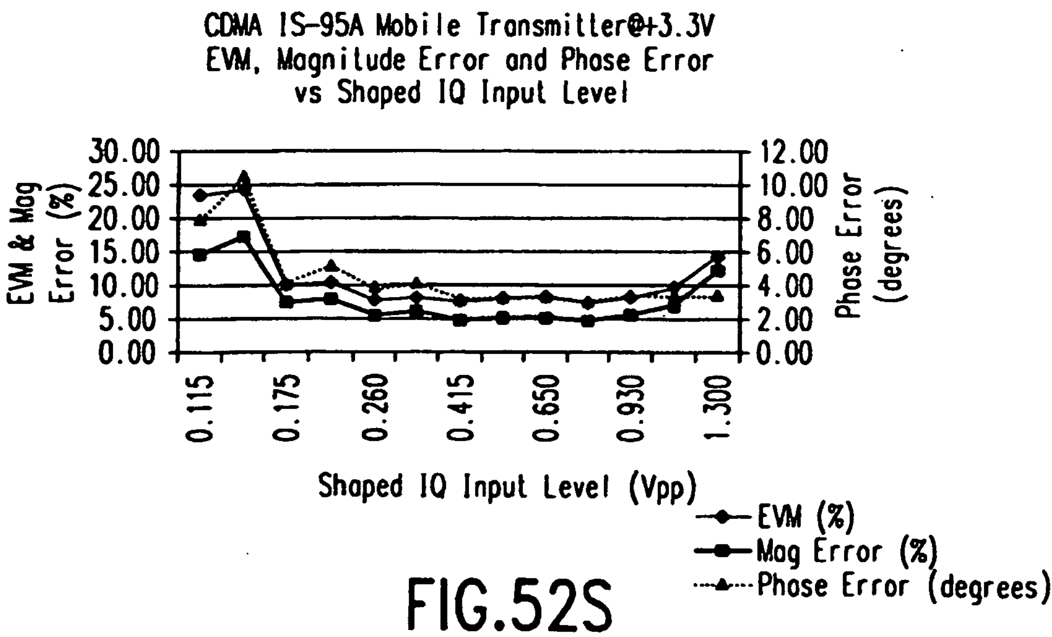


FIG.52S

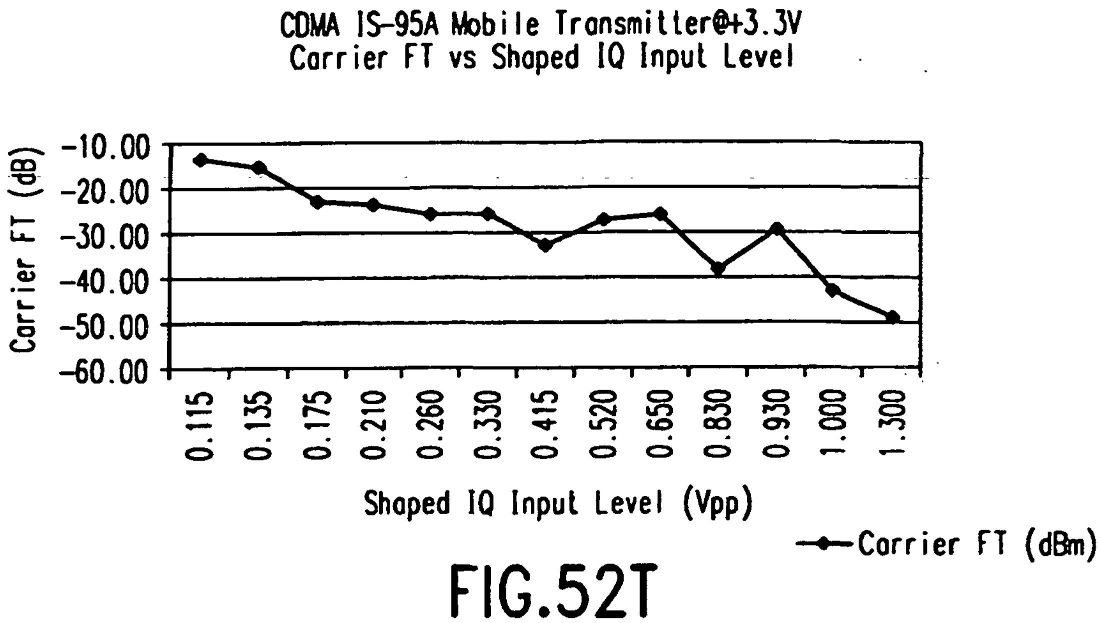


FIG.52T

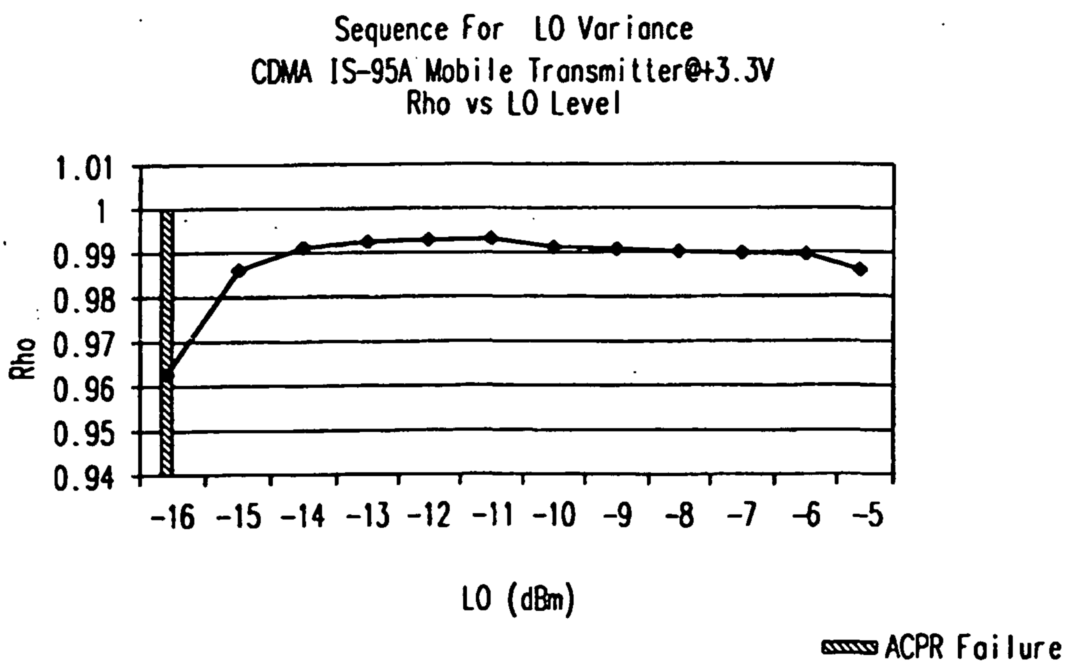


FIG.52U

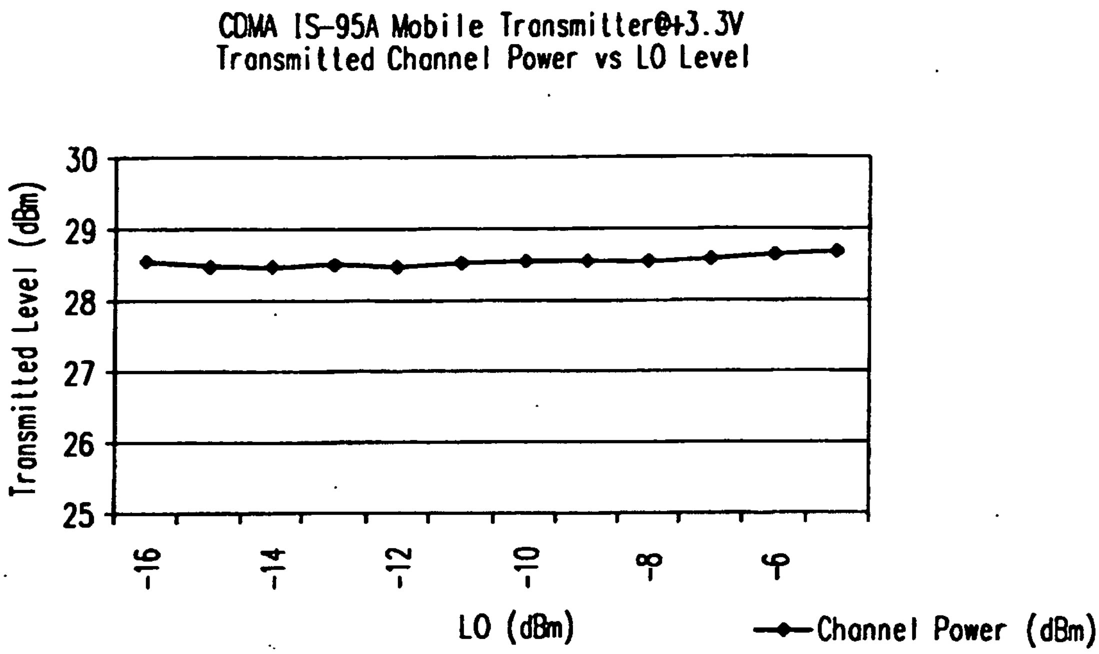


FIG.52V

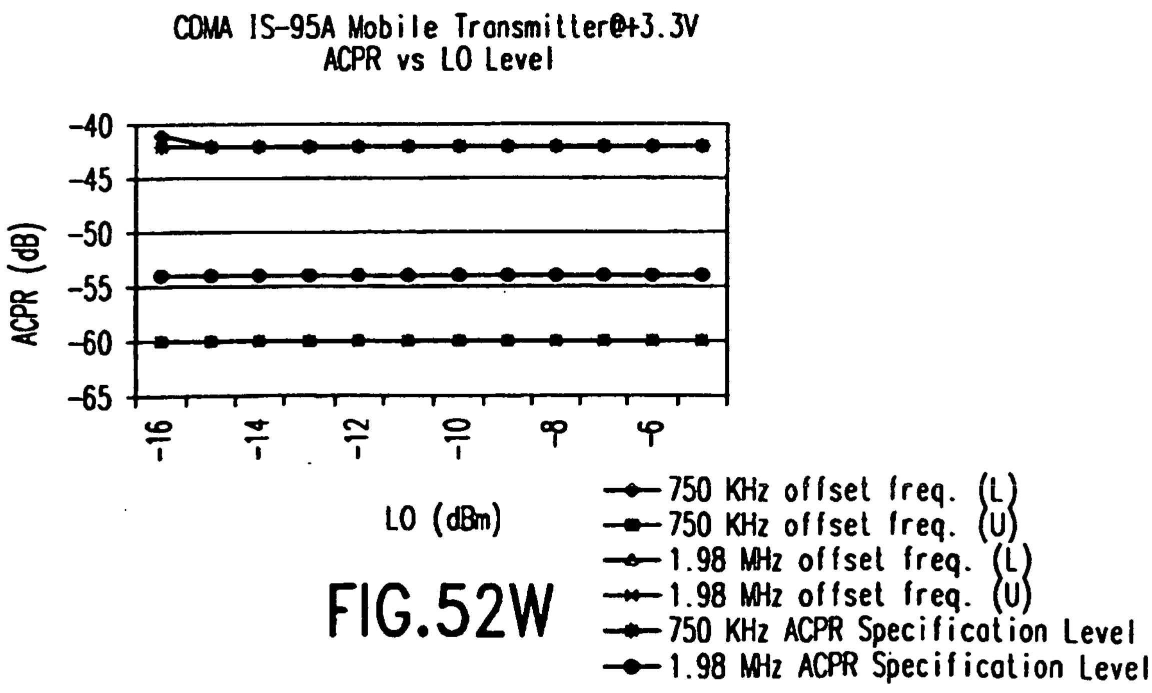


FIG.52W

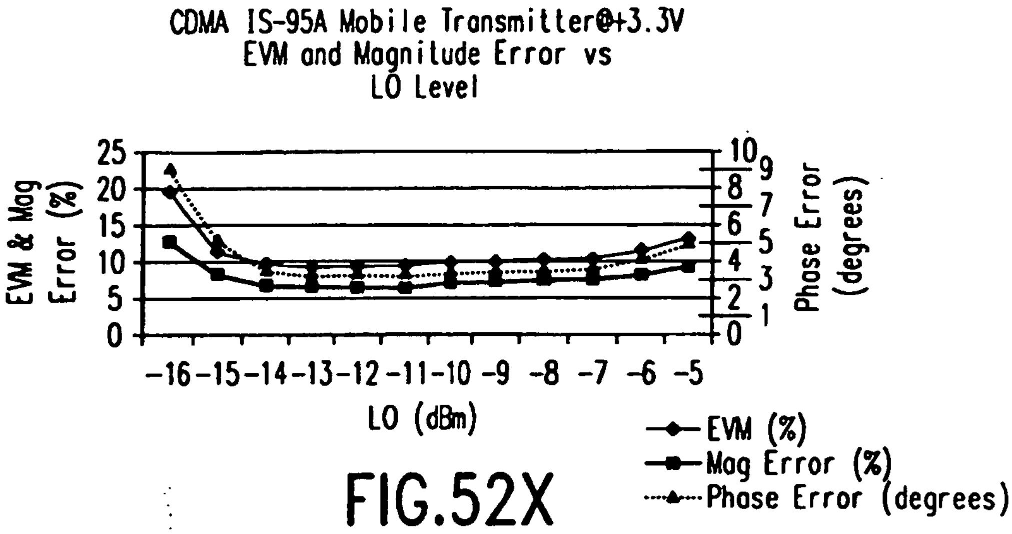


FIG.52X

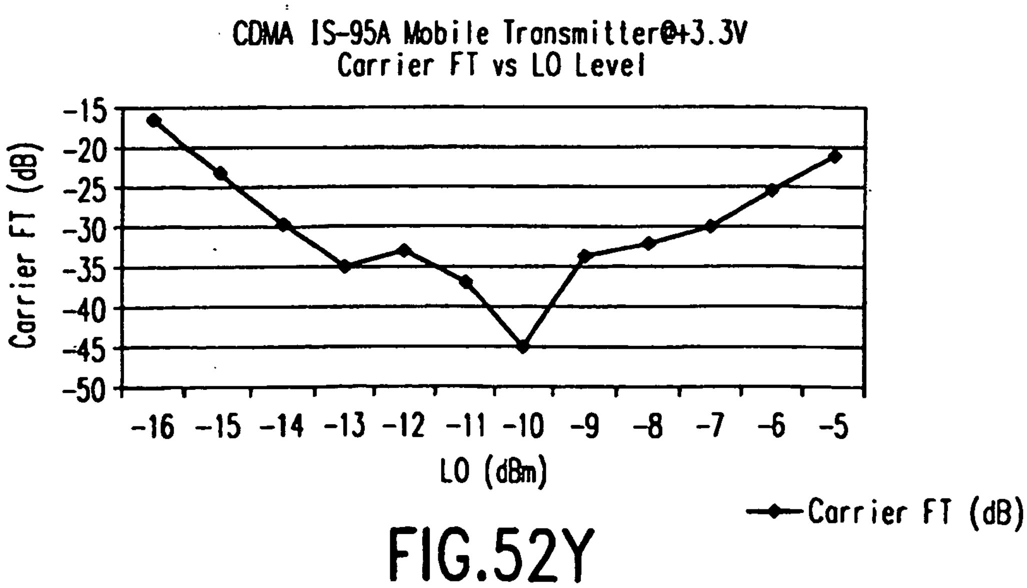


FIG.52Y

| QUANTITY | DESCRIPTION | VOLTAGE | TOTAL CURRENT | POWER |
|---|---|---|---|---|
| 2 | CORES | 3.3 | 4mA | 13.2mW |
| 2 | BASEBAND INTERFACE CIRCUITS WITH/BW LIMIT | 3.3 | 6mA | 21.8mW |
| 1 | CLOCK CIRCUIT | 3.3 | 5mA | 20.0mW |
| | | | SUB TOTAL | 54.0mW |

FIG.52Z

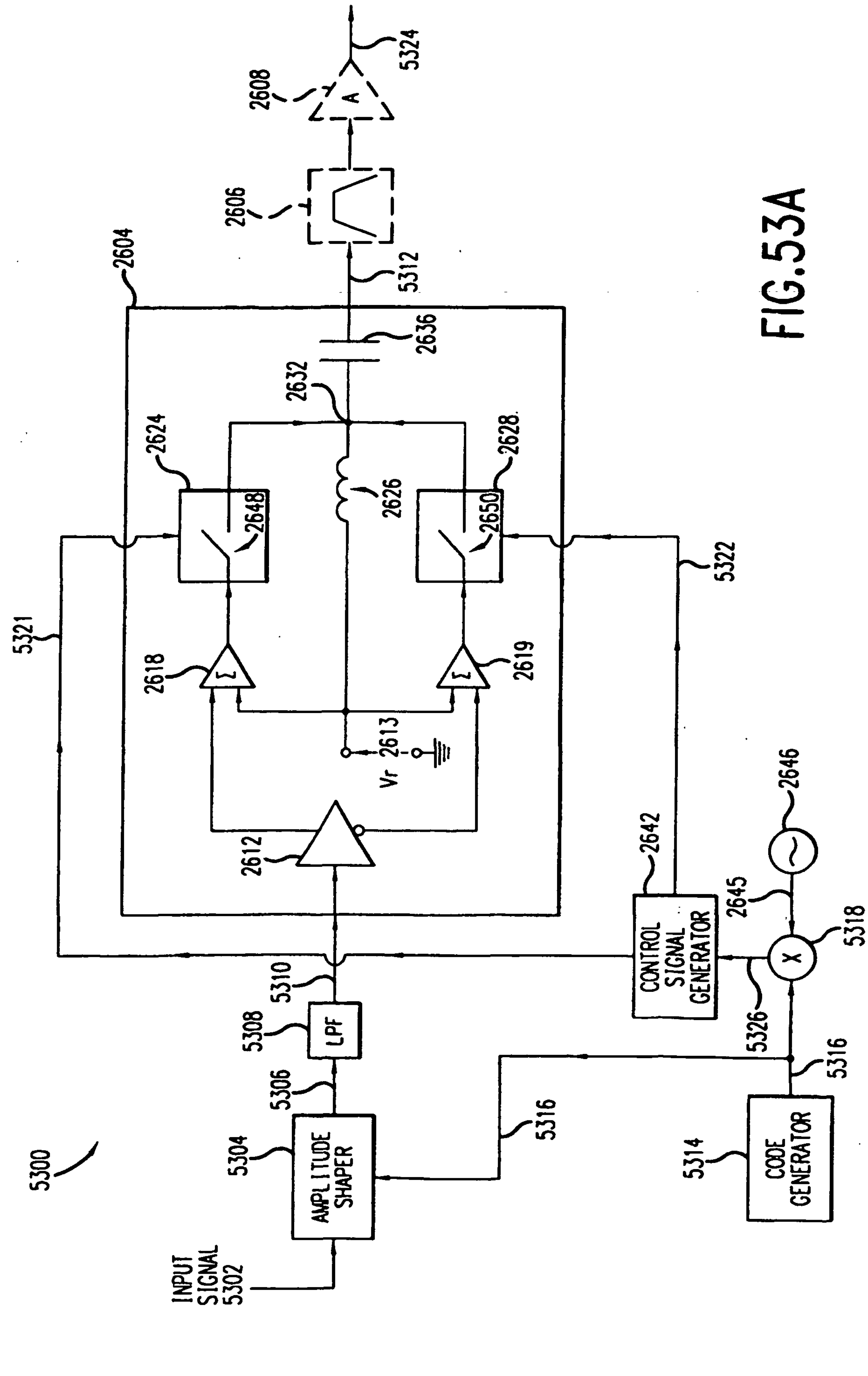
5300
INPUT SIGNAL 5302
AMPLITUDE SHAPER
5304
5306
LPF
5308
5310
5321
2612
Vr
2613
2618
2619
2624
2648
2626
2650
2628
2632
2636
2604
5312
2606
2608
A
5324
5322
2642
CONTROL SIGNAL GENERATOR
2645
2646
X
5318
5326
5316
CODE GENERATOR
5314

FIG.53A

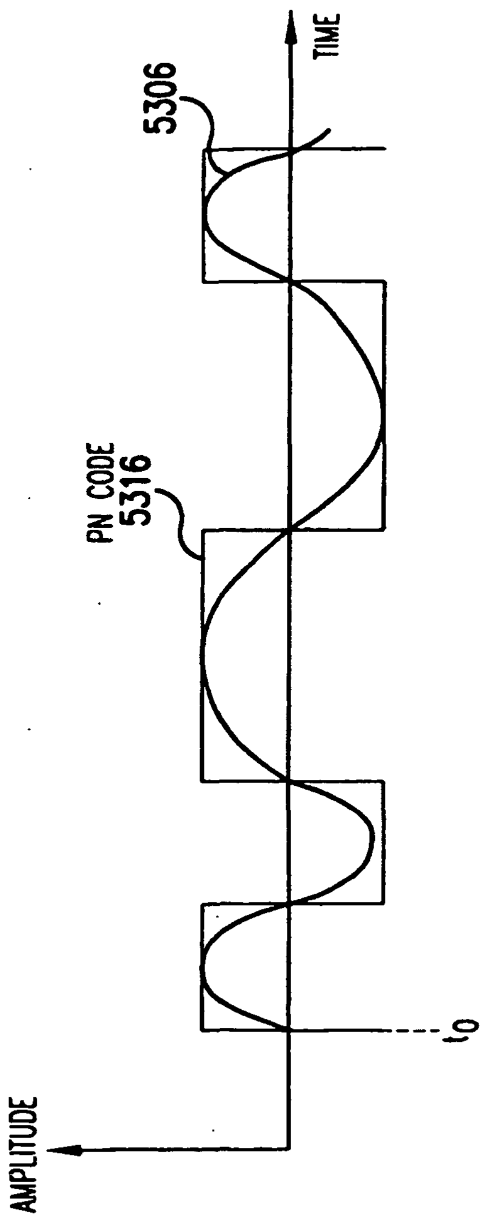


FIG.53B

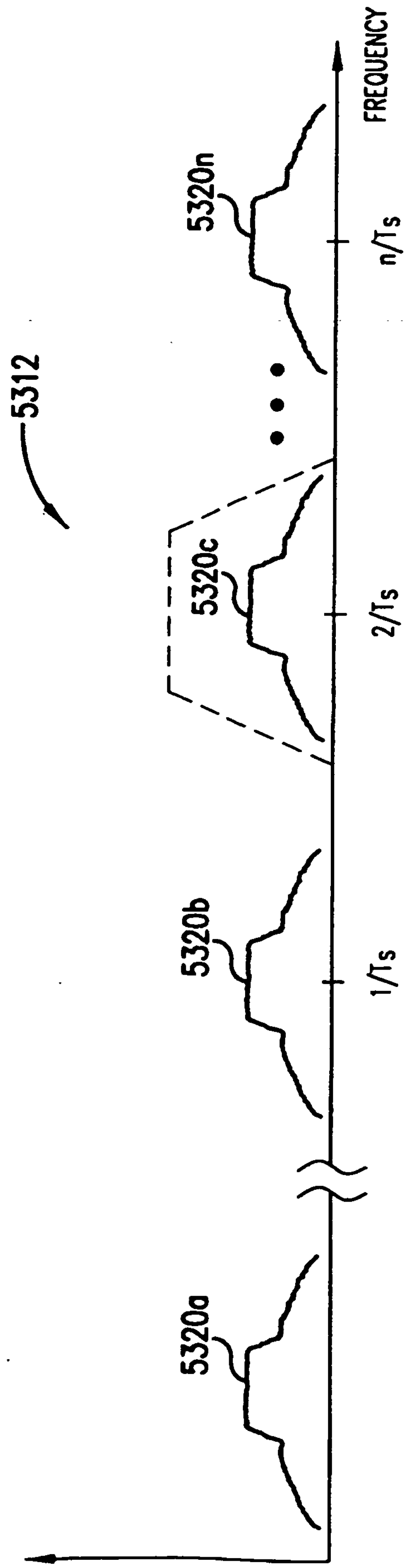


FIG.53C

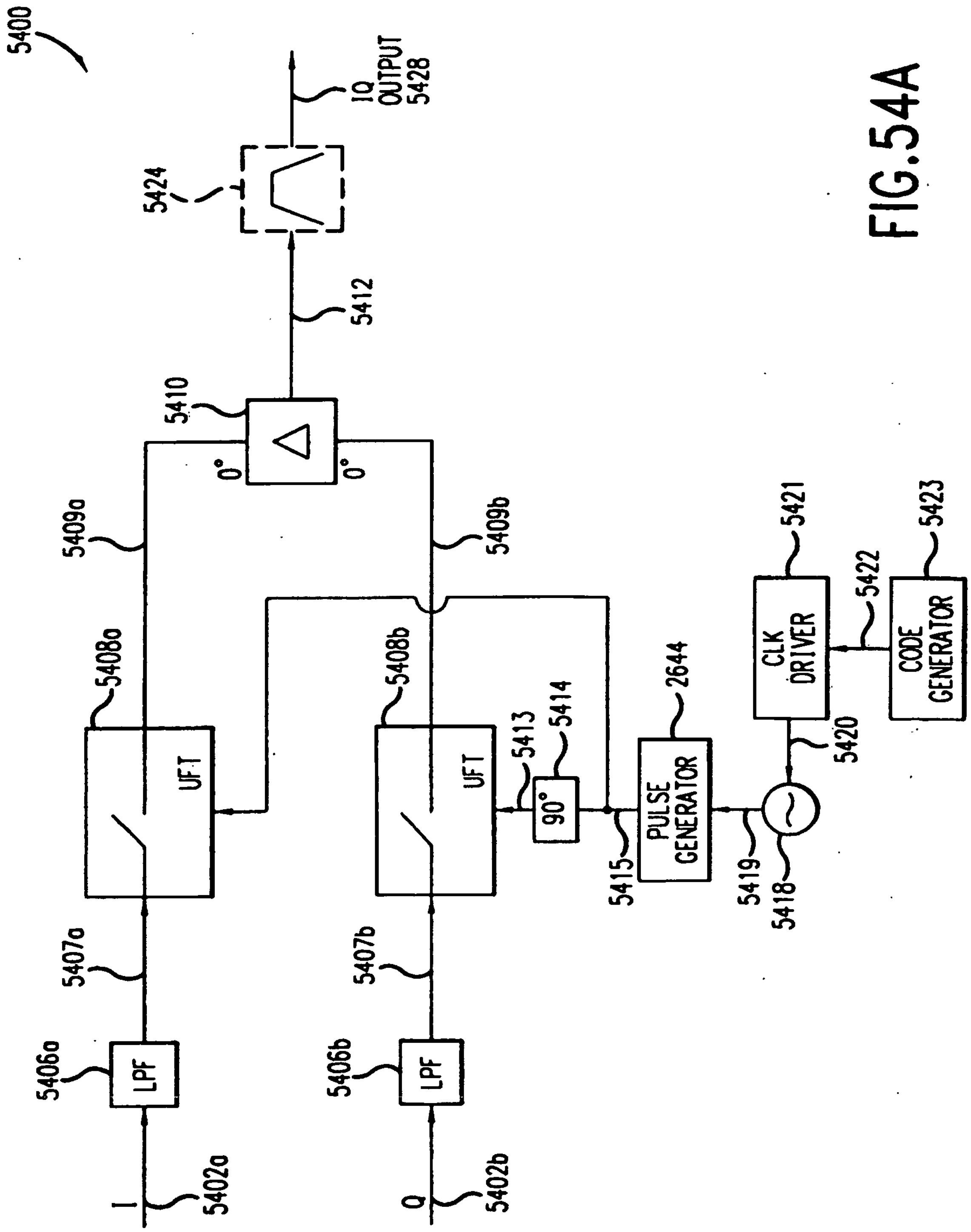
5400
I
5402a
5406a
LPF
5407a
5408a
UFT
5409a
Q
5402b
5406b
LPF
5407b
5408b
UFT
5409b
5410
0°
0°
5412
5424
IQ
OUTPUT
5428
5413
5414
90°
5415
PULSE
GENERATOR
2644
5419
5418
5420
CLK
DRIVER
5421
5422
CODE
GENERATOR
5423

FIG.54A

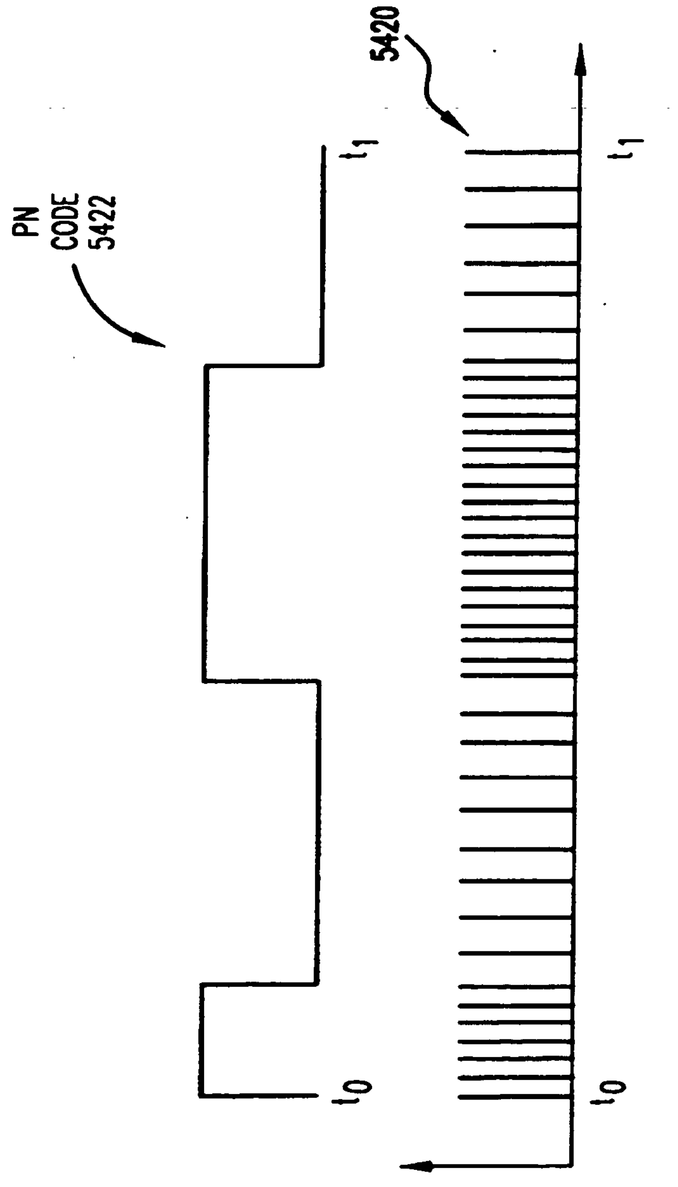


FIG.54B

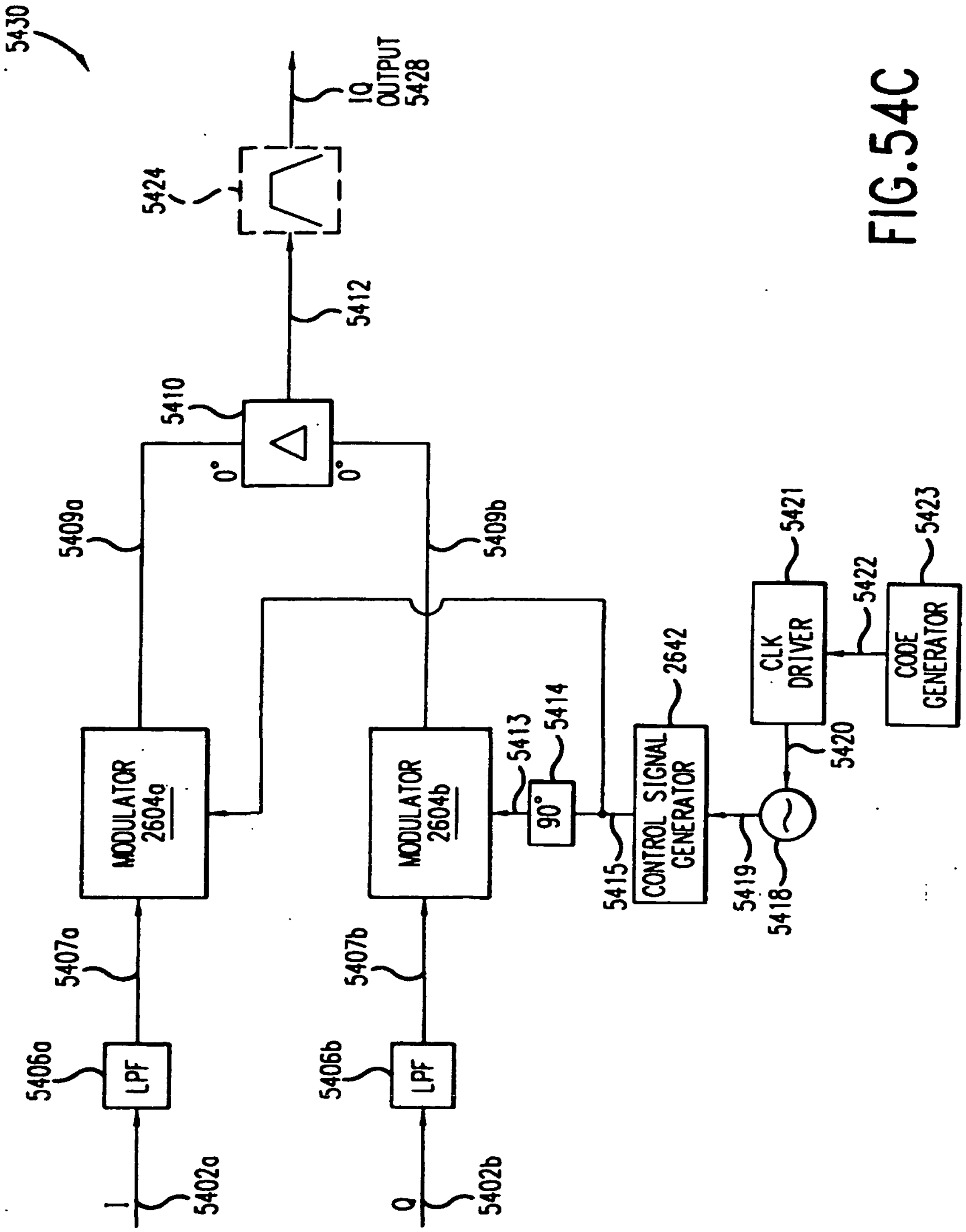
5430
I
5402a
5406a
LPF
5407a
MODULATOR
2604a
5409a
0°
5410
0°
5412
5424
IQ
OUTPUT
5428
Q
5402b
5406b
LPF
5407b
MODULATOR
2604b
5413
5414
90°
5415
5409b
CONTROL SIGNAL
GENERATOR
2642
5419
5418
5420
CLK
DRIVER
5421
5422
CODE
GENERATOR
5423

FIG.54C

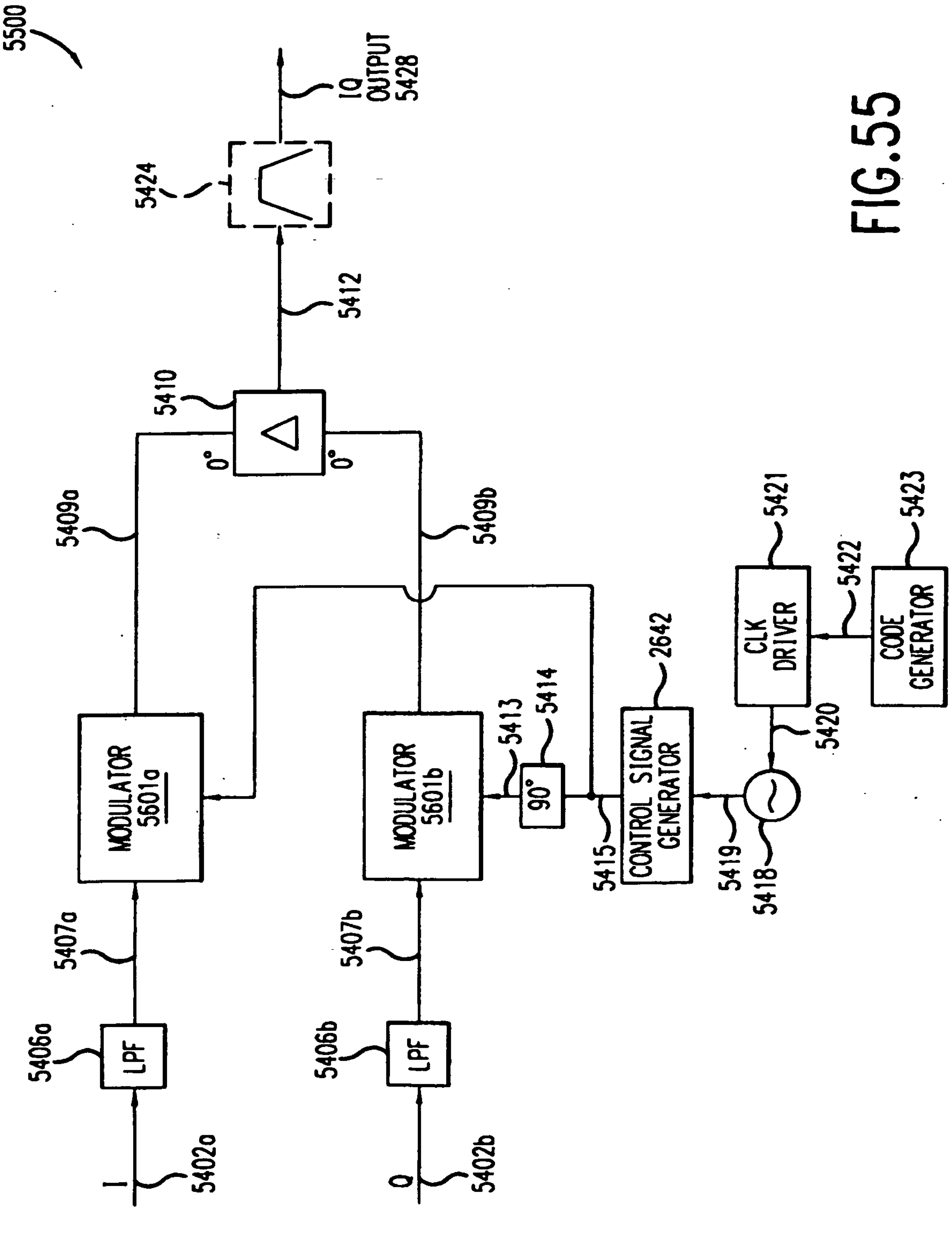
5500
I
5402a
5406a
LPF
5407a
MODULATOR
5601a
5409a
0°
0°
5410
5412
5424
IQ
OUTPUT
5428
Q
5402b
5406b
LPF
5407b
MODULATOR
5601b
5413
5414
90°
5409b
5415
CONTROL SIGNAL
GENERATOR
2642
5419
5418
5420
CLK
DRIVER
5421
5422
CODE
GENERATOR
5423

FIG.55

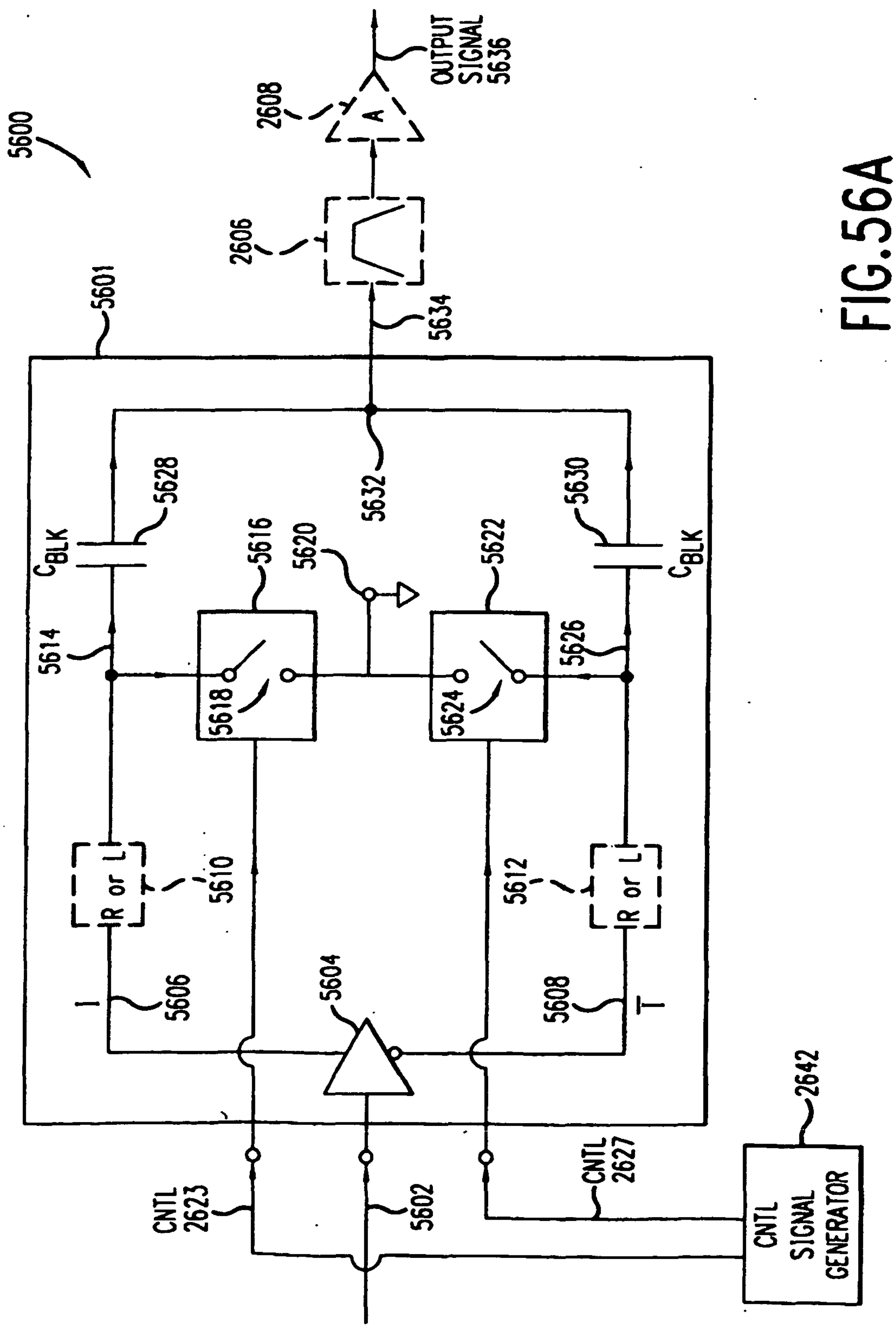
5600
5601
OUTPUT
SIGNAL
5636
2608
A
2606
5634
5628
$C_{BLK}$
5616
5620
5622
5630
$C_{BLK}$
5632
5614
5618
5624
5626
R or L
5610
R or L
5612
I
5606
5604
5608
T
CNTL
2623
5602
CNTL
2627
2642
CNTL
SIGNAL
GENERATOR

FIG.56A

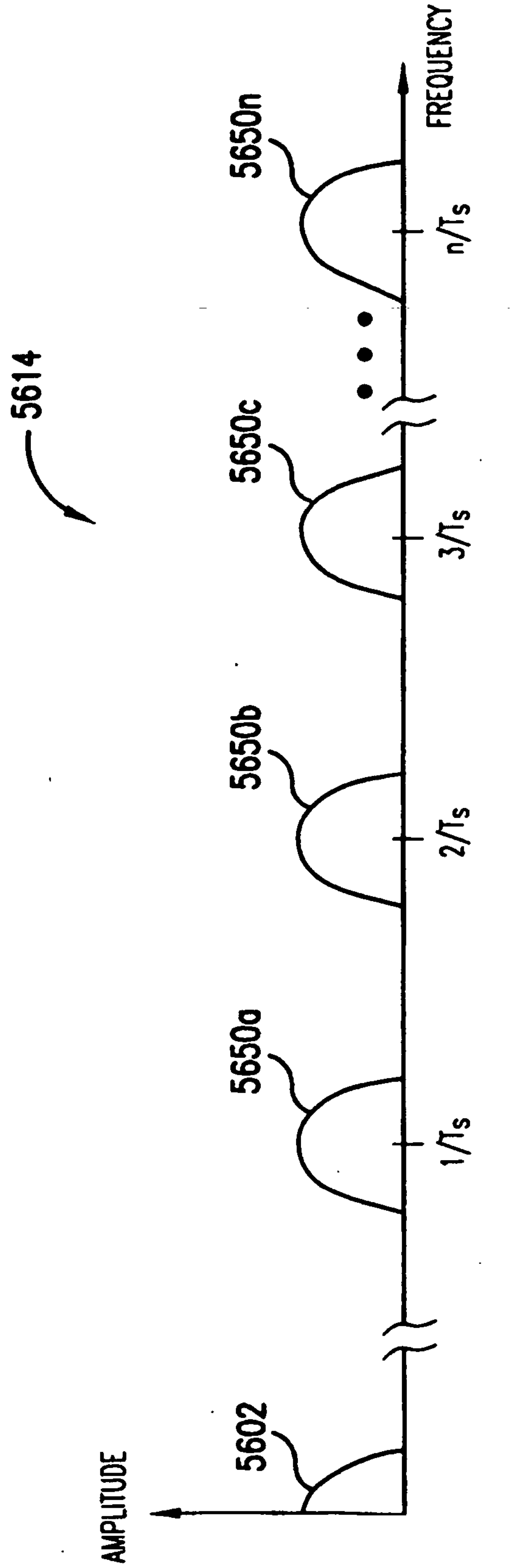
5614
FREQUENCY
5650n
n/Ts
5650c
3/Ts
5650b
2/Ts
5650a
1/Ts
5602
AMPLITUDE

FIG.56B

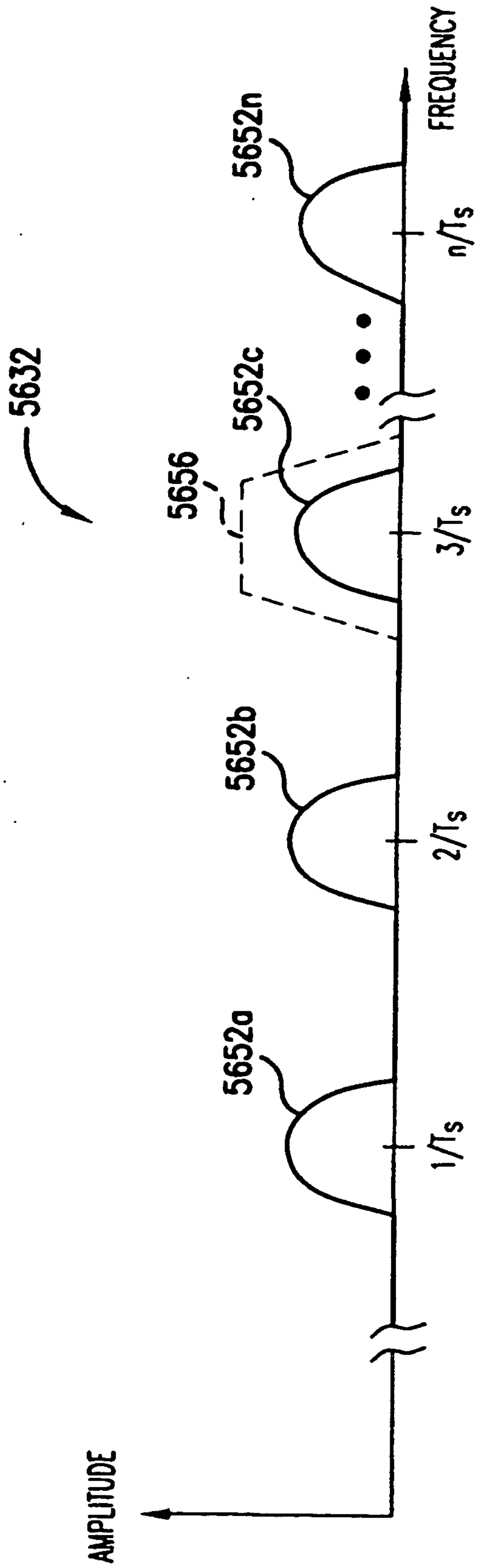
5632
FREQUENCY
AMPLITUDE
5652a
5652b
5652c
5652n
5656
$1/T_s$
$2/T_s$
$3/T_s$
$n/T_s$

FIG.56C

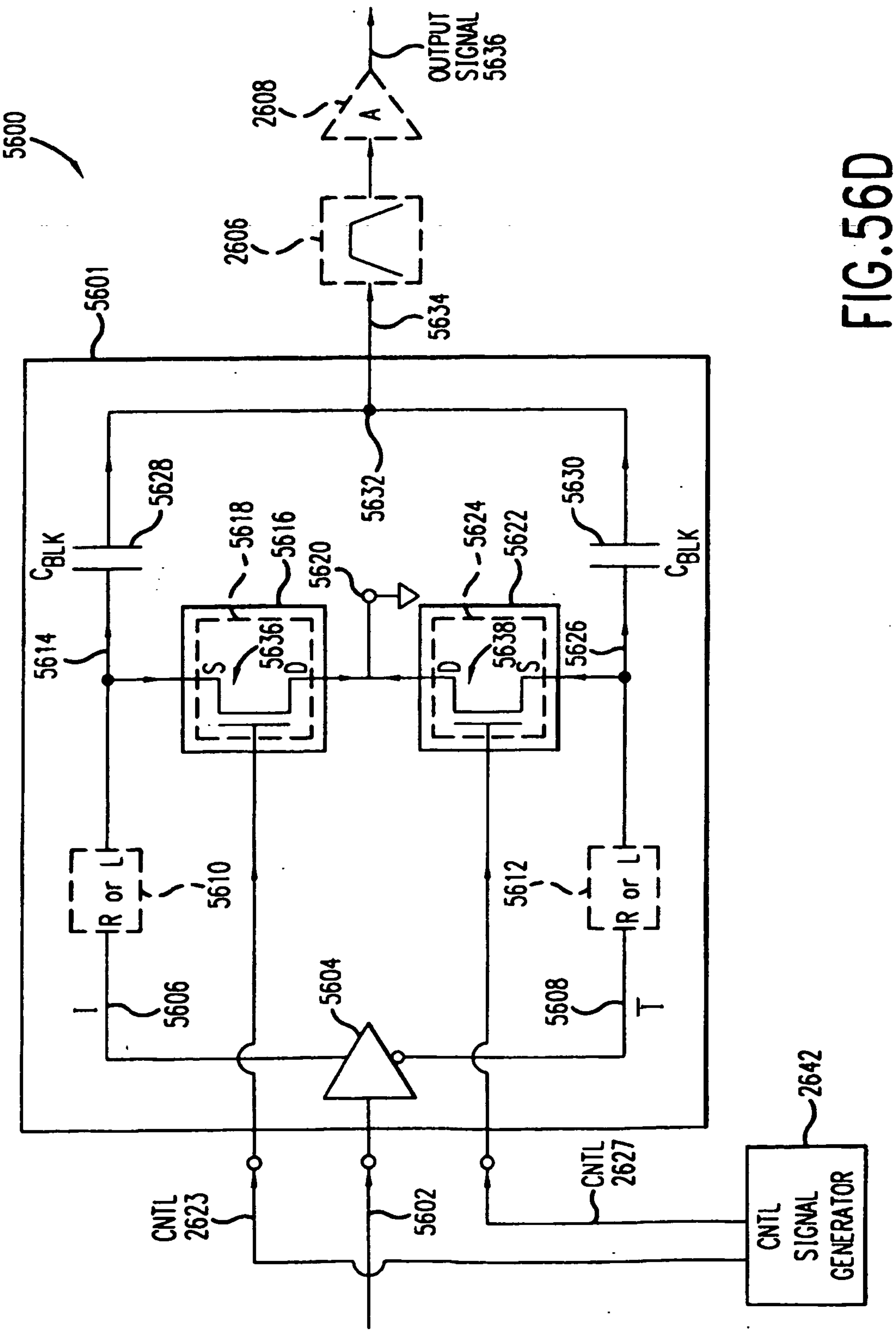
5600
5601
OUTPUT SIGNAL 5636
2608
A
2606
5634
5632
5628
5630
$C_{BLK}$
$C_{BLK}$
5618
5616
5620
5624
5622
5614
5626
S
D
56361
D
S
56381
R or L
5610
R or L
5612
I
5606
T
5608
5604
CNTL 2623
5602
CNTL 2627
2642
CNTL SIGNAL GENERATOR

FIG.56D

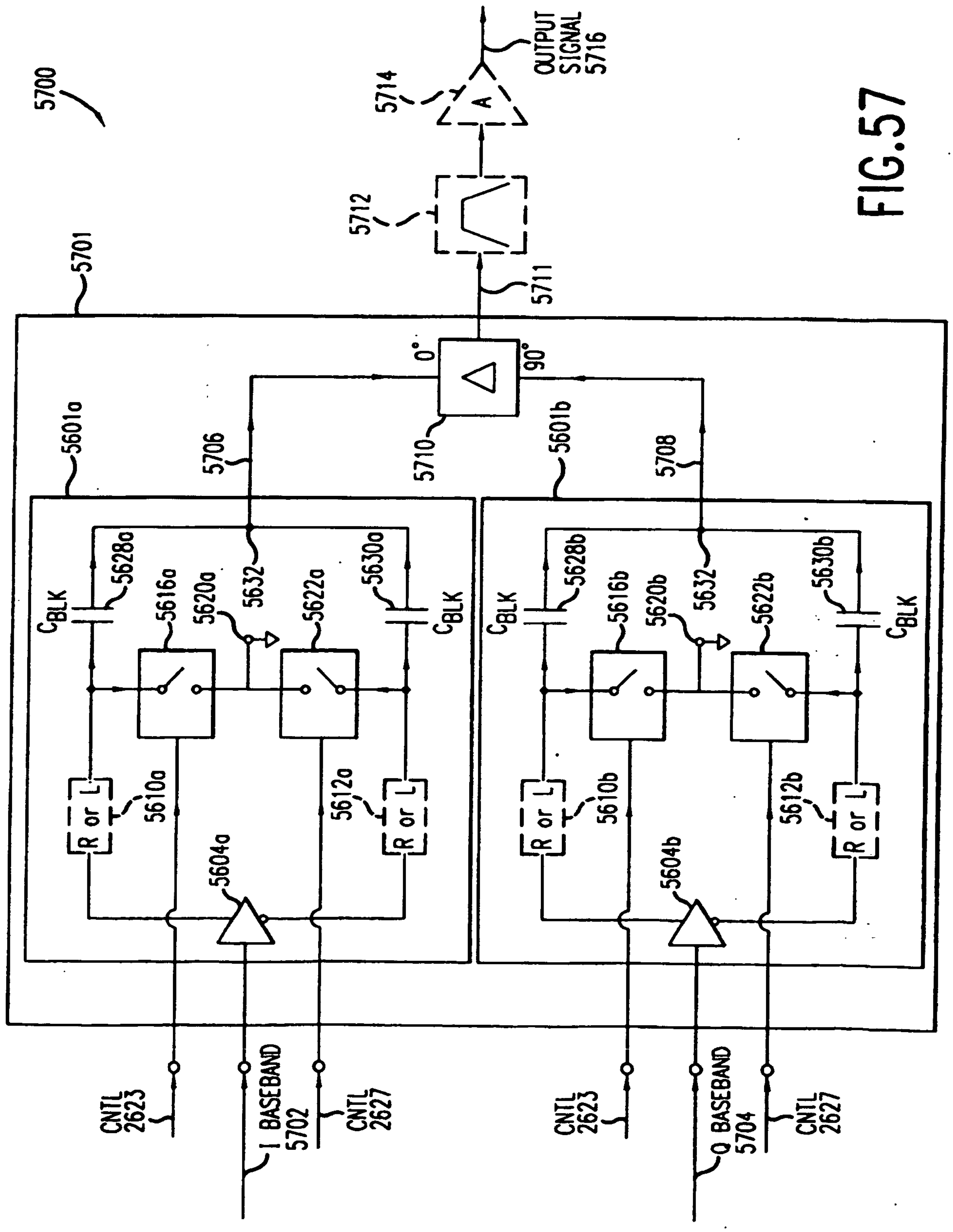
5700
5701
5601a
5601b
5706
5708
5710
0°
90°
5711
5712
5714
A
OUTPUT SIGNAL 5716
5628a
5630a
5616a
5620a
5632
5622a
5610a
5612a
5604a
5628b
5630b
5616b
5620b
5622b
5610b
5612b
5604b
$C_{BLK}$
R or L
CNTL 2623
CNTL 2627
I BASEBAND 5702
Q BASEBAND 5704

FIG.57

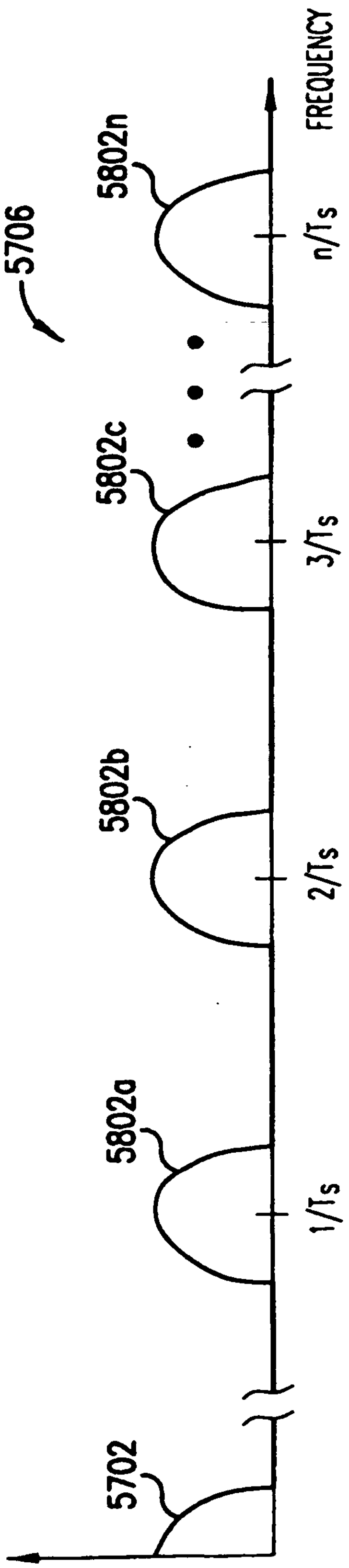


FIG.58A

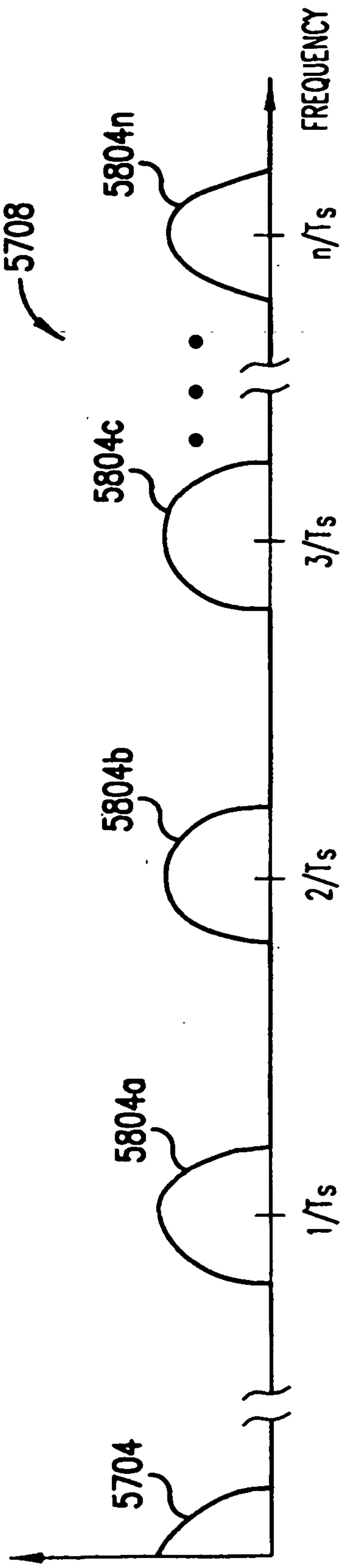


FIG.58B

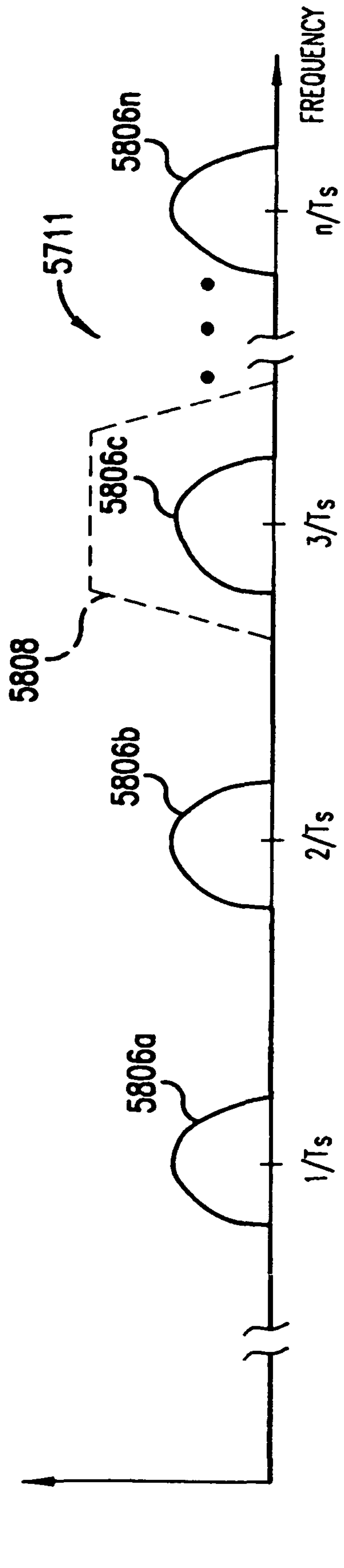


FIG.58C

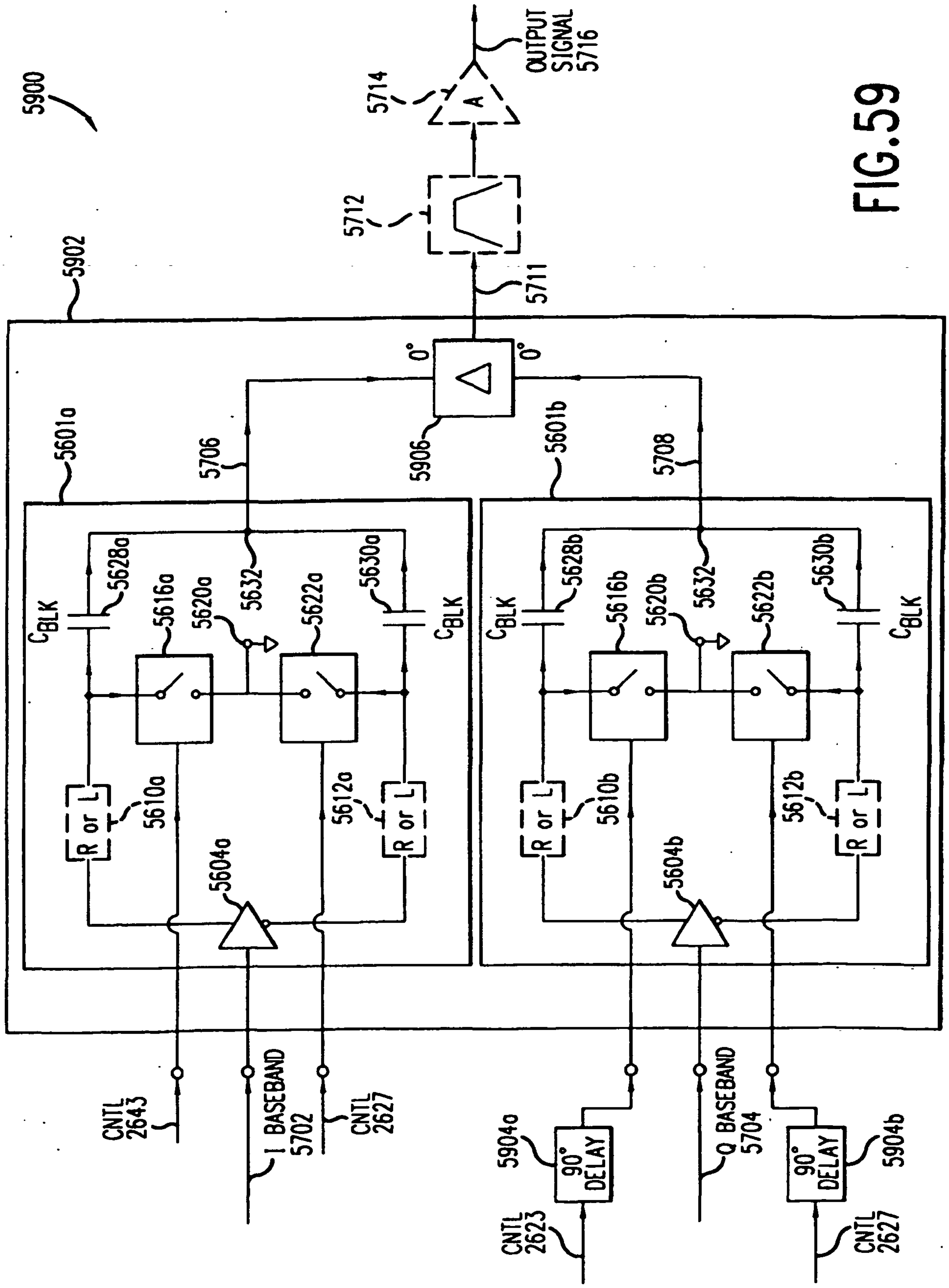
5900
5902
5601a
5601b
5706
5708
5906
0°
0°
5711
5712
5714
A
OUTPUT SIGNAL 5716
$C_{BLK}$
5628a
5616a
5620a
5632
5622a
5630a
5610a
5612a
R or L
5604a
5628b
5616b
5620b
5622b
5630b
5610b
5612b
5604b
CNTL 2643
I BASEBAND 5702
CNTL 2627
5904a
90° DELAY
Q BASEBAND 5704
5904b
CNTL 2623

FIG.59

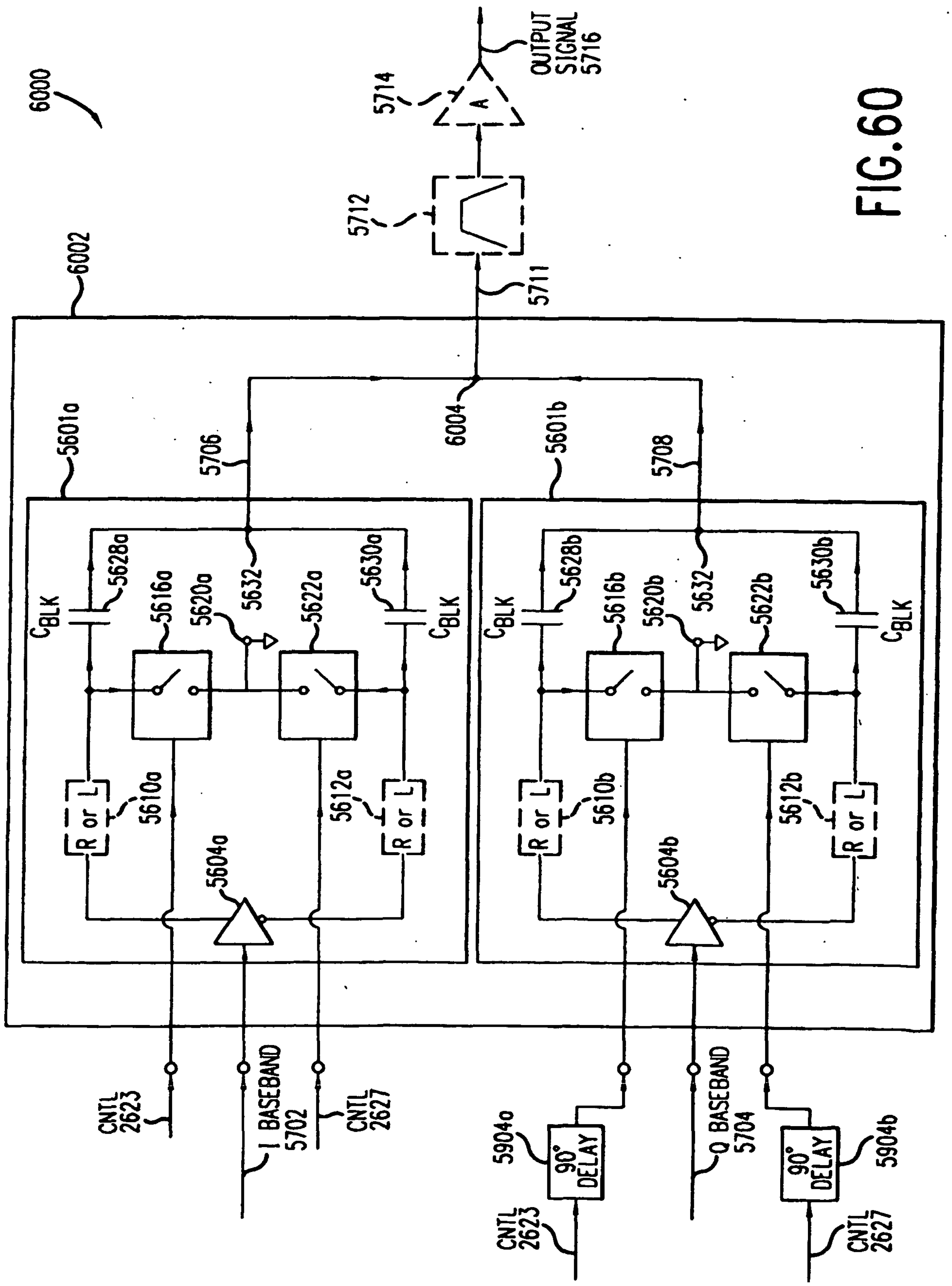
6000
6002
5601a
5601b
5706
5708
6004
5711
5712
5714
A
OUTPUT SIGNAL 5716
5628a
5616a
5620a
5632
5622a
5630a
$C_{BLK}$
5610a
5612a
R or L
5604a
5628b
5616b
5620b
5622b
5630b
5610b
5612b
5604b
CNTL 2623
I BASEBAND 5702
CNTL 2627
5904a
90° DELAY
Q BASEBAND 5704
5904b

FIG.60

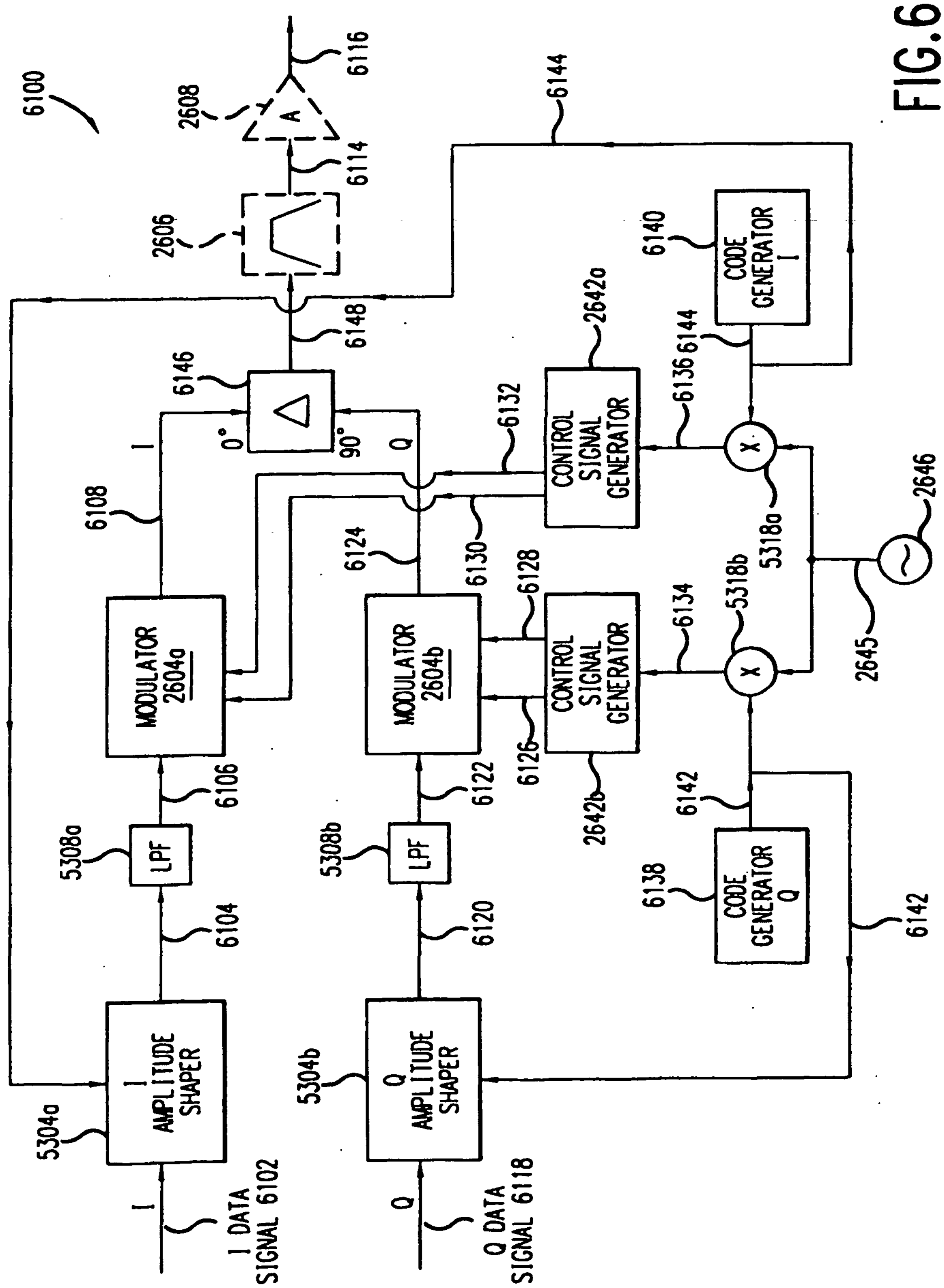
6100
I
I DATA SIGNAL 6102
5304a
I AMPLITUDE SHAPER
6104
5308a
LPF
6106
MODULATOR 2604a
6108
I
0°
6146
90°
Q
6148
2606
6114
2608
A
6116
6144
Q
Q DATA SIGNAL 6118
5304b
Q AMPLITUDE SHAPER
6120
5308b
LPF
6122
MODULATOR 2604b
6124
6130
6132
6126
6128
CONTROL SIGNAL GENERATOR
CONTROL SIGNAL GENERATOR
2642a
2642b
6134
6136
6144
5318a
5318b
X
X
2645
2646
6140
CODE GENERATOR I
6138
CODE GENERATOR Q
6142
6142

FIG.61

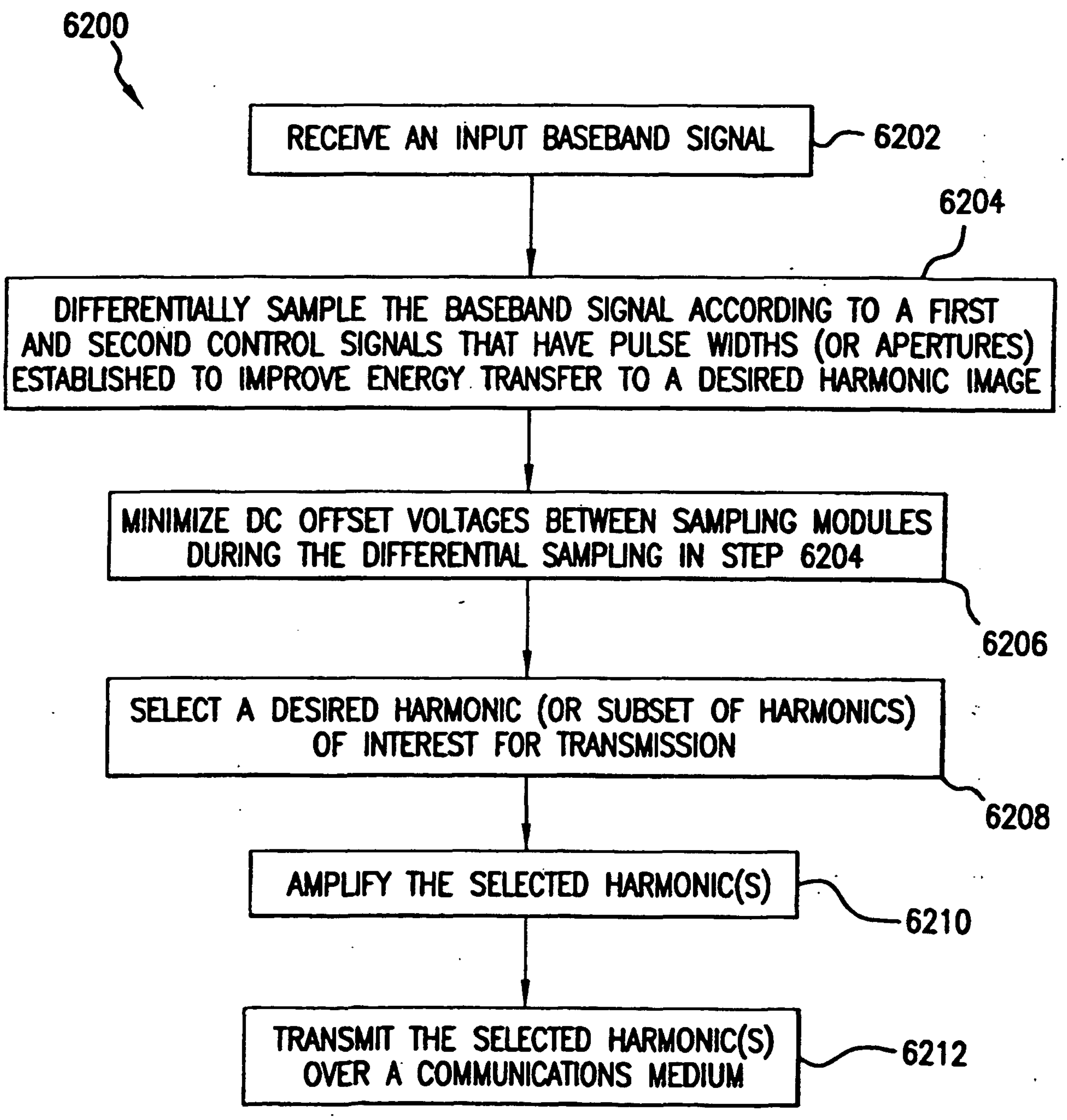
6200
RECEIVE AN INPUT BASEBAND SIGNAL
6202
6204
DIFFERENTIALLY SAMPLE THE BASEBAND SIGNAL ACCORDING TO A FIRST AND SECOND CONTROL SIGNALS THAT HAVE PULSE WIDTHS (OR APERTURES) ESTABLISHED TO IMPROVE ENERGY TRANSFER TO A DESIRED HARMONIC IMAGE
MINIMIZE DC OFFSET VOLTAGES BETWEEN SAMPLING MODULES DURING THE DIFFERENTIAL SAMPLING IN STEP 6204
6206
SELECT A DESIRED HARMONIC (OR SUBSET OF HARMONICS) OF INTEREST FOR TRANSMISSION
6208
AMPLIFY THE SELECTED HARMONIC(S)
6210
TRANSMIT THE SELECTED HARMONIC(S) OVER A COMMUNICATIONS MEDIUM
6212

FIG.62

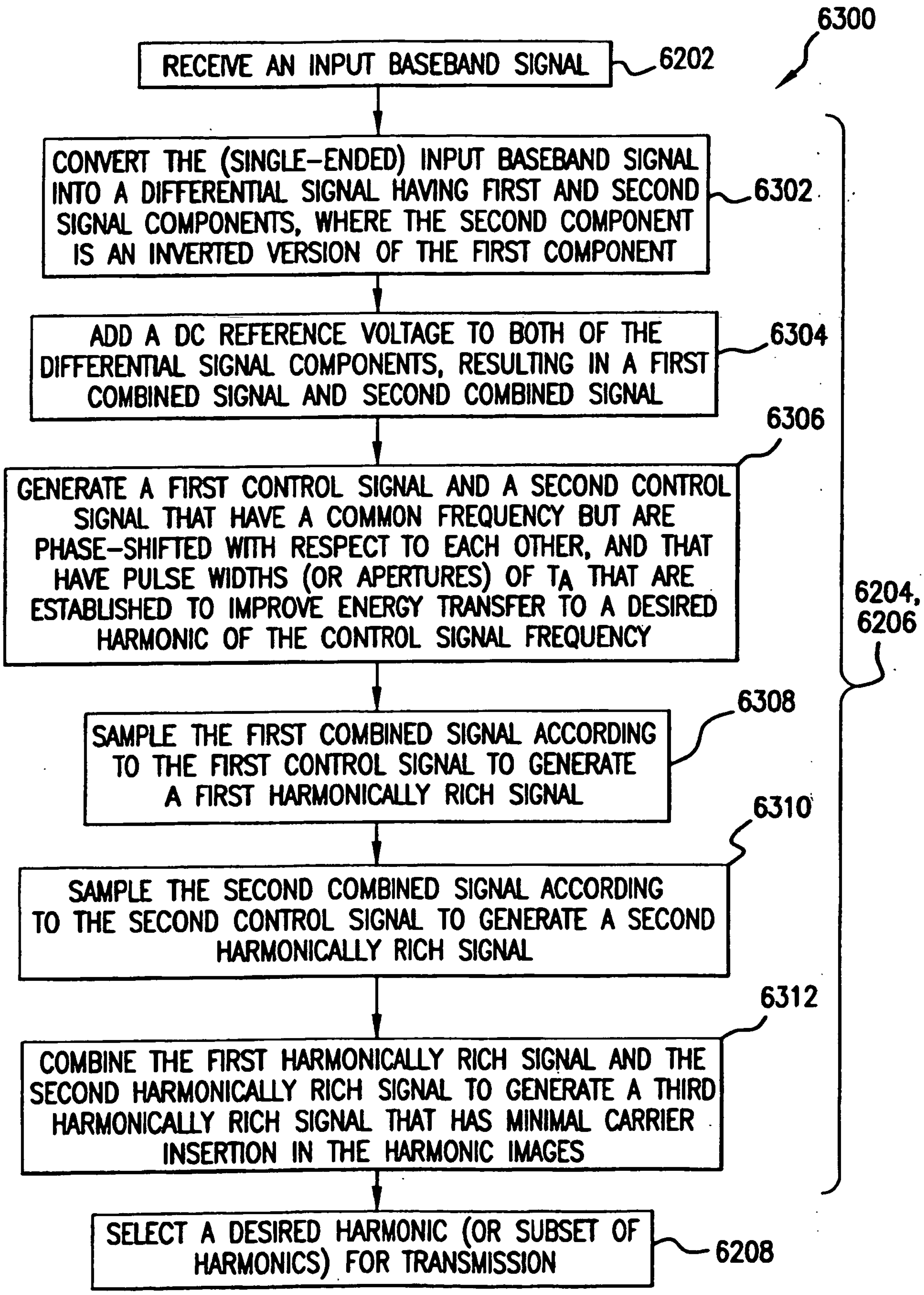
6300
RECEIVE AN INPUT BASEBAND SIGNAL
6202
CONVERT THE (SINGLE-ENDED) INPUT BASEBAND SIGNAL INTO A DIFFERENTIAL SIGNAL HAVING FIRST AND SECOND SIGNAL COMPONENTS, WHERE THE SECOND COMPONENT IS AN INVERTED VERSION OF THE FIRST COMPONENT
6302
ADD A DC REFERENCE VOLTAGE TO BOTH OF THE DIFFERENTIAL SIGNAL COMPONENTS, RESULTING IN A FIRST COMBINED SIGNAL AND SECOND COMBINED SIGNAL
6304
GENERATE A FIRST CONTROL SIGNAL AND A SECOND CONTROL SIGNAL THAT HAVE A COMMON FREQUENCY BUT ARE PHASE-SHIFTED WITH RESPECT TO EACH OTHER, AND THAT HAVE PULSE WIDTHS (OR APERTURES) OF $T_A$ THAT ARE ESTABLISHED TO IMPROVE ENERGY TRANSFER TO A DESIRED HARMONIC OF THE CONTROL SIGNAL FREQUENCY
6306
SAMPLE THE FIRST COMBINED SIGNAL ACCORDING TO THE FIRST CONTROL SIGNAL TO GENERATE A FIRST HARMONICALLY RICH SIGNAL
6308
SAMPLE THE SECOND COMBINED SIGNAL ACCORDING TO THE SECOND CONTROL SIGNAL TO GENERATE A SECOND HARMONICALLY RICH SIGNAL
6310
COMBINE THE FIRST HARMONICALLY RICH SIGNAL AND THE SECOND HARMONICALLY RICH SIGNAL TO GENERATE A THIRD HARMONICALLY RICH SIGNAL THAT HAS MINIMAL CARRIER INSERTION IN THE HARMONIC IMAGES
6312
6204, 6206
SELECT A DESIRED HARMONIC (OR SUBSET OF HARMONICS) FOR TRANSMISSION
6208

FIG.63

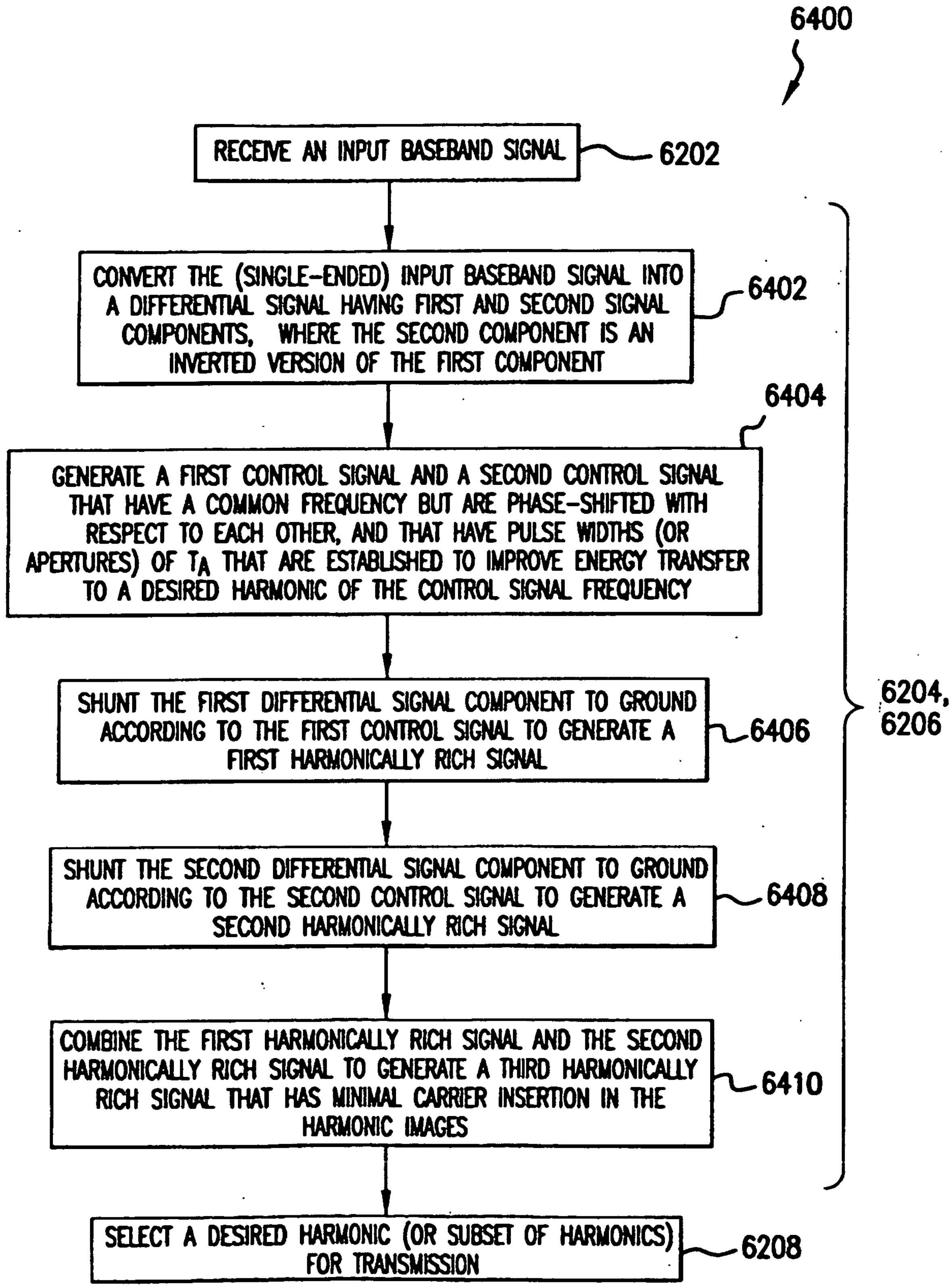
6400
RECEIVE AN INPUT BASEBAND SIGNAL
6202
CONVERT THE (SINGLE-ENDED) INPUT BASEBAND SIGNAL INTO A DIFFERENTIAL SIGNAL HAVING FIRST AND SECOND SIGNAL COMPONENTS, WHERE THE SECOND COMPONENT IS AN INVERTED VERSION OF THE FIRST COMPONENT
6402
6404
GENERATE A FIRST CONTROL SIGNAL AND A SECOND CONTROL SIGNAL THAT HAVE A COMMON FREQUENCY BUT ARE PHASE-SHIFTED WITH RESPECT TO EACH OTHER, AND THAT HAVE PULSE WIDTHS (OR APERTURES) OF $T_A$ THAT ARE ESTABLISHED TO IMPROVE ENERGY TRANSFER TO A DESIRED HARMONIC OF THE CONTROL SIGNAL FREQUENCY
SHUNT THE FIRST DIFFERENTIAL SIGNAL COMPONENT TO GROUND ACCORDING TO THE FIRST CONTROL SIGNAL TO GENERATE A FIRST HARMONICALLY RICH SIGNAL
6406
6204, 6206
SHUNT THE SECOND DIFFERENTIAL SIGNAL COMPONENT TO GROUND ACCORDING TO THE SECOND CONTROL SIGNAL TO GENERATE A SECOND HARMONICALLY RICH SIGNAL
6408
COMBINE THE FIRST HARMONICALLY RICH SIGNAL AND THE SECOND HARMONICALLY RICH SIGNAL TO GENERATE A THIRD HARMONICALLY RICH SIGNAL THAT HAS MINIMAL CARRIER INSERTION IN THE HARMONIC IMAGES
6410
SELECT A DESIRED HARMONIC (OR SUBSET OF HARMONICS) FOR TRANSMISSION
6208

FIG.64

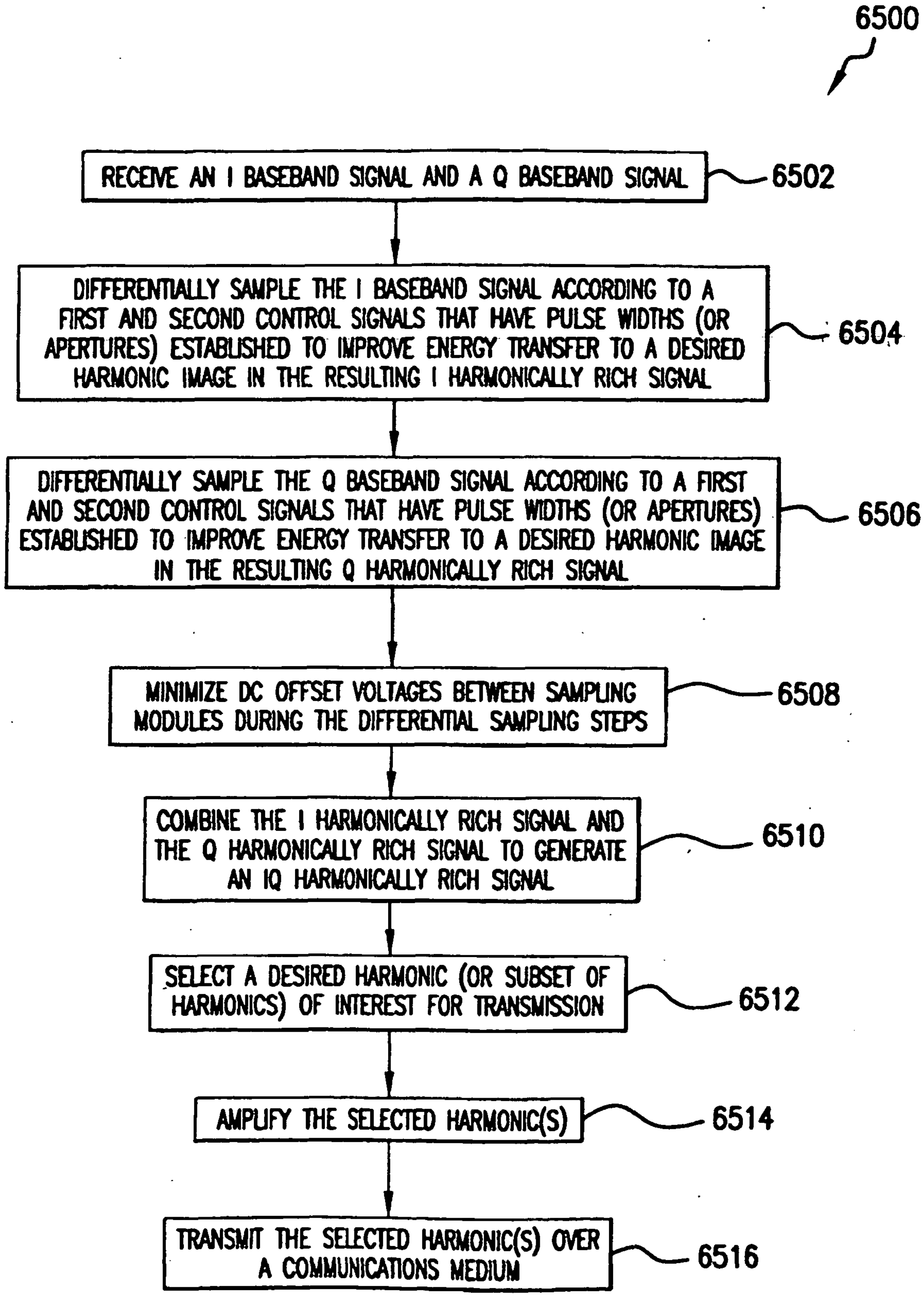
6500
RECEIVE AN I BASEBAND SIGNAL AND A Q BASEBAND SIGNAL
6502
DIFFERENTIALLY SAMPLE THE I BASEBAND SIGNAL ACCORDING TO A FIRST AND SECOND CONTROL SIGNALS THAT HAVE PULSE WIDTHS (OR APERTURES) ESTABLISHED TO IMPROVE ENERGY TRANSFER TO A DESIRED HARMONIC IMAGE IN THE RESULTING I HARMONICALLY RICH SIGNAL
6504
DIFFERENTIALLY SAMPLE THE Q BASEBAND SIGNAL ACCORDING TO A FIRST AND SECOND CONTROL SIGNALS THAT HAVE PULSE WIDTHS (OR APERTURES) ESTABLISHED TO IMPROVE ENERGY TRANSFER TO A DESIRED HARMONIC IMAGE IN THE RESULTING Q HARMONICALLY RICH SIGNAL
6506
MINIMIZE DC OFFSET VOLTAGES BETWEEN SAMPLING MODULES DURING THE DIFFERENTIAL SAMPLING STEPS
6508
COMBINE THE I HARMONICALLY RICH SIGNAL AND THE Q HARMONICALLY RICH SIGNAL TO GENERATE AN IQ HARMONICALLY RICH SIGNAL
6510
SELECT A DESIRED HARMONIC (OR SUBSET OF HARMONICS) OF INTEREST FOR TRANSMISSION
6512
AMPLIFY THE SELECTED HARMONIC(S)
6514
TRANSMIT THE SELECTED HARMONIC(S) OVER A COMMUNICATIONS MEDIUM
6516

FIG.65

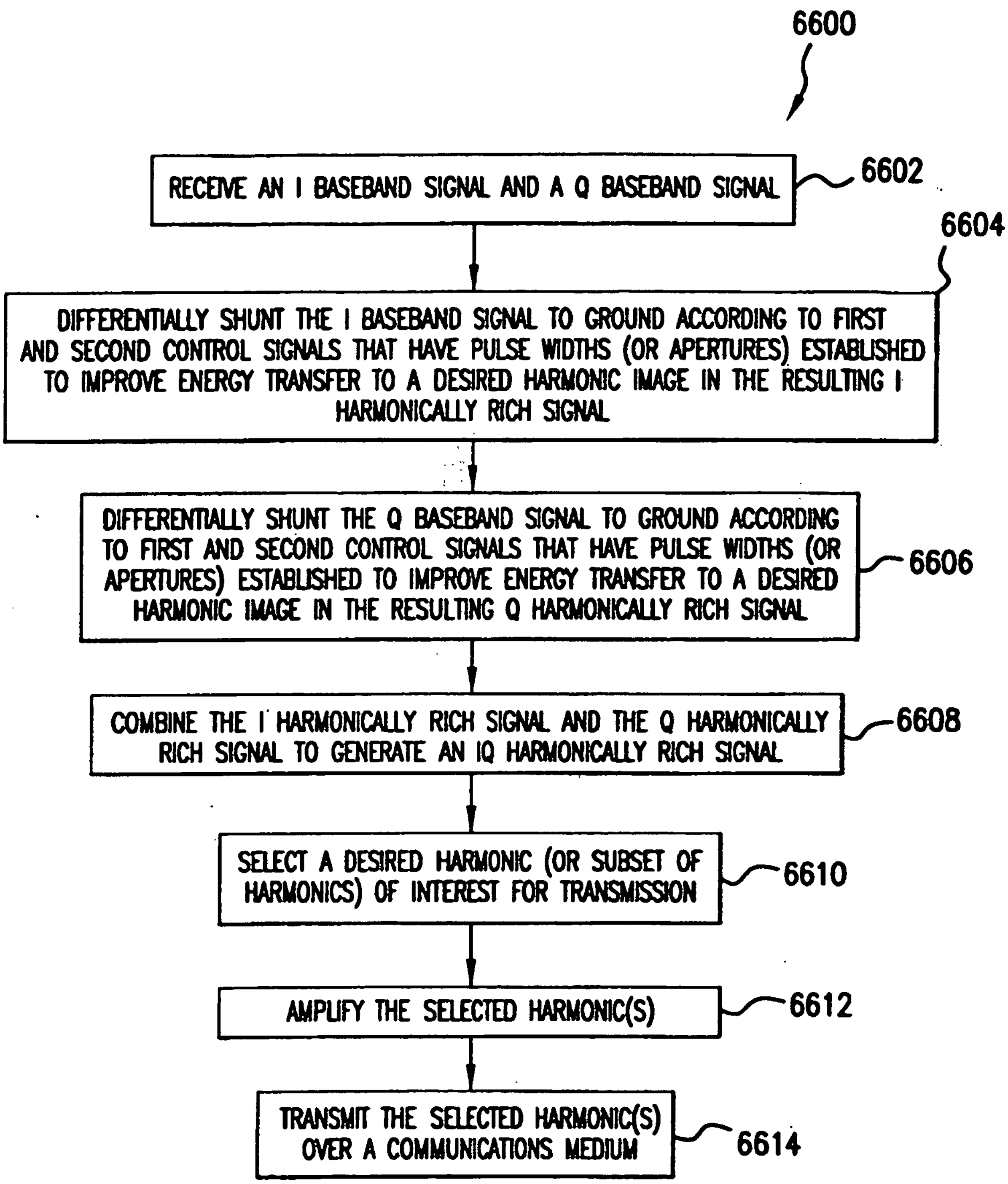
6600
RECEIVE AN I BASEBAND SIGNAL AND A Q BASEBAND SIGNAL
6602
DIFFERENTIALLY SHUNT THE I BASEBAND SIGNAL TO GROUND ACCORDING TO FIRST AND SECOND CONTROL SIGNALS THAT HAVE PULSE WIDTHS (OR APERTURES) ESTABLISHED TO IMPROVE ENERGY TRANSFER TO A DESIRED HARMONIC IMAGE IN THE RESULTING I HARMONICALLY RICH SIGNAL
6604
DIFFERENTIALLY SHUNT THE Q BASEBAND SIGNAL TO GROUND ACCORDING TO FIRST AND SECOND CONTROL SIGNALS THAT HAVE PULSE WIDTHS (OR APERTURES) ESTABLISHED TO IMPROVE ENERGY TRANSFER TO A DESIRED HARMONIC IMAGE IN THE RESULTING Q HARMONICALLY RICH SIGNAL
6606
COMBINE THE I HARMONICALLY RICH SIGNAL AND THE Q HARMONICALLY RICH SIGNAL TO GENERATE AN IQ HARMONICALLY RICH SIGNAL
6608
SELECT A DESIRED HARMONIC (OR SUBSET OF HARMONICS) OF INTEREST FOR TRANSMISSION
6610
AMPLIFY THE SELECTED HARMONIC(S)
6612
TRANSMIT THE SELECTED HARMONIC(S) OVER A COMMUNICATIONS MEDIUM
6614

FIG.66

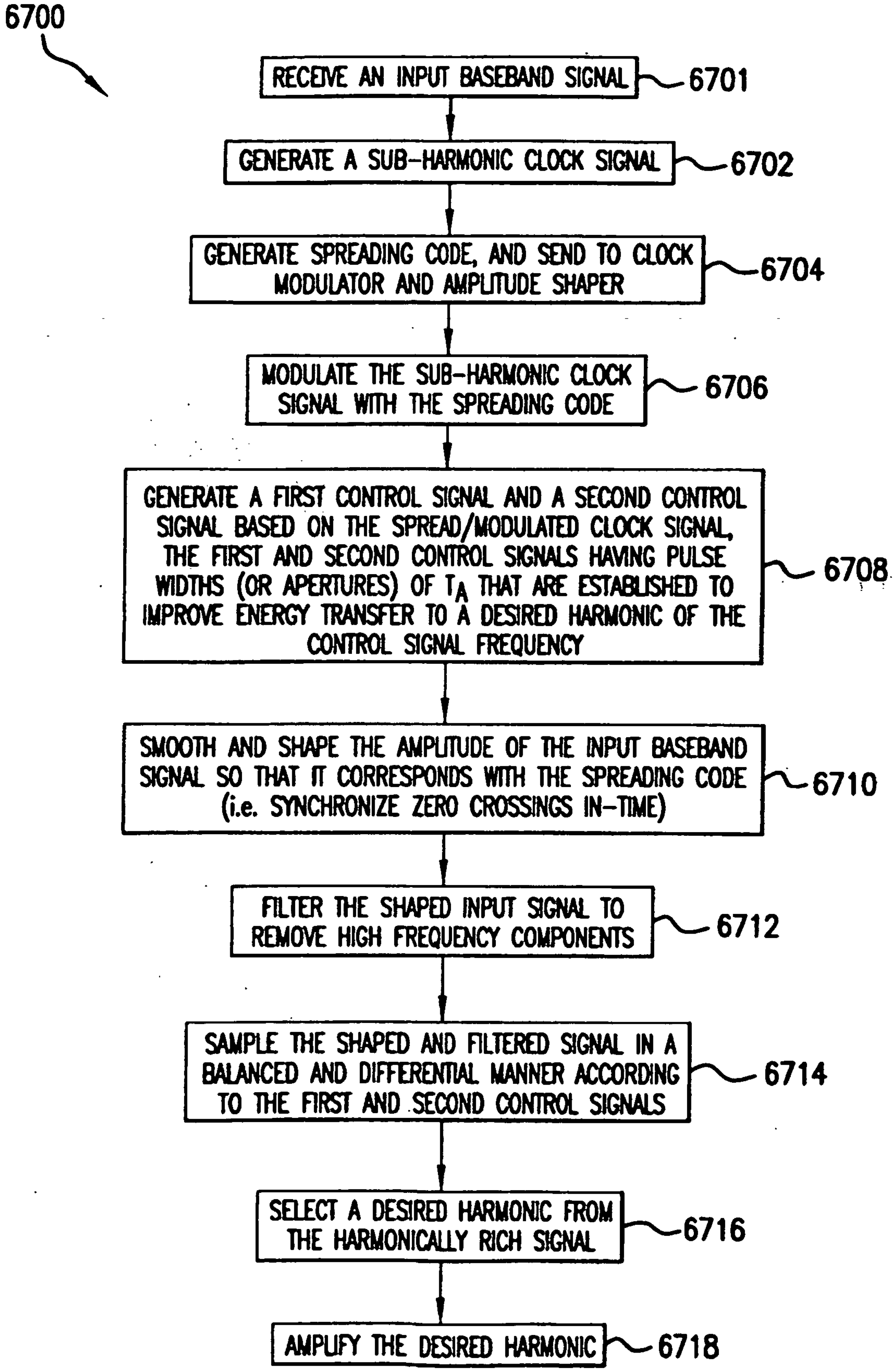
6700
RECEIVE AN INPUT BASEBAND SIGNAL
6701
GENERATE A SUB-HARMONIC CLOCK SIGNAL
6702
GENERATE SPREADING CODE, AND SEND TO CLOCK MODULATOR AND AMPLITUDE SHAPER
6704
MODULATE THE SUB-HARMONIC CLOCK SIGNAL WITH THE SPREADING CODE
6706
GENERATE A FIRST CONTROL SIGNAL AND A SECOND CONTROL SIGNAL BASED ON THE SPREAD/MODULATED CLOCK SIGNAL, THE FIRST AND SECOND CONTROL SIGNALS HAVING PULSE WIDTHS (OR APERTURES) OF $T_A$ THAT ARE ESTABLISHED TO IMPROVE ENERGY TRANSFER TO A DESIRED HARMONIC OF THE CONTROL SIGNAL FREQUENCY
6708
SMOOTH AND SHAPE THE AMPLITUDE OF THE INPUT BASEBAND SIGNAL SO THAT IT CORRESPONDS WITH THE SPREADING CODE (i.e. SYNCHRONIZE ZERO CROSSINGS IN-TIME)
6710
FILTER THE SHAPED INPUT SIGNAL TO REMOVE HIGH FREQUENCY COMPONENTS
6712
SAMPLE THE SHAPED AND FILTERED SIGNAL IN A BALANCED AND DIFFERENTIAL MANNER ACCORDING TO THE FIRST AND SECOND CONTROL SIGNALS
6714
SELECT A DESIRED HARMONIC FROM THE HARMONICALLY RICH SIGNAL
6716
AMPLIFY THE DESIRED HARMONIC
6718

FIG.67

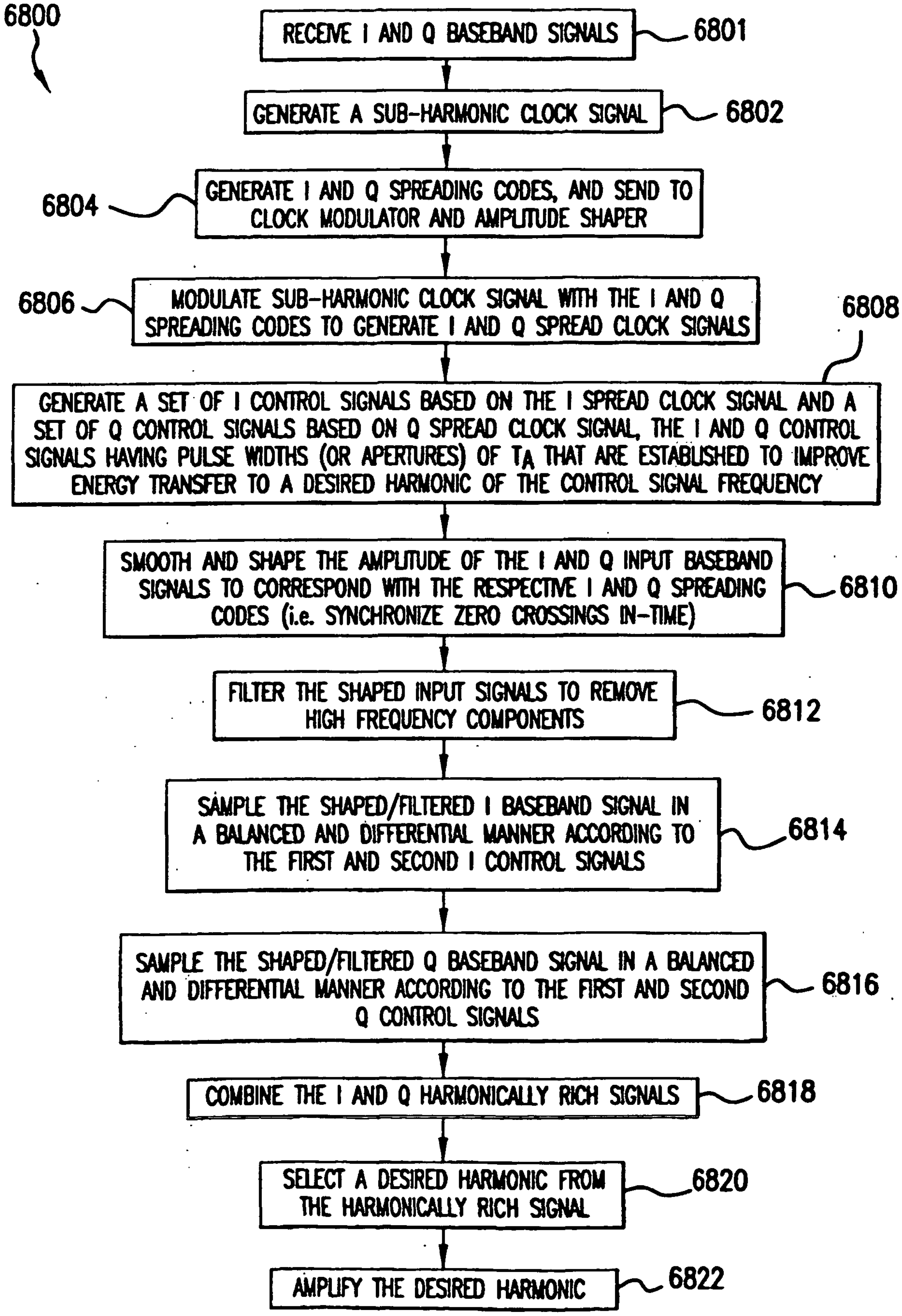
6800
RECEIVE I AND Q BASEBAND SIGNALS
6801
GENERATE A SUB-HARMONIC CLOCK SIGNAL
6802
GENERATE I AND Q SPREADING CODES, AND SEND TO CLOCK MODULATOR AND AMPLITUDE SHAPER
6804
MODULATE SUB-HARMONIC CLOCK SIGNAL WITH THE I AND Q SPREADING CODES TO GENERATE I AND Q SPREAD CLOCK SIGNALS
6806
6808
GENERATE A SET OF I CONTROL SIGNALS BASED ON THE I SPREAD CLOCK SIGNAL AND A SET OF Q CONTROL SIGNALS BASED ON Q SPREAD CLOCK SIGNAL, THE I AND Q CONTROL SIGNALS HAVING PULSE WIDTHS (OR APERTURES) OF $T_A$ THAT ARE ESTABLISHED TO IMPROVE ENERGY TRANSFER TO A DESIRED HARMONIC OF THE CONTROL SIGNAL FREQUENCY
SMOOTH AND SHAPE THE AMPLITUDE OF THE I AND Q INPUT BASEBAND SIGNALS TO CORRESPOND WITH THE RESPECTIVE I AND Q SPREADING CODES (i.e. SYNCHRONIZE ZERO CROSSINGS IN-TIME)
6810
FILTER THE SHAPED INPUT SIGNALS TO REMOVE HIGH FREQUENCY COMPONENTS
6812
SAMPLE THE SHAPED/FILTERED I BASEBAND SIGNAL IN A BALANCED AND DIFFERENTIAL MANNER ACCORDING TO THE FIRST AND SECOND I CONTROL SIGNALS
6814
SAMPLE THE SHAPED/FILTERED Q BASEBAND SIGNAL IN A BALANCED AND DIFFERENTIAL MANNER ACCORDING TO THE FIRST AND SECOND Q CONTROL SIGNALS
6816
COMBINE THE I AND Q HARMONICALLY RICH SIGNALS
6818
SELECT A DESIRED HARMONIC FROM THE HARMONICALLY RICH SIGNAL
6820
AMPLIFY THE DESIRED HARMONIC
6822

FIG.68

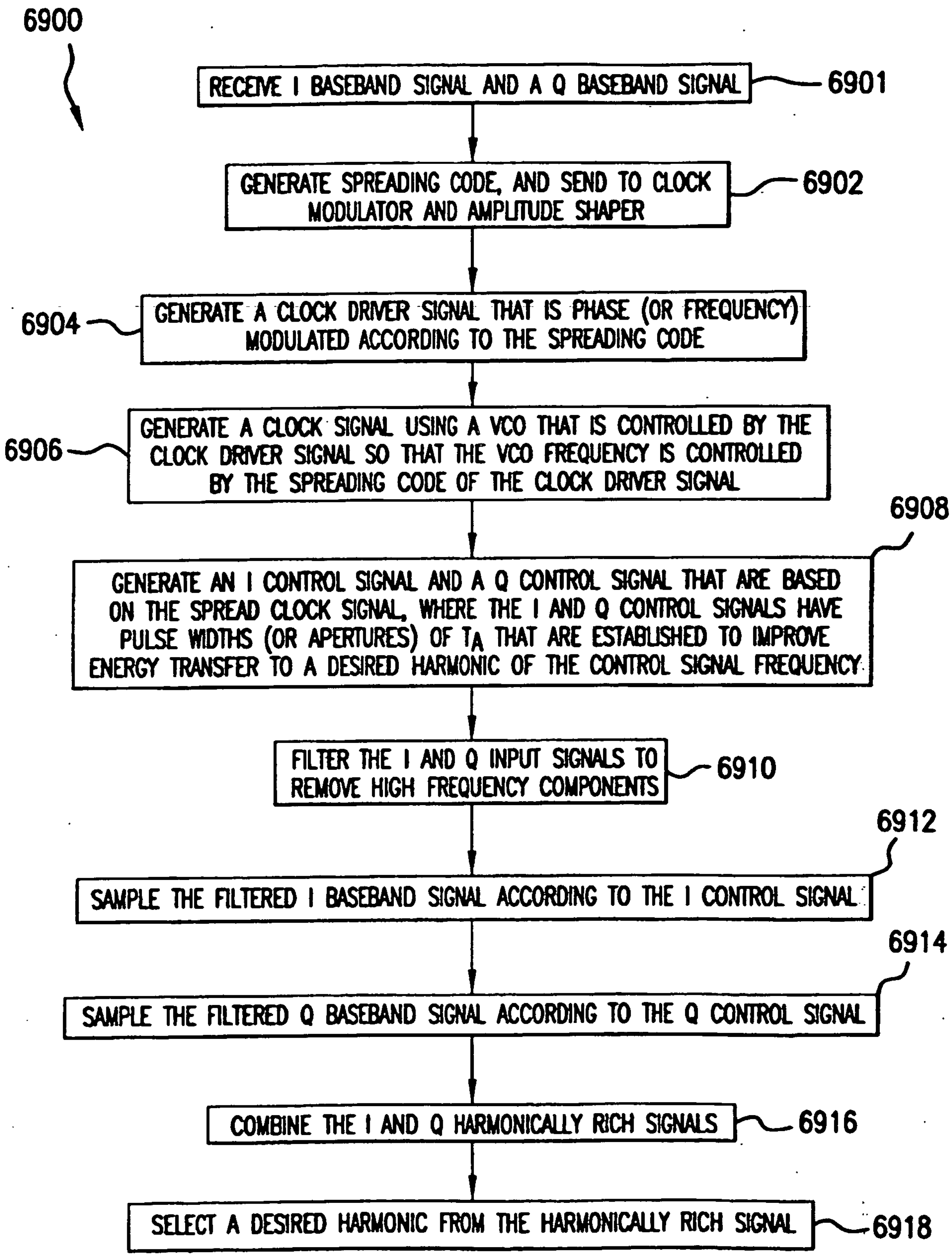
6900
RECEIVE I BASEBAND SIGNAL AND A Q BASEBAND SIGNAL
6901
GENERATE SPREADING CODE, AND SEND TO CLOCK MODULATOR AND AMPLITUDE SHAPER
6902
GENERATE A CLOCK DRIVER SIGNAL THAT IS PHASE (OR FREQUENCY) MODULATED ACCORDING TO THE SPREADING CODE
6904
GENERATE A CLOCK SIGNAL USING A VCO THAT IS CONTROLLED BY THE CLOCK DRIVER SIGNAL SO THAT THE VCO FREQUENCY IS CONTROLLED BY THE SPREADING CODE OF THE CLOCK DRIVER SIGNAL
6906
GENERATE AN I CONTROL SIGNAL AND A Q CONTROL SIGNAL THAT ARE BASED ON THE SPREAD CLOCK SIGNAL, WHERE THE I AND Q CONTROL SIGNALS HAVE PULSE WIDTHS (OR APERTURES) OF $T_A$ THAT ARE ESTABLISHED TO IMPROVE ENERGY TRANSFER TO A DESIRED HARMONIC OF THE CONTROL SIGNAL FREQUENCY
6908
FILTER THE I AND Q INPUT SIGNALS TO REMOVE HIGH FREQUENCY COMPONENTS
6910
SAMPLE THE FILTERED I BASEBAND SIGNAL ACCORDING TO THE I CONTROL SIGNAL
6912
SAMPLE THE FILTERED Q BASEBAND SIGNAL ACCORDING TO THE Q CONTROL SIGNAL
6914
COMBINE THE I AND Q HARMONICALLY RICH SIGNALS
6916
SELECT A DESIRED HARMONIC FROM THE HARMONICALLY RICH SIGNAL
6918

FIG.69

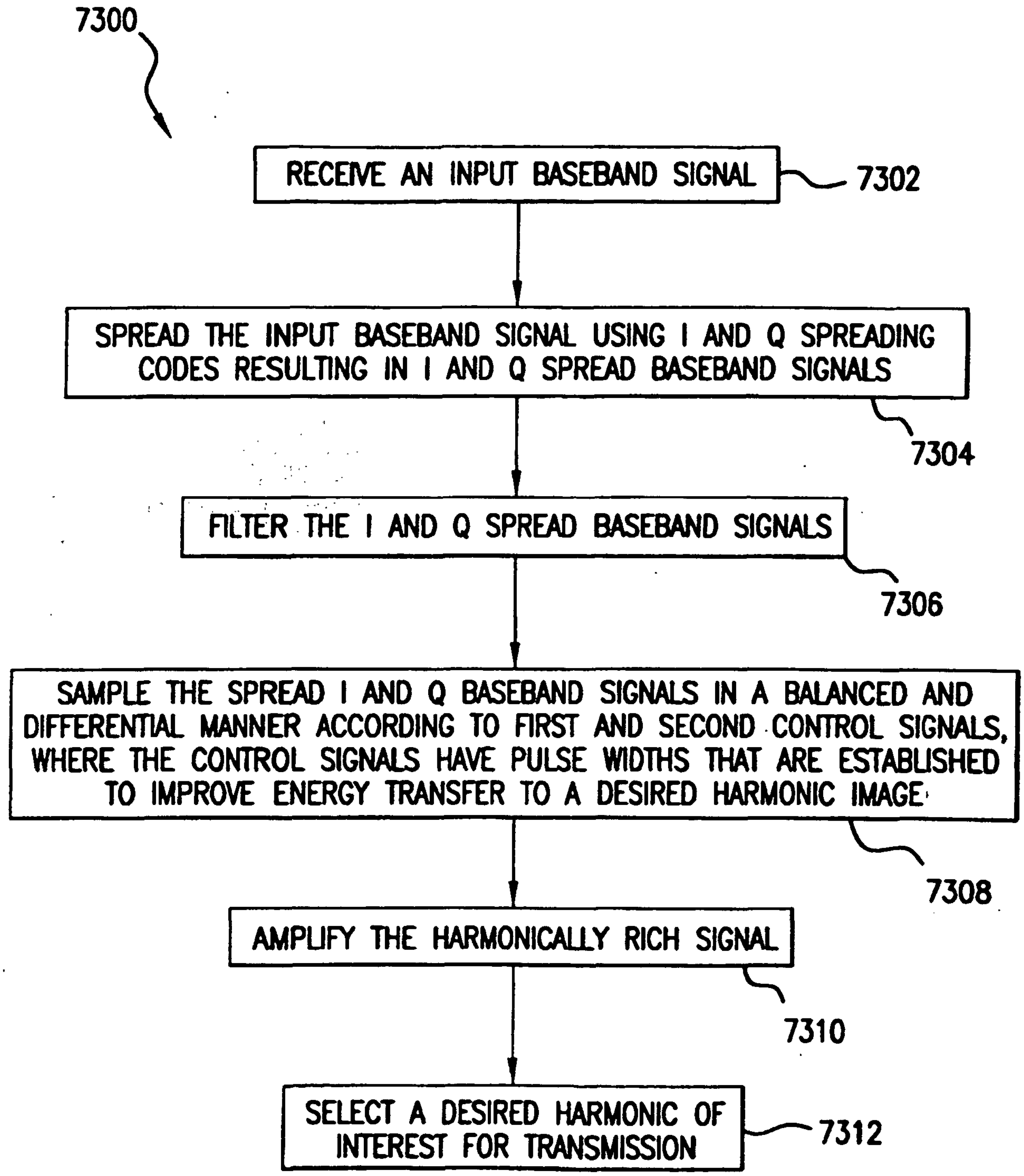
7300
RECEIVE AN INPUT BASEBAND SIGNAL
7302
SPREAD THE INPUT BASEBAND SIGNAL USING I AND Q SPREADING CODES RESULTING IN I AND Q SPREAD BASEBAND SIGNALS
7304
FILTER THE I AND Q SPREAD BASEBAND SIGNALS
7306
SAMPLE THE SPREAD I AND Q BASEBAND SIGNALS IN A BALANCED AND DIFFERENTIAL MANNER ACCORDING TO FIRST AND SECOND CONTROL SIGNALS, WHERE THE CONTROL SIGNALS HAVE PULSE WIDTHS THAT ARE ESTABLISHED TO IMPROVE ENERGY TRANSFER TO A DESIRED HARMONIC IMAGE
7308
AMPLIFY THE HARMONICALLY RICH SIGNAL
7310
SELECT A DESIRED HARMONIC OF INTEREST FOR TRANSMISSION
7312

FIG.70